# EUROPEAN PATENT SPECIFICATION

(11) **EP 4 131 456 B1**
(45) Date of publication and mention of the grant of the patent: **18.02.2026**
(21) Application number: 22188964.5
(22) Date of filing: 05.08.2022
(51) Int. Cl.: H10K 50/86, H10K 50/11

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 05.08.2021 KR 20210103045
(43) Date of publication of application: 08.02.2023
(73) Proprietor: SFC Co., Ltd., Cheongju-si, Chungcheongbuk-do 28122 (KR)
(72) Inventor: CHO, Jin-hwi, 28122 Chungcheongbuk-do (KR); YU, Se-jin, 28122 Chungcheongbuk-do (KR); SHIM, So-young, 28122 Chungcheongbuk-do (KR); YANG, Yong-woon, 28122 Chungcheongbuk-do (KR)
(74) Representative: Grosse, Felix Christopher

(56) References cited:
- EP-A1- 3 656 776
- WO-A1-2021/021840
- KR-A- 20190 115 615
- KR-A- 20190 139 492
- KR-A- 20210 009 912

## Description

### BACKGROUND OF THE INVENTION

### Field of the Invention

The present invention relates to a highly efficient organic light-emitting device, and more specifically, to a highly efficient organic light-emitting device that uses an anthracene derivative having a characteristic structure as a host compound in a light-emitting layer of the organic light-emitting device and includes a capping layer formed using a compound having a characteristic structure in the organic light-emitting device.

### Description of the Related Art

An organic light-emitting device is a self-luminous device that emits light when energy is released from excitons which are formed by recombination of electrons injected from an electron injection electrode (cathode) and holes injected from a hole injection electrode (anode) in a light-emitting layer. Such an organic light-emitting device attracts a great deal of attention as a next-generation light source due to applicability to full-color flat panel light-emitting displays based on advantages such as low driving voltage, high luminance, wide viewing angle, and rapid response speed thereof.

In order for the organic light-emitting device to exhibit the characteristics, the structure of the organic layer in the organic light-emitting device should be optimized, and the material constituting each organic layer, namely, a hole injection material, a hole transport material, a light-emitting material, an electron transport material, an electron injection material, or an electron blocking material should be based on stable and efficient ingredients. However, there is a continuing need to develop organic layer structures and respective materials thereof for stable and efficient organic light-emitting devices.

In particular, the energy bandgap between the host and the dopant should be properly balanced so that holes and electrons can form excitons through stable electrochemical paths in order to obtain maximum efficiency of the light-emitting layer.

In addition, in recent years, research on the improvement of the characteristics of the organic light-emitting device based on change of the performance of each organic layer material, and an approach to improve color purity and increase luminous efficacy based on the optimized optical thickness between an anode and a cathode have arisen as key factors for improving performance of the organic light-emitting device. As an example of this method, a capping layer is formed on an electrode to achieve desired luminous efficacy and excellent color purity. Organic light-emitting devices with capping layers have been disclosed in KR 20190139492 A and KR 20190115615 A.

As such, there is a continuing need for the development of the structure of an organic light-emitting device capable of improving the luminous characteristics thereof and the development of novel materials supporting the structure.

### SUMMARY OF THE INVENTION

Therefore, the present invention has been made in view of the above problems, and it is one object of the present invention to provide a highly efficient organic light-emitting device that uses an anthracene derivative having a characteristic structure as a material for a light-emitting layer and includes a capping layer.

In accordance with the present invention, the above and other objects can be accomplished by the provision of an organic light-emitting device characterized in that:
(i) the organic light-emitting device includes a first electrode, a second electrode facing the first electrode, and a light-emitting layer interposed between the first electrode and the second electrode;
(ii) the organic light-emitting device includes a capping layer disposed on one surface of the first electrode or the second electrode, which is opposite to a remaining surface of the first electrode or the second electrode that faces the light-emitting layer;
(iii) the light-emitting layer includes at least one selected from compounds represented by the following [Formula A-1] to [Formula A-6]; and 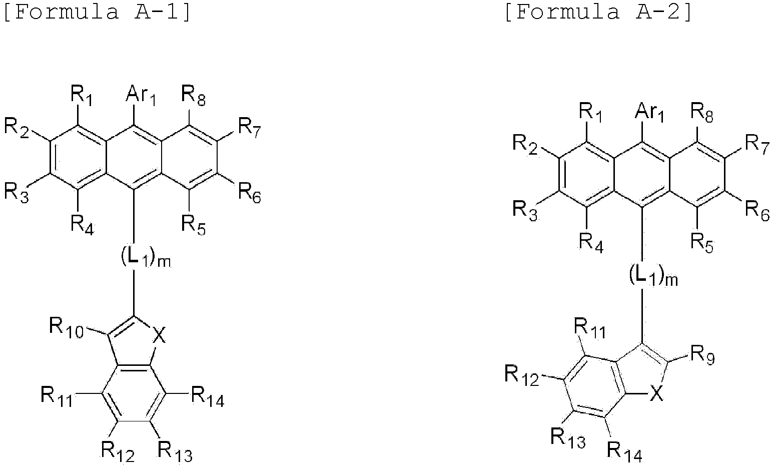 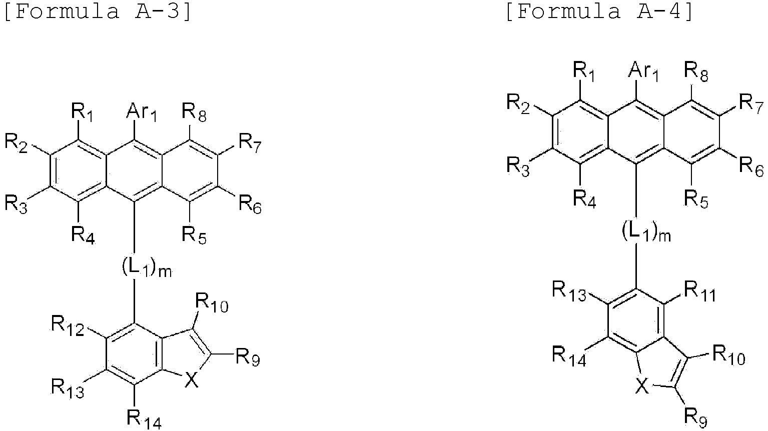 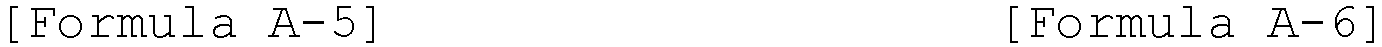 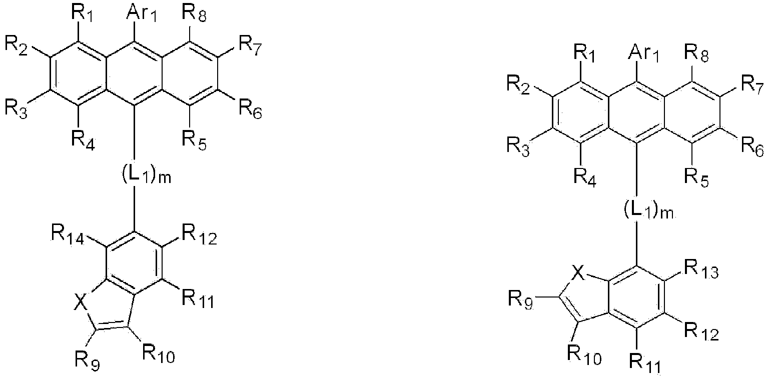
(iv) the capping layer includes at least one of compounds represented by the following [Formula B] or [Formula C].

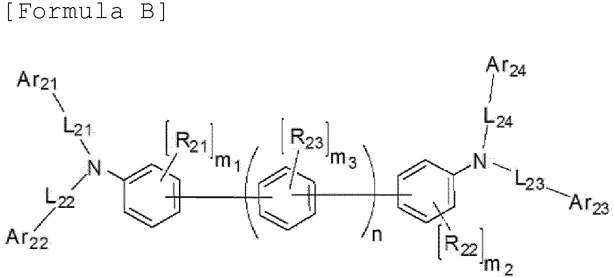

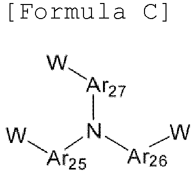

The structures and substituents of [Formula A-1] to [Formula A-6], [Formula B] and [Formula C], specific compounds thereof, and organic light-emitting devices including the same will be described later.

### DETAILED DESCRIPTION OF THE INVENTION

Hereinafter, the present invention will be described in detail with reference to the annexed drawings.

The organic light-emitting device according to the present invention includes a first electrode, a second electrode facing the first electrode, a light-emitting layer interposed between the first electrode and the second electrode, and a capping layer disposed on one surface of the first electrode or the second electrode which is opposite to a remaining surface of the first electrode or the second electrode that faces the light-emitting layer.

In the organic light-emitting device according to the present invention, the light-emitting layer includes at least one selected from compounds represented by the following [Formula A-1] to [Formula A-6]: 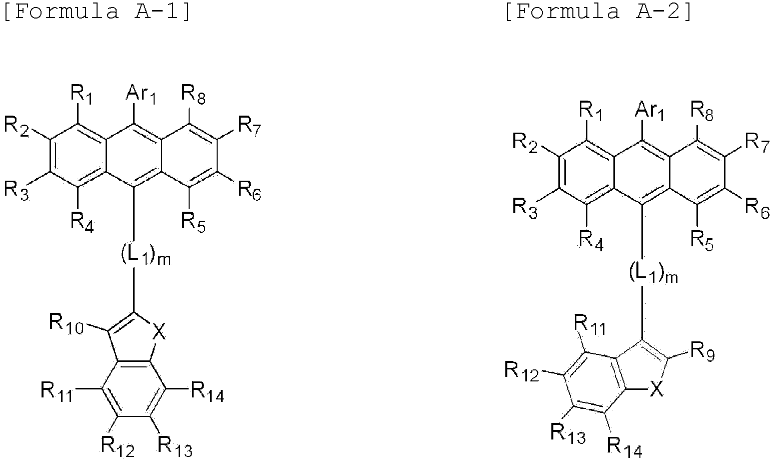 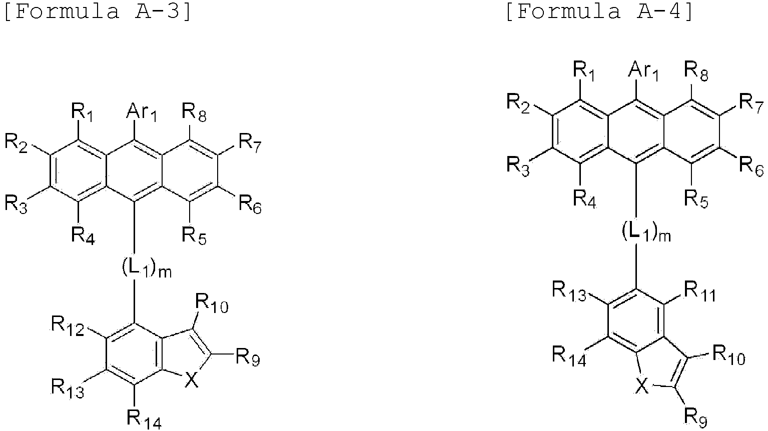 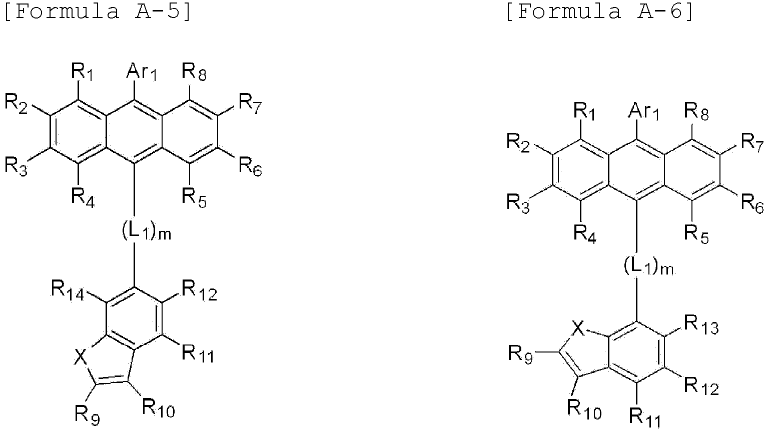
wherein Ar₁ is selected from a substituted or unsubstituted C6-C50 aryl group, a substituted or unsubstituted C2-C50 heteroaryl group, and a substituted or unsubstituted C3-C50 mixed aliphatic-aromatic ring group;
R₁ to R₁₄ are identical to or different from each other, and are each independently hydrogen, deuterium, a substituted or unsubstituted C1-C30 alkyl group, a substituted or unsubstituted C6-C50 aryl group, a substituted or unsubstituted C2-C30 alkynyl group, a substituted or unsubstituted C3-C30 cycloalkyl group, a substituted or unsubstituted C3-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a cyano group, a nitro group and a halogen group;
X is an oxygen atom (O) or a sulfur atom (S);
L₁ is a divalent linker and is a single bond or is selected from a substituted or unsubstituted C6-C50 arylene group, a substituted or unsubstituted C2-C50 heteroarylene group, and a substituted or unsubstituted C3-C50 mixed aliphatic-aromatic ring group; and
m is an integer from 1 to 3, provided that when m is 2 or more, a plurality of L₁ are identical to or different from each other.

The compound represented by [Formula A] according to the present invention has a structure including at least one benzofuran or benzothiophene, and is used as a host compound for a light-emitting layer of an organic light-emitting device based thereon. Therefore, it is possible to realize an organic light-emitting device having a long lifespan and low operating voltage.

According to an embodiment of the present invention, each of the compounds represented by [Formula A-1] to [Formula A-6] includes at least one deuterium atom (D). That is, at least one of Ar₁, R₁ to R₁₄ and L₁ or substituents thereof in each of [Formula A-1] to [Formula A-6] is a deuterium atom (D).

According to one embodiment of the present invention, the degree of deuteration of each of the compounds represented by [Formula A-1] to [Formula A-6] is 10% or more, which means that 10% or more of the substituents introduced into the respective skeletons are deuterium.

In addition, according to an embodiment of the present invention, each of the compounds represented by [Formula A-1] to [Formula A-6] has a degree of deuteration of 30% or more.

In addition, according to an embodiment of the present invention, each of the compounds represented by [Formula A-1] to [Formula A-6] has a degree of deuteration of 50% or more.

At least one of R₁₁ to R₁₄ in each of the compounds represented by [Formula A-1] to [Formula A-6] of the present invention may be selected from a substituted or unsubstituted C6-C20 aryl group, a substituted or unsubstituted C3-C20 cycloalkyl group, and a substituted or unsubstituted C3-C20 heteroaryl group.

In addition, according to an embodiment of the present invention, at least one of R₁₁ to R₁₄ may be a deuterium-substituted or unsubstituted C6-C20 aryl group.

The organic light-emitting device according to the present invention further includes a capping layer on the outside of one surface of an electrode which is opposite to the other surface of the electrode that faces the light-emitting layer and the capping layer contains at least one of compounds represented by the following [Formula B] and [Formula C]: 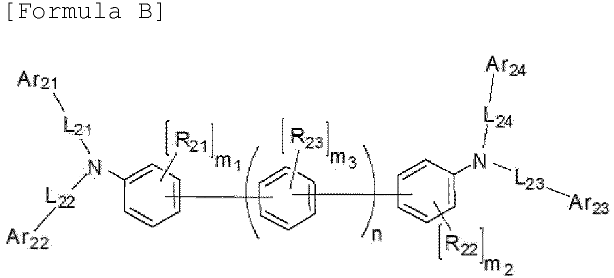
wherein R₂₁ to R₂₃ are identical to or different from each other, and are each independently selected from hydrogen, deuterium, a substituted or unsubstituted C1-C20 alkyl group, a substituted or unsubstituted C6-C50 aryl group, a substituted or unsubstituted C2-C30 heteroaryl group, a substituted or unsubstituted C7-C50 arylalkyl group, a substituted or unsubstituted C3-C30 cycloalkyl group, a substituted or unsubstituted silyl group, and a halogen group,
L₂₁ to L₂₄ are identical to or different from each other, and are each independently a single bond or are selected from a substituted or unsubstituted C6-C50 arylene group and a substituted or unsubstituted C2-C50 heteroarylene group,
Ar₂₁ to Ar₂₄ are identical to or different from each other, and are each independently selected from a substituted or unsubstituted C6-C50 aryl group, and a substituted or unsubstituted C2-C50 heteroaryl group,
n is an integer from 0 to 4, provided that when n is 2 or more, a plurality of aromatic ring structures in ( ) including R₂₃ are identical to or different from each other,
m₁ to m₃ are integers from 0 to 4, provided that when each of m₁ to m₃ is 2 or more, a plurality of each of R₂₁, R₂₂, and R₂₃ are identical to or different from each other, and
a carbon atom of the aromatic ring, to which R₂₁ to R₂₃ are not bonded, is bonded to hydrogen or deuterium.

According to one embodiment of the present invention, at least one of Ar₂₁ to Ar₂₄ in [Formula B] is represented by the following [Formula E]: 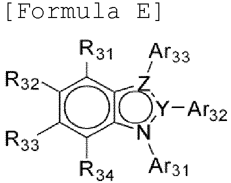
wherein R₃₁ to R₃₄ are identical to or different from each other, and are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C20 alkynyl group, a substituted or unsubstituted C3-C30 cycloalkyl group, a substituted or unsubstituted C5-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted amine group, a substituted or unsubstituted silyl group, a nitro group, a cyano group, and a halogen group, with the proviso that R₃₁ to R₃₄ are bonded to each other to form a ring,
Y is a carbon atom (C) or a nitrogen atom (N), and Z is a carbon atom (C), an oxygen atom (O), a sulfur atom (S), or a nitrogen atom (N), and
Ar₃₁ to Ar₃₃ are identical to or different from each other, and are each independently selected from a substituted or unsubstituted C5-C50 aryl group and a substituted or unsubstituted C3-C50 heteroaryl group, provided that when Z is an oxygen atom (O) or a sulfur atom (S), Ar₃₃ is nothing, provided that when Y and Z are nitrogen atoms (N), only one of Ar₃₁, Ar₃₂, and Ar₃₃ is present, provided that when Y is a nitrogen atom (N) and Z is a carbon atom (C), Ar₃₂ is nothing, with the proviso that one of R₃₁ to R₃₄ and Ar₃₁ to Ar₃₃ is a single bond linked to one of the linkers L₂₁ to L₂₄ in [Formula B]. 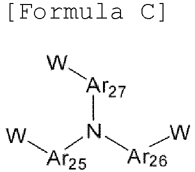
wherein
Ar₂₅ to Ar₂₇ are divalent linkers, are identical to or different from each other, and are each independently a single bond or are selected from a substituted or unsubstituted C6-C50 arylene group, a substituted or unsubstituted C2-C50 heteroarylene group, a substituted or unsubstituted C3-C30 cycloalkylene group, and a substituted or unsubstituted C3-C50 mixed aliphatic-aromatic ring group, and
W's are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C30 alkynyl group, a substituted or unsubstituted C3-C30 cycloalkyl group, a substituted or unsubstituted C3-C30 cycloalkenyl group, a substituted or unsubstituted C2-C50 heteroaryl group, a substituted or unsubstituted C2-30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a nitro group and a halogen group, wherein W's are identical to or different from each other, with the proviso that at least one of W's is represented by the following [Formula C-1]: 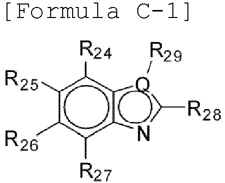
wherein R₂₄ to R₂₉ are identical to or different from each other, and are each independently linkers as binding sites to Ar₂₅ to Ar₂₇, or are selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C30 alkynyl group, a substituted or unsubstituted C3-C30 cycloalkyl group, a substituted or unsubstituted C3-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a cyano group, a nitro group and a halogen group, with the proviso that R₂₄ to R₂₇ are bonded to each other or each of R₂₄ to R₂₇ is bonded to an adjacent substituent to further form an alicyclic or aromatic monocyclic or polycyclic ring, at least one carbon atom of which is substituted with at least one heteroatom selected from nitrogen, oxygen, and sulfur, and
Q is N, O or S, provided that when Q is O or S, Q does not include R₂₉.

In addition, in the organic light-emitting device according to the present invention, the light-emitting layer includes a host and a dopant, each of the compounds represented by [Formula A-1] to [Formula A-6] is used as the host, and the dopant compound used for the light-emitting layer in the organic light-emitting device according to an embodiment is represented by the following [Formula D]: 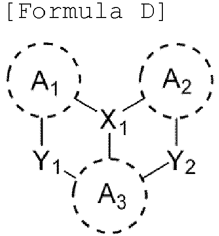 wherein
X₁ is selected from B, P=O and P=S,
Y₁ and Y₂ are each independently selected from NR₄₁, CR₄₂R₄₃, O, S*,* Se and SiR₄₄R₄₅,
A₁ to A₃ are each independently selected from a substituted or unsubstituted C6-C50 aromatic hydrocarbon ring, a substituted or unsubstituted C2-C50 heteroaromatic ring, a substituted or unsubstituted C3-C30 aliphatic ring, and a substituted or unsubstituted C3-C30 mixed aliphatic-aromatic ring, and
R₄₁ to R₄₅ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that each of R₄₁ to R₄₅ is bonded to each of the rings A₁ to A₃ to form an alicyclic or aromatic monocyclic or polycyclic ring, the substituents of the rings A₁ to A₃ are bonded to each other to form an alicyclic or aromatic monocyclic or polycyclic ring, and R₄₂ and R₄₃, and R₄₄ and R₄₅ are bonded to each other to further form an alicyclic or aromatic monocyclic or polycyclic ring, at least one carbon atom of which is substituted with at least one heteroatom selected from nitrogen, oxygen, and sulfur.

More specifically, the dopant compound represented by [Formula D] is represented by the following [Formula D-1] to [Formula D-8]: 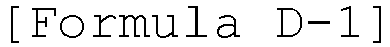 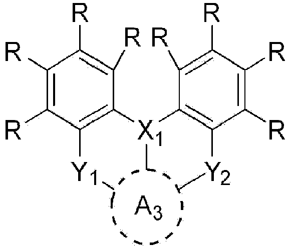 wherein
R's are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted a C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that R's are bonded to each other to further form an alicyclic or aromatic monocyclic or polycyclic ring, and the carbon atom of the formed alicyclic or aromatic ring may be substituted with at least one heteroatom selected from nitrogen, oxygen, and sulfur, and
X₁, Y₁, Y₂ and A₃ are as defined in [Formula D] above, 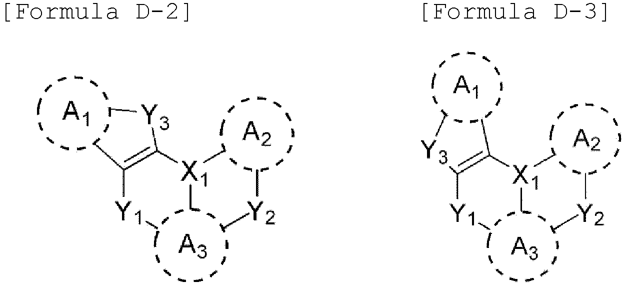
wherein
Y₃ is each independently selected from NR₄₁, CR₄₂R₄₃, O, S, Se, and SiR₄₄R₄₅, and
X₁, Y₁, Y₂, A₁ to A₃, and R₄₁ to R₄₅ are as defined in [Formula D] above, 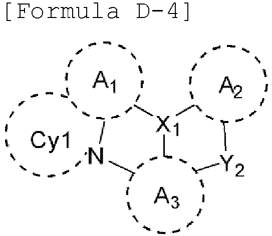
wherein
X₁, Y₂ and A₁ to A₃ are as defined in [Formula D] above, and
Cy1 is bonded to the adjacent nitrogen atom (N) and the aromatic carbon atom in the ring A₁ to be bonded to Cy1, to form a condensed ring including the nitrogen atom (N), the aromatic carbon atom in the ring A₁ to which the nitrogen atom (N) is bonded, and the aromatic carbon atom in the A₁ ring to be bonded to Cy1,
wherein a moiety of the ring formed by Cy1, excluding the nitrogen atom (N), the aromatic carbon atom in the ring A₁ to which the nitrogen atom (N) is bonded, and the aromatic carbon atom in the A₁ ring to be bonded to Cy1, is a substituted or unsubstituted C2-C5 alkylene group, 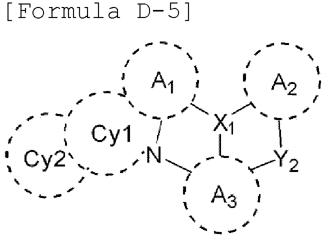
wherein
X₁, Y₂ and A₁ to A₃ are as defined in [Formula D] above,
Cy2 may be added to Cy1 to form a saturated hydrocarbon ring and a moiety of the ring formed by Cy2, excluding the carbon atom included in Cy1, is a substituted or unsubstituted C2-C5 alkylene group, 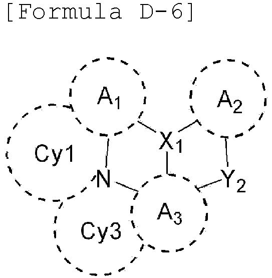
wherein
X₁, Y₂ and A₁ to A₃ are as defined in [Formula D] above, and
Cy3 is bonded to the carbon atom bonded to the nitrogen atom (N) in Cy1 and to the aromatic carbon atom in the ring A₃ to be bonded to Cy3, to form a condensed ring including the aromatic carbon atom in the A₃ ring to be bonded to Cy3, the nitrogen atom (N), and the carbon atom in Cy1 to which the nitrogen atom (N) is bonded,
wherein a moiety of the ring formed by Cy3, excluding the aromatic carbon atom in the A₃ ring to be bonded to Cy3, the nitrogen atom (N), and the carbon atom in Cy1 to which the nitrogen atom (N) is bonded, is a substituted or unsubstituted C1-C4 alkylene group, 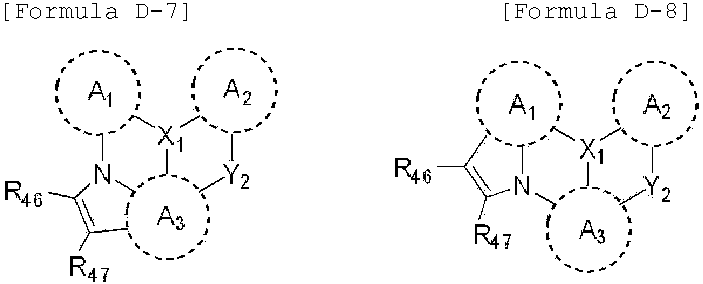
wherein
R₄₆ and R₄₇ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that R₄₆ and R₄₇ are bonded to each other to further form an alicyclic or aromatic monocyclic or polycyclic ring and a mixed aliphatic-aromatic ring, at least one carbon atom of which is substituted with at least one heteroatom selected from nitrogen, oxygen, and sulfur, and
X₁, Y₂ and A₁ to A₃ are as defined in [Formula D] above.

In addition, the light-emitting layer may include a combination or stack of one of the host compounds represented by [Formula A-1] to [Formula A-6] and at least one additional host compound, and the dopant in the light-emitting layer may include a combination or stack of two or more dopants.

In addition, as used in [Formula A-1] to [Formula A-6], [Formula B], [Formula C], [Formula C-1], [Formula D], [Formula D-1] to [Formula D-8] and [Formula E] according to the present invention, the term "substituted" indicates substitution of various substituents defined in each of the formulas with one or more substituents selected from deuterium, a cyano group, a halogen group, a hydroxyl group, a nitro group, an alkyl group, a halogenated alkyl group, a cycloalkyl group, an alkenyl group, an alkynyl group, a heteroalkyl group, an aryl group, an arylalkyl group, an alkylaryl group, a heteroaryl group, a heteroarylalkyl group, an alkoxy group, an amine group, a silyl group, an aryloxy group and a mixed aliphatic-aromatic ring group, or substitution with a substituent including two or more of the substituents linked to each other. The term "unsubstituted" in the same definition indicates having no substituent.

In addition, the range of the number of the carbon atoms of the alkyl group or aryl group in the term "substituted or unsubstituted C1-C30 alkyl group", "substituted or unsubstituted C6-C50 aryl group" or the like refers to the total number of carbon atoms constituting the alkyl or aryl moiety when the corresponding group is not substituted without considering the number of carbon atoms in the substituent(s). For example, a phenyl group substituted at the para position with a butyl group corresponds to an aryl group having 6 carbon atoms substituted with a butyl group having 4 carbon atoms.

In addition, as used herein, the expression "a substituent is bonded to an adjacent substituent to form a ring" means that the corresponding substituent is bonded to the adjacent substituent to form a substituted or unsubstituted alicyclic or aromatic ring, and the term "adjacent substituent" may mean a substituent substituted for an atom which is directly attached to an atom substituted with the corresponding substituent, a substituent sterically disposed at the nearest position to the corresponding substituent, or another substituent substituted for an atom which is substituted with the corresponding substituent. For example, two substituents substituted at the ortho position in a benzene ring and two substituents substituted at the same carbon in the aliphatic ring may be considered "adjacent" to each other.

As used herein, the alkyl group may be a linear or branched alkyl group. Examples of the alkyl group include, but are not limited to, a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethylbutyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethylpropyl group, an isohexyl group, a 2-methylpentyl group, a 4-methylhexyl group, a 5-methylhexyl group, and the like.

As used herein, the alkenyl group may include a linear or branched alkenyl group and may be further substituted with another substituent. Specifically, examples of the alkenyl group include, but are not limited to, a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like.

As used herein, the alkynyl group may also include a linear or branched alkynyl group, and may be further substituted with another substituent, and examples of the substituent may include, but are not limited to, ethynyl, 2-propynyl, and the like.

As used herein, the aromatic hydrocarbon ring or the aryl group may be monocyclic or polycyclic, examples of the monocyclic aryl group include a phenyl group, a biphenyl group, a terphenyl group, a stilbene group, and the like, and examples of the polycyclic aryl group include, but are not limited to, a naphthyl group, an anthracenyl group, a phenanthrenyl group, a pyrenyl group, a perylenyl group, a tetracenyl group, a chrysenyl group, a fluorenyl group, an acenaphthcenyl group, a triphenylene group, a fluoranthene group, and the like, but the scope of the present invention is not limited thereto.

As used herein, the aromatic heterocyclic or heteroaryl group is an aromatic ring containing at least one heteroatom and examples thereof include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups and the like.

As used herein, the aliphatic hydrocarbon ring refers to a non-aromatic ring that contains only carbon and hydrogen atoms, for example, includes a monocyclic or polycyclic ring, and may be further substituted with another substituent. The term "polycyclic" means that the polycyclic group may be directly attached to or fused with at least one other cyclic group, the other cyclic group may be an aliphatic hydrocarbon ring, or a different type of ring group, for example, an aliphatic heterocyclic group, an aryl group, a heteroaryl group, and the like. Specifically, examples thereof include, but are not limited to, cycloalkyls such as a cyclopropyl group, a cyclobutyl group, a cyclopentyl group, an adamantyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, and a cyclooctyl group, cycloalkanes such as cyclohexane and cyclopentane, and cycloalkenes such as cyclohexene and cyclobutene.

As used herein, the aliphatic heterocyclic ring refers to an aliphatic ring that contains at least one of heteroatoms such as O, S, Se, N and Si, also includes a monocyclic or polycyclic ring, and may be further substituted with another substituent. The term "polycyclic" means that the polycyclic group may be directly attached to or fused with at least one other cyclic group, and the other cyclic group may be an aliphatic hydrocarbon ring, or a different type of ring group, for example, an aliphatic heterocyclic group, an aryl group, a heteroaryl group, or the like.

As used herein, the mixed aliphatic-aromatic ring group refers to a ring in which two or more rings are attached to and fused with each other, and aliphatic and aromatic rings are fused together to be overall non-aromatic, and a polycyclic mixed aliphatic-aromatic ring may contain a heteroatom selected from N, O, P and S, in addition to C.

As used herein, specifically, the alkoxy group may be methoxy, ethoxy, propoxy, isobutyloxy, sec-butyloxy, pentyloxy, iso-amyloxy, hexyloxy, or the like, but is not limited thereto.

As used herein, the silyl group is represented by -SiH₃, and may be an alkylsilyl group, an arylsilyl group, an alkylarylsilyl group, an arylheteroarylsilyl group, or the like, and specific examples of the silyl group include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl, and the like.

As used herein, the amine group is represented by -NH₂, or may be an alkylamine group, an arylamine group, an arylheteroarylamine group, or the like. The arylamine group refers to amine substituted with aryl, the alkylamine group refers to amine substituted with alkyl, and the arylheteroarylamine group refers to an amine substituted with aryl and heteroaryl. For example, the arylamine group includes a substituted or unsubstituted monoarylamine group, a substituted or unsubstituted diarylamine group, or a substituted or unsubstituted triarylamine group. The aryl group and the heteroaryl group in the arylamine group and the arylheteroarylamine group may be a monocyclic aryl group or a monocyclic heteroaryl group, or a polycyclic aryl group or a polycyclic heteroaryl group. The arylamine group and the arylheteroarylamine group that contain two or more aryl groups and two or more heteroaryl groups, respectively, include a monocyclic aryl group (heteroaryl group), a polycyclic aryl group (heteroaryl group), or both of the monocyclic aryl group (heteroaryl group) and the polycyclic aryl group (heteroaryl group). In addition, the aryl group and the heteroaryl group in the arylamine group and the arylheteroarylamine group may be selected from examples of aryl groups and heteroaryl groups described above.

As used herein, examples of the aryl group in the aryloxy group and the arylthioxy group are the same as examples of the aryl group described above and specifically, examples of the aryloxy group include a phenoxy group, a p-tolyloxy group, an m-tolyloxy group, a 3,5-dimethylphenoxy group, a 2,4, 6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group, and the like, and examples of the arylthioxy group include, but are not limited to, a phenylthioxy group, a 2-methylphenylthioxy group, a 4-tert-butylphenylthioxy group, and the like.

In the present invention, examples of the halogen group include fluorine, chlorine, bromine, and iodine.

The compounds represented by [Formula A-1] to [Formula A-6] contained in the light-emitting layer in the organic light-emitting device according to the present invention are selected from compounds represented by the following [A-1] to [A-218], but are not limited thereto.

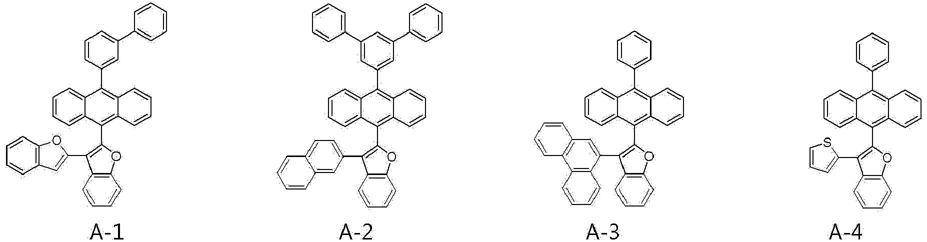

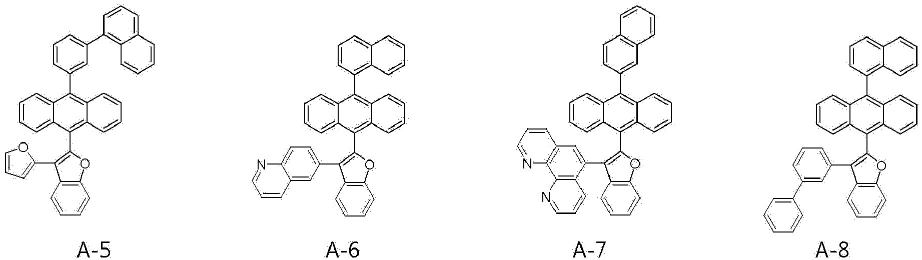

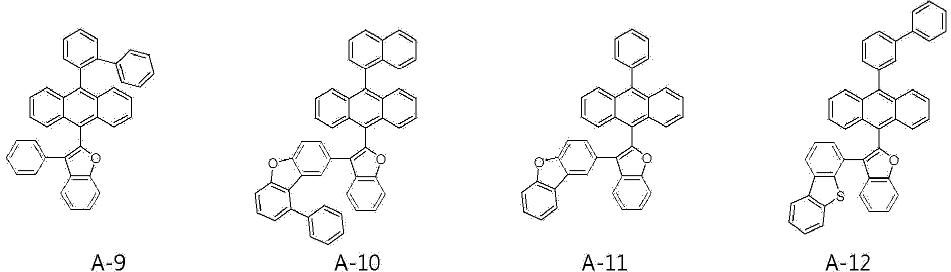

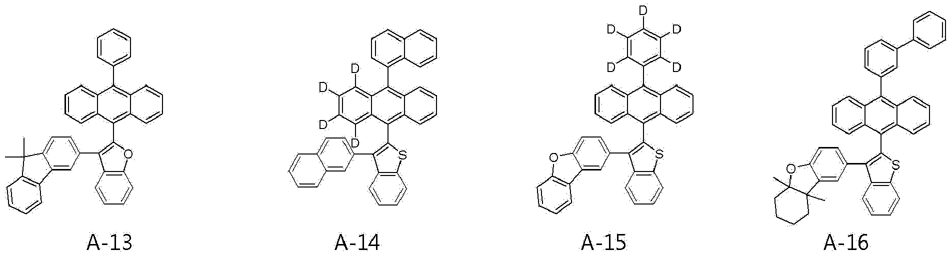

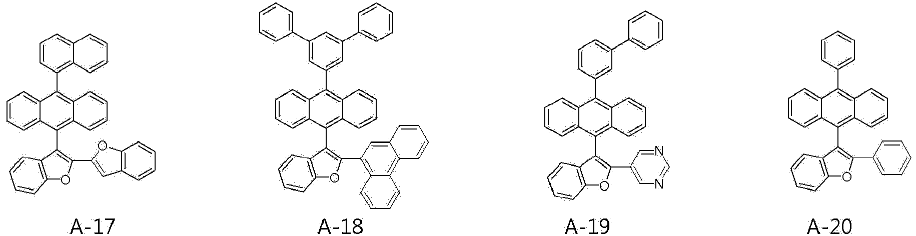

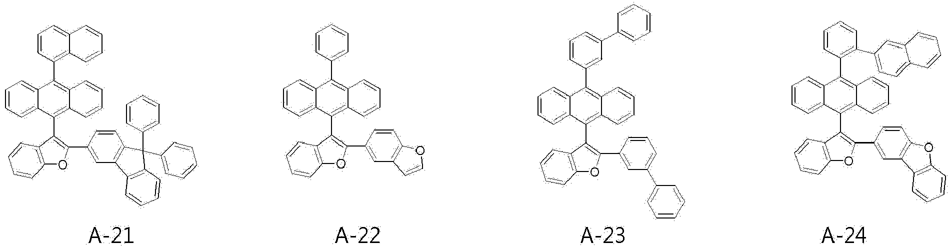

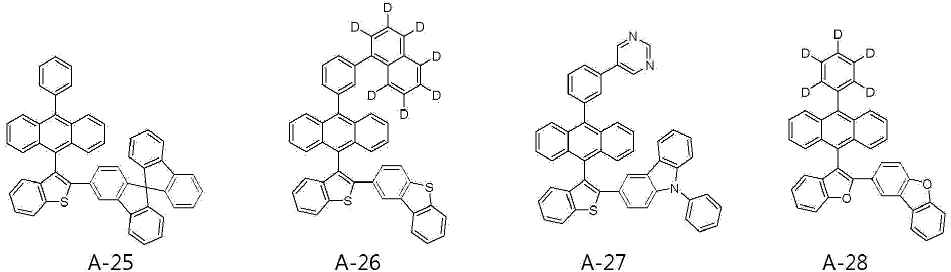

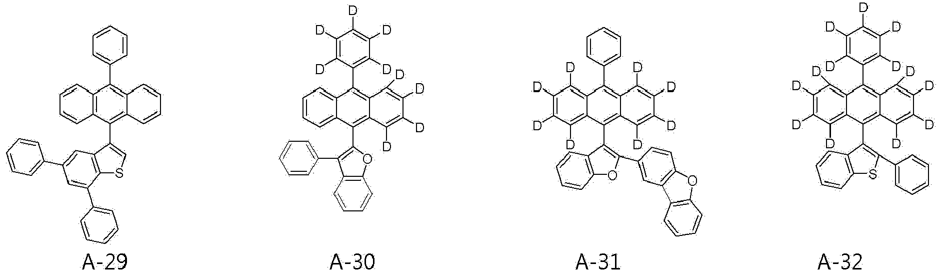

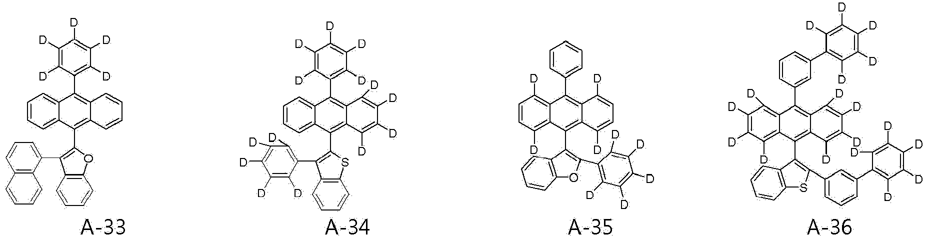

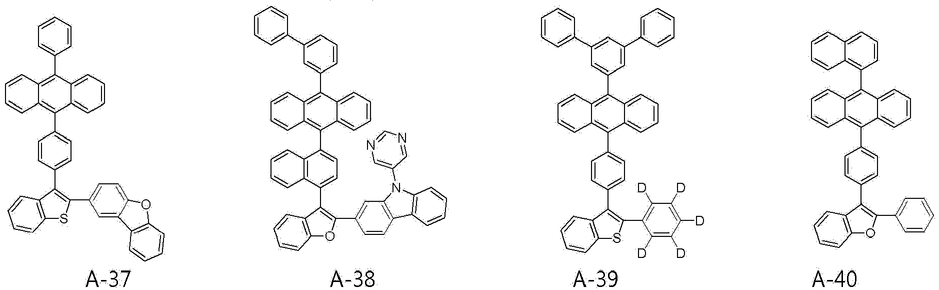

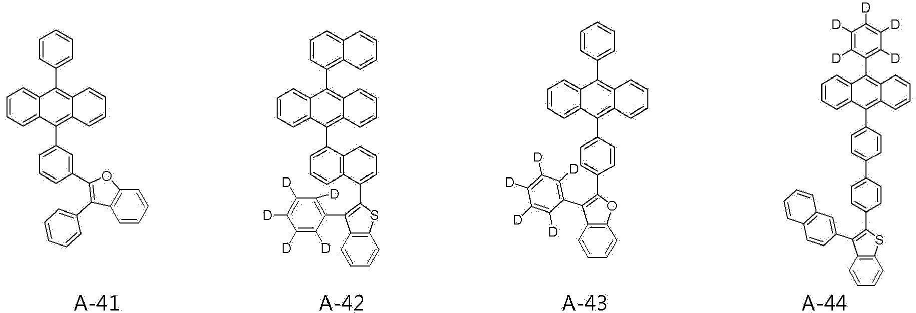

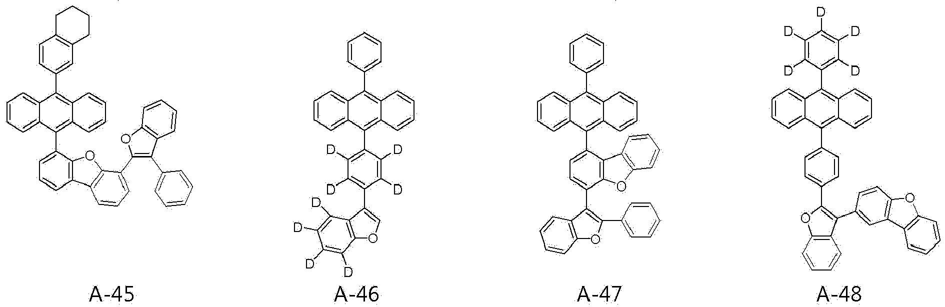

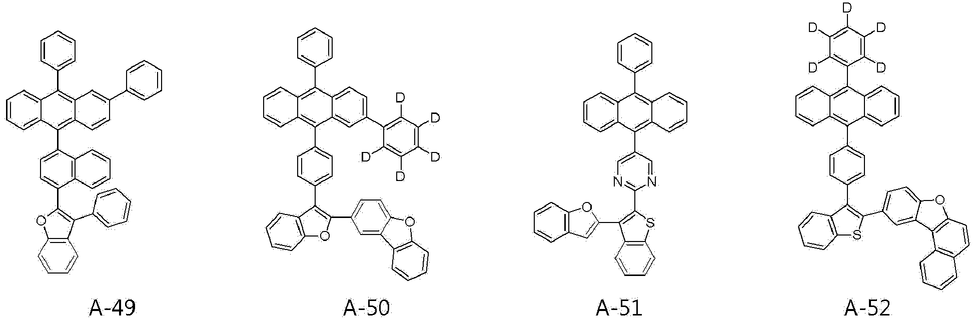

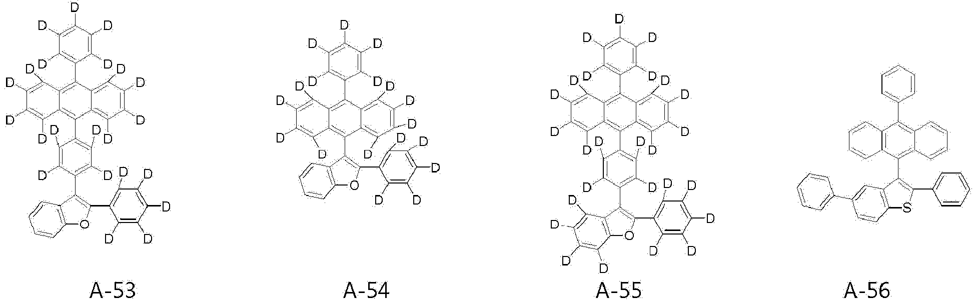

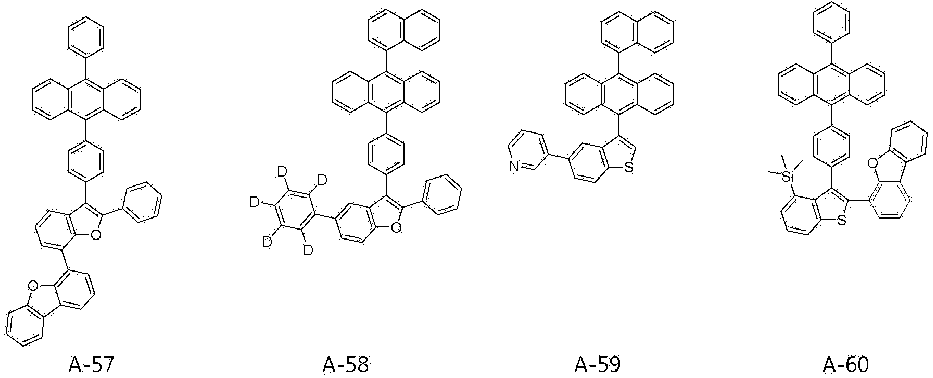

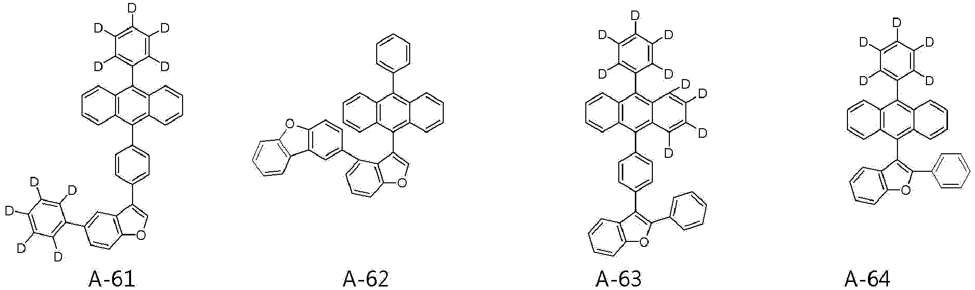

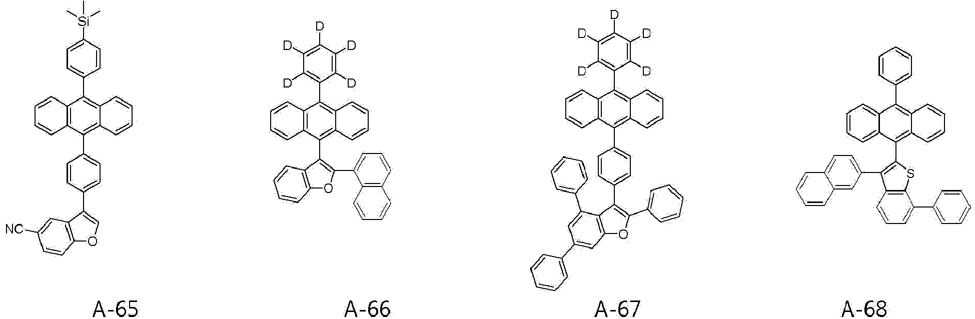

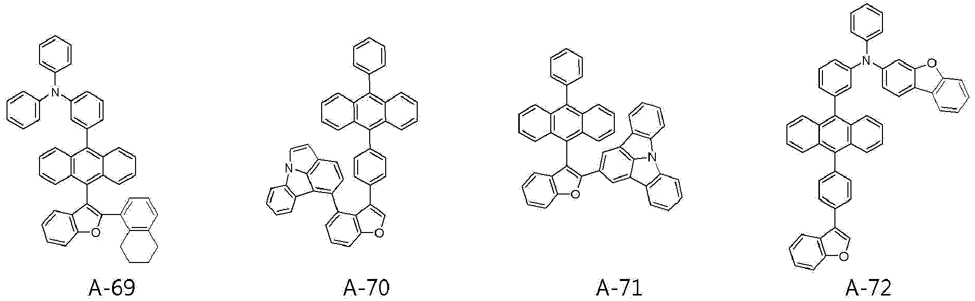

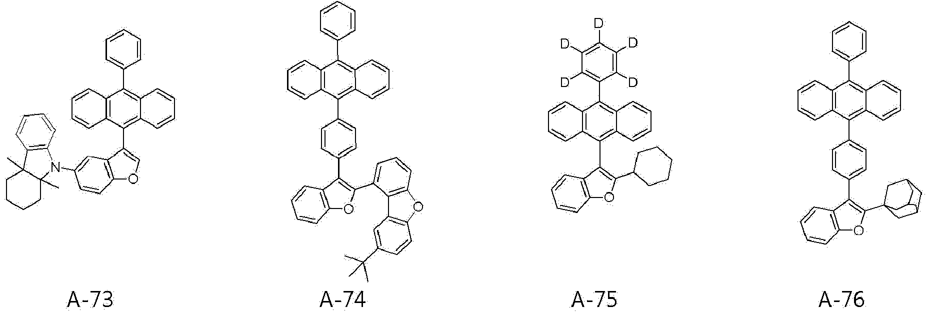

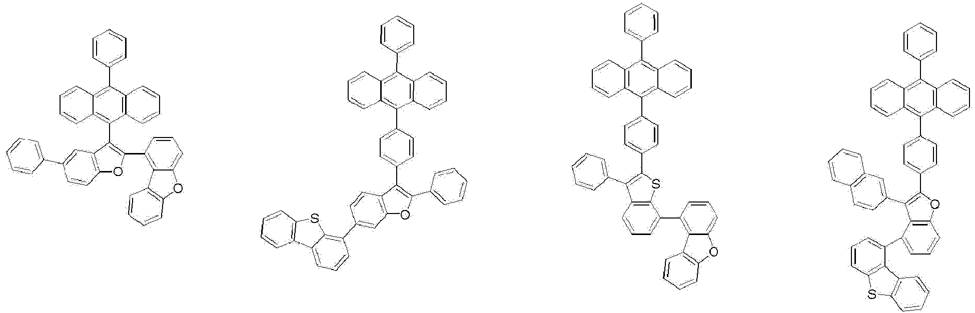

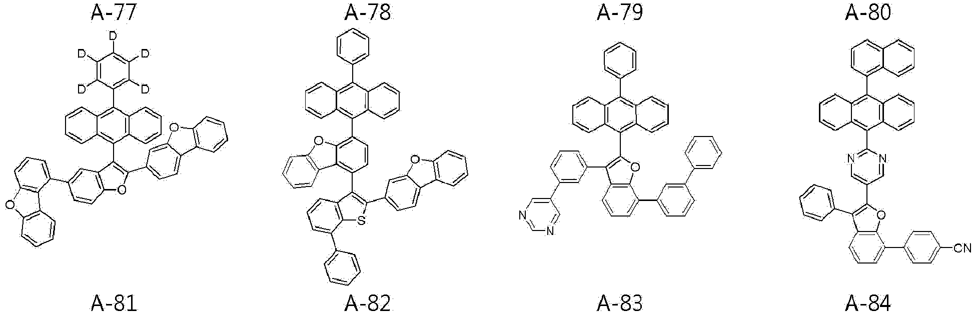

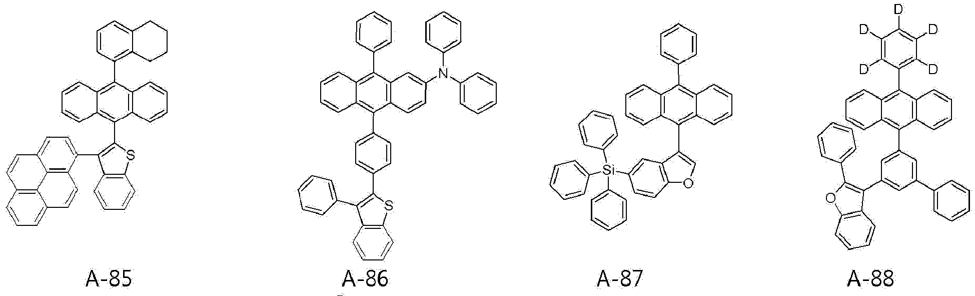

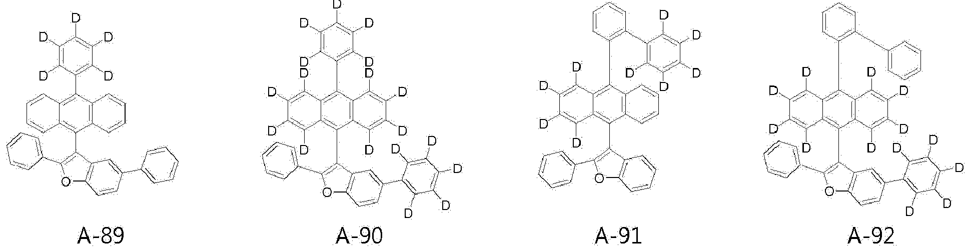

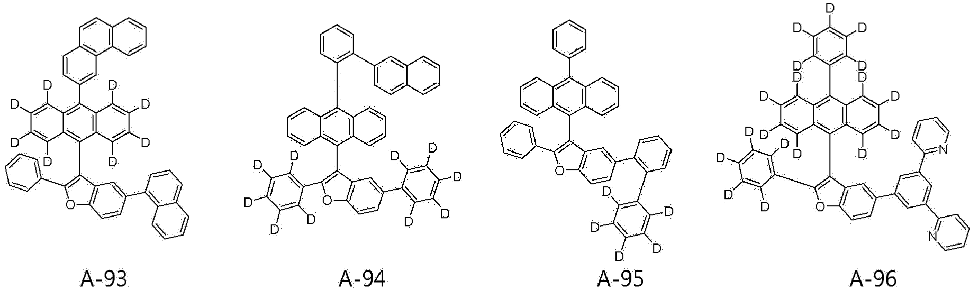

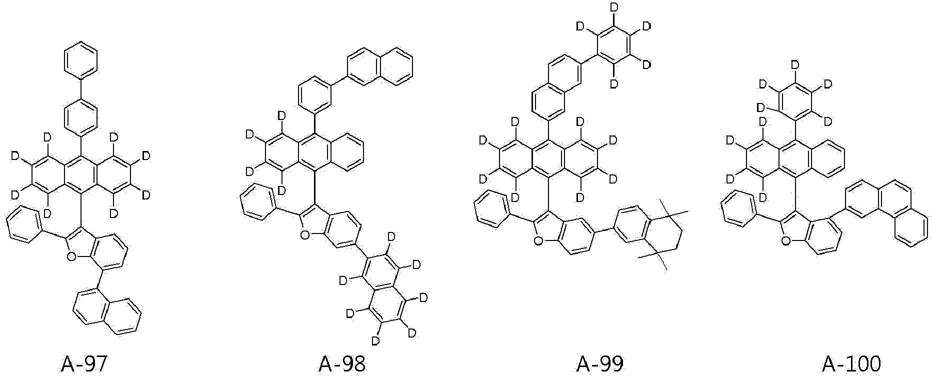

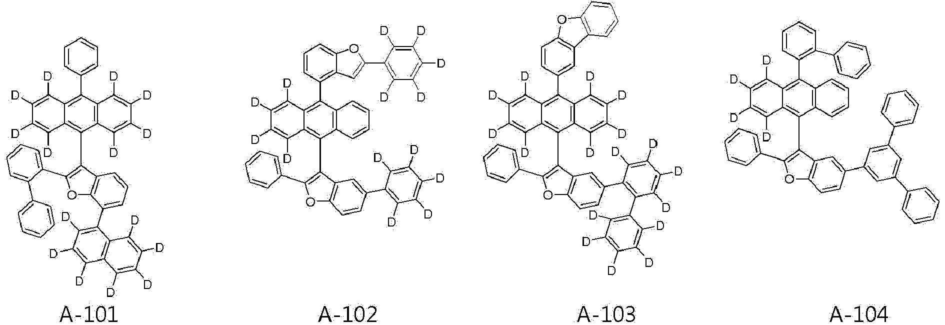

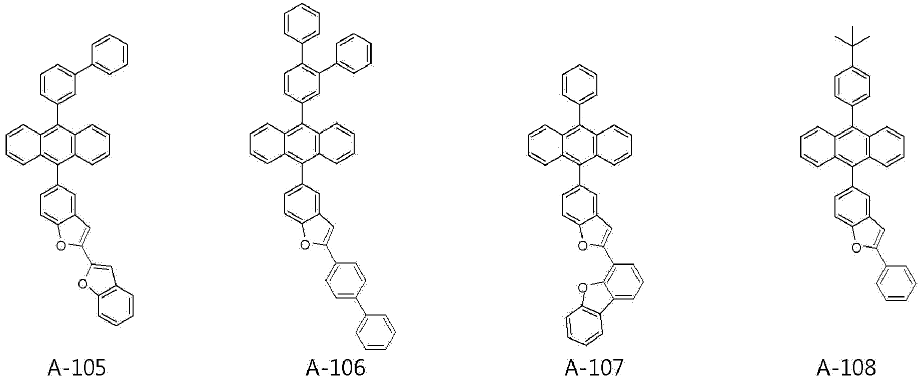

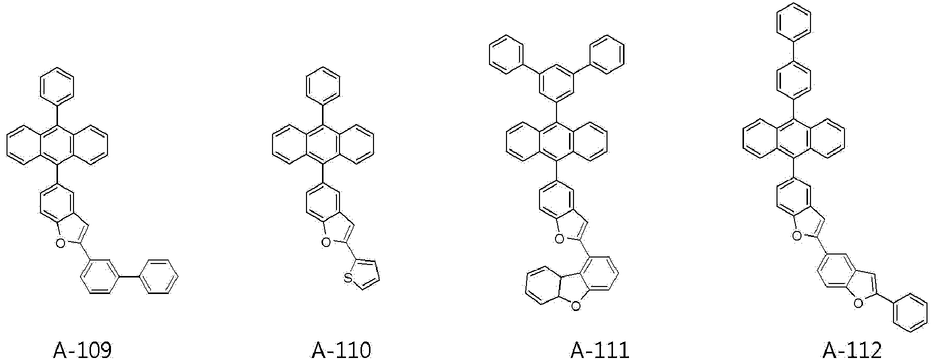

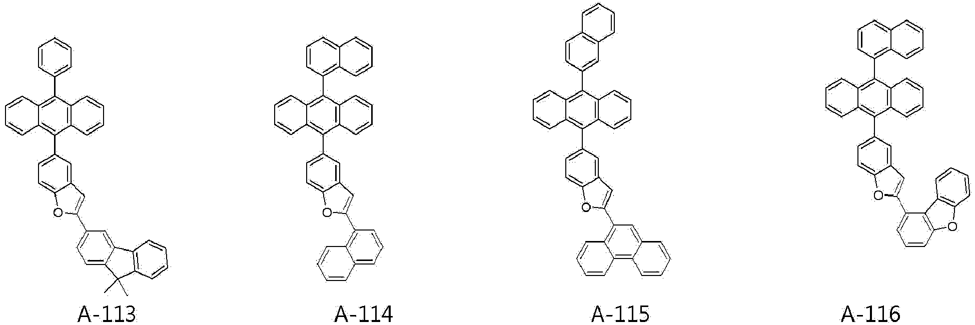

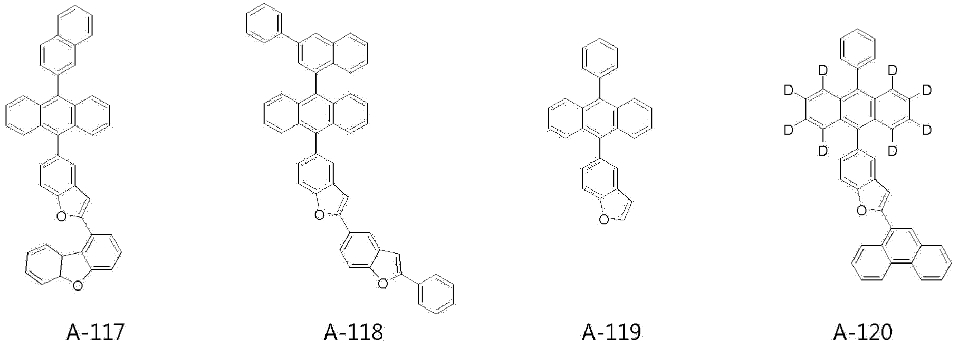

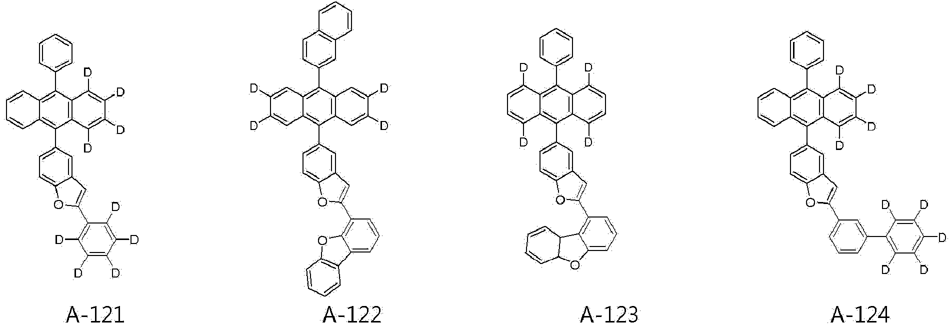

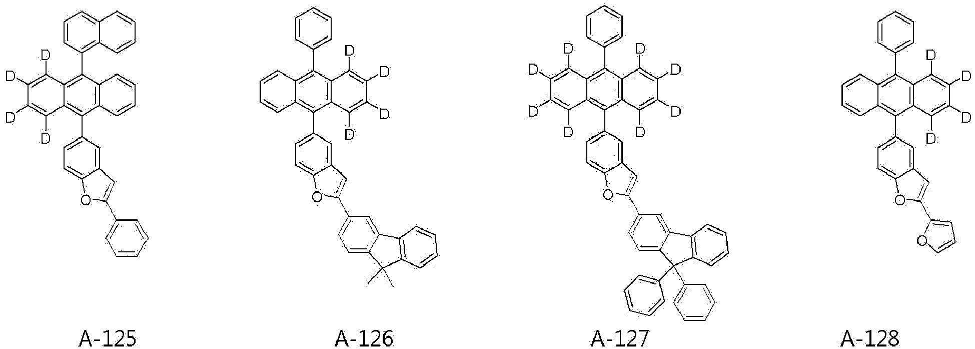

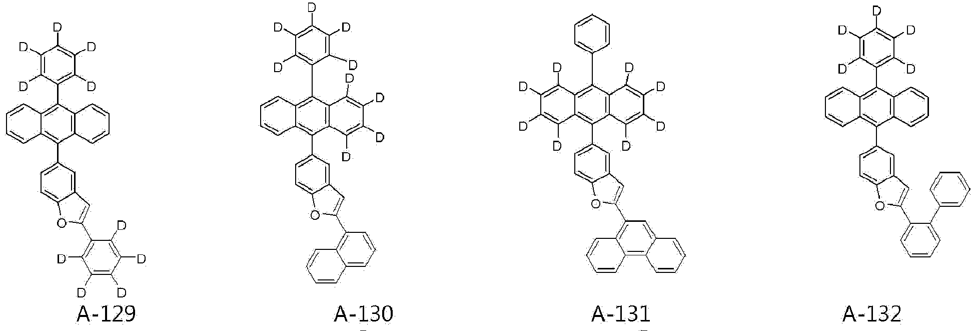

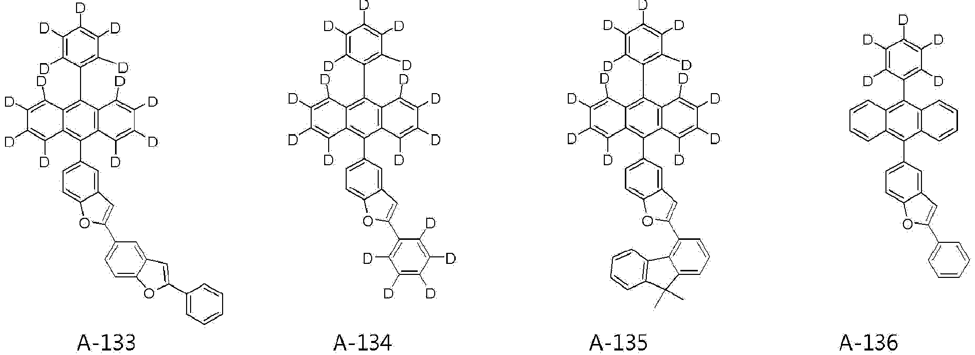

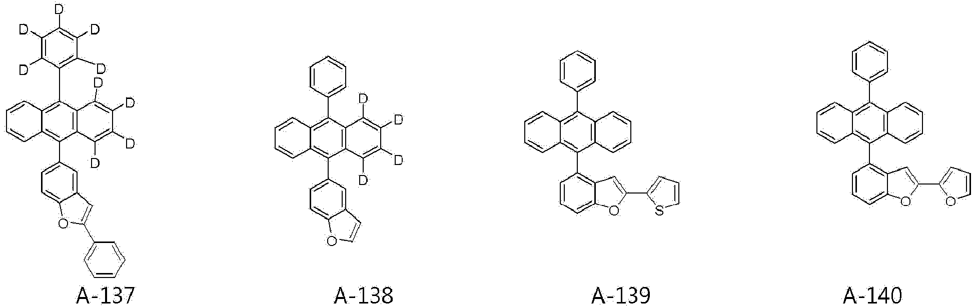

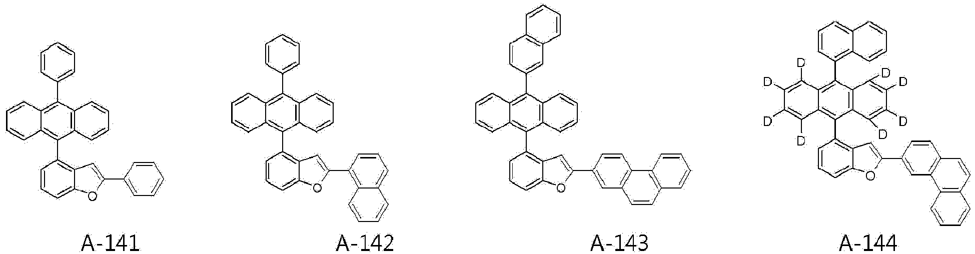

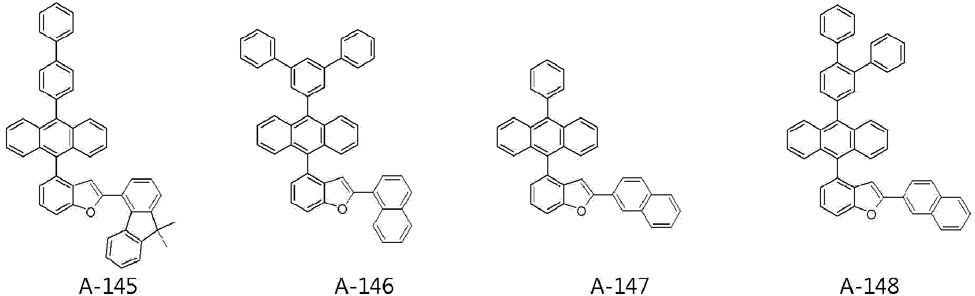

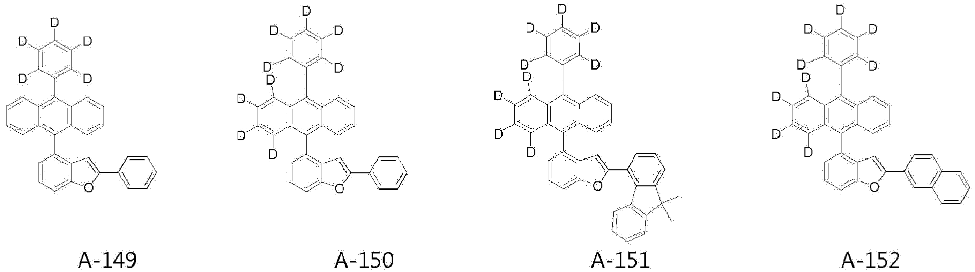

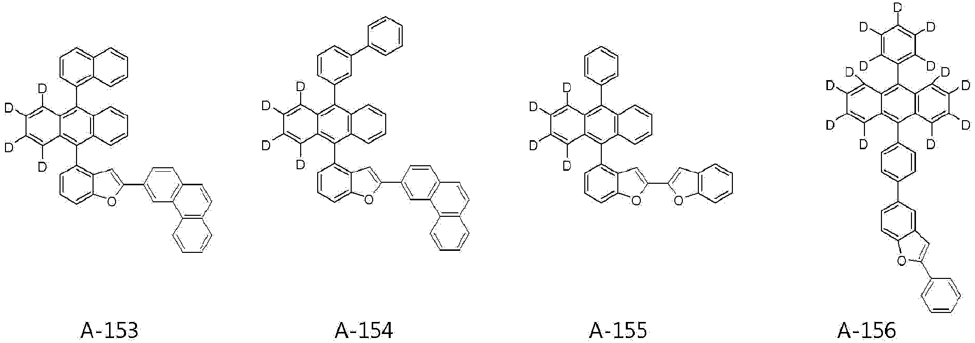

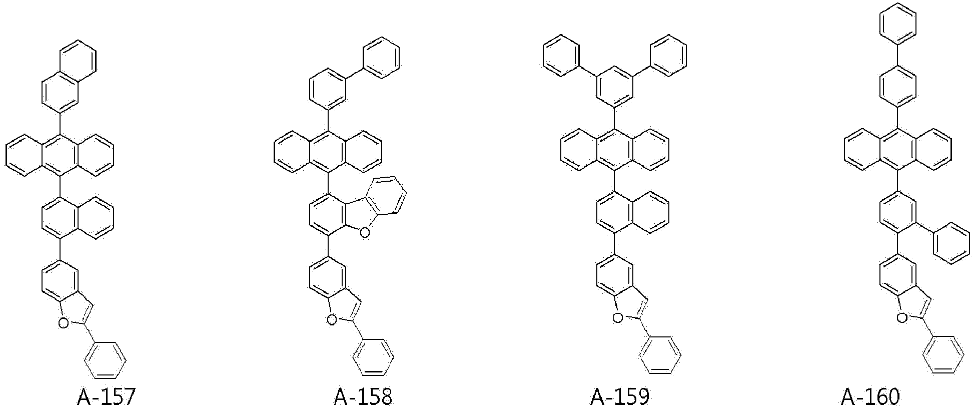

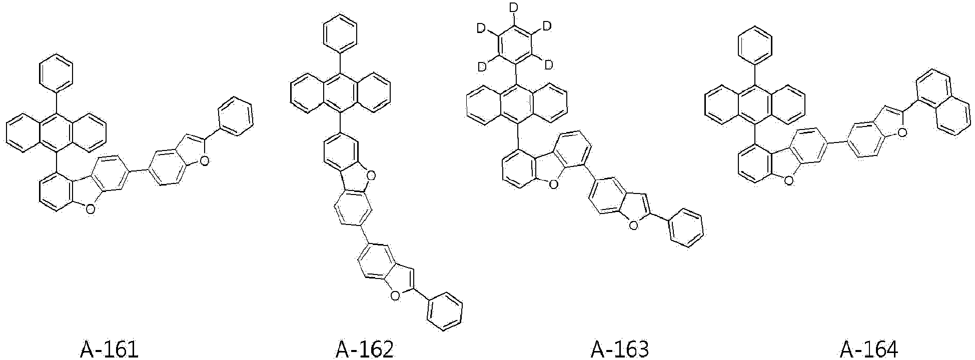

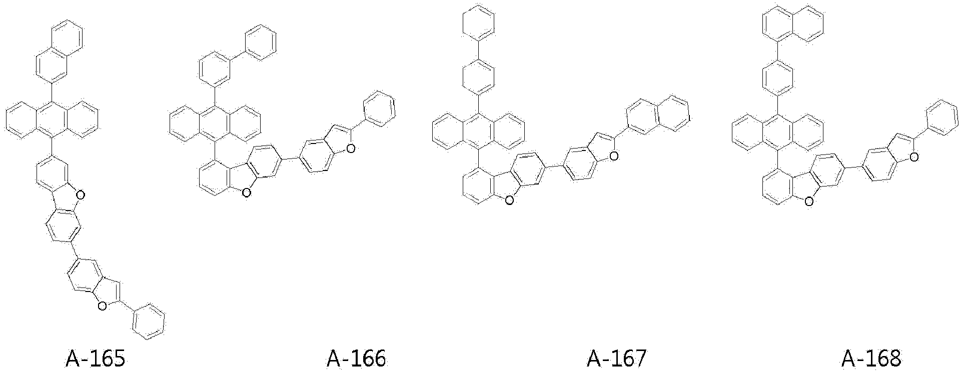

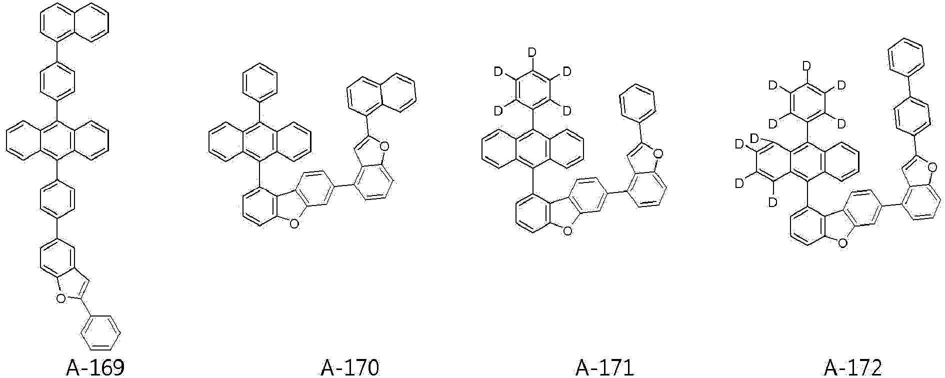

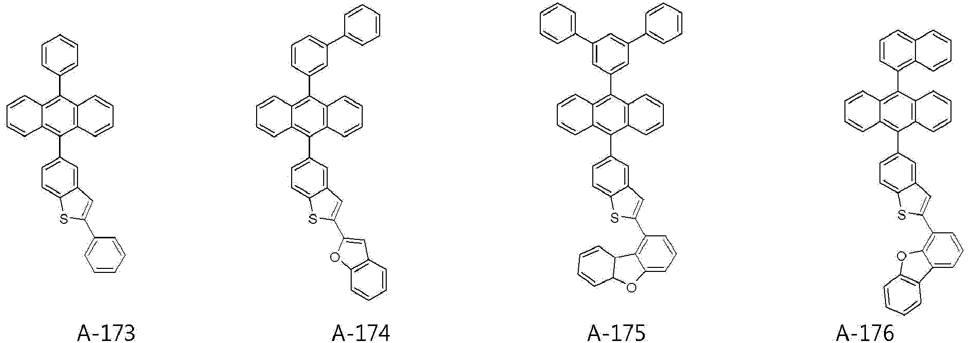

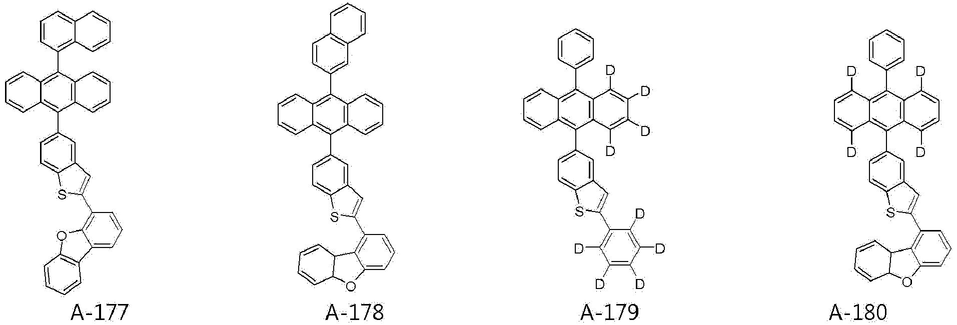

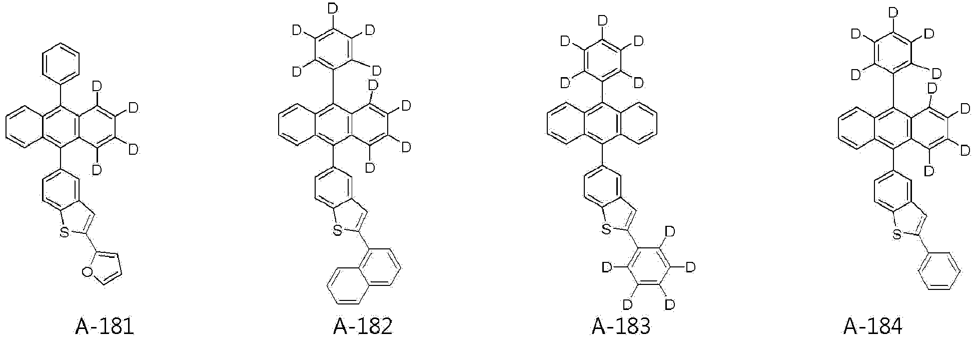

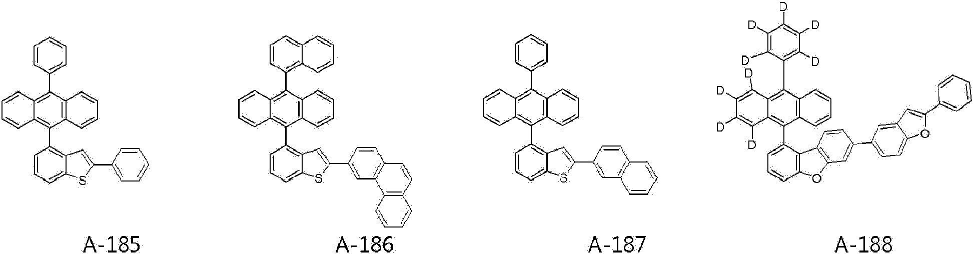

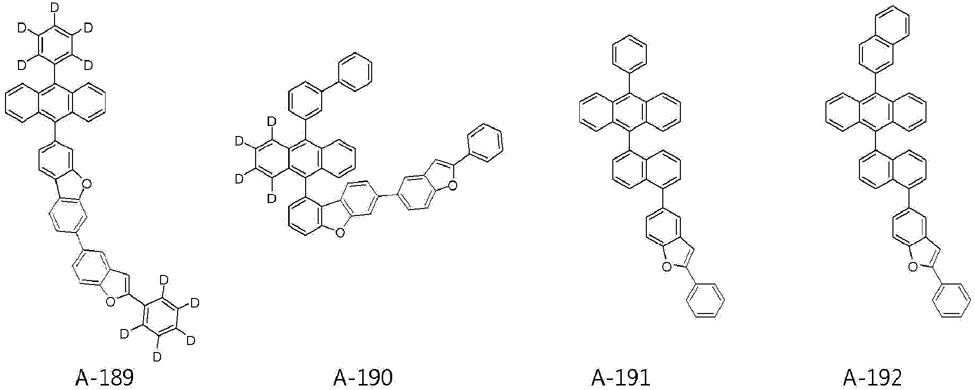

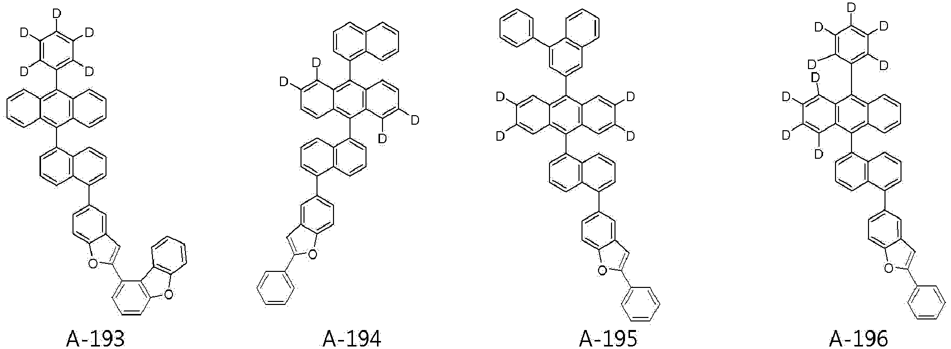

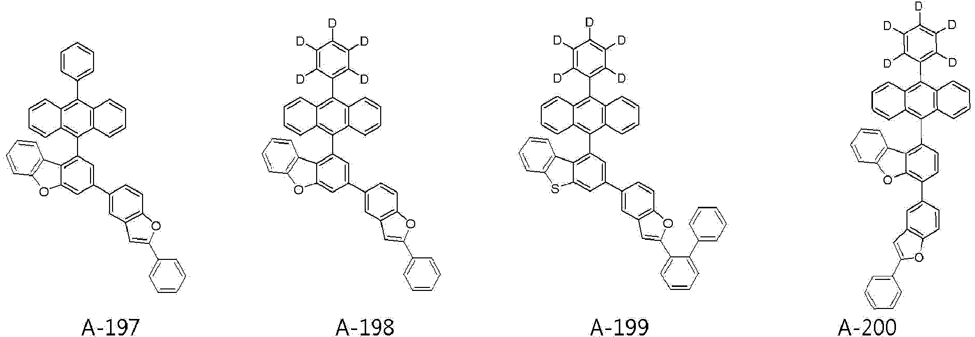

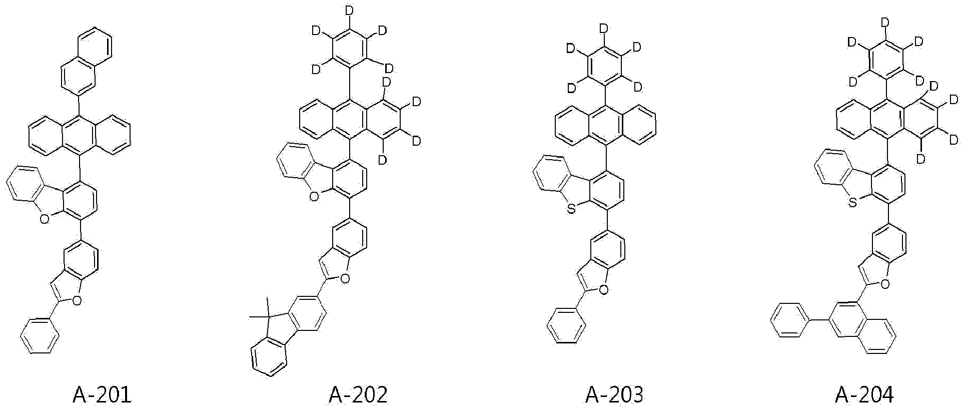

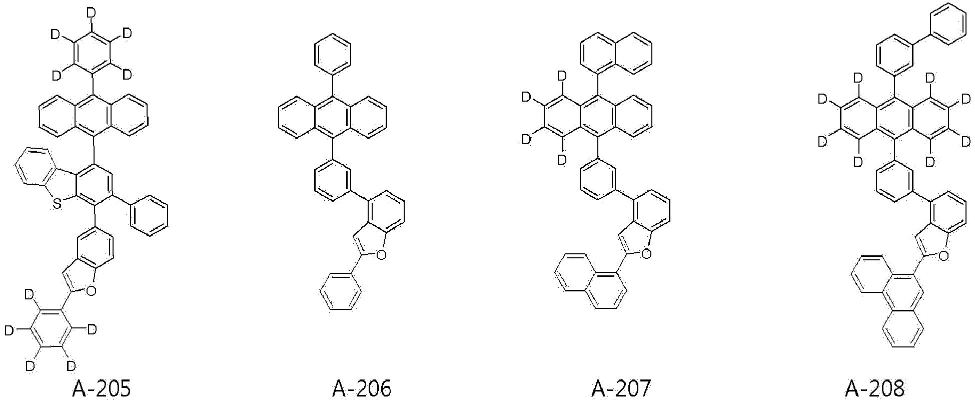

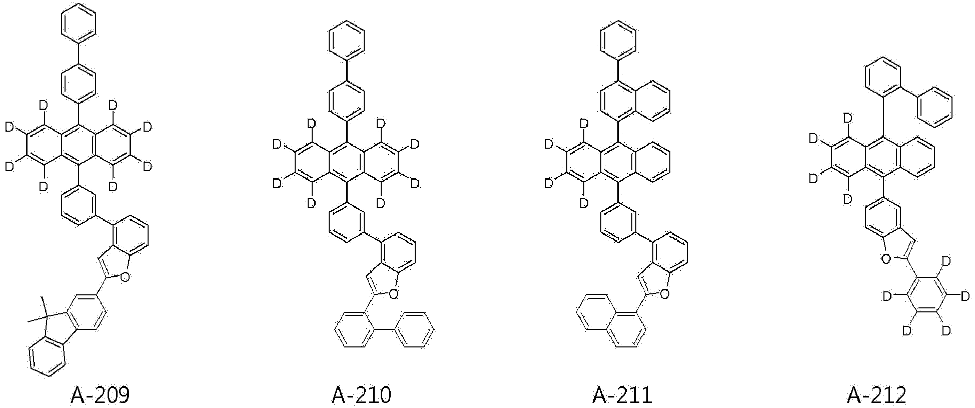

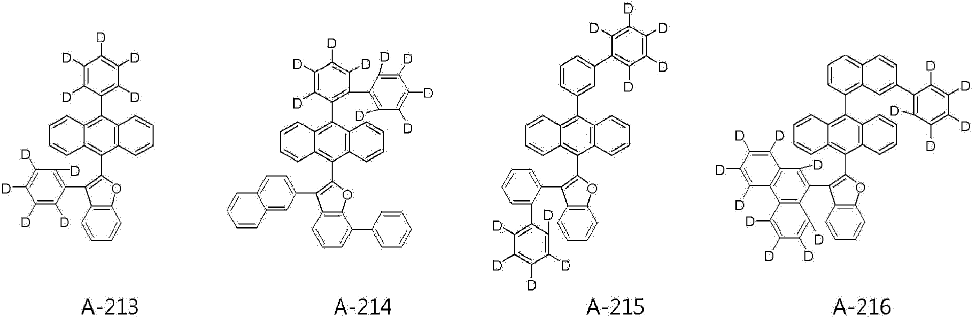

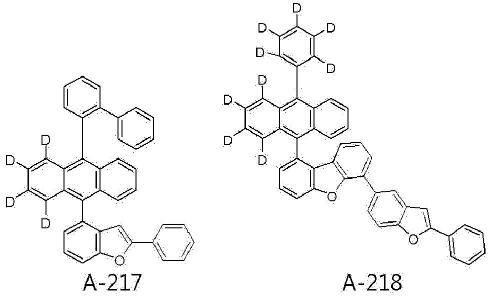

The organic light-emitting device according to the present invention further includes a capping layer, and the compound represented by [Formula B] contained in the capping layer is selected from compounds represented by the following [B-1] to [B-79], or is selected from compounds represented by the following [B-101] to [B-148]. In addition, the compound represented by [Formula C] may be selected from compounds represented by the following [C-1] to [C-99], but is not limited thereto.

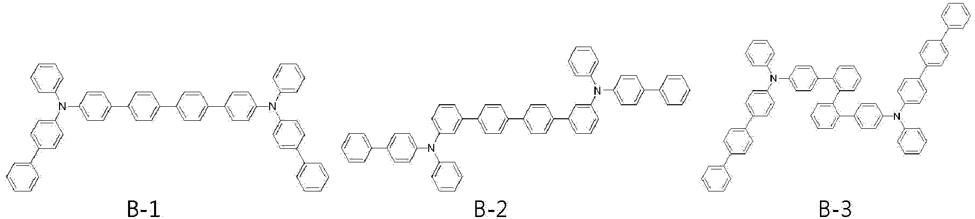

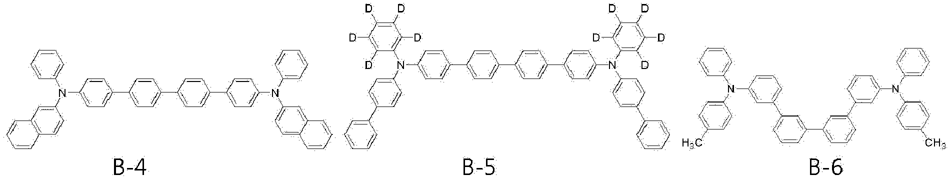

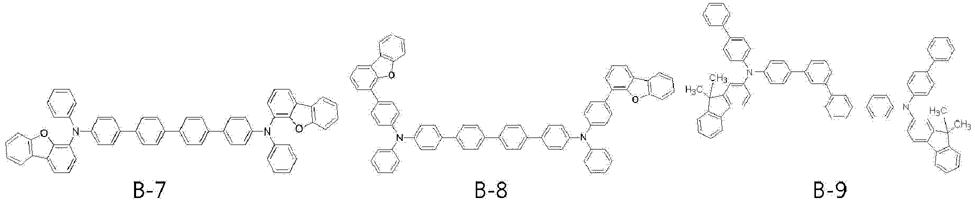

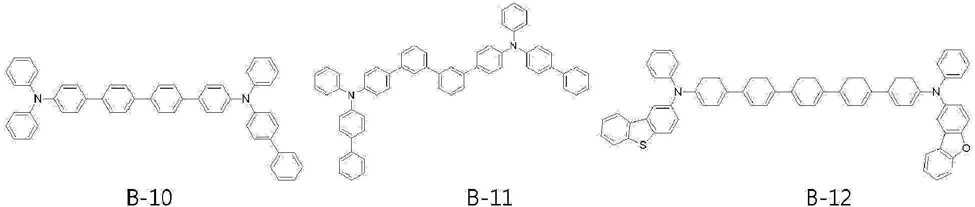

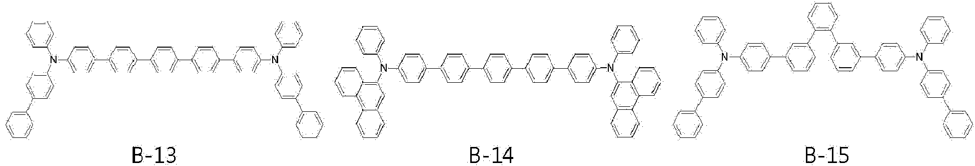

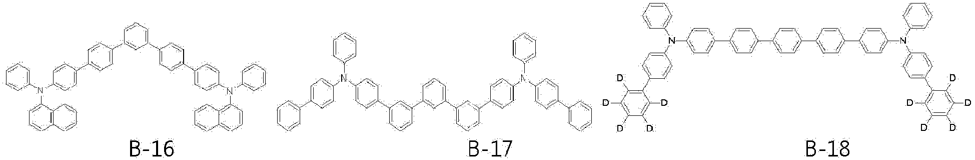

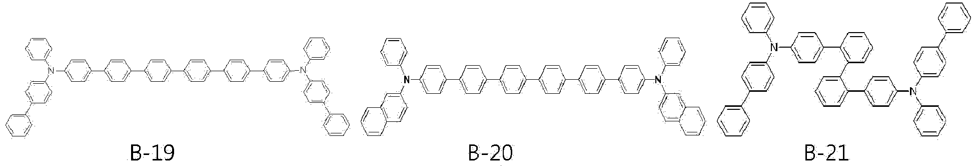

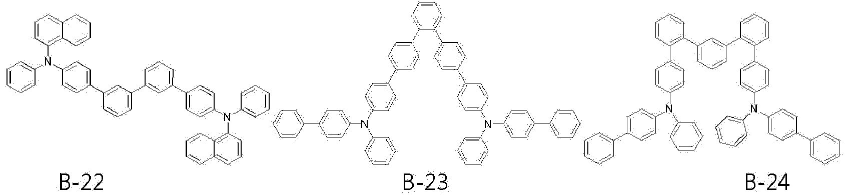

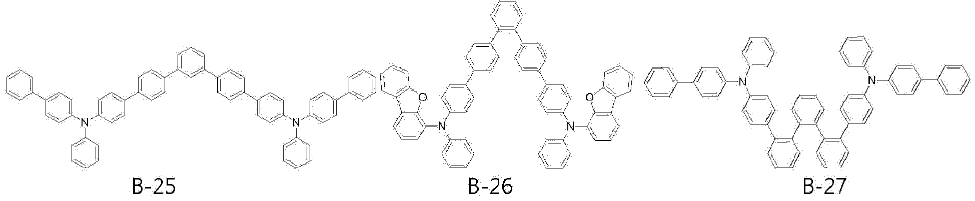

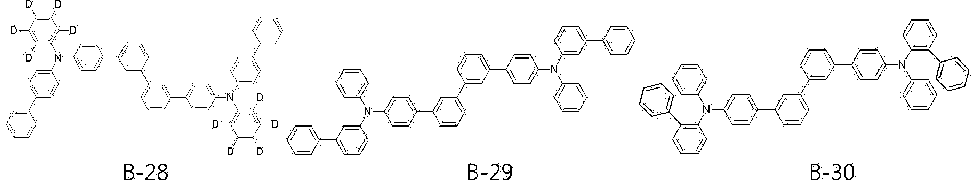

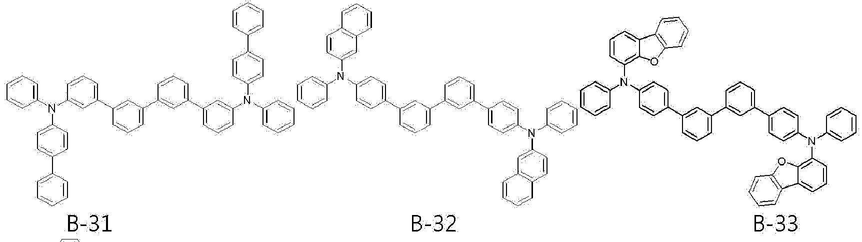

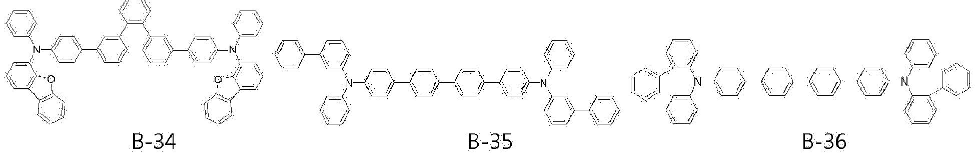

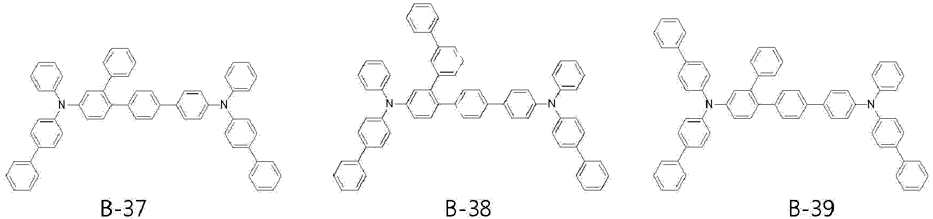

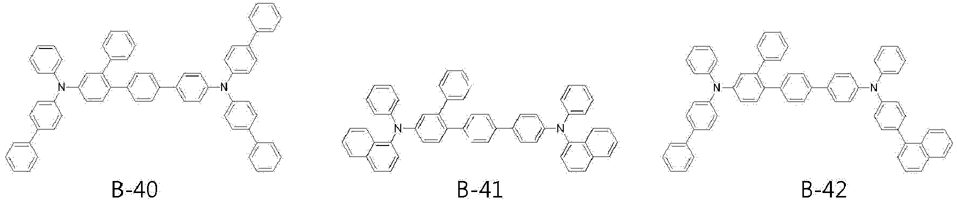

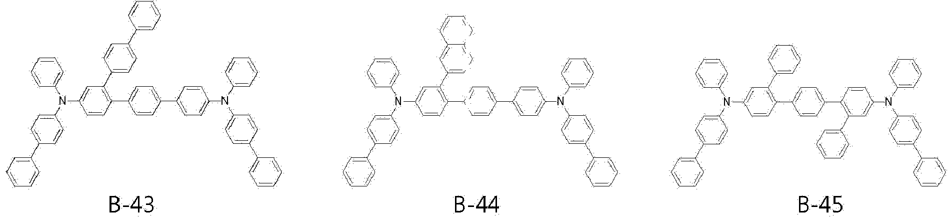

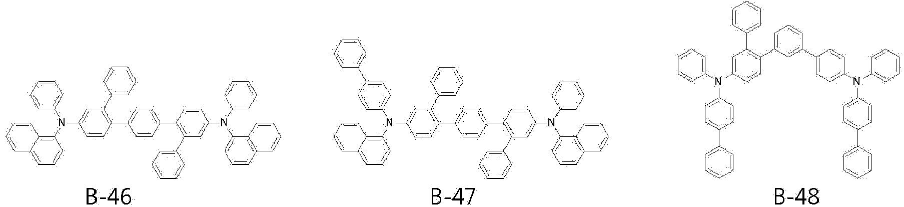

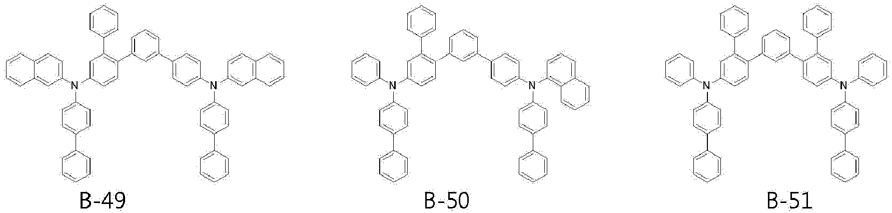

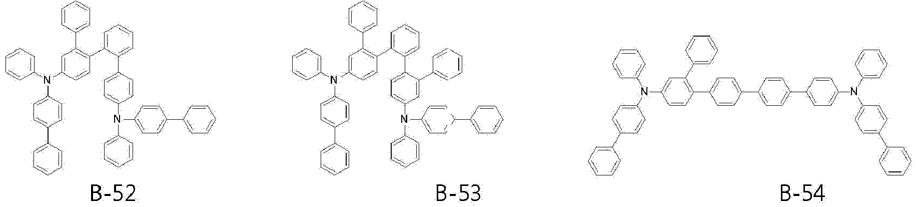

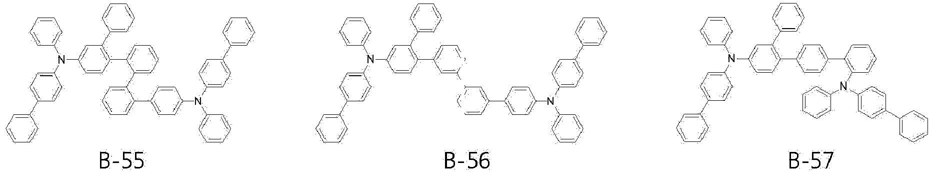

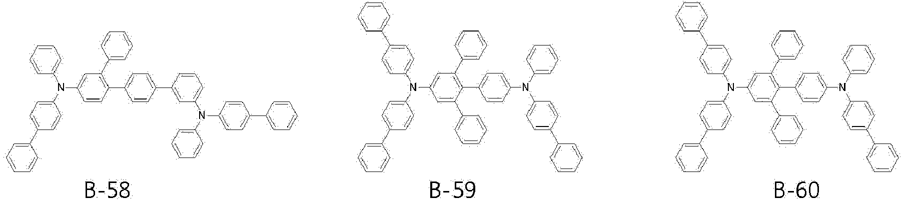

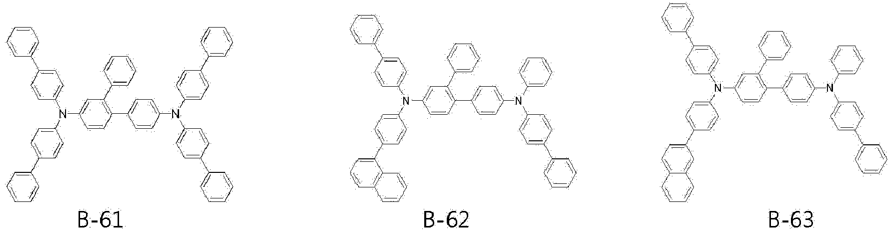

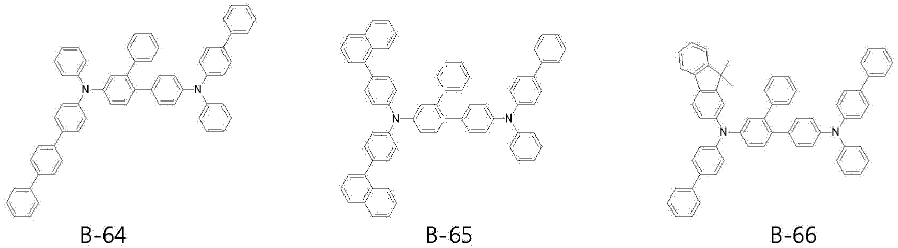

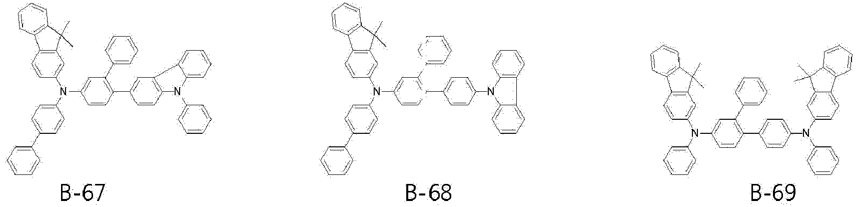

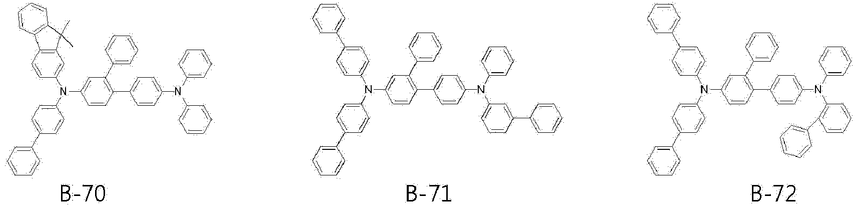

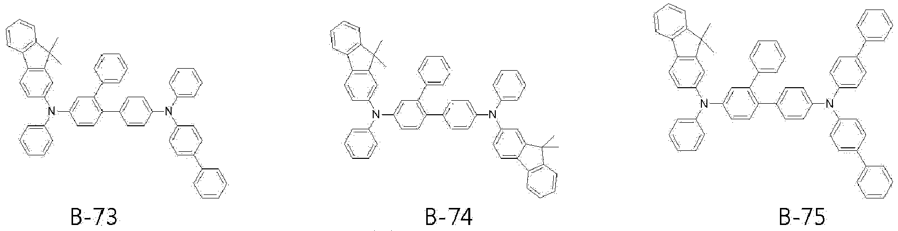

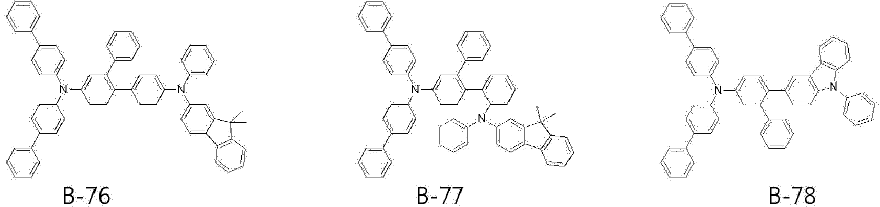

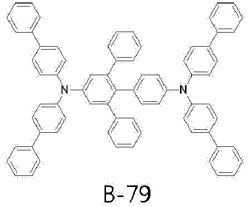

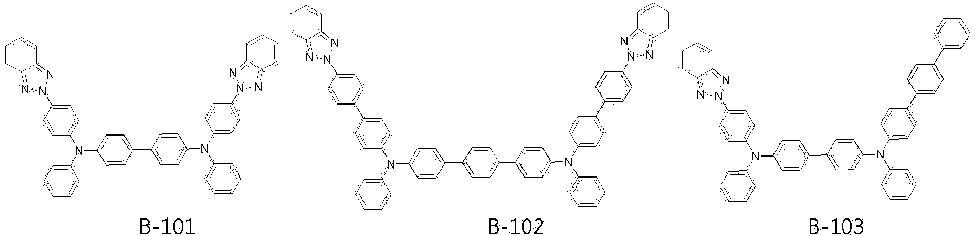

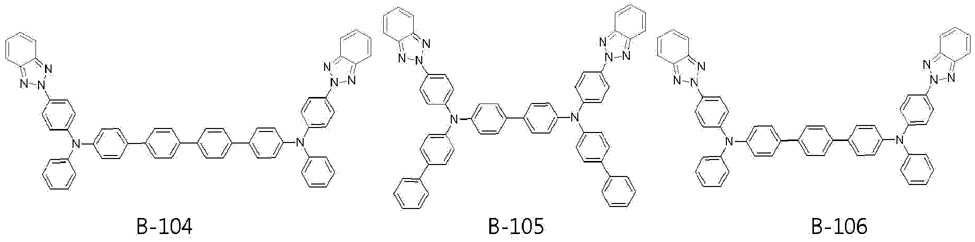

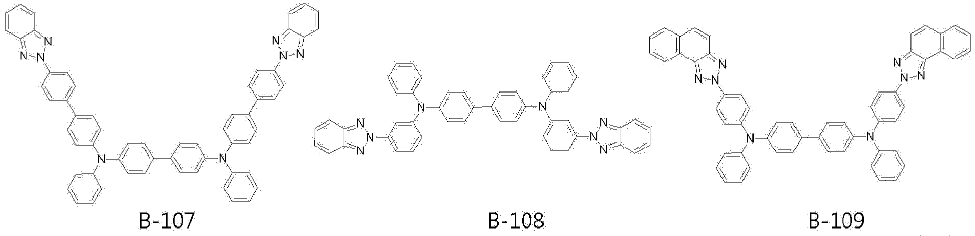

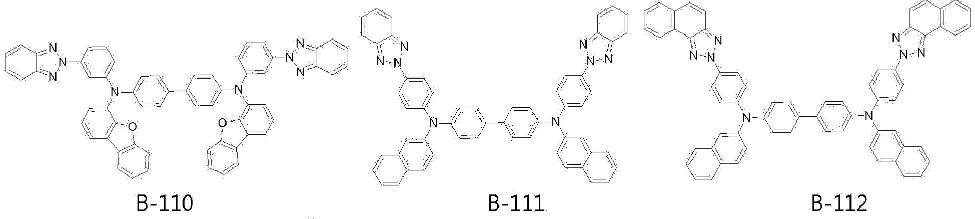

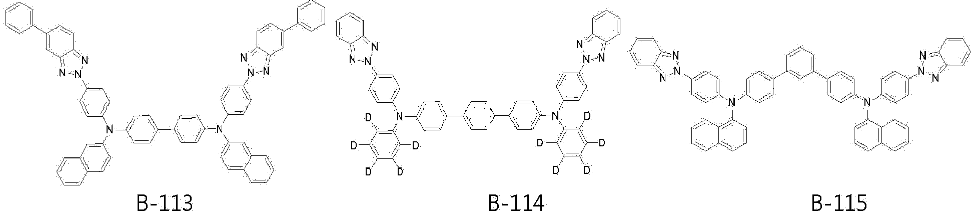

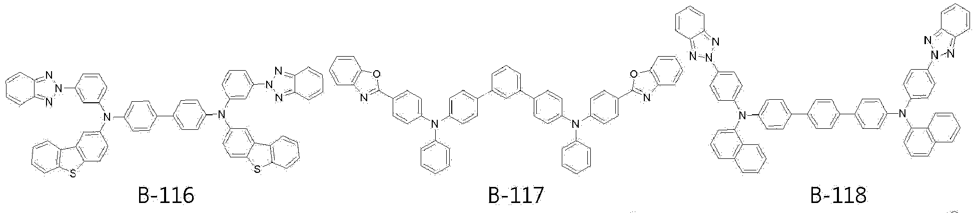

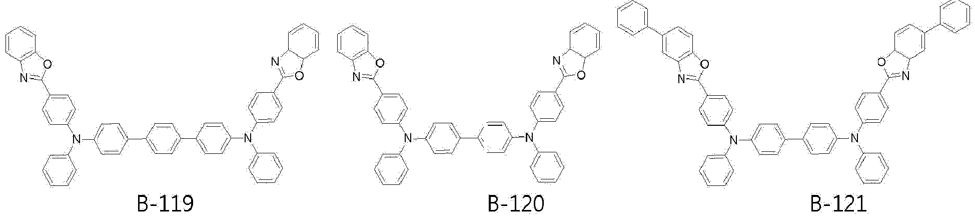

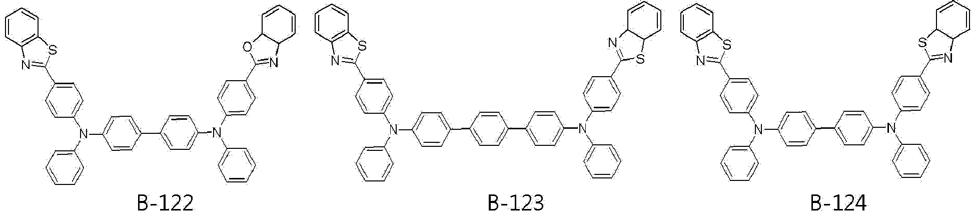

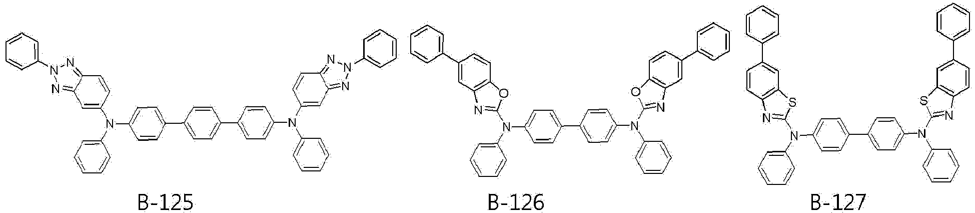

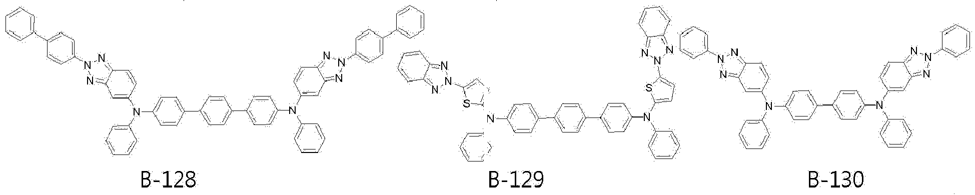

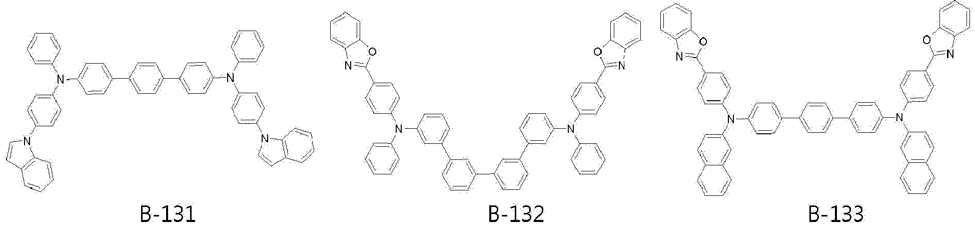

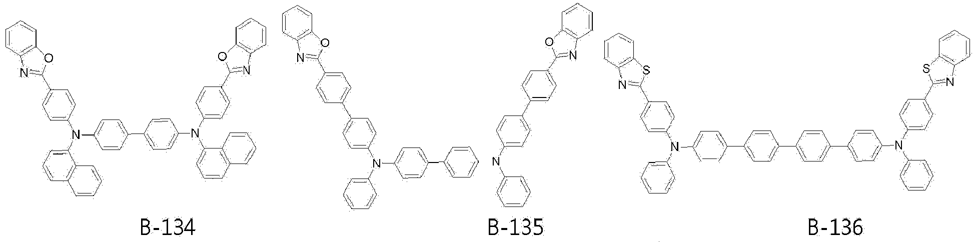

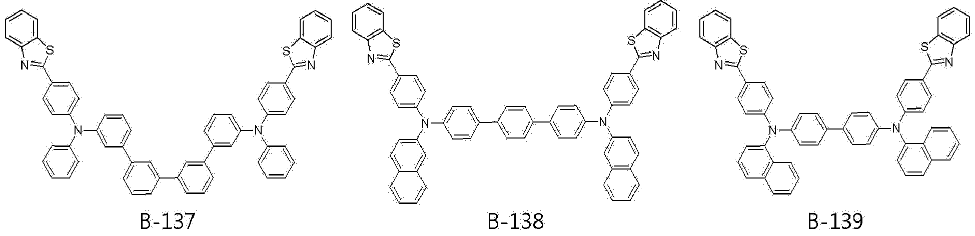

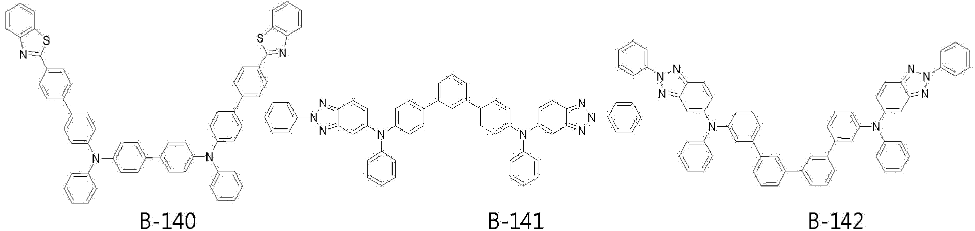

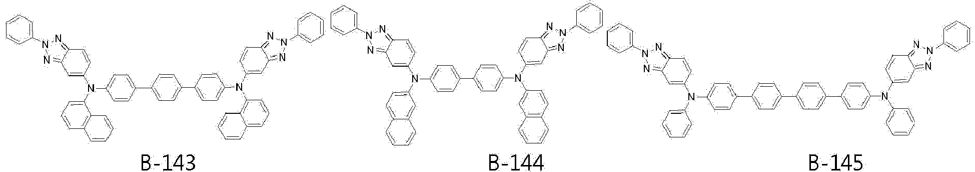

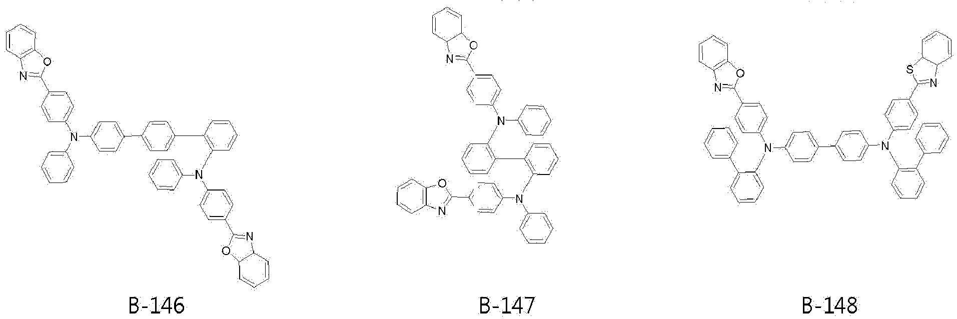

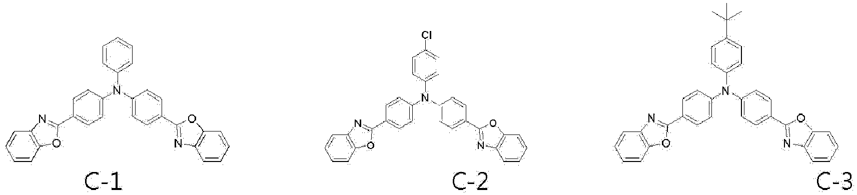

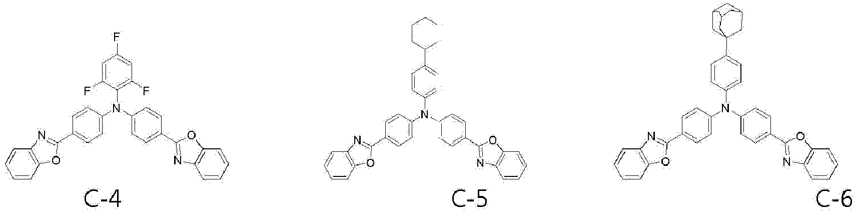

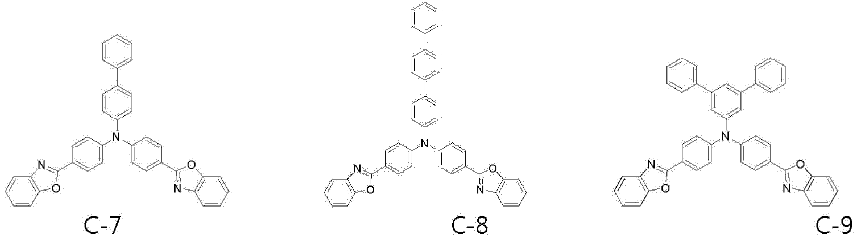

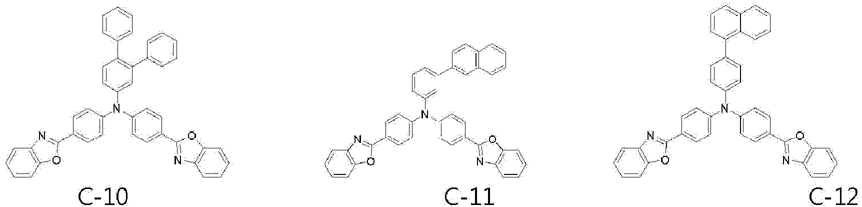

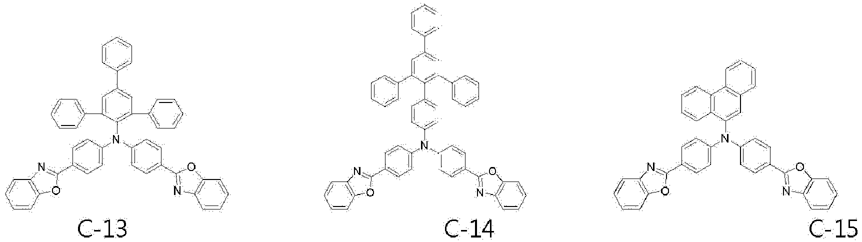

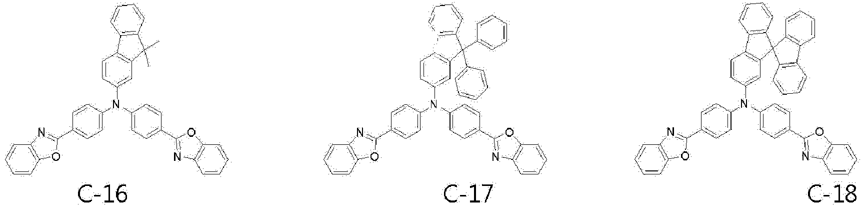

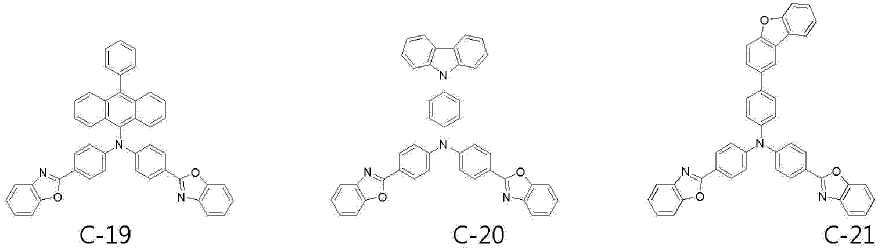

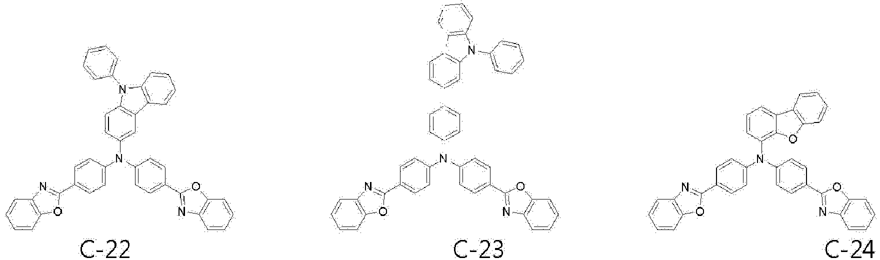

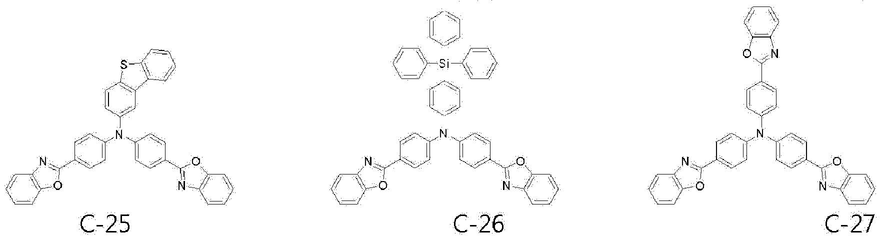

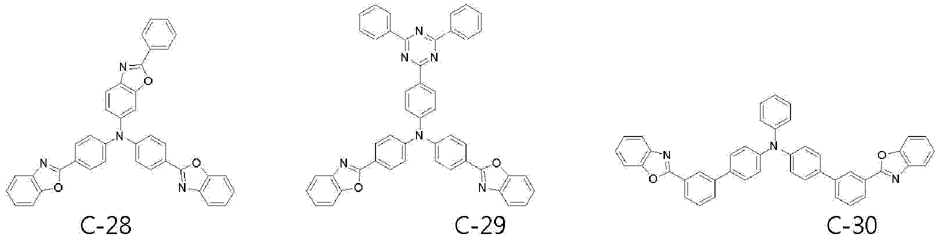

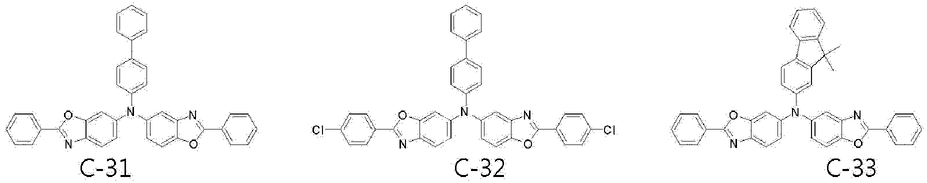

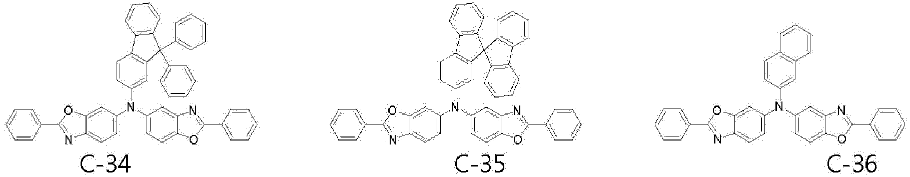

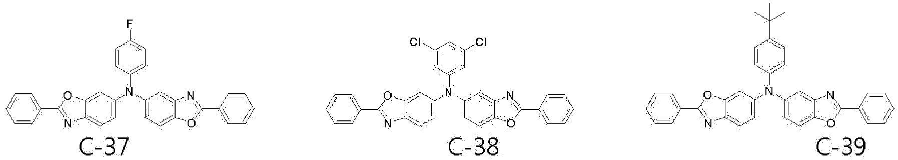

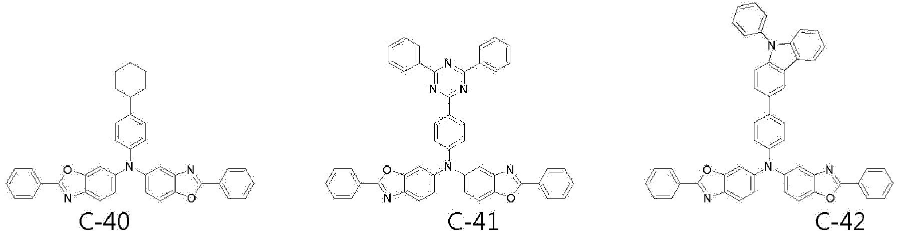

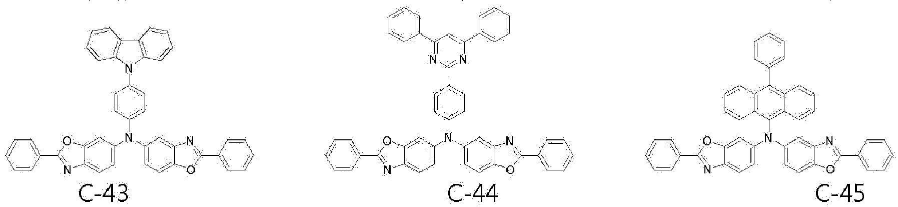

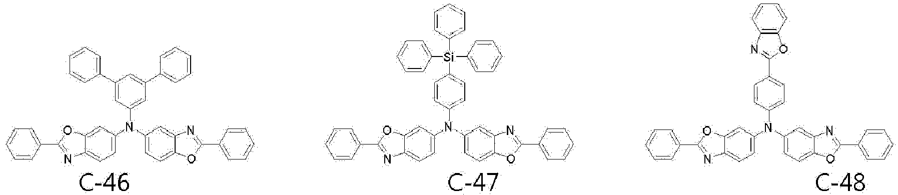

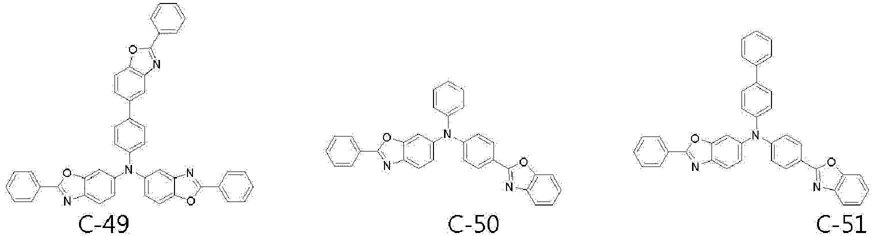

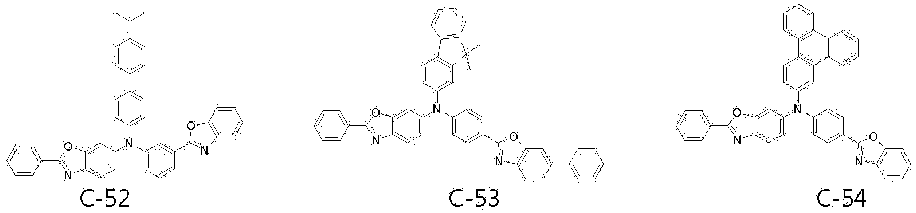

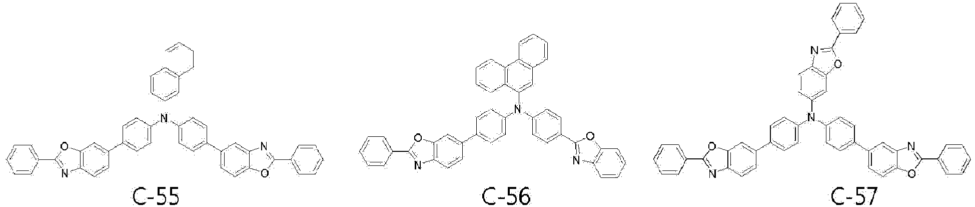

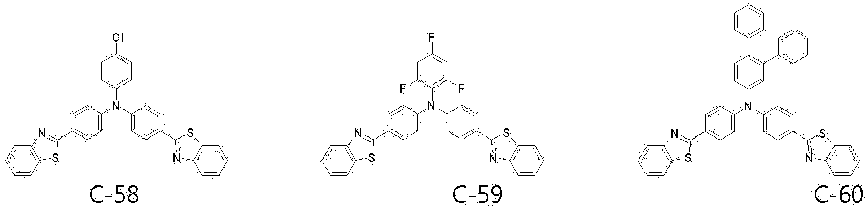

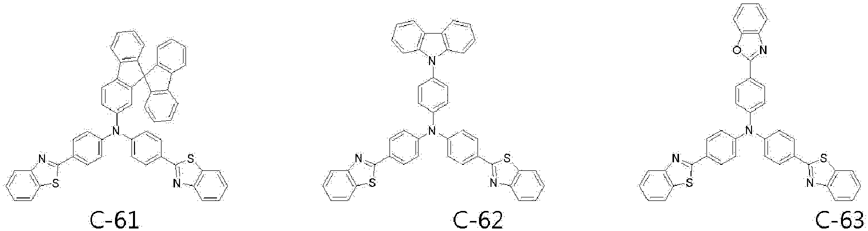

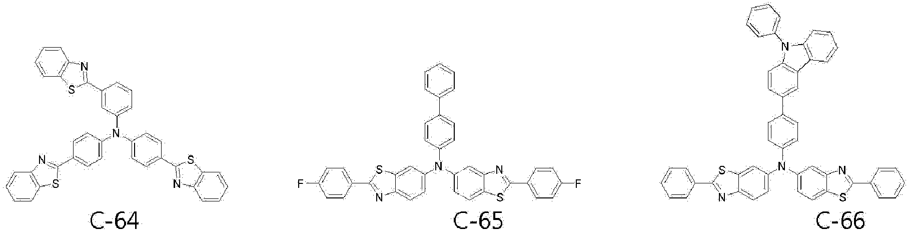

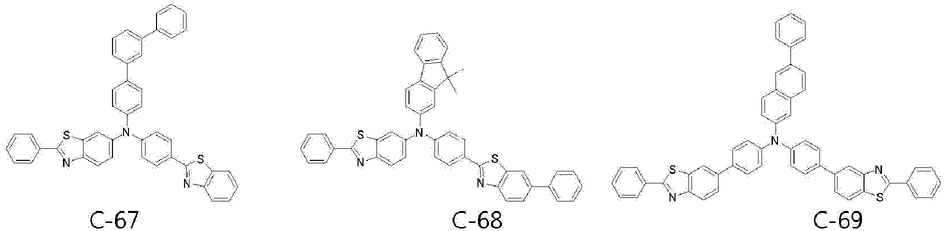

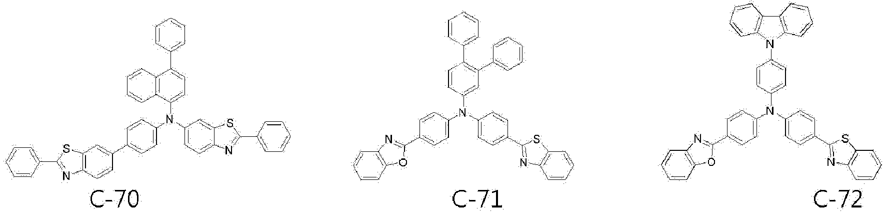

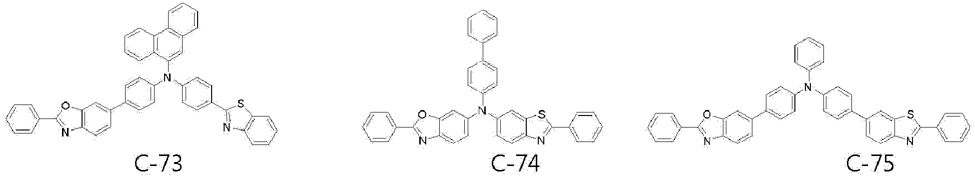

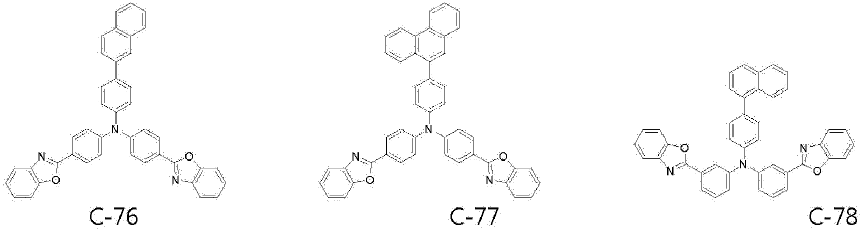

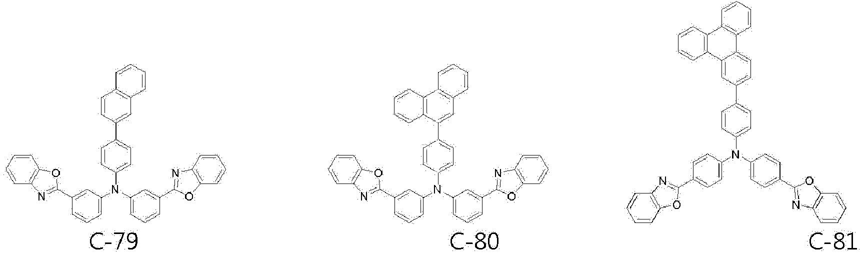

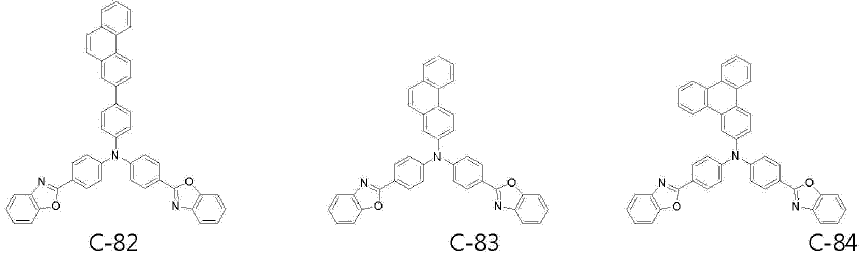

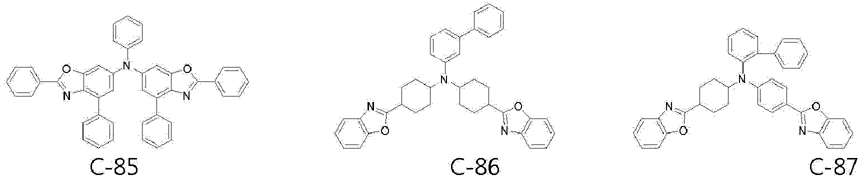

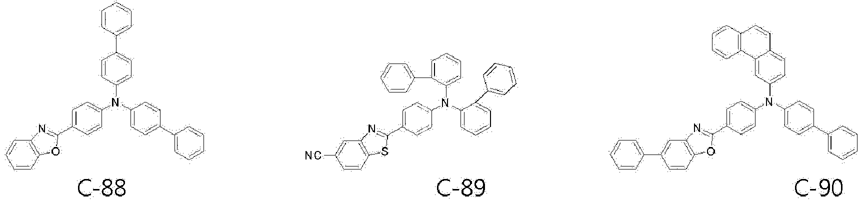

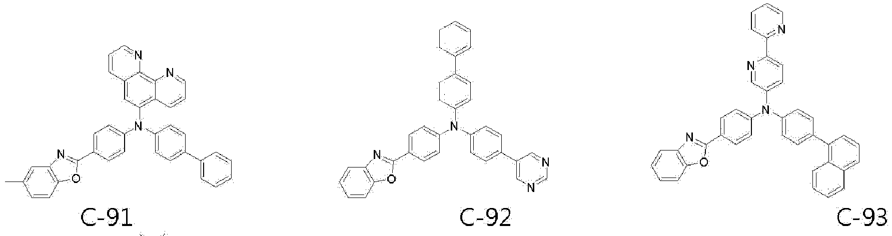

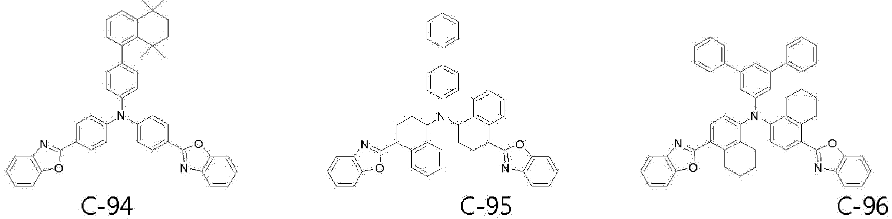

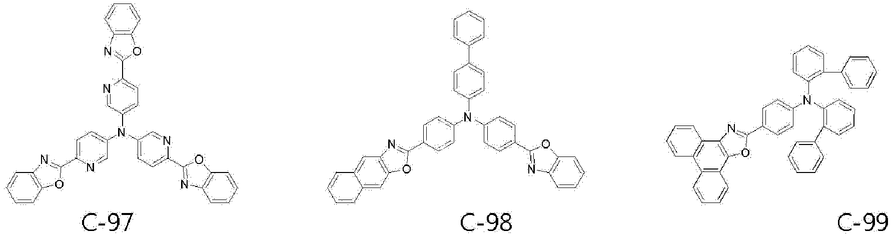

In addition, the light-emitting layer in the organic light-emitting device according to the present invention includes a host and a dopant, and the dopant compound may be represented by [Formula D-1] to [Formula D-8], and specific compounds thereof are as follows, but are not limited thereto.

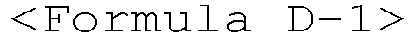

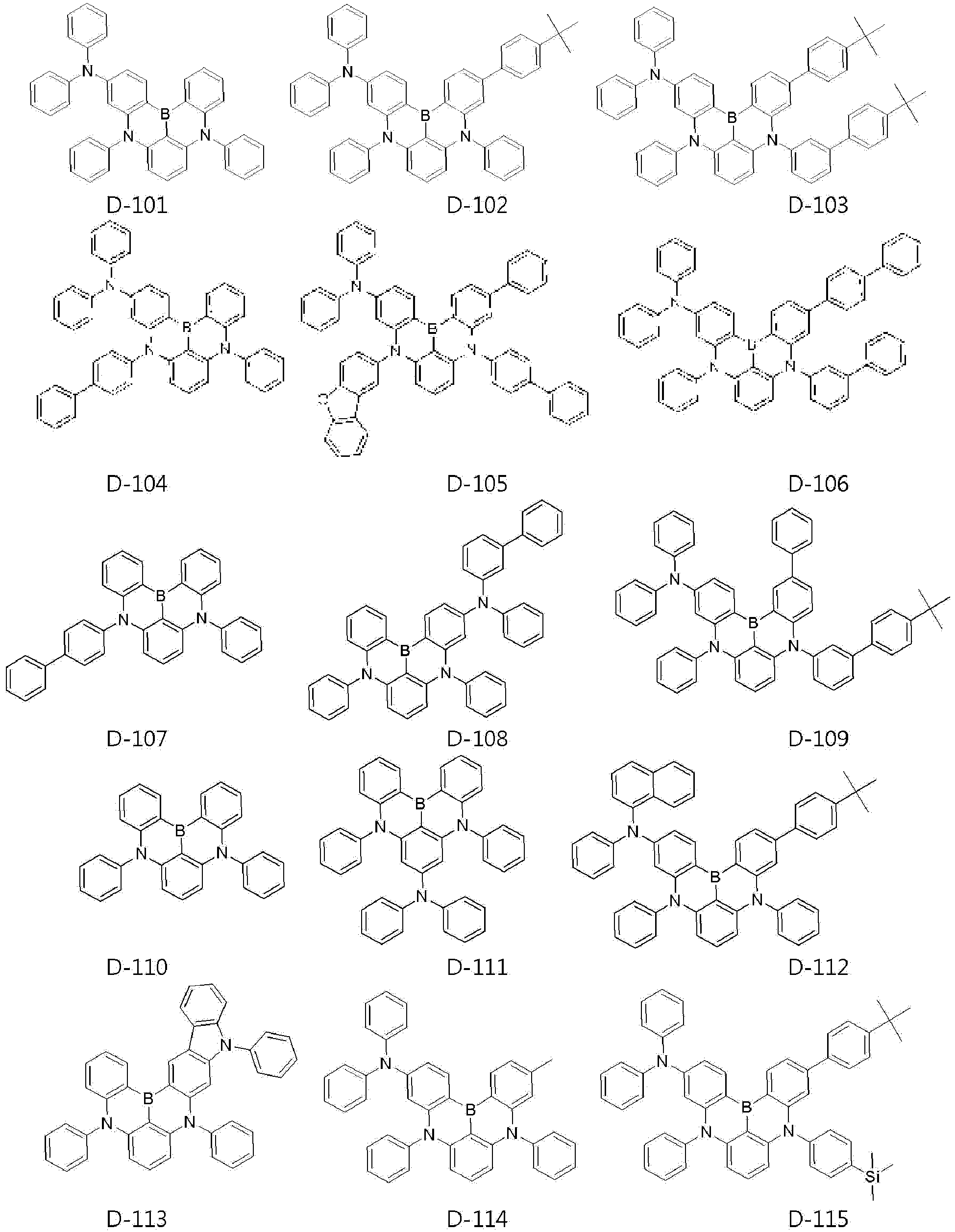

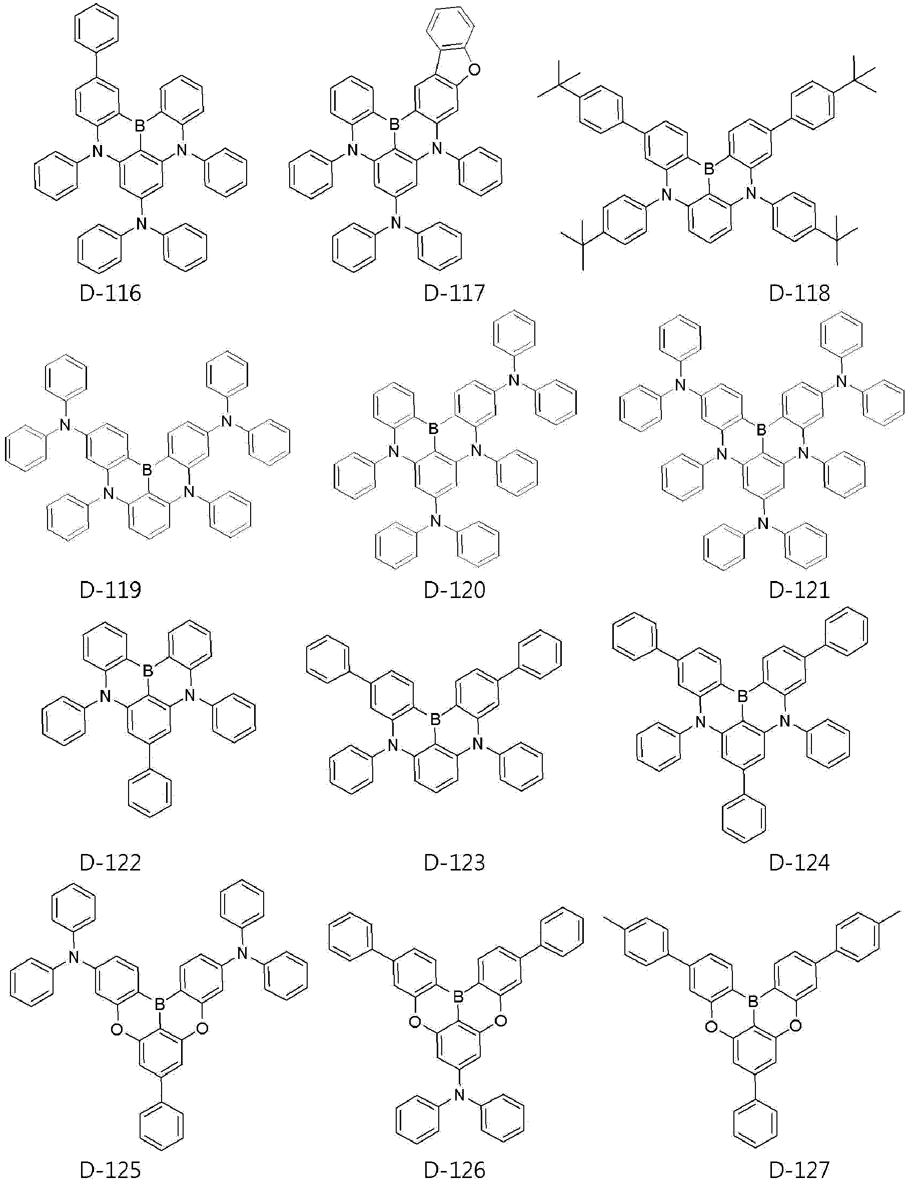

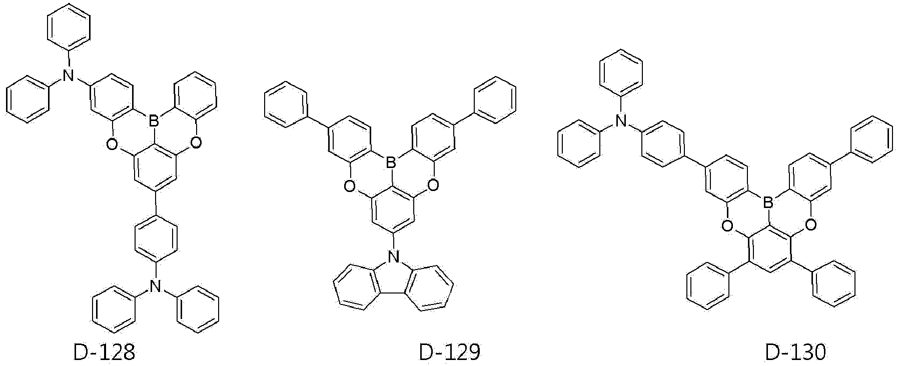

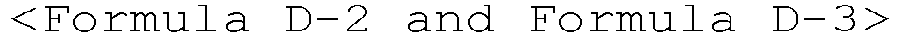

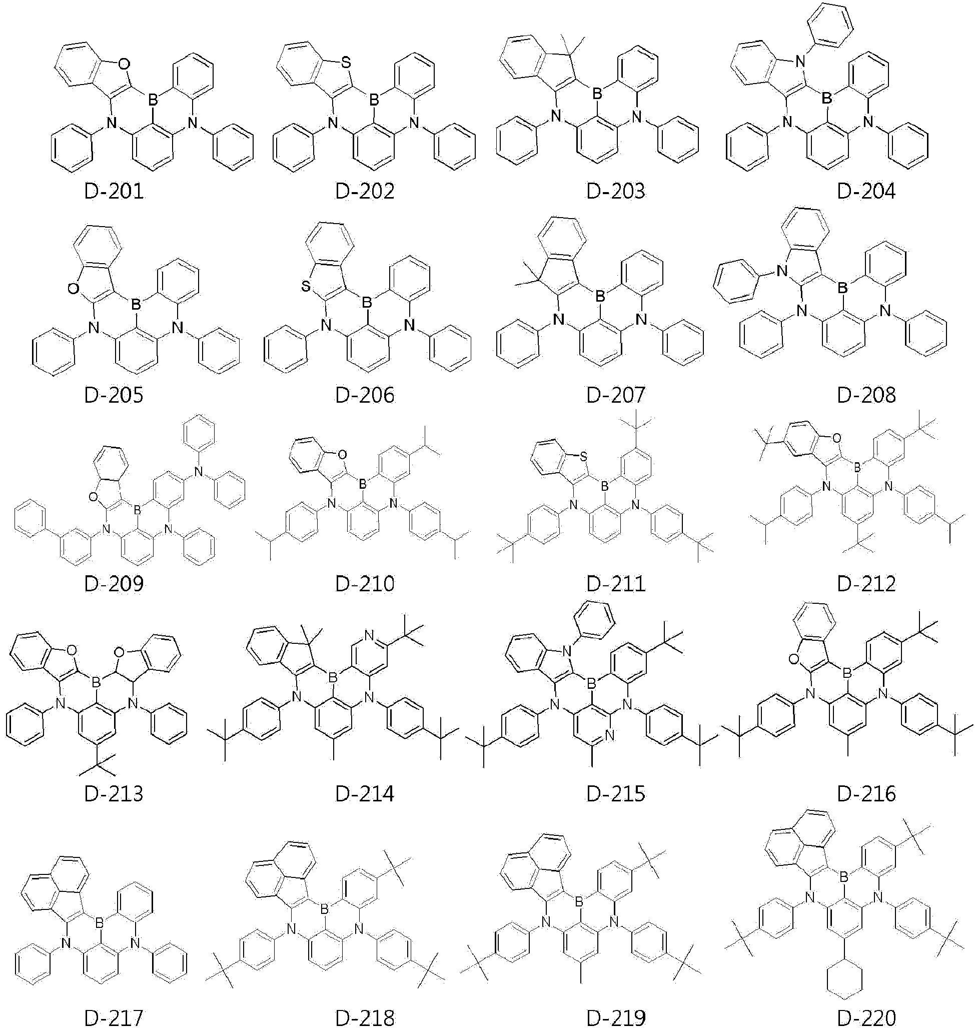

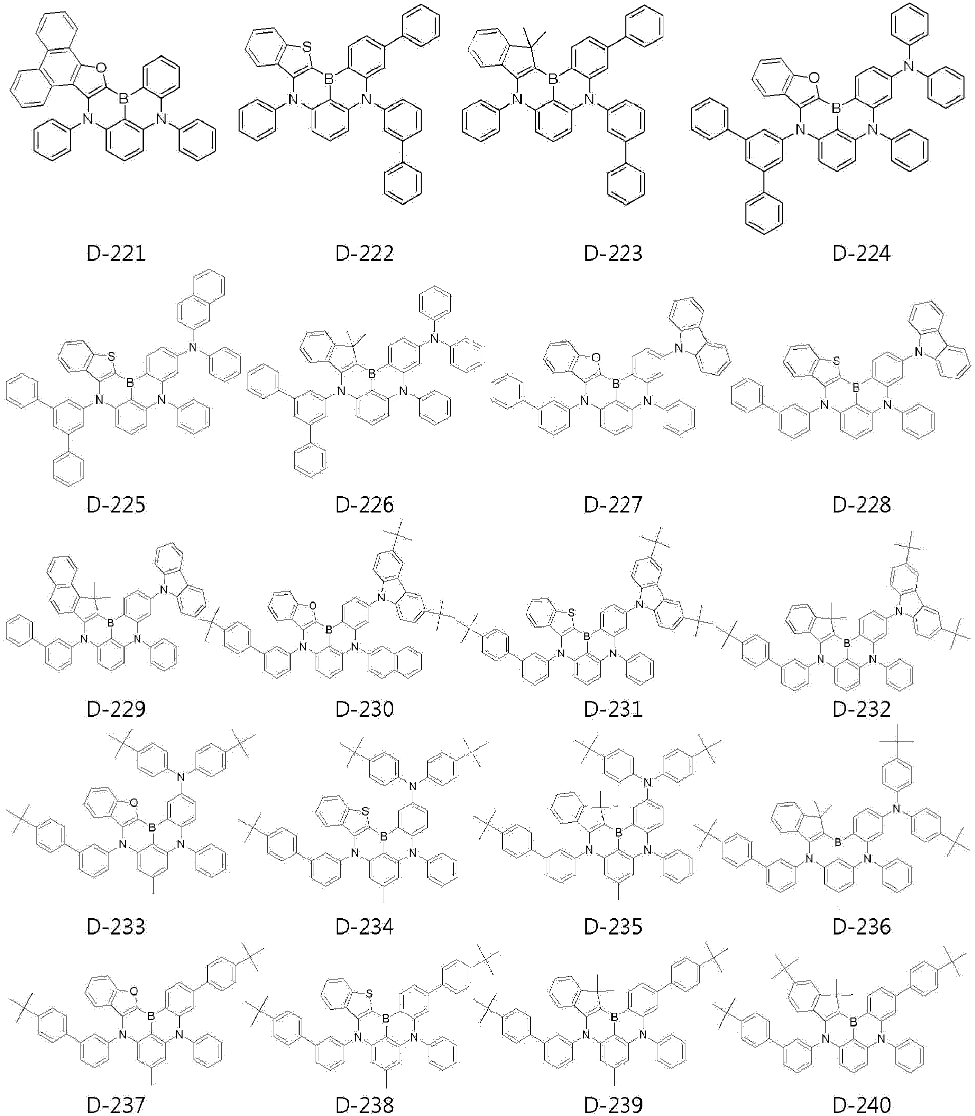

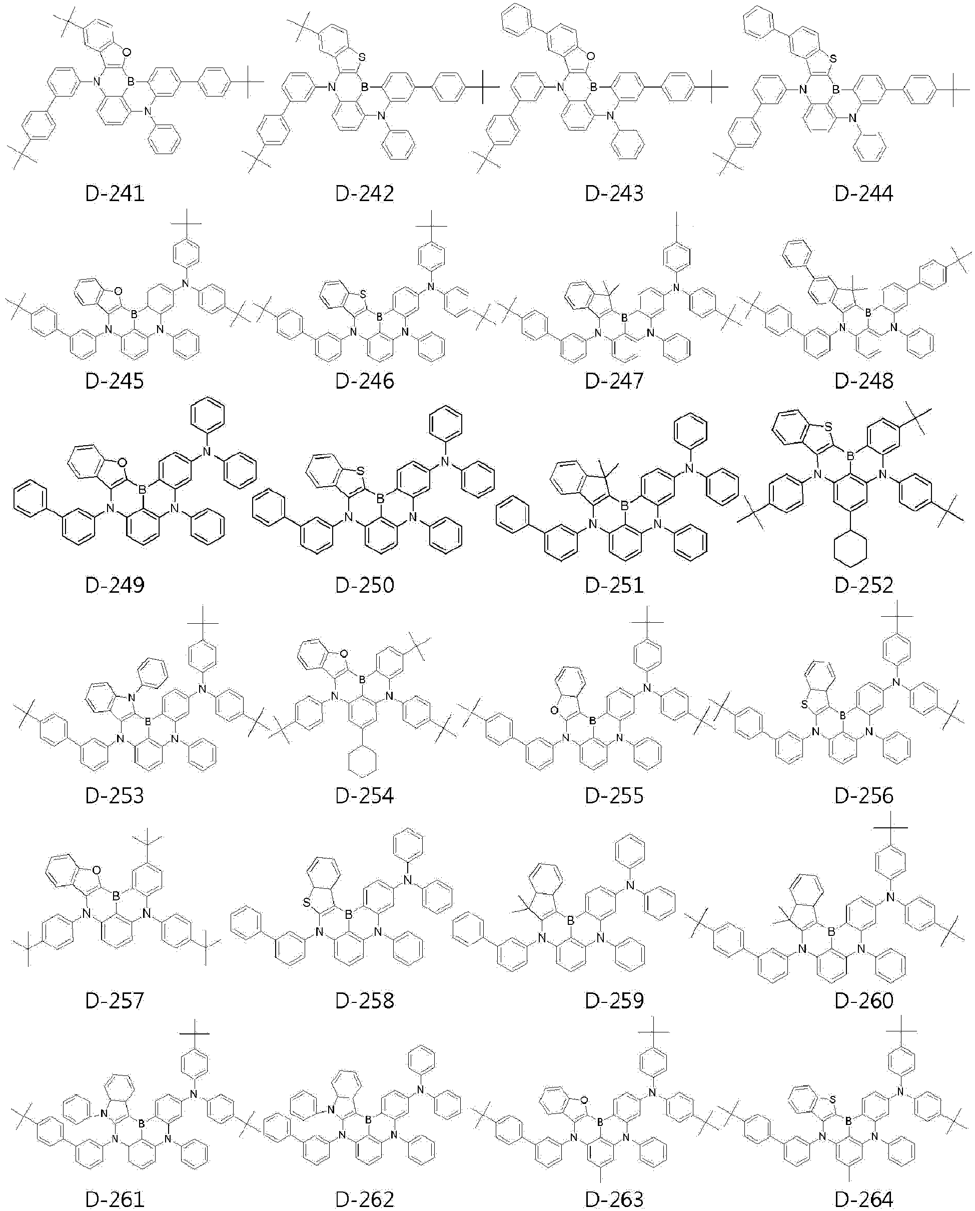

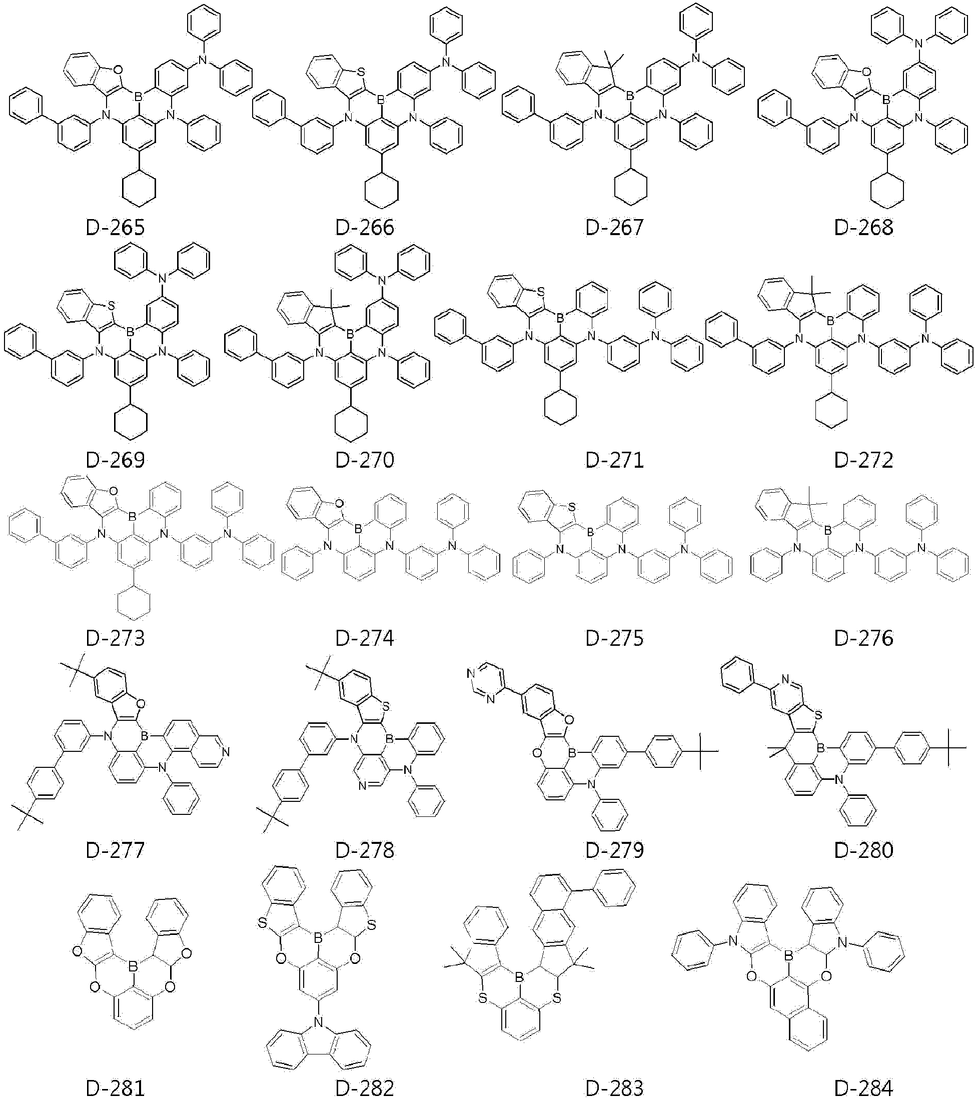

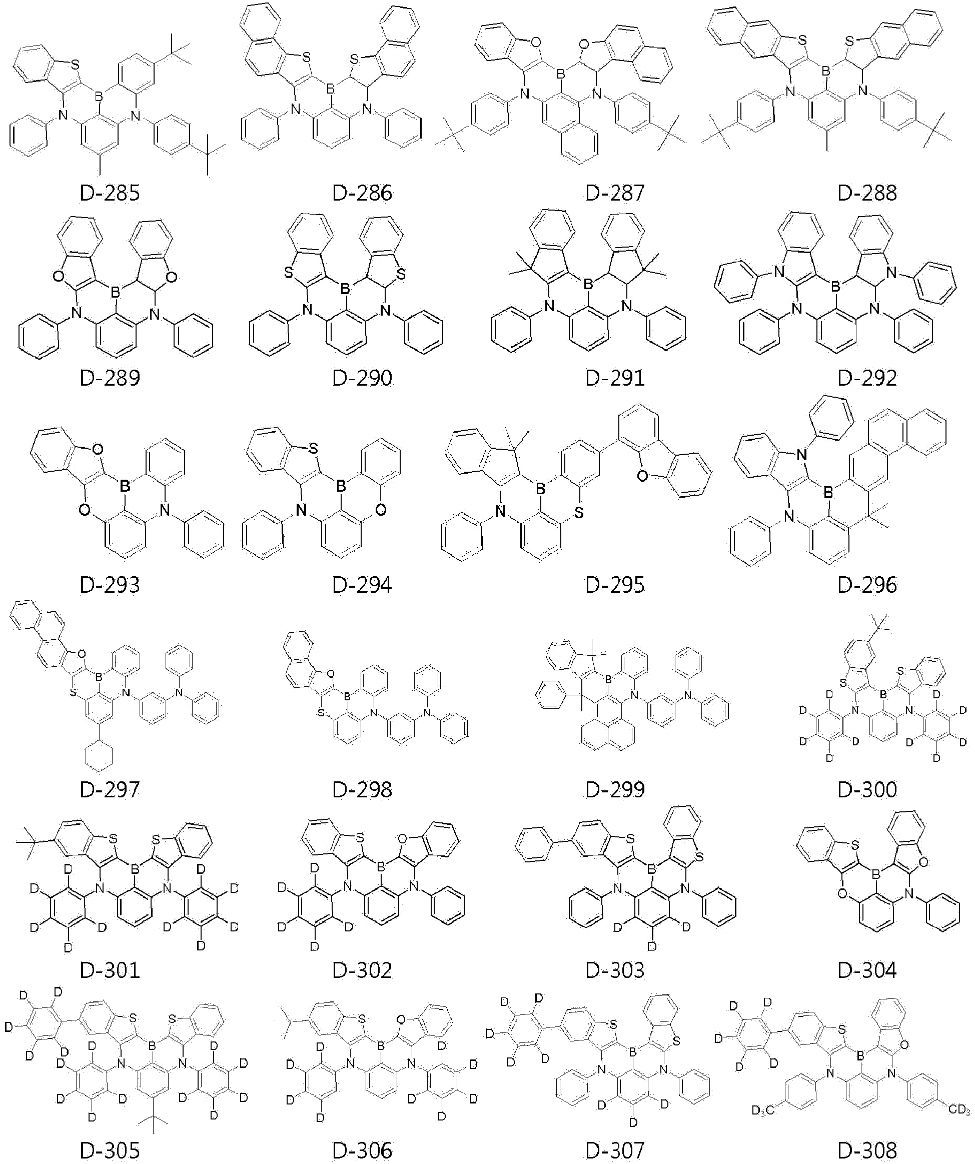

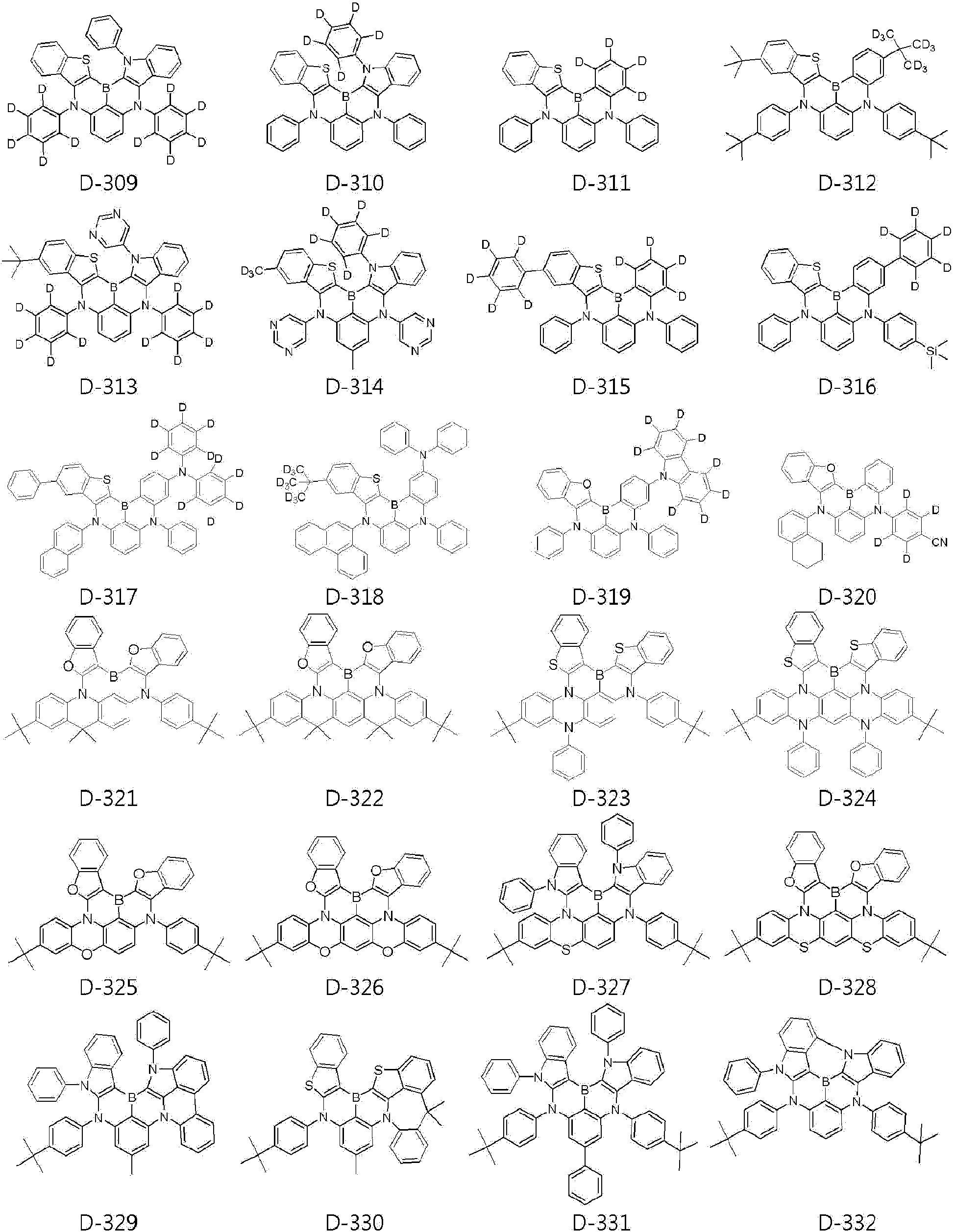

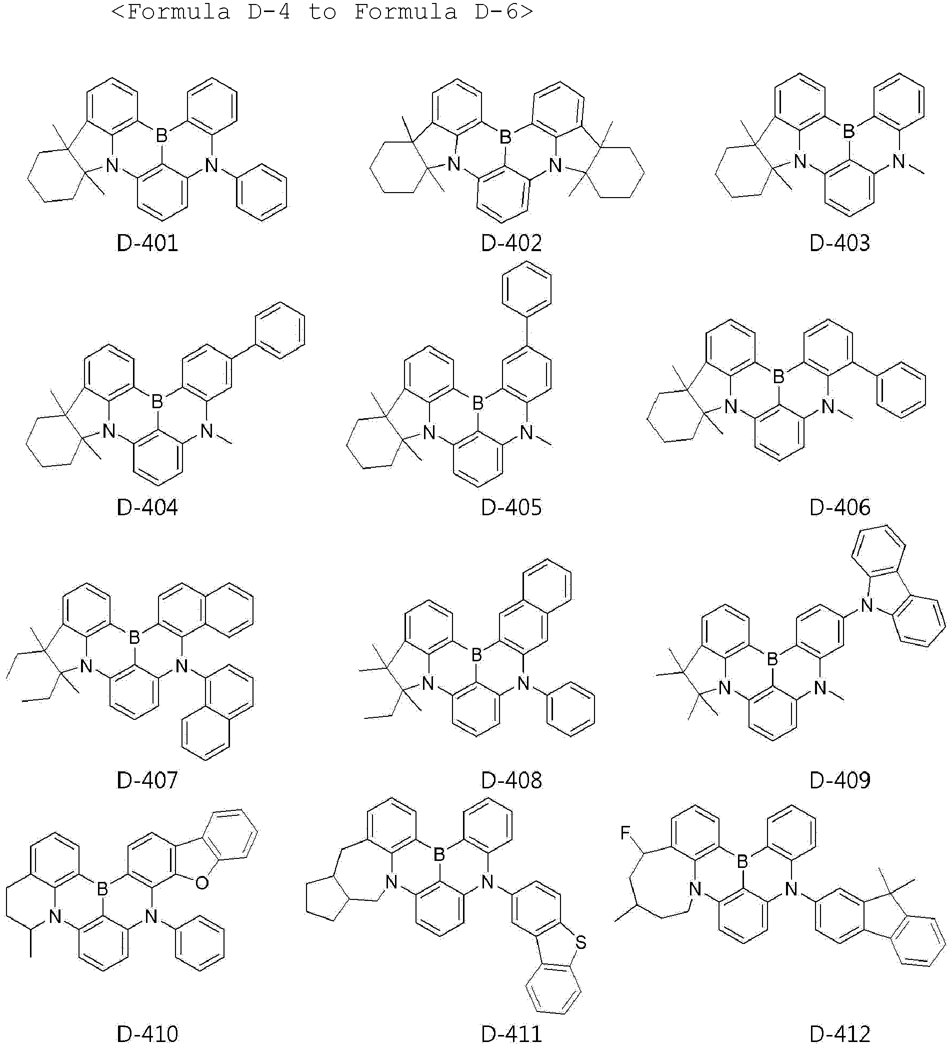

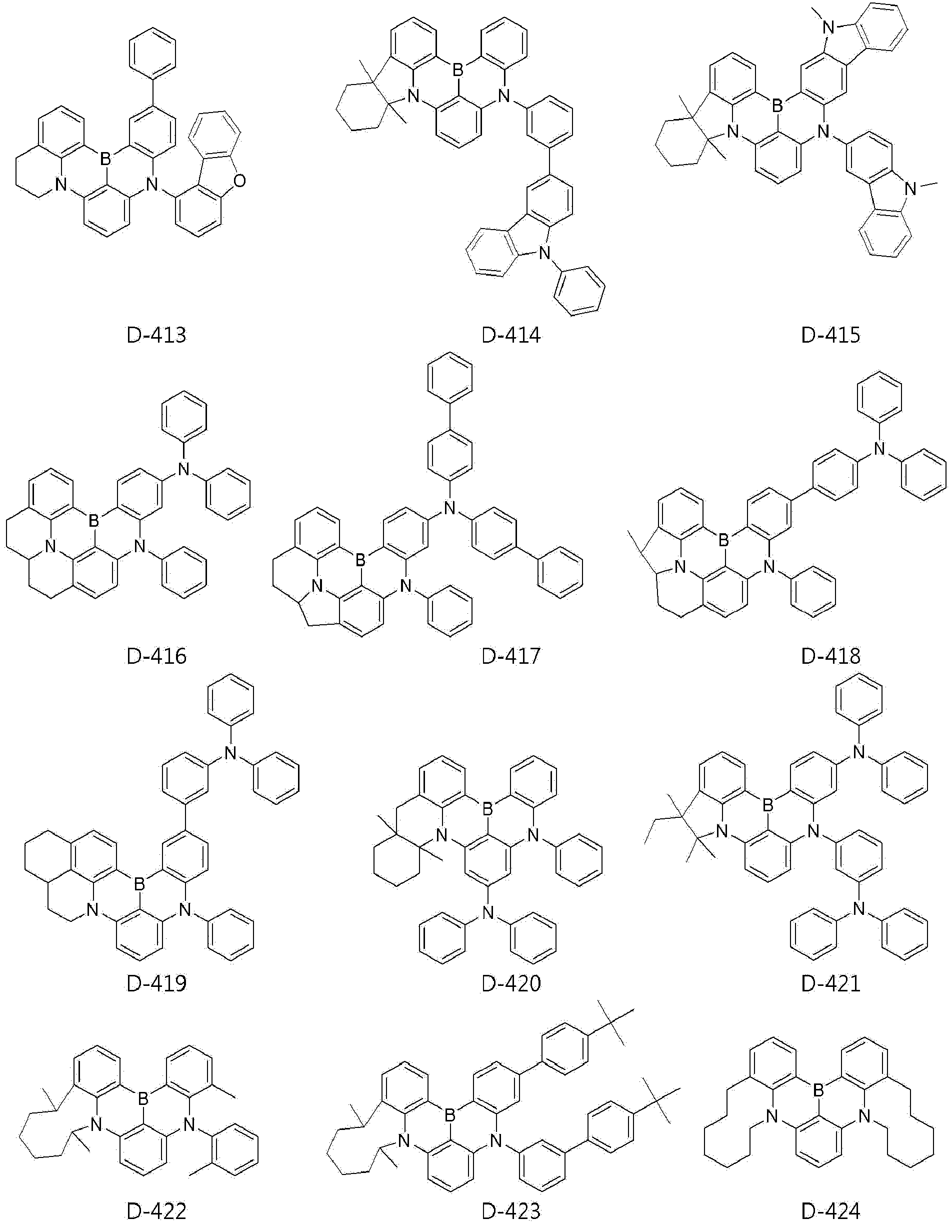

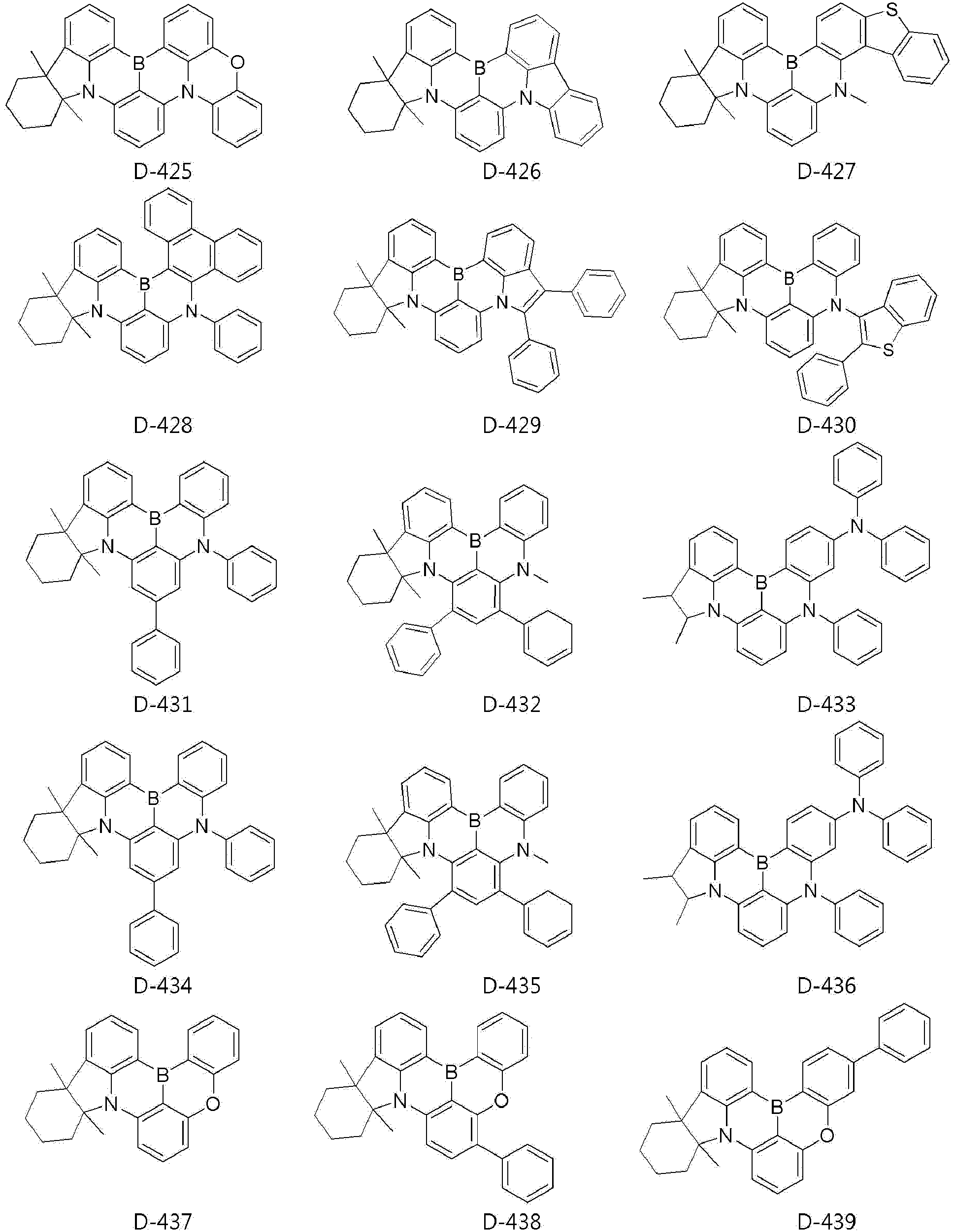

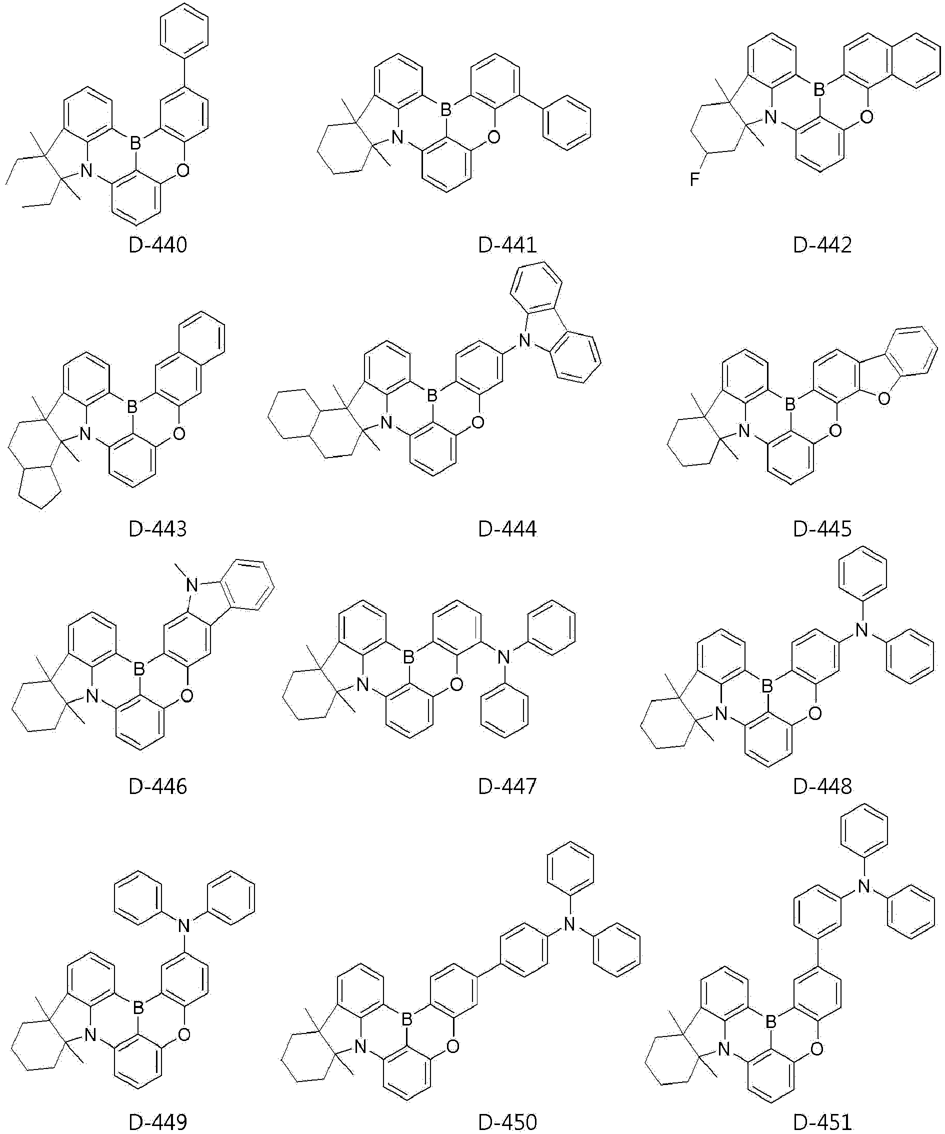

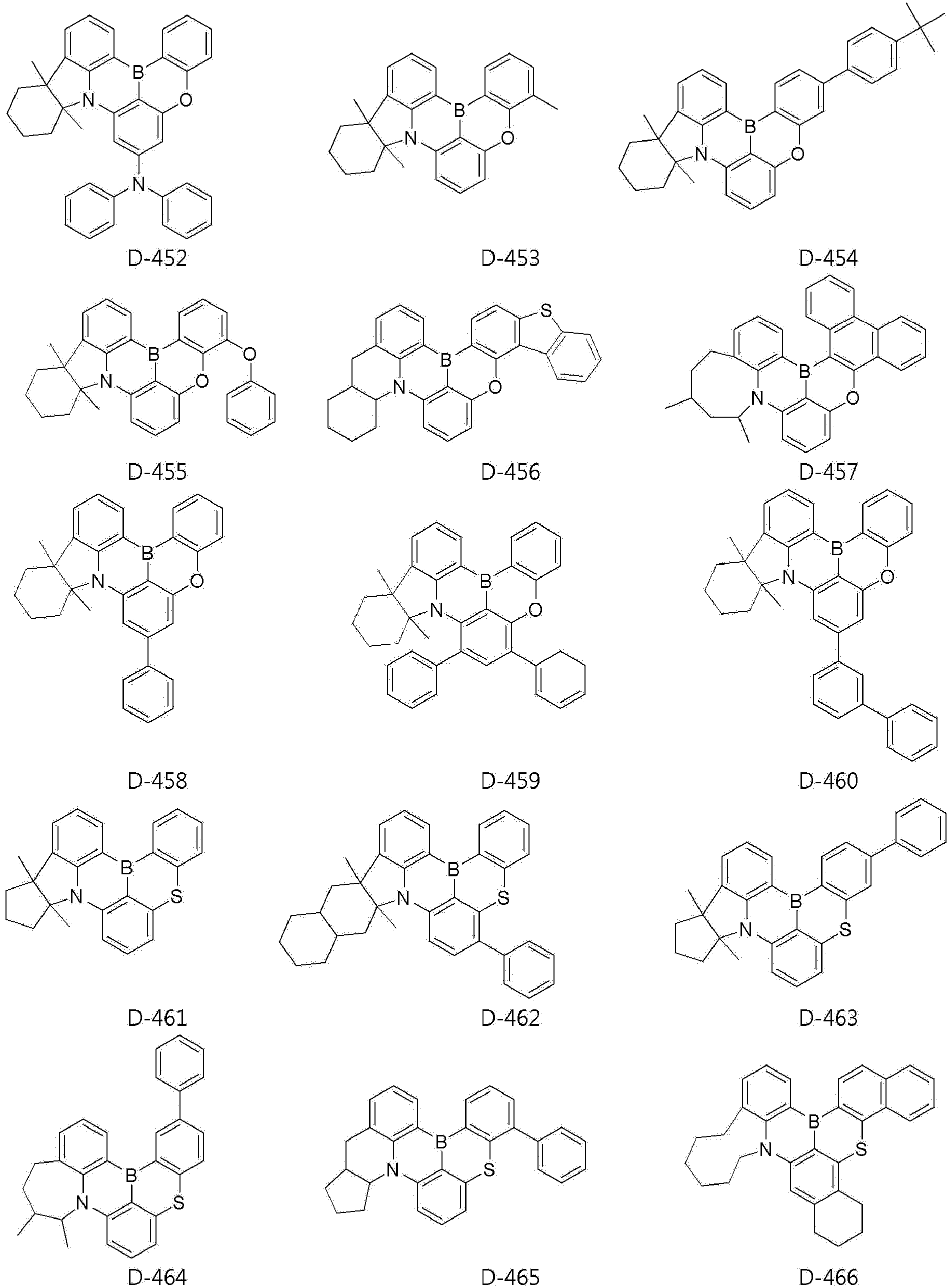

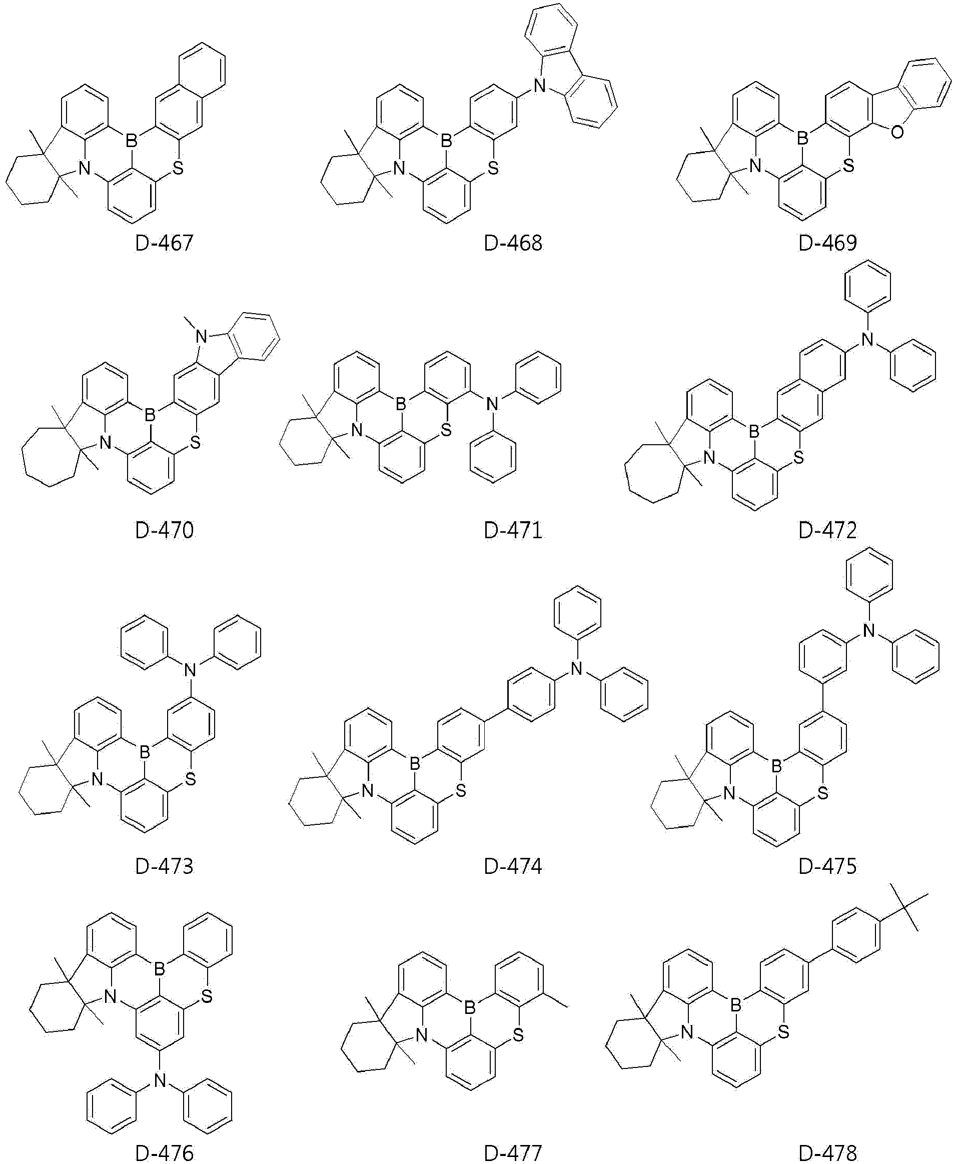

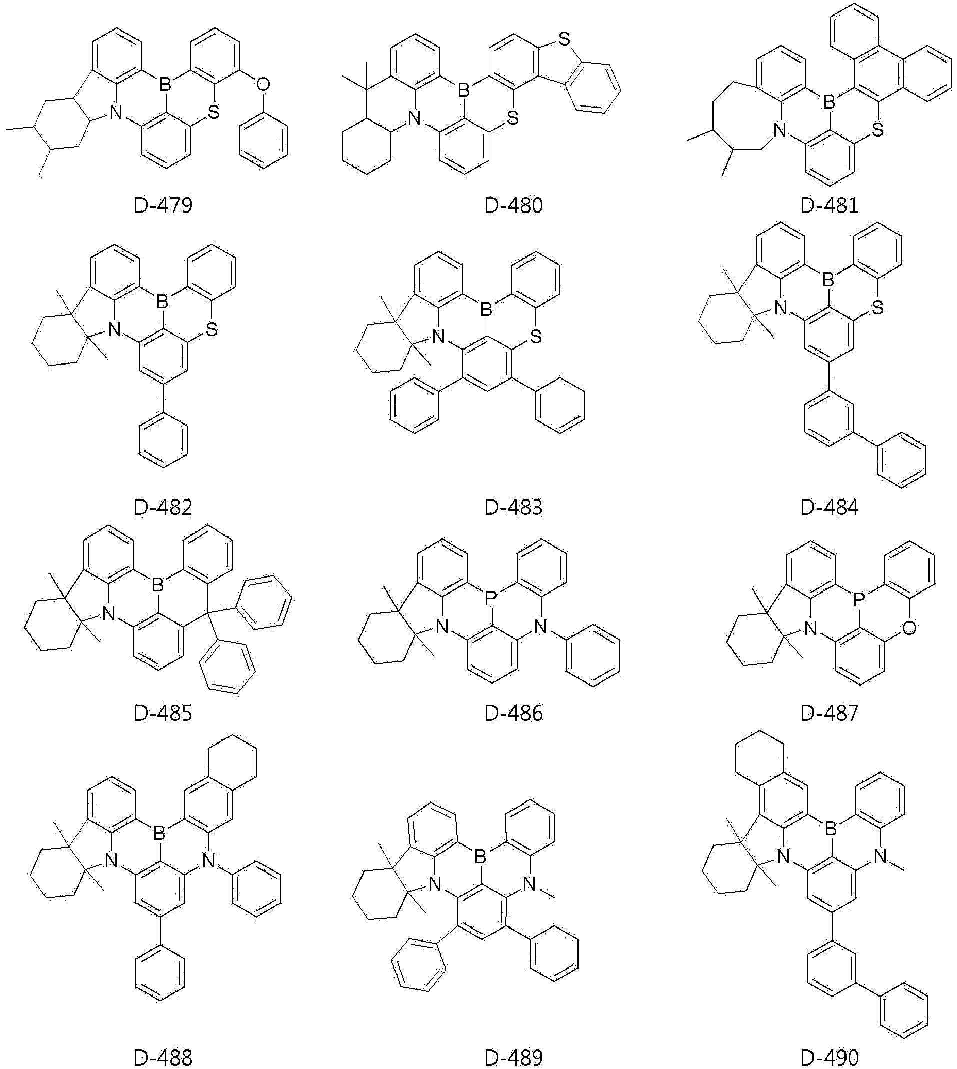

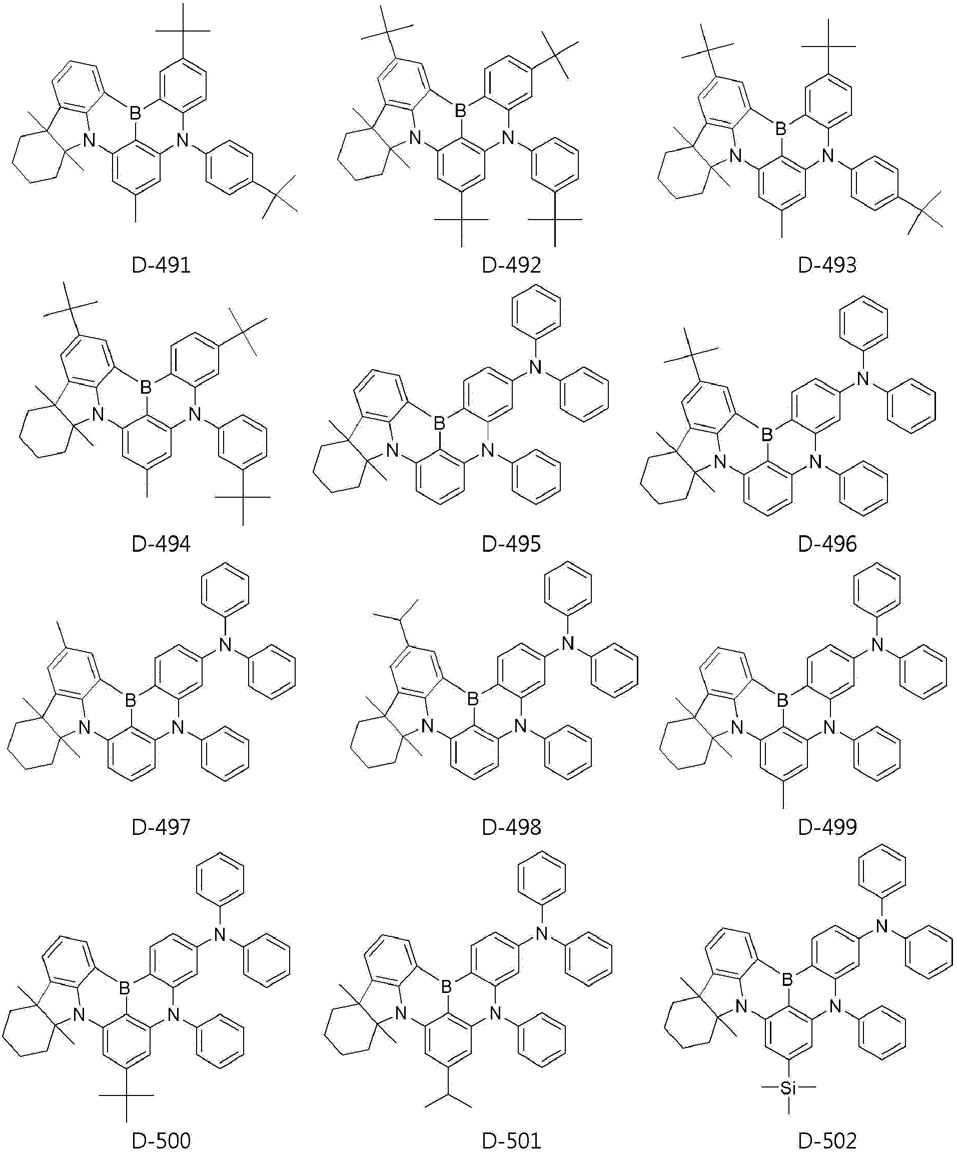

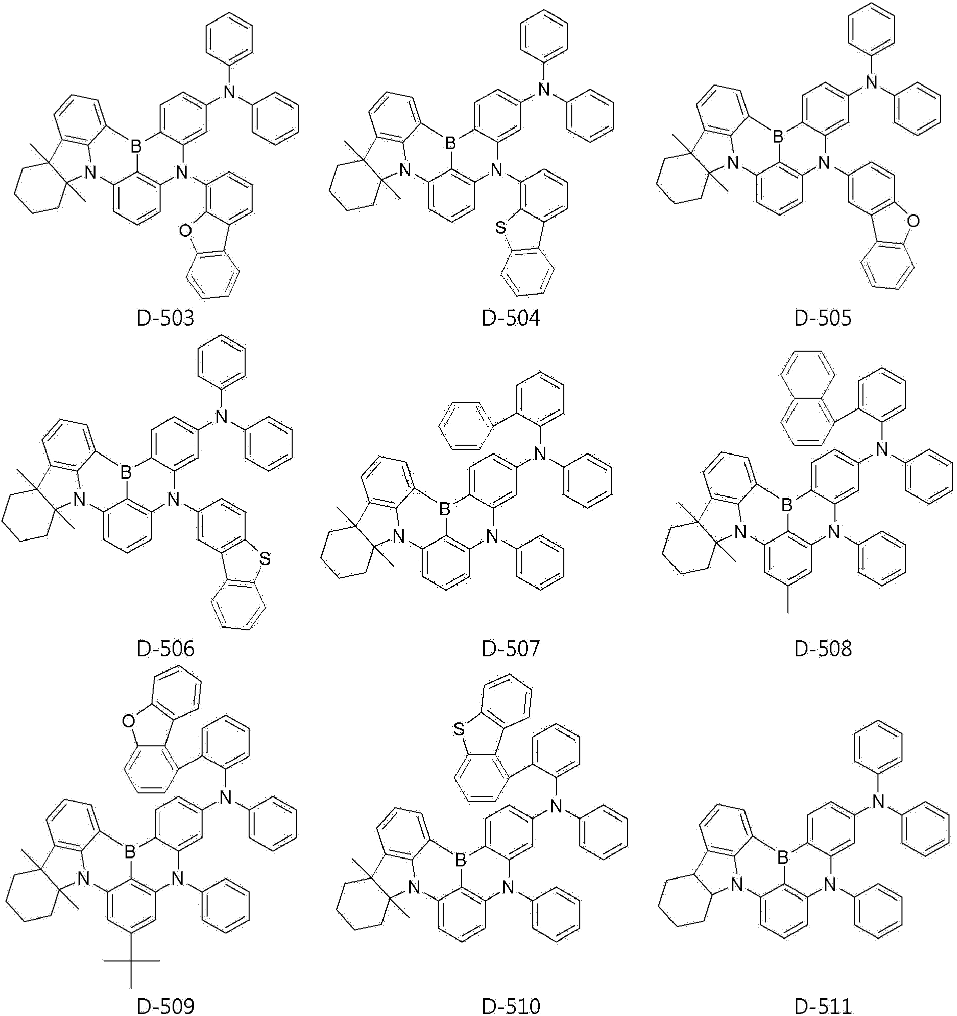

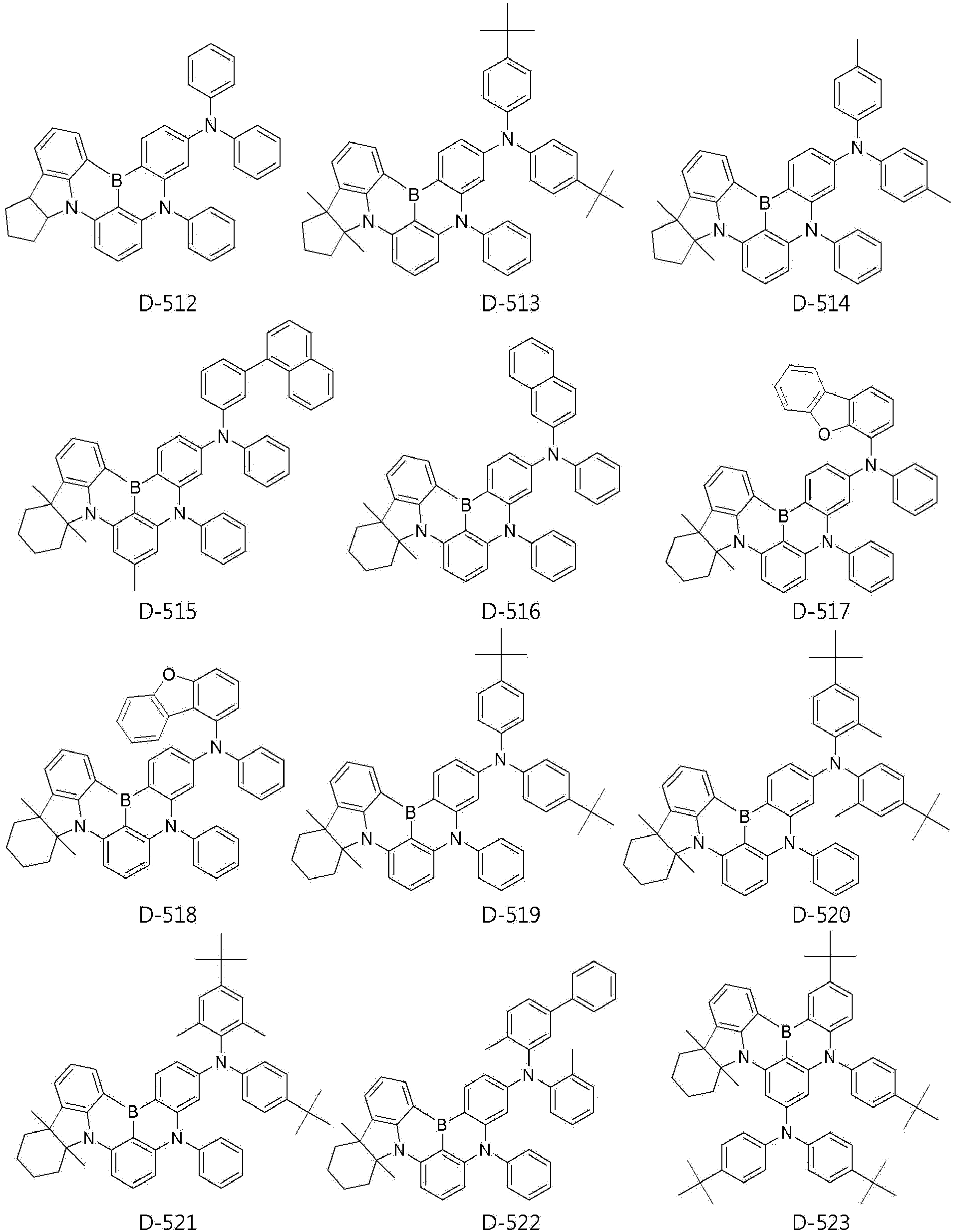

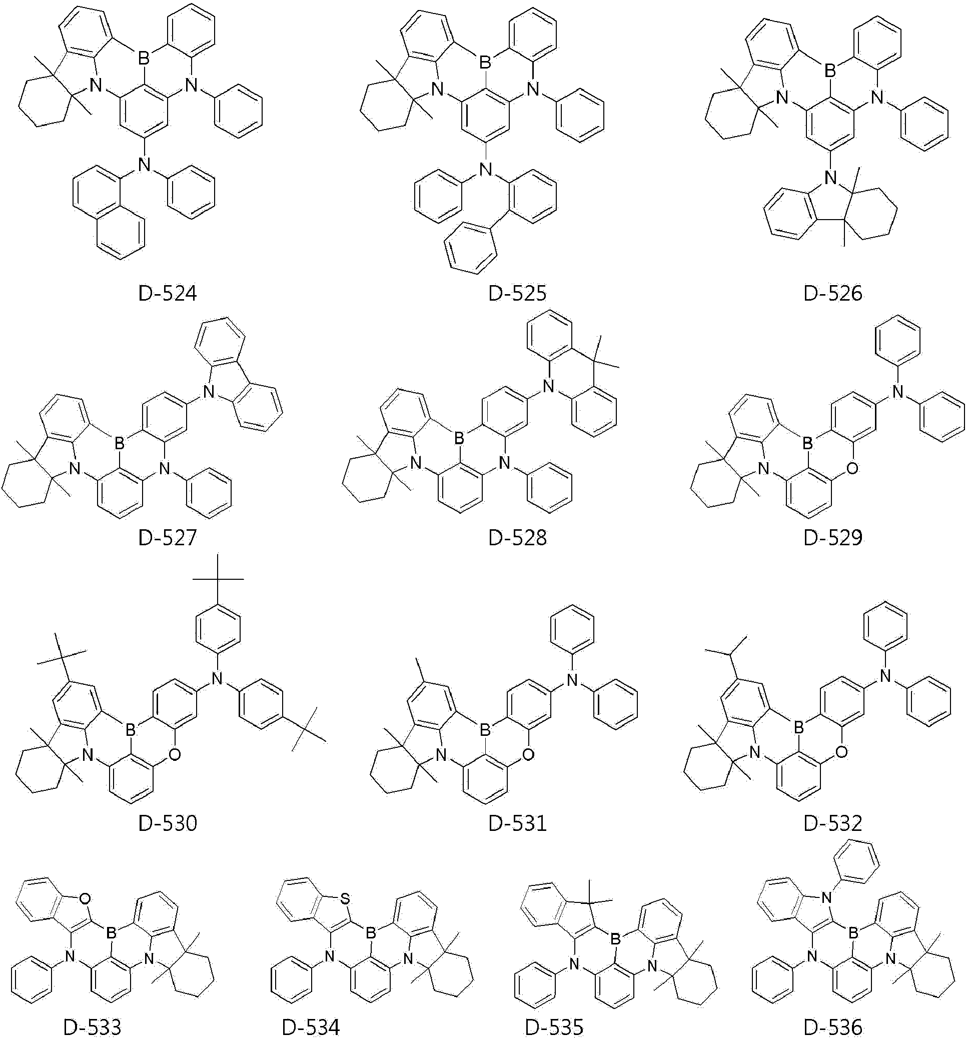

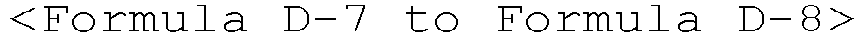

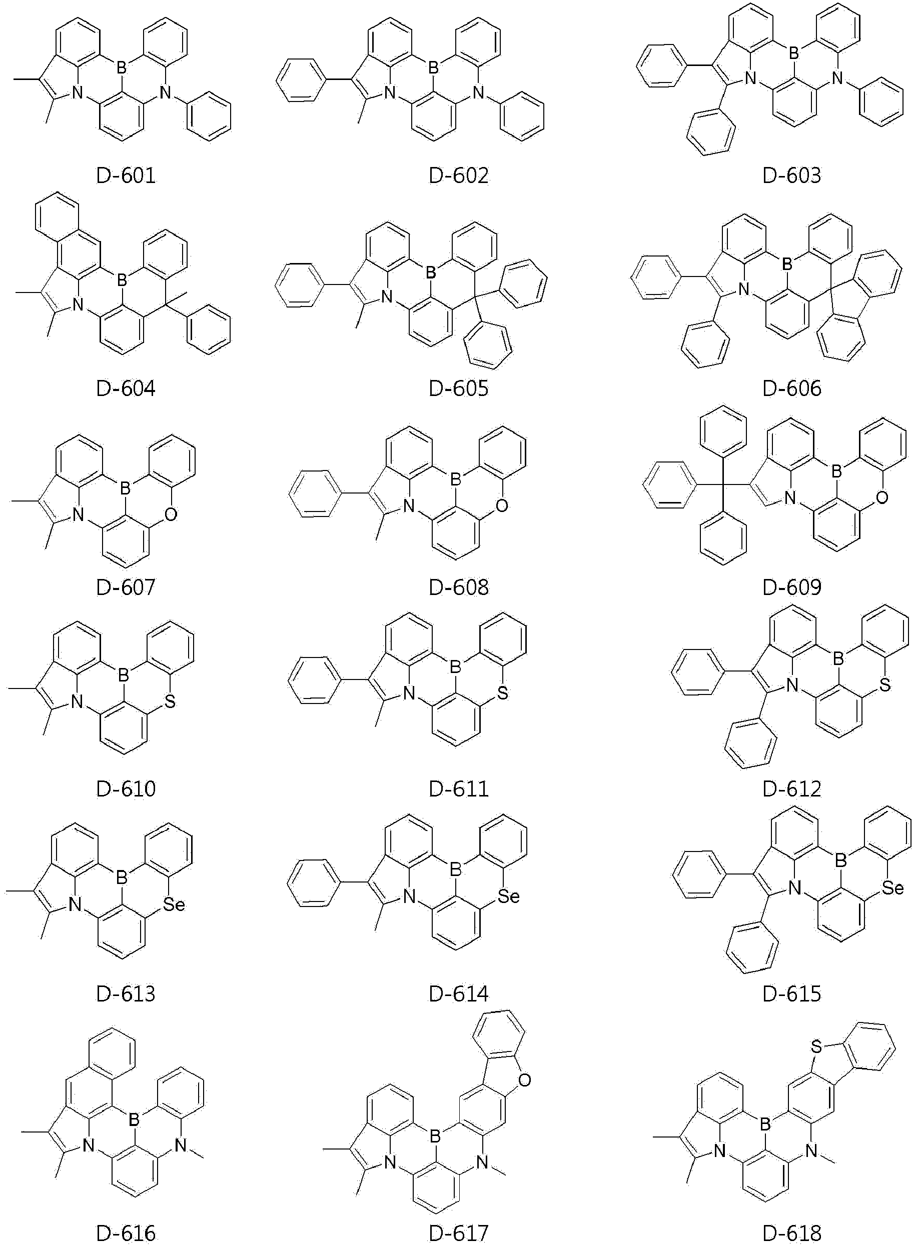

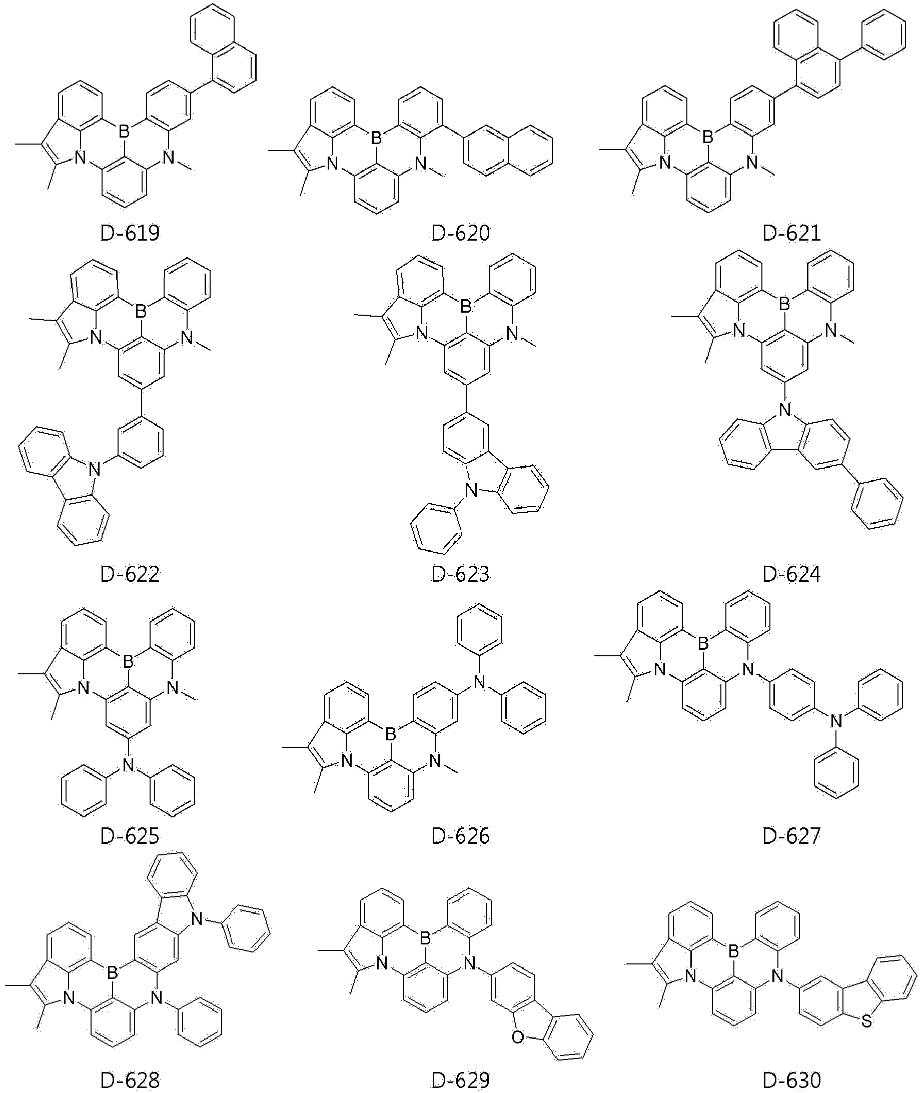

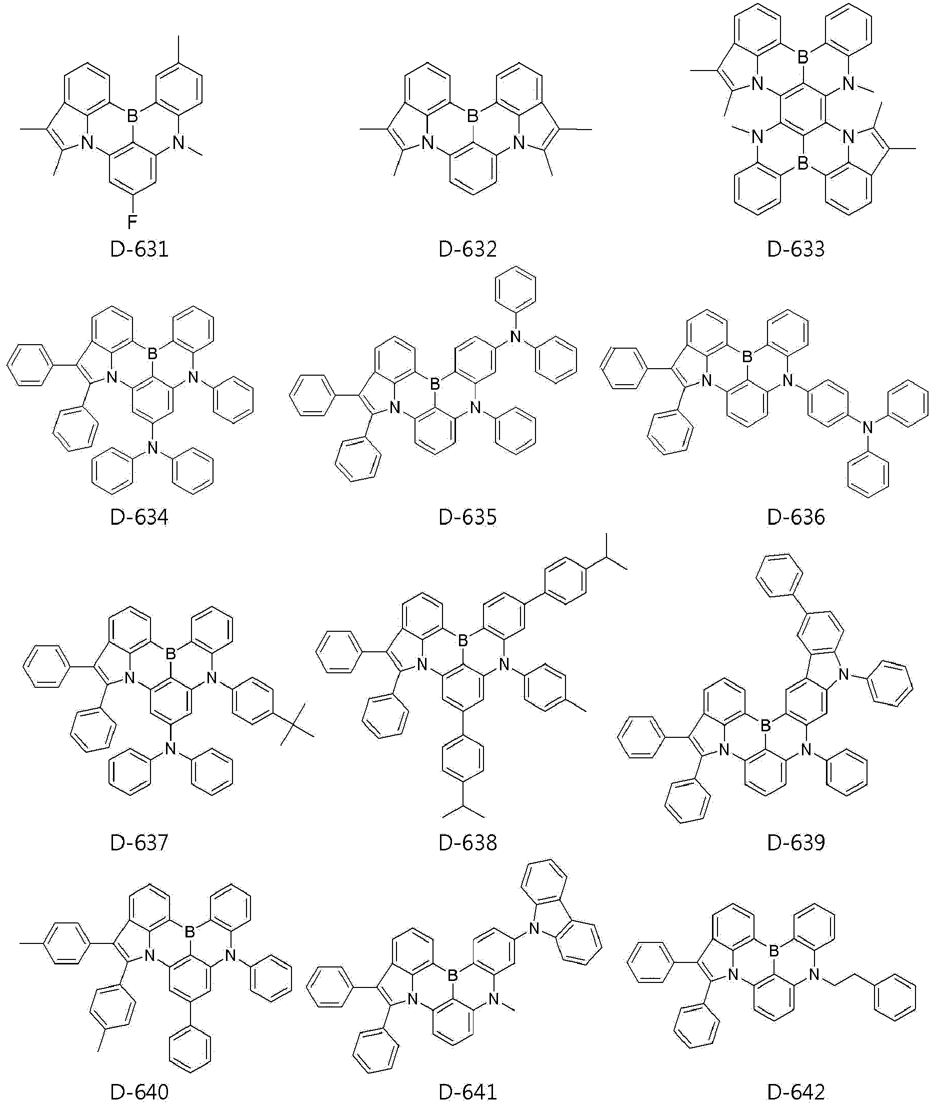

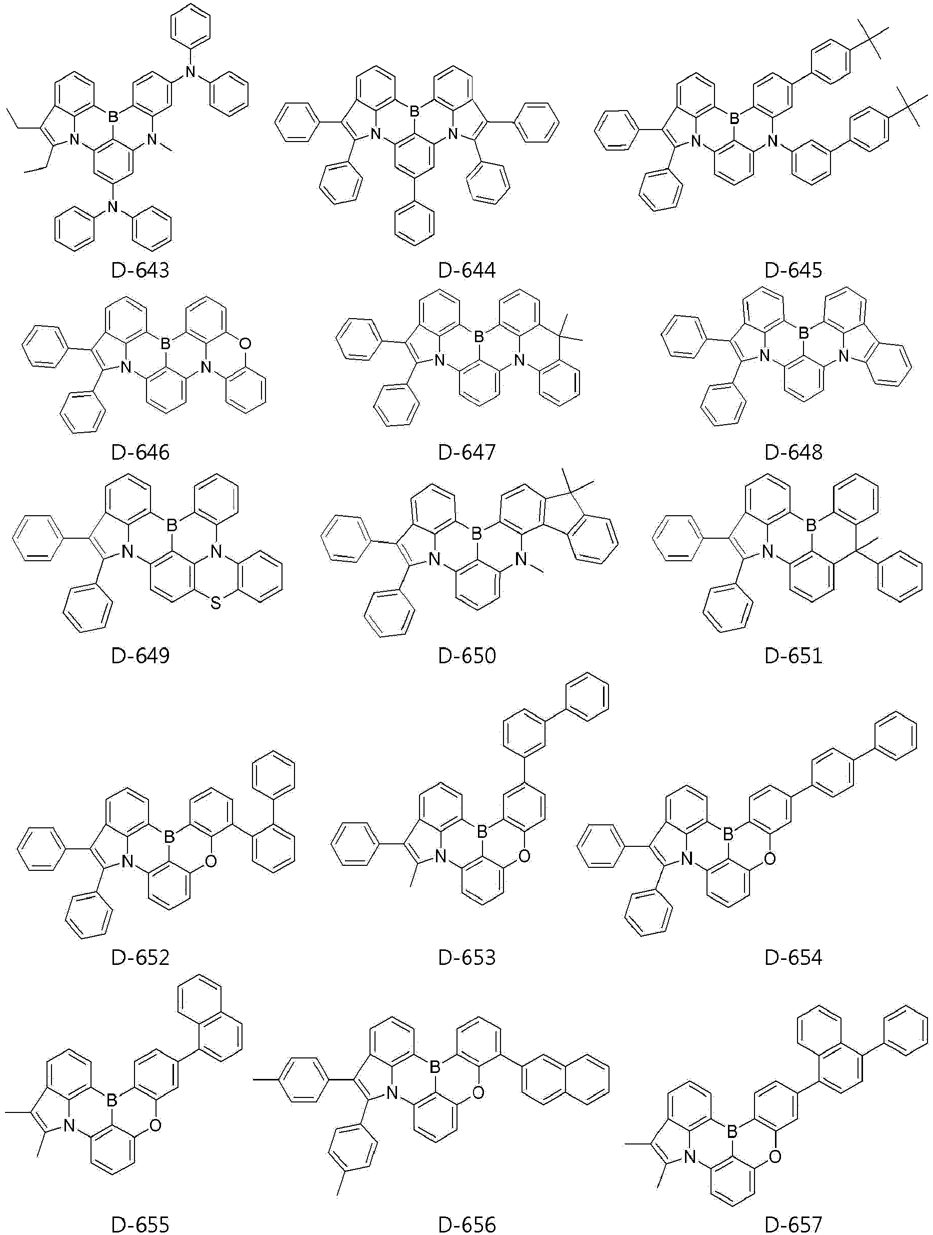

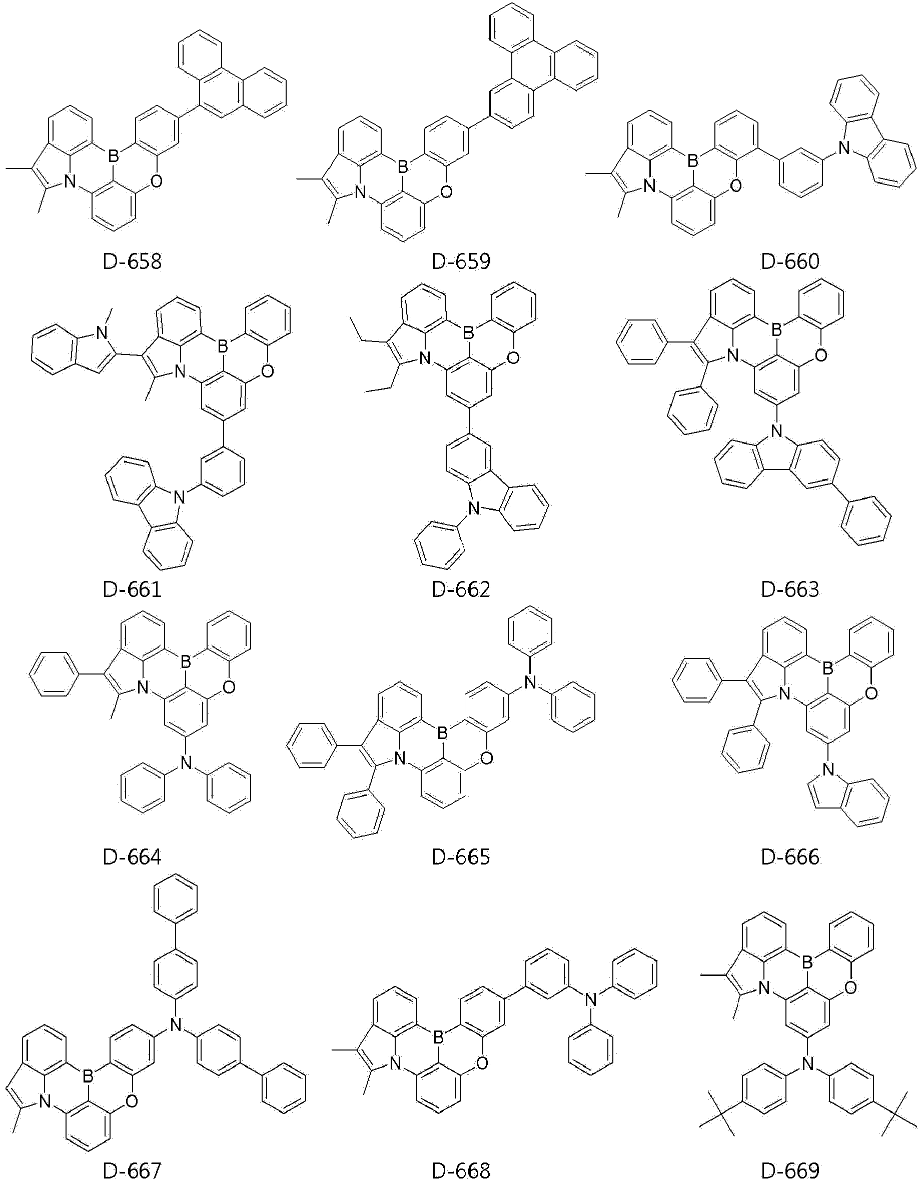

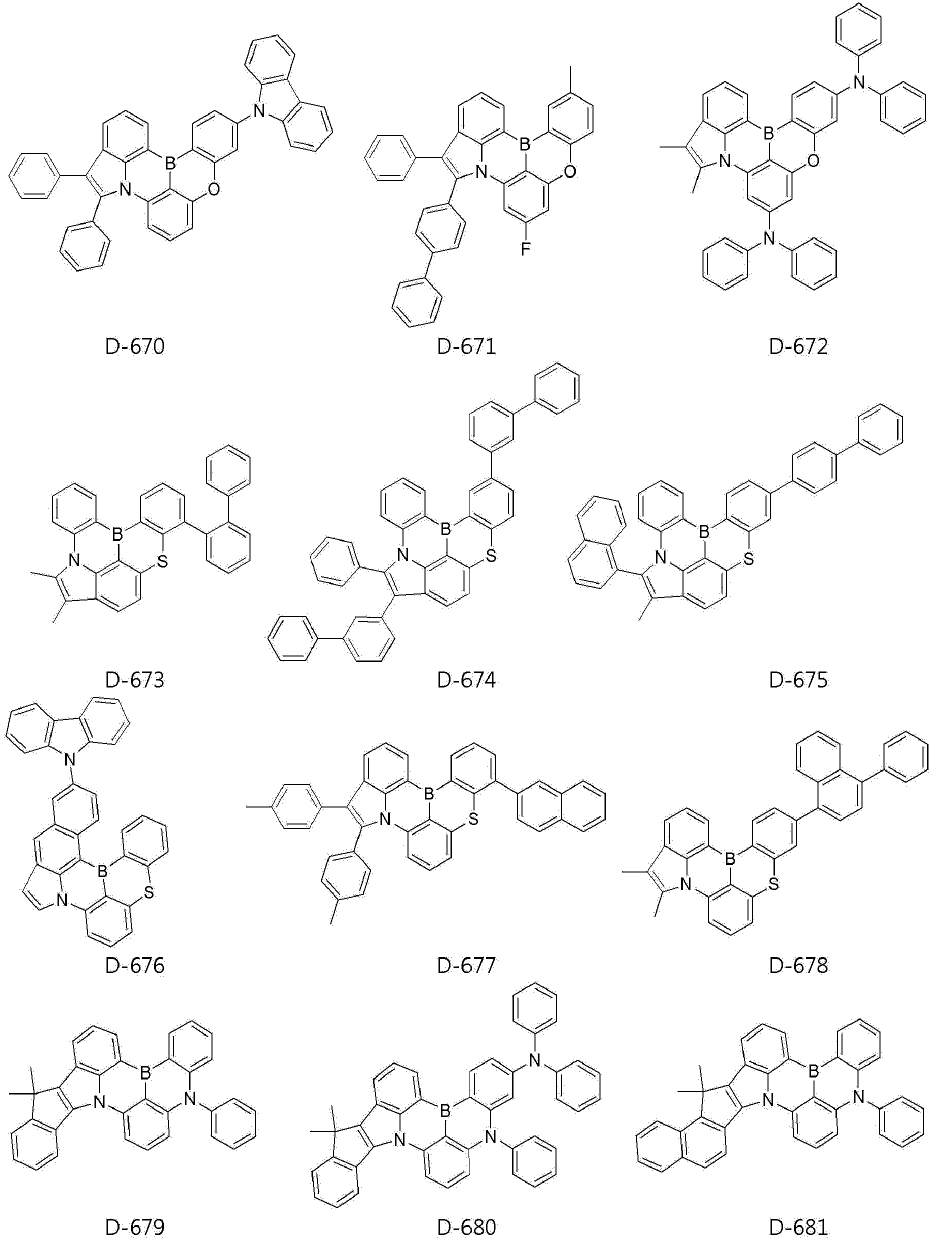

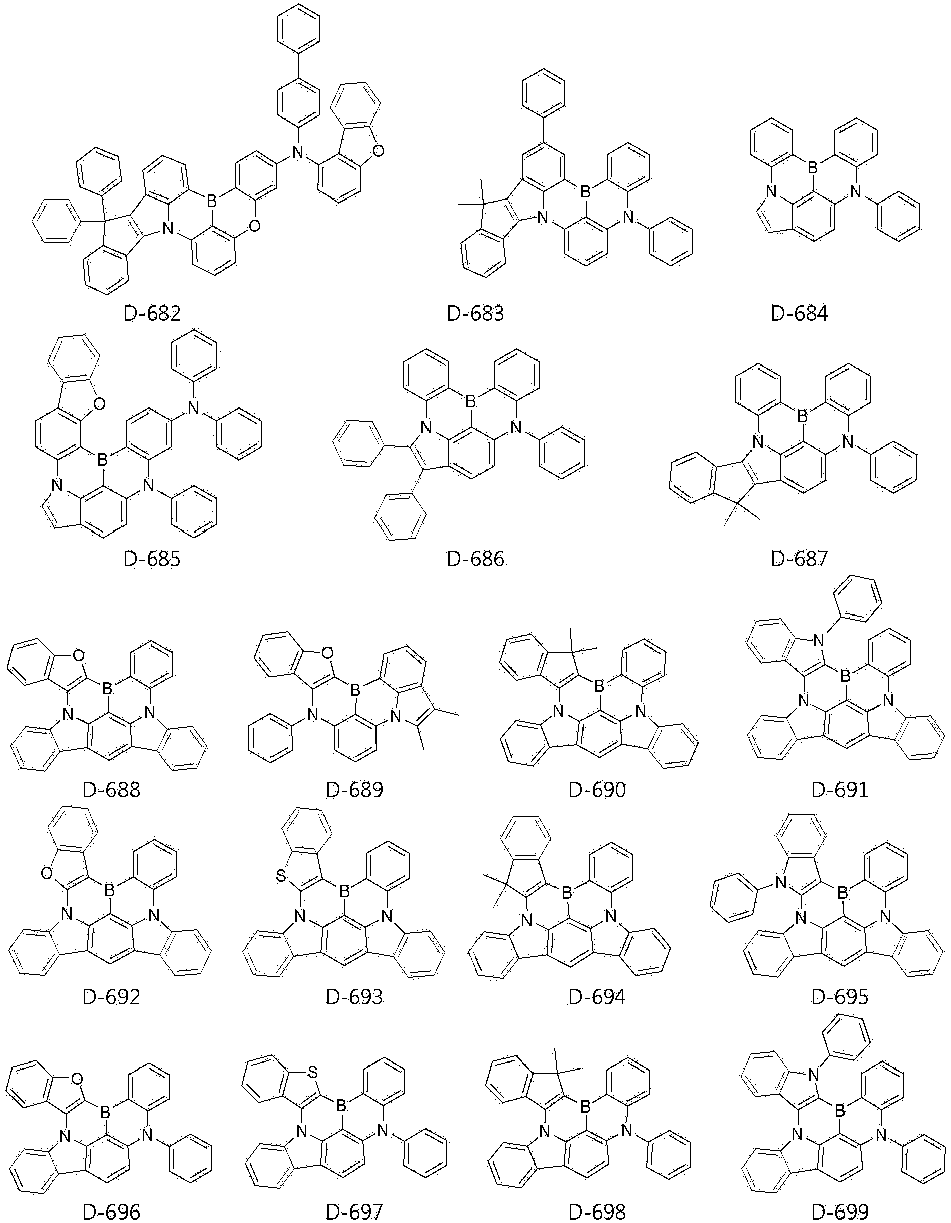

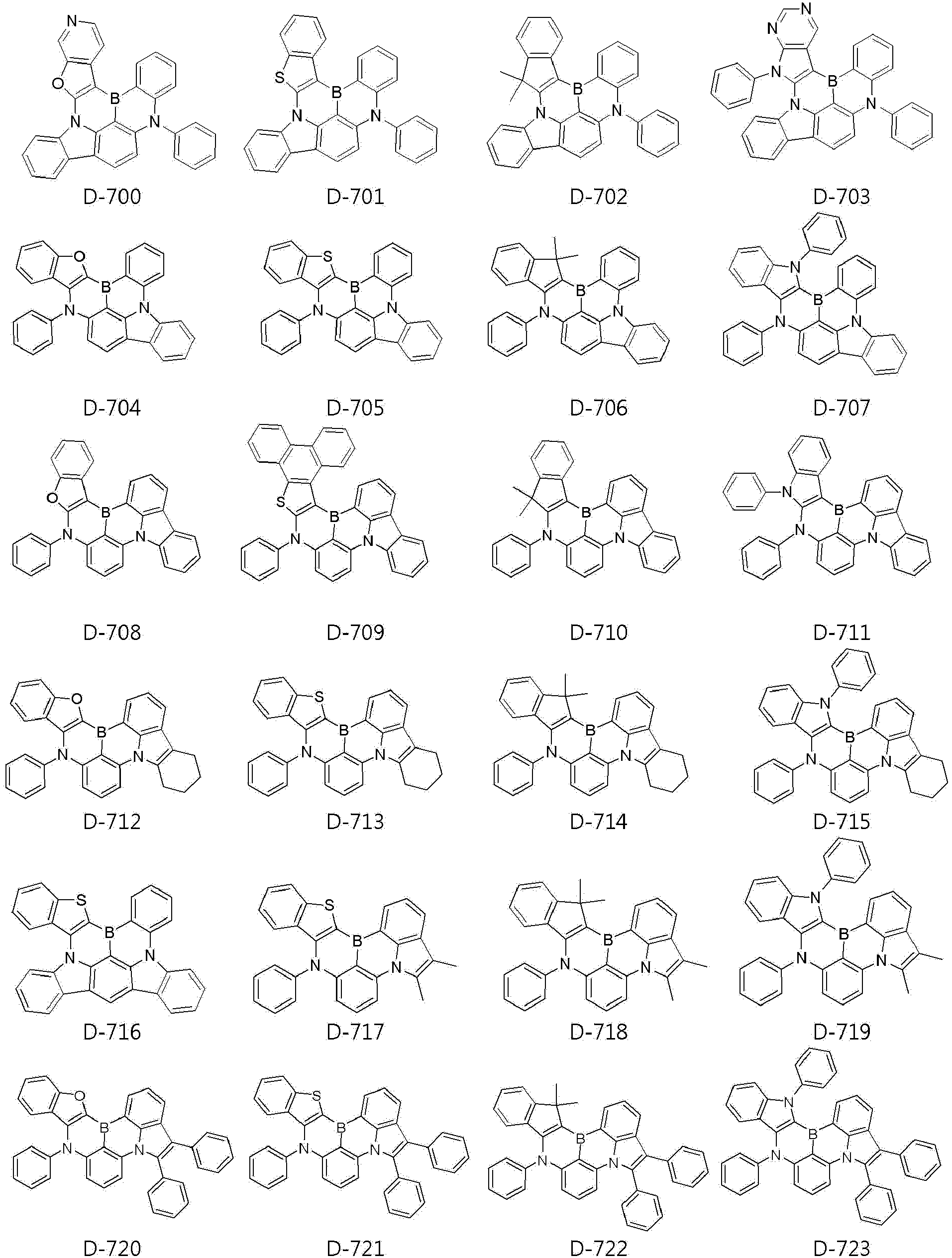

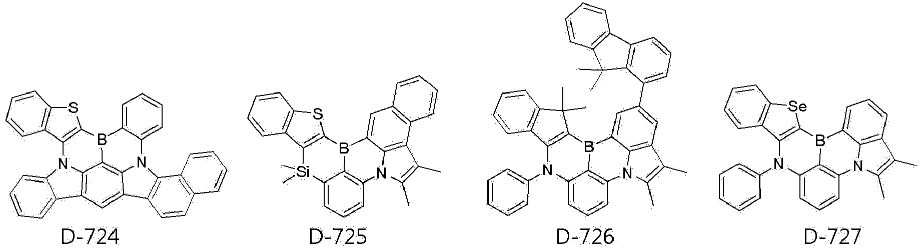

As can be seen from the above specific compounds, the compounds used for the light-emitting layer and the capping layer in the organic light-emitting device according to the present invention have intrinsic characteristics based on the specific skeleton structures and the substituents introduced into the structures and thus can be used to obtain a highly efficient organic light-emitting device.

The organic light-emitting device according to the present invention may have a structure including a first electrode, a second electrode and an organic layer disposed therebetween, and the organic layer of the organic light-emitting device according to the present invention may have a single layer structure or a multilayer structure in which two or more organic layers are stacked. For example, the organic layer may have a structure including a hole injection layer, a hole transport layer, a hole blocking layer, a light-emitting layer, an electron blocking layer, an electron transport layer, an electron injection layer, and the like. However, the structure of the organic layer is not limited thereto and may include a smaller or larger number of organic layers, and the preferred organic material layer structure of the organic light-emitting device according to the present invention will be described in more detail in Example which will be described later.

In addition, the organic light-emitting device according to the present invention includes a substrate, a first electrode (anode), an organic layer, a second electrode (cathode), and a capping layer, and the capping layer is formed under the first electrode (bottom emission) or on the second electrode (top emission) and is preferably formed on the second electrode.

In the configuration in which the capping layer is formed on the second electrode (top emission), the light formed in the light-emitting layer is emitted toward the cathode, and the light emitted toward the cathode passes through the capping layer (CPL) formed of the compound according to the present invention having a relatively high refractive index. At this time, the wavelength is amplified and thus the luminous efficacy is increased. In addition, in the configuration in which the capping layer is formed under the second electrode (bottom emission), the luminous efficacy of the organic electric device is also improved using the compound according to the present invention in the capping layer based on the same principle.

In addition, the organic light-emitting device according to the present invention includes a light-emitting layer interposed between the first electrode and the second electrode, and the light-emitting layer includes a host and a dopant. In this case, the content of the dopant in the light-emitting layer may be determined from about 0.01 to about 20 parts by weight based on about 100 parts by weight of the host, but is not limited thereto.

Hereinafter, an embodiment of the organic light-emitting device according to the present invention will be described in more detail.

The organic light-emitting device according to the present invention includes an anode, a hole transport layer, a light-emitting layer, an electron transport layer and a cathode, and if necessary, may further include a hole injection layer between the anode and the hole transport layer, may further include an electron injection layer between the electron transport layer and the cathode, may further include one or two intermediate layers, and may further include a hole blocking layer or an electron blocking layer. As described above, the organic light-emitting device may further include an organic layer having various functions depending on characteristics thereof.

Meanwhile, a detailed structure of an organic light-emitting device according to an embodiment of the present invention, a method for manufacturing the same, and the material for each organic layer will be described as follows.

First, a substrate is coated with a material for an anode to form the anode. The substrate used herein is a substrate generally used for organic light-emitting devices and is preferably an organic substrate or a transparent plastic substrate that has excellent transparency, surface evenness, handleability and waterproofness. In addition, a material for the anode is indium tin oxide (ITO), indium zinc oxide (IZO), tin oxide (SnO₂), zinc oxide (ZnO), or the like, which is transparent and has excellent conductivity.

A hole injection layer is formed on the anode by vacuum thermal evaporation or spin coating using a material for the hole injection layer, and then a hole transport layer is formed on the hole injection layer by vacuum thermal evaporation or spin coating using a material for the hole transport layer.

The material for the hole injection layer may be used without particular limitation as long as it is commonly used in the art and specific examples thereof include 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], DNTPD [N,N'-diphenyl-N,N'-bis-[4-(phenyl-m-tolyl-amino)-phenyl]-biphenyl-4,4'-diamine], and the like.

In addition, the material for the hole transport layer is also used without particular limitation as long as it is commonly used in the art and is, for example, N,N'-bis(3-methylphenyl)-N,N'-diphenyl-[1,1-biphenyl]-4,4'-diamine (TPD) or N,N'-di(naphthalen-1-yl)-N,N'-diphenylbenzidine (α-NPD).

Subsequently, a hole auxiliary layer and a light-emitting layer are sequentially stacked on the hole transport layer, and a hole blocking layer is selectively deposited on the light-emitting layer by vacuum deposition or spin coating to form a thin film. Because the lifetime and efficiency of the device are reduced when holes are introduced into the cathode through the organic light-emitting layer, the hole blocking layer is formed using a material having a very low HOMO (highest occupied molecular orbital) level so as to prevent this problem. The hole blocking material used herein is not particularly limited and is typically BAlq, BCP or TPBI that has an electron transport ability and has an ionization potential higher than that of a light-emitting compound.

The material used for the hole blocking layer may be BAlq, BCP, Bphen, TPBI, NTAZ, BeBq₂, OXD-7, Liq, or the like, but is not limited thereto.

An electron transport layer is deposited on the hole blocking layer through vacuum deposition or spin coating and a metal for forming a cathode is formed on the electron injection layer through vacuum thermal evaporation to form a cathode. As a result, an organic light-emitting device according to an embodiment is completed.

Here, the metal for forming the cathode may be lithium (Li), magnesium (Mg), aluminum (Al), aluminum-lithium (Al-Li), calcium (Ca), magnesium-indium (Mg-In), magnesium-silver (Mg-Ag) or the like. A transmissive cathode using ITO or IZO may be used in order to obtain a top-emission type light-emitting device.

The material for the electron transport layer functions to stably transport electrons injected from the cathode and may be a well-known electron transport material. Examples of the well-known electron transport material include quinoline derivatives, especially, tris(8-quinolinolate)aluminum (Alq3), TAZ, BAlq, beryllium bis(benzoquinolin-10-olate: Bebq2) and oxadiazole derivatives (PBD, BMD, BND, etc.).

In addition, each of the organic layers may be formed by a monomolecular deposition or solution process. The deposition is a method of forming a thin film by evaporating a material for forming each layer through heating in the presence of a vacuum or low pressure and the solution process is a method of forming a thin film by mixing a material for forming each layer with a solvent and forming the thin film from the mixture through a method such as inkjet printing, roll-to-roll coating, screen printing, spray coating, dip coating, or spin coating.

In addition, the organic light-emitting device according to the present invention may further include a light-emitting layer of a blue light-emitting material, a green light-emitting material, or a red light-emitting material that emits light in a wavelength range of 380 nm to 800 nm. That is, the light-emitting layer of the present invention includes a plurality of light-emitting layers, and a blue light-emitting material, a green light-emitting material, or a red light-emitting material in the additionally formed light-emitting layer may be a fluorescent material or a phosphorescent material.

In addition, the organic light-emitting device is used for a display or lighting system selected from flat panel displays, flexible displays, monochromatic or white flat panel lighting systems, monochromatic or white flexible lighting systems, vehicle displays, and displays for virtual or augmented reality.

Hereinafter, the present invention will be described in more detail with reference to preferred examples. However, it will be obvious to those skilled in the art that these examples are merely provided for illustration of the present invention, and should not be construed as limiting the scope of the present invention.

### Synthesis Example 1. Synthesis of A-20

### Synthesis Example 1-1 : Synthesis of Intermediate 1-a

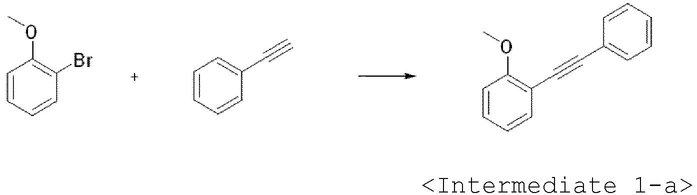

2-bromoanisole (30 g, 0.171 mol), phenylacetylene (38.5 g, 0.377 mol), bis(triphenylphosphine)palladium (II) dichloride (2.41 g, 0.003 mol), copper (I) iodide (1.63 g, 0.009 mol), and triphenylphosphine (0.45 g, 0.002 mol) were stirred under reflux in 300 mL of triethylamine in a 1L reactor overnight. After completion of the reaction, the reaction product was cooled to room temperature and filtered with hexane. The filtrate was concentrated and separated by column chromatography to obtain <Intermediate 1-a>. (25 g, 74%)

### Synthesis Example 1-2 : Synthesis of Intermediate 1-b

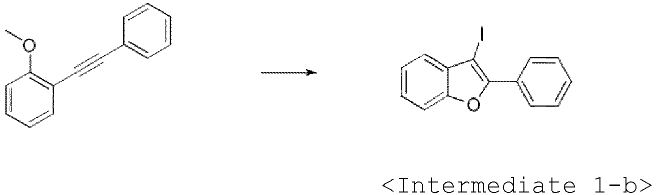

<Intermediate 1-a> (25 g, 0.12 mol) was dissolved in dichloromethane in a 1L reactor and was then purged with nitrogen. Iodine (45.7g, 0.18 mol) was added to the resulting solution, followed by stirring at room temperature for 12 hours. After completion of the reaction, an aqueous sodium thiosulfate solution was added thereto to remove the remaining iodine. The residue was extracted with dichloromethane and then was separated by column chromatography to obtain <Intermediate 1-b> (31 g, 81%).

### Synthesis Example 1-3 : Synthesis of A-20

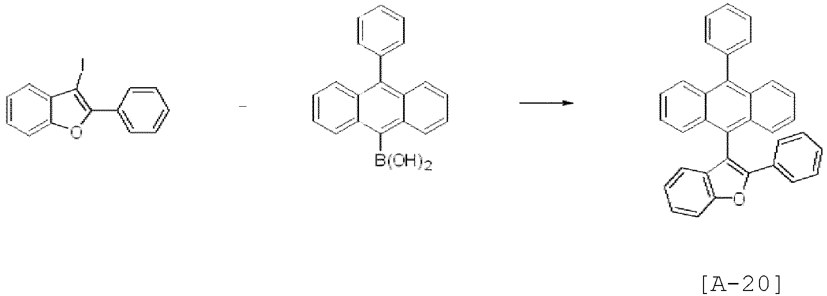

<Intermediate 1-b> (31 g, 0.097 mol), 10-phenylanthracene-9-boronic acid (31.7 g, 0.107 mol), potassium carbonate (26.8 g, 0.194 mol), tetrakis (triphenylphosphine)palladium(0) (2.24 g, 0.002 mol), 210 mL of toluene, and 90 mL of ethanol were stirred under reflux in a 1L reactor at 110°C overnight. The reaction product was cooled to room temperature and then was extracted with ethyl acetate/distilled water, and the organic layer was concentrated and then was separated by column chromatography to obtain [A-20]. (19 g, 44%)
MS (MALDI-TOF) : m/z 446.17 [M⁺]

### Synthesis Example 2. Synthesis of A-30

### Synthesis Example 2-1 : Synthesis of Intermediate 2-a

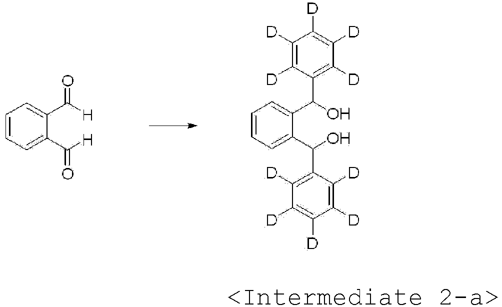

Bromobenzene (d5) (60.4 g, 0.373 mol) and tetrahydrofuran 480 mL were added to a 2L reactor, cooled to -78°C and stirred. N-butyllithium (223.6 mL, 0.357 mol) was added dropwise to the cooled reaction solution, followed by stirring at the same temperature for 1 hour. O-phthalaldehyde (20 g, 0.149 mol) was dissolved in 100 mL of tetrahydrofuran, and the solution was added dropwise to the reaction solution, followed by stirring at room temperature. After completion of the reaction, 200 mL of an aqueous ammonium chloride solution was added thereto to terminate the reaction. The reaction solution was extracted with ethyl acetate, concentrated under reduced pressure and then separated by column chromatography to obtain <Intermediate 2-a> (40 g, 89%).

### Synthesis Example 2-2 : Synthesis of Intermediate 2-b

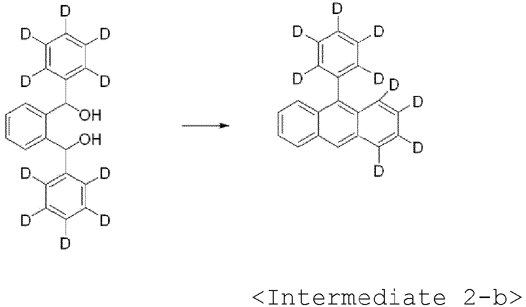

<Intermediate 2-a> (40 g, 0.133 mol) was dissolved in 200 mL of acetic acid in a 500 mL reactor, followed by stirring. 2 mL of hydrogen bromide was added to the reaction solution, followed by stirring at 80°C for 2 hours. After completion of the reaction, the reaction product was cooled to room temperature and the reaction solution was slowly poured into a beaker containing 500 mL of distilled water, followed by stirring. The resulting solid was filtered and washed with distilled water. The solid was separated by column chromatography to obtain <Intermediate 2-b> (13 g, 37%).

### Synthesis Example 2-3 : Synthesis of Intermediate 2-c

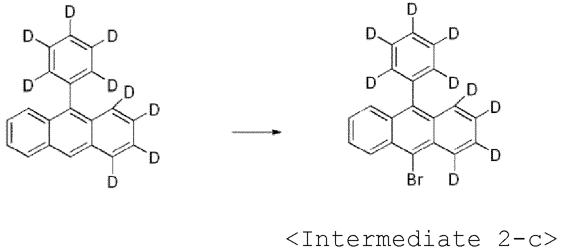

<Intermediate 2-b> (13 g, 0.049 mol) was dissolved in 130 mL of N,N-dimethylamide in a 500 mL reactor, followed by stirring at room temperature. N-bromosuccinimide (10.5 g, 0.059 mol) was dissolved in 40 mL of N,N-dimethylamide and the resulting solution was added dropwise to the reaction solution. The completion of the reaction was determined by thin film chromatography. The reaction solution was slowly poured into a beaker containing 500 mL of distilled water, followed by stirring. The resulting solid was filtered and washed with distilled water. The result was separated by column chromatography to obtain <Intermediate 2-c> (14 g, 83%).

### Synthesis Example 2-4 : Synthesis of Intermediate 2-d

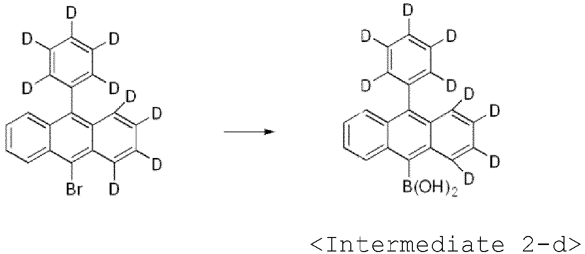

<Intermediate 2-c> (50 g, 0.146 mol) was dissolved in 500 mL of tetrahydrofuran in a 500 mL reactor, and cooled to -78°C, and n-butyllithium (100 ml, 0.161 mol) was added dropwise to the resulting solution. The resulting mixture was stirred for 5 hours and trimethyl borate (18 mL, 0.161 mol) was added thereto, followed by stirring at room temperature overnight. After completion of the reaction, the reaction product was acidified with 2N hydrochloric acid and then recrystallized to obtain <Intermediate 2-d> (25 g, 56%).

### Synthesis Example 2-5 : Synthesis of A-30

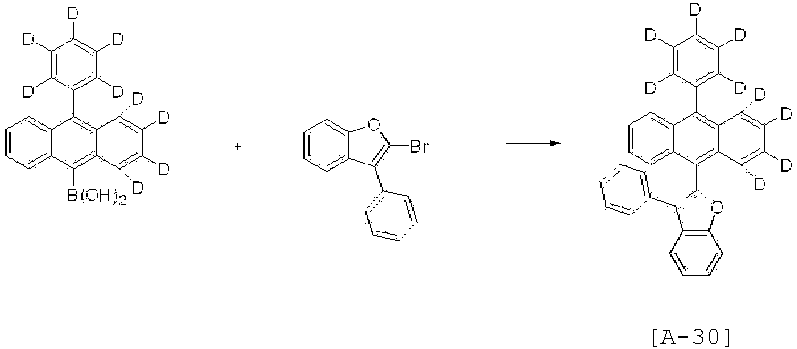

[A-30] was obtained in the same manner as in Synthesis Example 1-3, except that 2-bromo-3-phenylbenzofuran was used instead of <Intermediate 1-b> and <Intermediate 2-d> was used instead of 10-phenylanthracene-9-boronic acid. (yield 30%)
MS (MALDI-TOF) : m/z 531.25 [M⁺]

### Synthesis Example 3. Synthesis of A-57

### Synthesis Example 3-1 : Synthesis of Intermediate 3-a

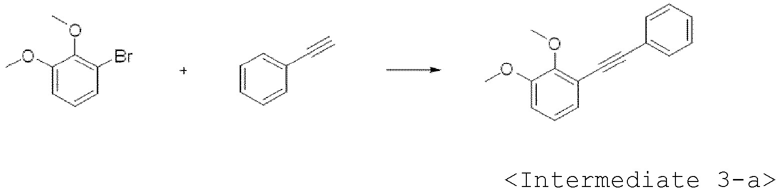

<Intermediate 3-a> was obtained in the same manner as in Synthesis Example 1-1, except that 3-bromoveratrole was used instead of 2-bromoanisole. (yield 79%)

### Synthesis Example 3-2 : Synthesis of Intermediate 3-b

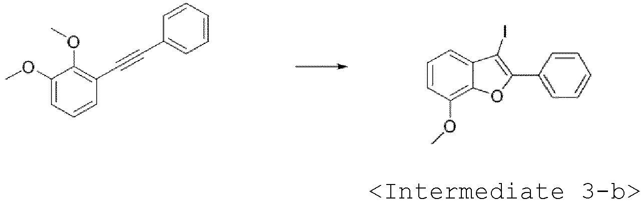

<Intermediate 3-b> was obtained in the same manner as in Synthesis Example 1-2, except that <Intermediate 3-a> was used instead of <Intermediate 1-a>. (yield 63%)

### Synthesis Example 3-3 : Synthesis of Intermediate 3-c

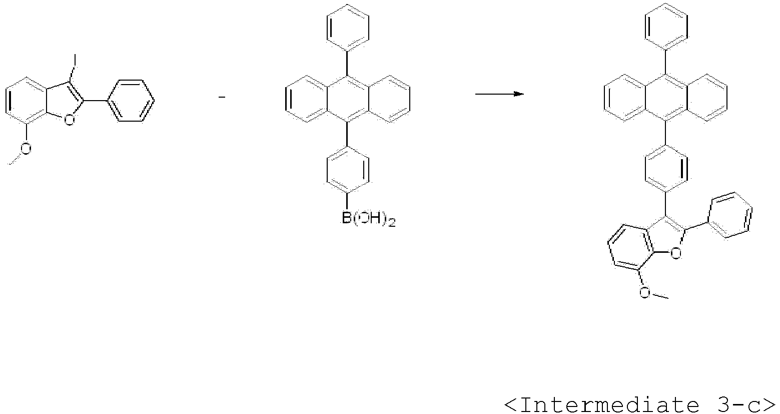

<Intermediate 3-c> was obtained in the same manner as in Synthesis Example 1-3, except that <Intermediate 3-b> was used instead of <Intermediate 1-b> and 4-(10-phenylanthracen-9-yl)benzeneboronic acid was used instead of 10-phenylanthracene-9-boronic acid. (yield 61%)

### Synthesis Example 3-4 : Synthesis of intermediate 3-d

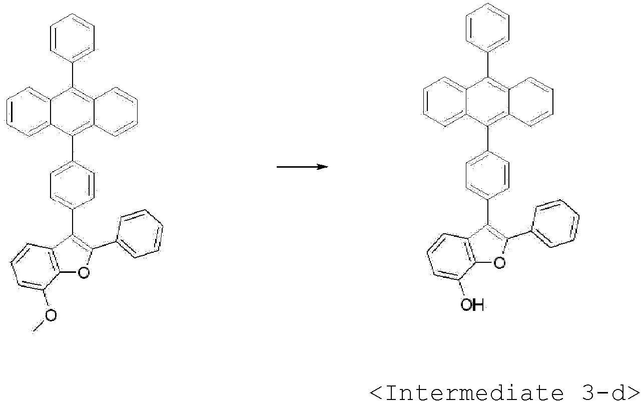

<Intermediate 3-c> (20 g, 0.036 mol) was dissolved in dichloromethane in a 500 mL reactor. The temperature of the reactor was cooled to 0°C, BBr₃ (13.6 g, 0.054 mol) was slowly added thereto, and the reactor was allowed to warm to room temperature, followed by stirring for 2 hours. After completion of the reaction, cold distilled water was slowly added thereto to complete the reaction. The reaction product was extracted with dichloromethane and distilled water, and the organic layer was concentrated and then separated by column chromatography to obtain <Intermediate 3-d>. (17 g, 87%)

### Synthesis Example 3-5 : Synthesis of Intermediate 3-e

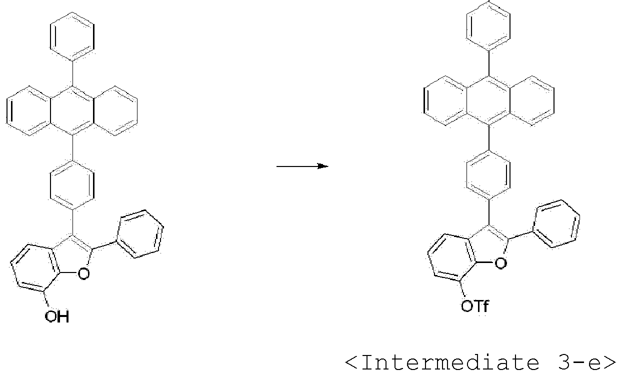

<Intermediate 3-d> (17 g, 0.032 mol) was dissolved in 170 mL of dichloromethane in a 500 mL reactor. The temperature of the reactor was reduced to 0°C, trifluoromethanesulfonic anhydride (10.7 g, 0.048 mol) was slowly added thereto, the reaction product was stirred at room temperature for 3 hours and cold distilled water was slowly added thereto to complete the reaction. The reaction product was extracted with dichloromethane and distilled water, and the organic layer was concentrated and then separated by column chromatography to obtain <Intermediate 3-e>. (17 g, 80%)

### Synthesis Example 3-6 : Synthesis of A-57

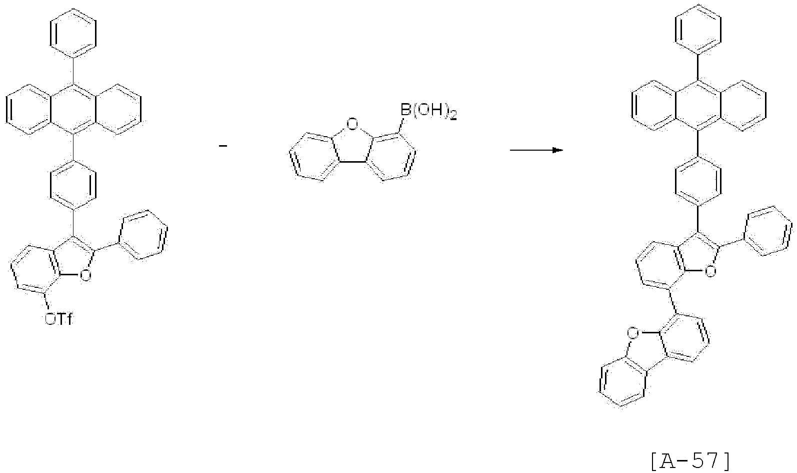

[A-57] was obtained in the same manner as in Synthesis Example 1-3, except that <Intermediate 3-e> was used instead of <Intermediate 1-b> and 4-dibenzofuran boronic acid was used instead of 10-phenylanthracene-9-boronic acid. (yield 45%)
MS (MALDI-TOF) : m/z 688.24 [M⁺]

### Synthesis Example 4. Synthesis of A-58

### Synthesis Example 4-1 : Synthesis of Intermediate 4-a

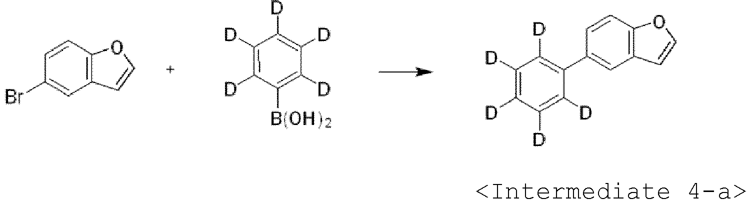

<Intermediate 4-a> was obtained in the same manner as in Synthesis Example 1-3, except that 5-bromobenzofuran was used instead of <Intermediate 1-b> and (phenyl-d5)boronic acid was used instead of 10-phenylanthracene-9-boronic acid. (yield 70%)

### Synthesis Example 4-2 : Synthesis of Intermediate 4-b

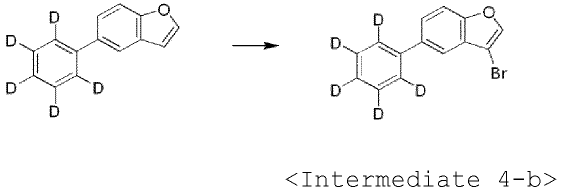

<Intermediate 4-a> (21.2 g, 0.106 mol) and dichloromethane were added to a 500 mL reactor and cooled to -10°C, and bromine was added thereto, followed by stirring for 1 hour. An aqueous sodium thiosulfate solution was added to the reaction solution, followed by stirring and layer separation. The organic layer was concentrated under reduced pressure. Ethanol was added to the result, followed by cooling to -10°C. Then, potassium hydroxide was dissolved in ethanol and the resulting solution was added to the reaction product, followed by refluxing for 4 hours. After completion of the reaction, layers were separated from the reaction product, and the organic layer was concentrated under reduced pressure and then separated by column chromatography <Intermediate 4-b>. (20 g, 70%)

### Synthesis Example 4-3 : Synthesis of Intermediate 4-c

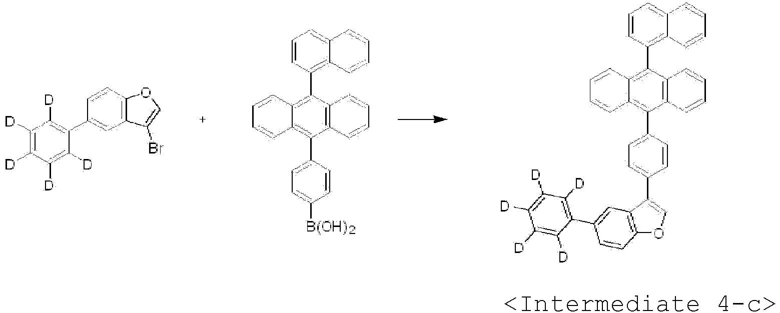

<Intermediate 4-c> was obtained in the same manner as in Synthesis Example 1-3, except that <Intermediate 4-b> was used instead of <Intermediate 1-b> and (4-(10-naphthalen-1-yl)anthracen-9-yl)benzeneboronic acid was used instead of 10-phenylanthracene-9-boronic acid. (yield 72%)

### Synthesis Example 4-4 : Synthesis of Intermediate 4-d

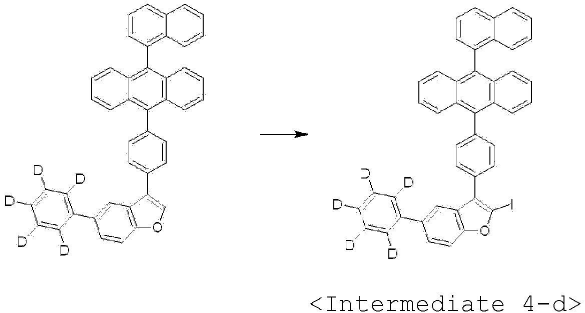

<Intermediate 4-c> (20 g, 0.035 mol) and 250 mL of THF were added to a 500 mL reactor and cooled to -50°C, and n-butyllithium (1.6M) was added thereto. 1 hour later, iodine was slowly added and the reactor was slowly allowed to warm to room temperature. An aqueous sodium thiosulfate solution was added to the reaction solution at room temperature, followed by layer separation. The organic layer was concentrated under reduced pressure and then separated by column chromatography to obtain <Intermediate 4-d> (17 g, 70%).

### Synthesis Example 4-5 : Synthesis of A-58

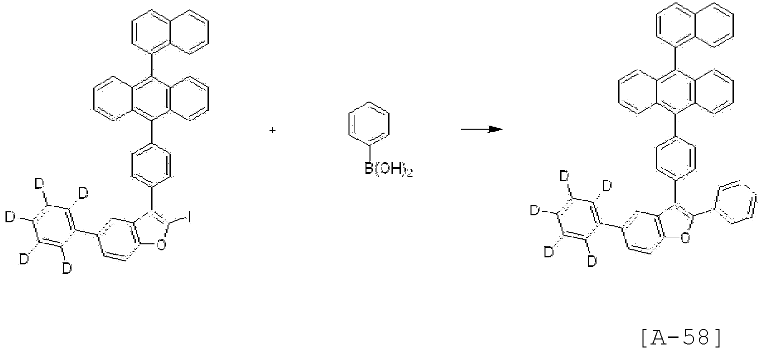

<A-58> was obtained in the same manner as in Synthesis Example 1-3, except that <Intermediate 4-d> was used instead of <Intermediate 1-b> and phenylboronic acid was used instead of 10-phenylanthracene-9-boronic acid. (yield 47%)
MS (MALDI-TOF) : m/z 653.28 [M⁺]

### Synthesis Example 5. Synthesis of A-68

### Synthesis Example 5-1 : Synthesis of Intermediate 5-a

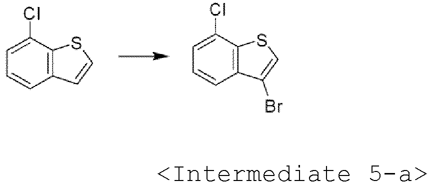

7-chlorobenzo[b]thiophene (30 g, 0.178 mol) and DMF were added to a 500 mL reactor, followed by stirring. Then, NBS was added to the reaction solution, followed by stirring under reflux for 6 hours and addition of distilled water. The layers were separated, and the organic layer was concentrated under reduced pressure and then separated by column chromatography to obtain <Intermediate 5-a> (27 g, 62%).

### Synthesis Example 5-2 : Synthesis of Intermediate 5-b

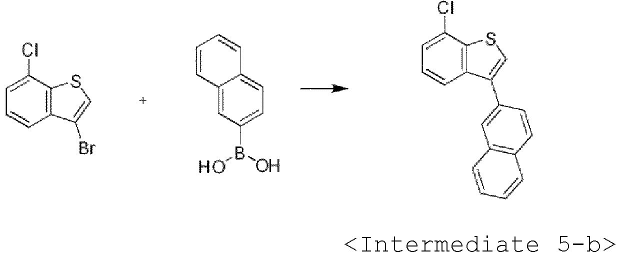

<Intermediate 5-b> was obtained in the same manner as in Synthesis Example 1-3, except that <Intermediate 5-a> was used instead of <Intermediate 1-b> and 2-naphthylboronic acid was used instead of 10-phenylanthracene-9-boronic acid. (yield 68%)

### Synthesis Example 5-3 : Synthesis of Intermediate 5-c

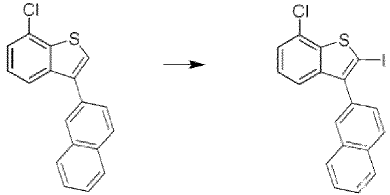

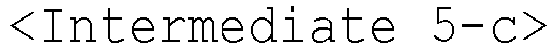

<Intermediate 5-c> was obtained in the same manner as in Synthesis Example 4-4, except that <Intermediate 5-b> was used instead of <Intermediate 4-c>. (yield 70%)

### Synthesis Example 5-4 : Synthesis of Intermediate 5-d

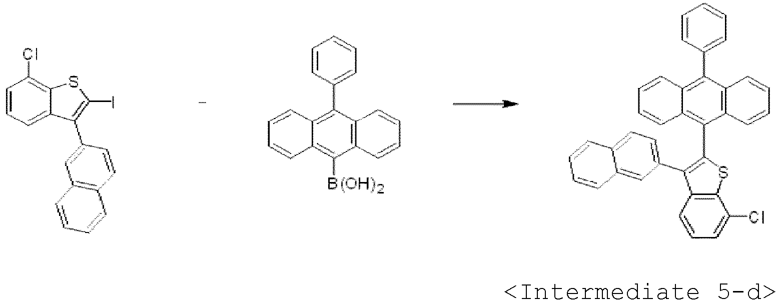

<Intermediate 5-d> was obtained in the same manner as in Synthesis Example 1-3, except that <Intermediate 5-c> was used instead of <Intermediate 1-b>. (yield 63%)

### Synthesis Example 5-5 : Synthesis of Intermediate 5-e

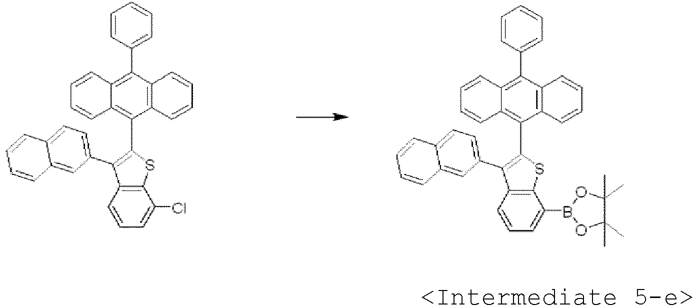

<Intermediate 5-d> (30 g, 0.055 mol), bis(pinacolato)diboron (16.7 g, 0.066 mol), palladium (II) dichloride (diphenylphosphine ferrocene) (1.3 g, 0.002 mol), potassium acetate (16.2 g, 0.165 mol), X-phos (2.6 g, 0.005 mol), and 300 mL of 1,4-dioxane were refluxed in a 1L flask. After completion of the reaction, the reaction solution was concentrated under reduced pressure and then separated by column chromatography to obtain <Intermediate 5-e>. (27 g, 77%)

### Synthesis Example 5-6 : Synthesis of A-68

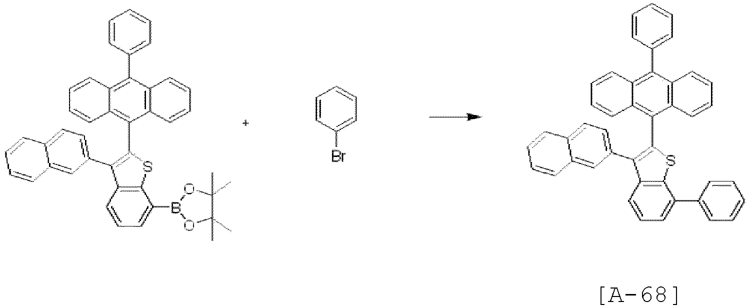

[A-68] was obtained in the same manner as in Synthesis Example 1-3, except that <Intermediate 5-e> was used instead of <Intermediate 1-b> and bromobenzene was used instead of 10-phenylanthracene-9-boronic acid. (yield 69%)
MS (MALDI-TOF) : m/z 588.19 [M⁺]

### Synthesis Example 6. Synthesis of A-79

### Synthesis Example 6-1 : Synthesis of Intermediate 6-a

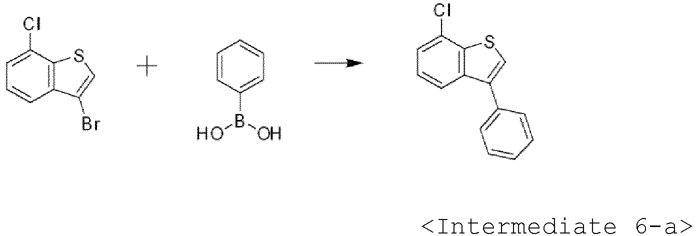

<Intermediate 6-a> was obtained in the same manner as in Synthesis Example 5-2, except that phenylboronic acid was used instead of 2-naphthylboronic acid. (yield 70%)

### Synthesis Example 6-2 : Synthesis of Intermediate 6-b

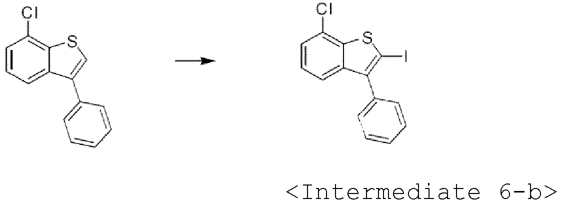

<Intermediate 6-b> was obtained in the same manner as in Synthesis Example 4-4, except that <Intermediate 6-a> was used instead of <Intermediate 4-c>. (yield 70%)

### Synthesis Example 6-3 : Synthesis of Intermediate 6-c

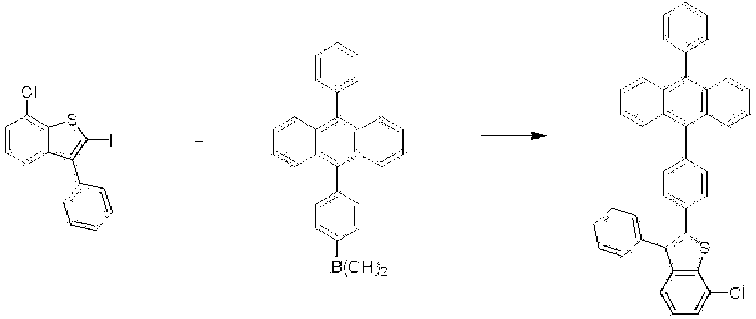

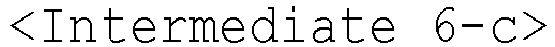

<Intermediate 6-c> was obtained in the same manner as in Synthesis Example 1-3, except that <Intermediate 6-b> was used instead of <Intermediate 1-b> and 4-(10-phenylanthracen-9-yl)benzeneboronic acid was used instead of 10-phenylanthracene-9-boronic acid. (yield 65%)

### Synthesis Example 6-4 : Synthesis of Intermediate 6-d

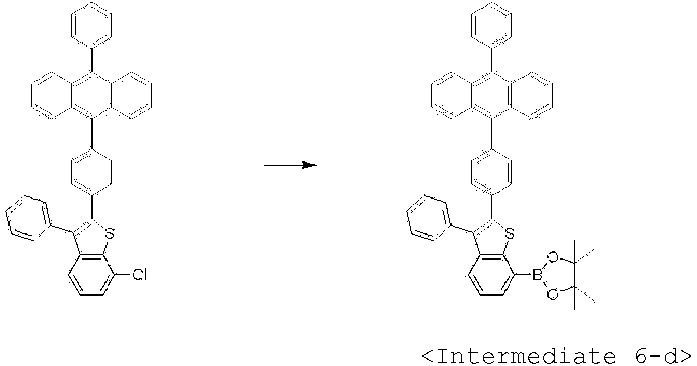

<Intermediate 6-d> was obtained in the same manner as in Synthesis Example 5-5, except that <Intermediate 6-c> was used instead of <Intermediate 5-d>. (yield 72%)

### Synthesis Example 6-5 : Synthesis of A-79

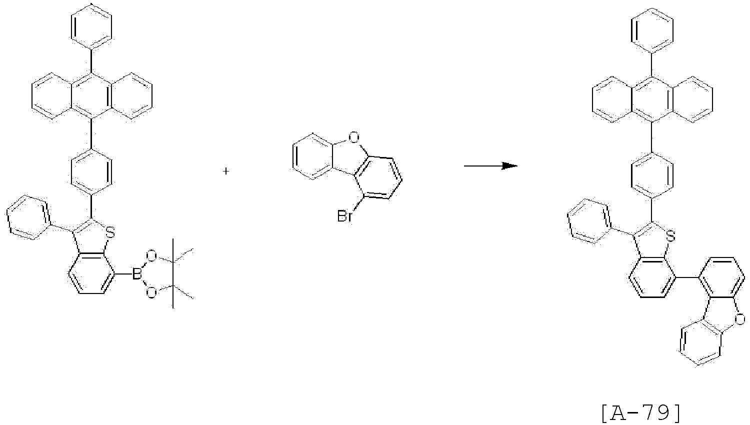

[A-79] was obtained in the same manner as in Synthesis Example 1-3, except that <Intermediate 6-d> was used instead of <Intermediate 1-b> and 1-bromodibenzo[b,d]furan was used instead of 10-phenylanthracene-9-boronic acid. (yield 75%)
MS (MALDI-TOF) : m/z 704.22 [M⁺]

### Synthesis Example 7. Synthesis of A-89

### Synthesis Example 7-1 : Synthesis of Intermediate 7-a

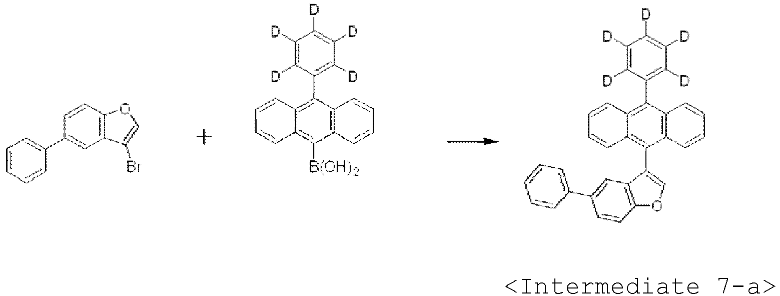

<Intermediate 7-a> was obtained in the same manner as in Synthesis Example 1-3, except that 3-bromo-5-phenylbenzofuran was used instead of <Intermediate 1-b> and 10-(phenyl-d5)-anthracene-9-boronic acid was used instead of 10-phenylanthracene-9-boronic acid. (yield 31%)

### Synthesis Example 7-2 : Synthesis of Intermediate 7-b

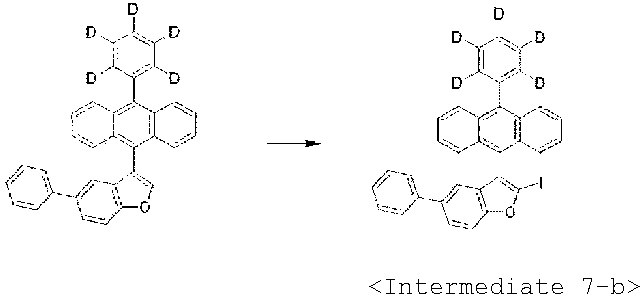

<Intermediate 7-b> was obtained in the same manner as in Synthesis Example 4-4, except that <Intermediate 7-a> was used instead of <Intermediate 4-c>. (yield 71%)

### Synthesis Example 7-3 : Synthesis of A-89

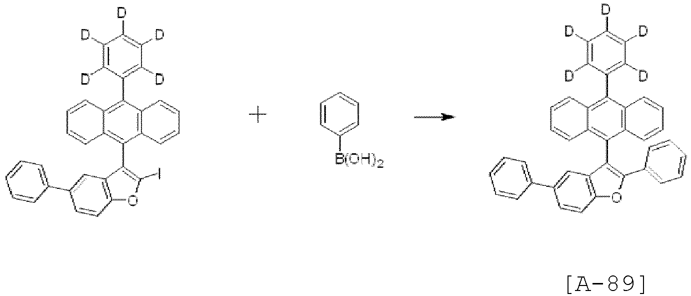

[A-89] was obtained in the same manner as in Synthesis Example 1-3, except that <Intermediate 7-b> was used instead of <Intermediate 1-b> and phenylboronic acid was used instead of 10-phenylanthracene-9-boronic acid. (yield 51%)
MS (MALDI-TOF) : m/z 527.23 [M⁺]

### Synthesis Example 8. Synthesis of A-90

### Synthesis Example 8-1 : Synthesis of Intermediate 8-a

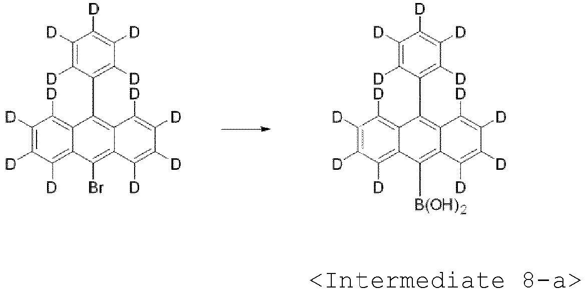

<Intermediate 8-a> was obtained in the same manner as in Synthesis Example 2-4, except that (anthracene-d8)-9-bromo-10-(phenyl-d5) was used instead of <Intermediate 2-c>. (yield 55%)

### Synthesis Example 8-2 : Synthesis of Intermediate 8-b

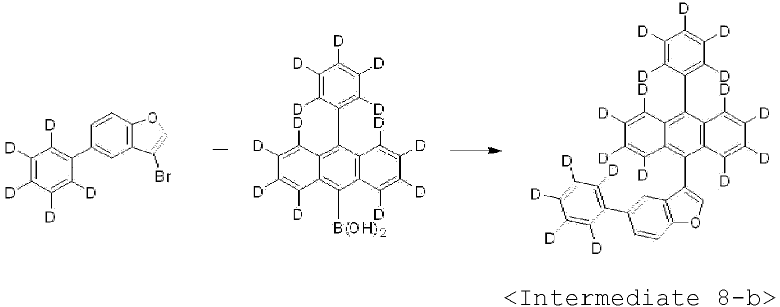

<Intermediate 8-b> was obtained in the same manner as in Synthesis Example 4-3, except that <Intermediate 8-a> was used instead of (4-(10-naphthalen-1-yl)anthracen-9-yl)benzeneboronic acid. (yield 55%)

### Synthesis Example 8-3 : Synthesis of Intermediate 8-c

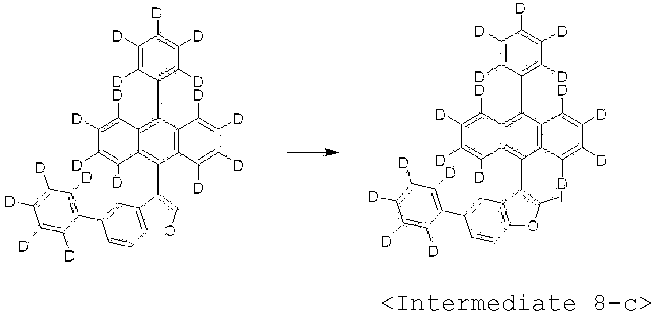

<Intermediate 8-c> was obtained in the same manner as in Synthesis Example 4-4, except that <Intermediate 8-b> was used instead of <Intermediate 4-c>. (yield 67%)

### Synthesis Example 8-4 : Synthesis of A-90

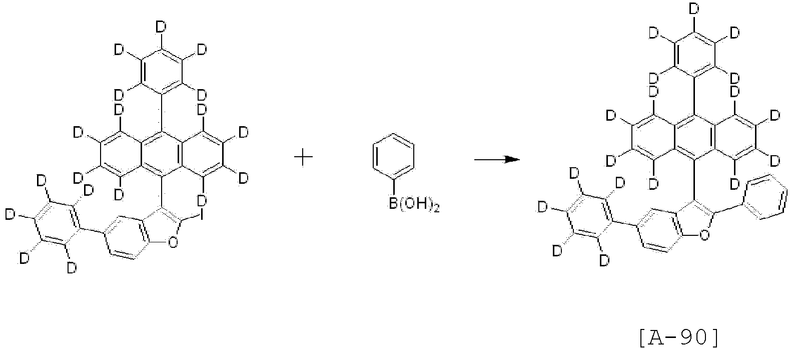

[A-90] was obtained in the same manner as in Synthesis Example 7-3, except that <Intermediate 8-c> was used instead of <Intermediate 7-b>. (yield 47%)
MS (MALDI-TOF) : m/z 540.31 [M⁺]

### Synthesis Example 9. Synthesis of A-91

### Synthesis Example 9-1 : Synthesis of Intermediate 9-a

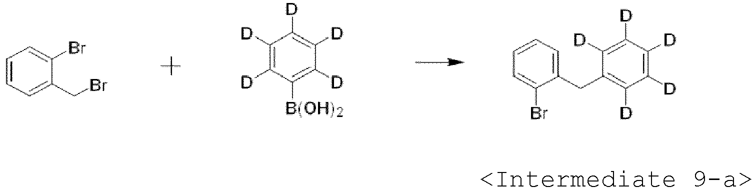

Bromobenzyl bromide (20 g, 0.08 mol), (phenyl-d5)boronic acid (10 g, 0.078 mol), sodium carbonate (10 g, 0.1 mol), and tetrakis(triphenylphosphine)palladium(0) (1.8 g, 0.002 mol) were heated to 50°C in a 500 mL reactor and refluxed. 1 hour later, distilled water was added to the result, followed by stirring and layer separation. The organic layer was filtered, washed with toluene and then concentrated under reduced pressure. Then, the result was separated by column chromatography to obtain <Intermediate 9-a>. (16 g, 82%)

### Synthesis Example 9-2 : Synthesis of Intermediate 9-b

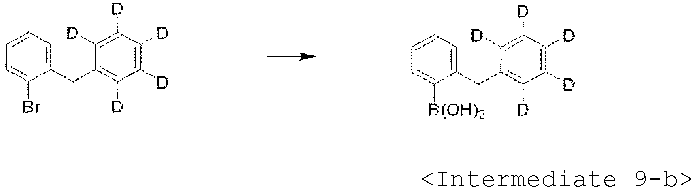

<Intermediate 9-a> (20 g, 0.08 mol) and THF 200 mL were added to a 500 mL reactor and then cooled to -78°C and n-butyllithium (1.6 M) was added thereto. Further, trimethyl borate was slowly added thereto and slowly allowed to warm to room temperature. A 2M aqueous HCl solution was added to the result and stirred for 20 minutes, and layers were separated and washed with distilled water. The organic layer was concentrated and recrystallized with THF and heptane to obtain <Intermediate 9-b> (11 g, 63%).

### Synthesis Example 9-3 : Synthesis of Intermediate 9-c

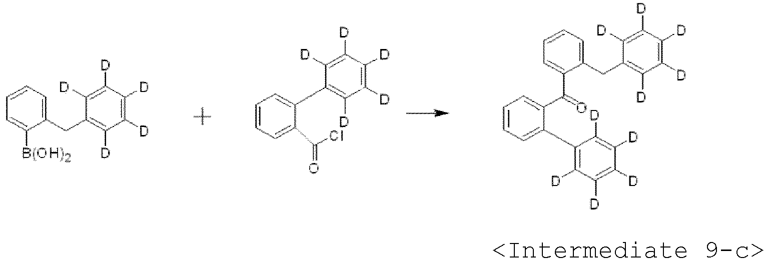

<Intermediate 9-b> (15 g, 0.07 mol), cesium carbonate (34 g, 0.1 mol), tetrakis(triphenylphosphine)palladium(O) (2.4 g, 0.002 mol), and toluene 150 mL were added to a 500 mL reactor and stirred. 1,1'-(biphenyl-d5)-2-carbonyl chloride (20 g, 0.09 mol) was added dropwise to the resulting reaction, followed by heating to 110°C and refluxing. 2 hours later, toluene and distilled water were added to the result, followed by stirring and layer separation. The organic layer was filtered, concentrated under reduced pressure and then separated by column chromatography to obtain <Intermediate 9-c> (14 g, 57%).

### Synthesis Example 9-4 : Synthesis of Intermediate 9-d

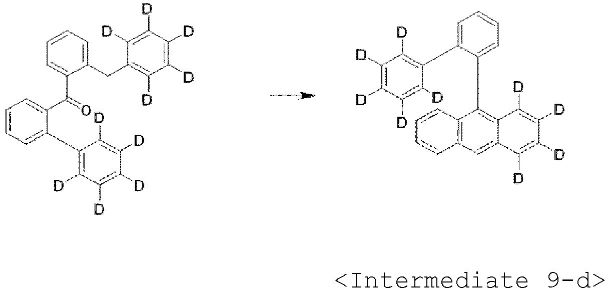

<Intermediate 9-c> (20 g, 0.06 mol), In(OTf)3 (3.1 g, 0.006 mol), and dichlorobenzene 120 mL were added to a 500 mL reactor, heated to 110°C and refluxed. 24 hours later, the result was filtered at 50°C through celite, and washed with MC to separate the organic layer. The organic layer was concentrated under reduced pressure and separated by column chromatography. Then, the result was recrystallized to obtain <Intermediate 9-d>. (8 g, 43%)

### Synthesis Example 9-5 : Synthesis of Intermediate 9-e

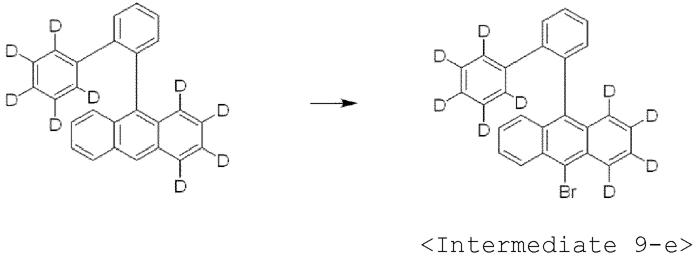

<Intermediate 9-d> (30 g, 0.09 mol) and DMF 300 mL were stirred in a 500 mL reactor and cooled to 0°C, and NBS (16 g, 0.09 mol) was added thereto, followed by allowing to warm to room temperature and stirring. 3 hours later, distilled water was added thereto, followed by filtering, washing and separation by column chromatography. Then, the result was recrystallized with methanol to obtain <Intermediate 9-e>. (33 g, 89%)

### Synthesis Example 9-6 : Synthesis of Intermediate 9-f

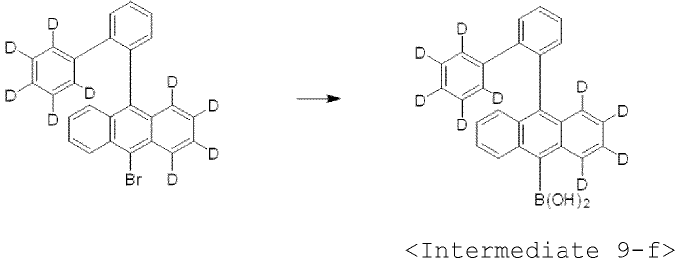

<Intermediate 9-f> was obtained in the same manner as in Synthesis Example 2-4, except that <Intermediate 9-e> was used instead of <Intermediate 2-c>. (yield 53%)

### Synthesis Example 9-7 : Synthesis of A-91

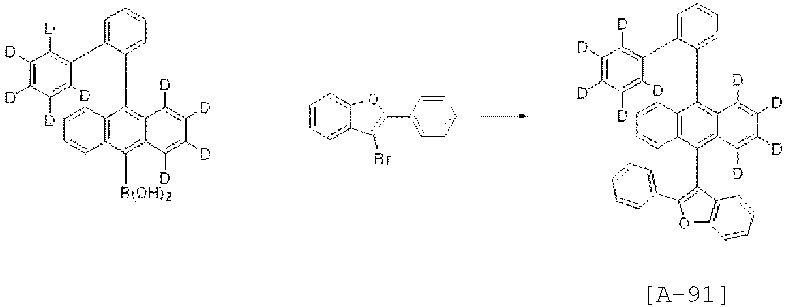

[A-91] was obtained in the same manner as in Synthesis Example 1-3, except that 3-bromo-2-phenylbenzofuran was used instead of <Intermediate 1-b> and <Intermediate 9-f> was used instead of 10-phenylanthracene-9-boronic acid. (yield 52%)
MS (MALDI-TOF) : m/z 531.25 [M⁺]

### Synthesis Example 10. Synthesis of A-92

### Synthesis Example 10-1 : Synthesis of Intermediate 10-a

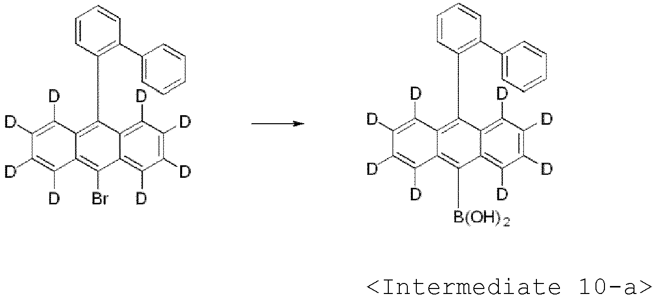

<Intermediate 10-a> was obtained in the same manner as in Synthesis Example 2-4, except that (anthracene-d8)-9-bromo-10-(1,1-biphenyl) was used instead of <Intermediate 2-c>. (yield 52%)

### Synthesis Example 10-2 : Synthesis of Intermediate 10-b

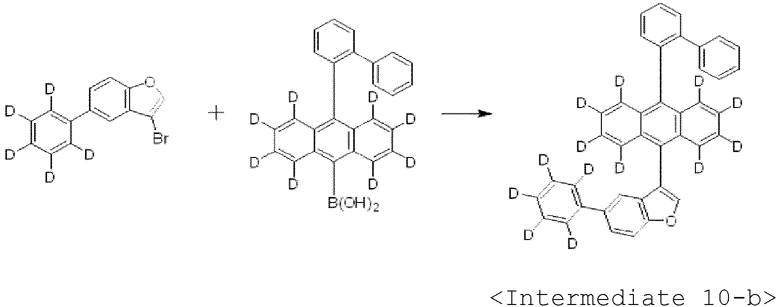

<Intermediate 10-b> was obtained in the same manner as in Synthesis Example 4-3, except that <Intermediate 10-a> was used instead of (4-(10-naphthalen-1-yl)anthracen-9-yl)benzeneboronic acid. (yield 54%)

### Synthesis Example 10-3 : Synthesis of Intermediate 10-c

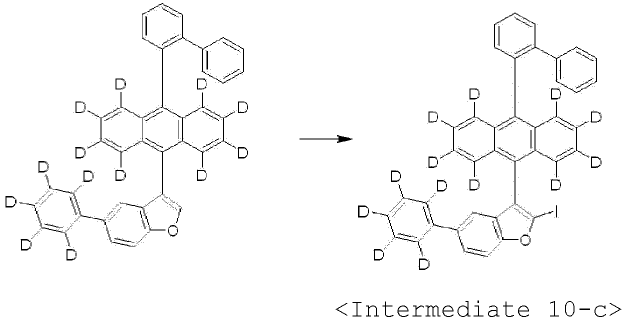

<Intermediate 10-c> was obtained in the same manner as in Synthesis Example 4-4, except that <Intermediate 10-b> was used instead of <Intermediate 4-c>. (yield 64%)

### Synthesis Example 10-4 : Synthesis of A-92

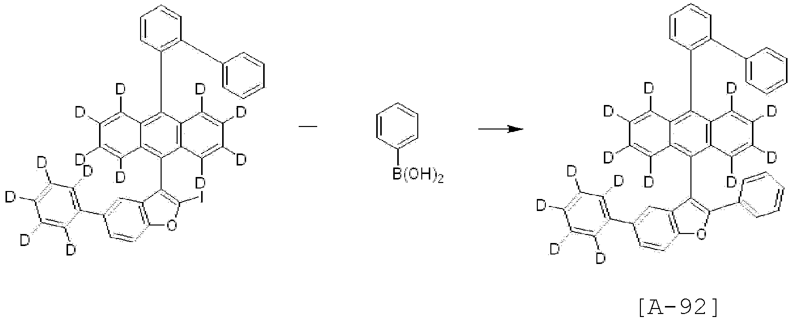

[A-92] was obtained in the same manner as in Synthesis Example 7-3, except that <Intermediate 10-c> was used instead of <Intermediate 7-b>. (yield 45%)
MS (MALDI-TOF) : m/z 611.31 [M⁺]

### Synthesis Example 11. Synthesis of A-116

### Synthesis Example 11-1 : Synthesis of Intermediate 11-a

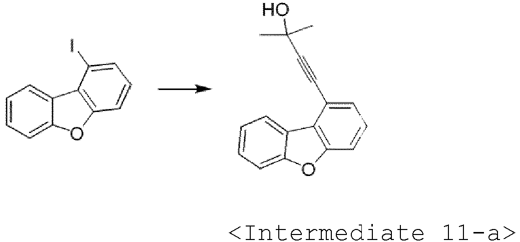

1-iododibenzofuran (25 g, 0.085 mol), tetrakis(triphenylphosphine)palladium (0.98 g, 0.001 mol) and 250 mL of trimethylamine were stirred in a 500 mL flask at room temperature and 2-methyl-3-butyn-2-ol (7.2 g, 0.085 mol) (8.3 mL) was added dropwise thereto. After completion of the reaction, excess heptane was added thereto and then the organic layer was concentrated under reduced pressure to obtain <Intermediate 11-a>. (15.3 g, 72%)

### Synthesis Example 11-2 : Synthesis of Intermediate 11-b

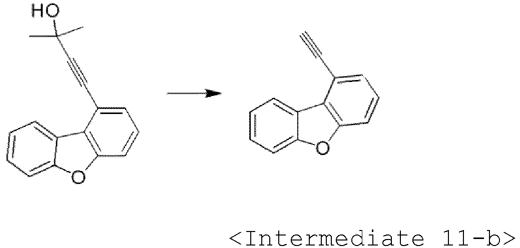

<Intermediate 11-b> (15.3 g, 0.061 mol) and toluene 100 mL were added to in a 500 mL flask, followed by heating to 70 to 75°C under a nitrogen atmosphere in a reactor. Tetrabutylammonium hydroxide (1.59 g, 0.0061 mol) was added thereto, followed by stirring. The reaction was terminated by addition of a 2M hydrochloric acid. The reaction product was extracted with ethyl acetate, and the organic layer was concentrated under reduced pressure and separated by column chromatography to obtain <Intermediate 11-b>. (10.6 g, 90%)

### Synthesis Example 11-3 : Synthesis of Intermediate 11-c

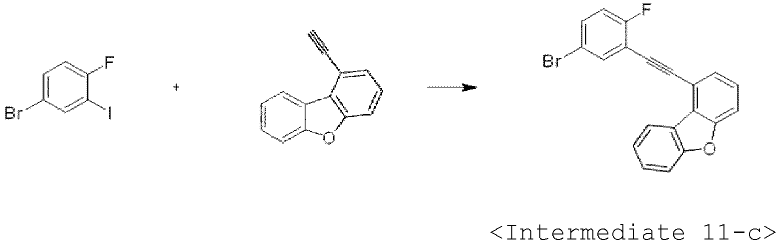

1-bromo-4-fluoro-3-iodobenzene (17.8 g, 0.059 mol), tetrakis (triphenylphosphine)palladium (0.68 g, 0.001 mol), copper iodide (0.56 g, 0.003 mol), and 180 mL of triethylamine were stirred in a 300 mL flask at room temperature, and then <Intermediate 11-b> (10.6 g, 0.059 mol) was added dropwise thereto. After completion of the reaction, excess heptane was poured into the reaction solution, followed by filtering. The organic layer was concentrated under reduced pressure, crystallized with heptane and filtered to obtain <Intermediate 11-c>. (18.3 g, 85%)

### Synthesis Example 11-4 : Synthesis of Intermediate 11-d

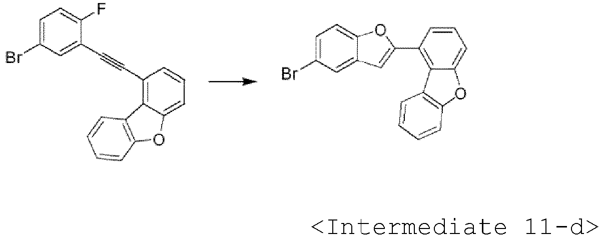

<Intermediate 11-c> (18.3 g, 0.05 mol), copper iodide (0.95 g, 0.005 mol), potassium hydroxide (10.1 g, 0.028 mol), potassium iodide (1.66 g, 0.01 mol), and dimethylsulfoxide 180 mL were added to a 500 mL flask and heated to 80 to 90°C, followed by stirring. After completion of the reaction, the organic layer was concentrated under reduced pressure and separated by column chromatography to obtain <Intermediate 11-d>. (13.4 g, 74%)

### Synthesis Example 11-5 : Synthesis of A-116

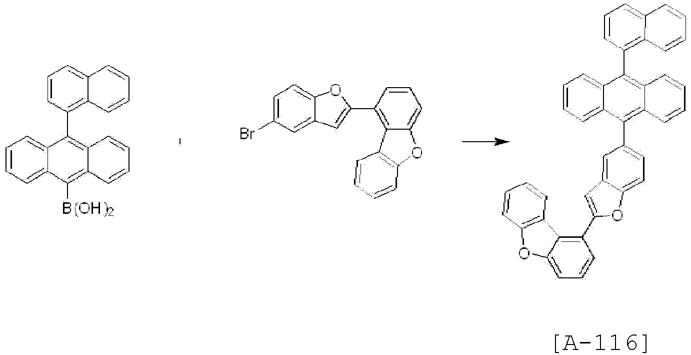

[A-116] was obtained in the same manner as in Synthesis Example 4-3, except that [10-(naphthalen-1-yl)anthracen-9-yl]boronic acid was used instead of [4-(10-naphthalen-1-yl)anthracen-9-yl]benzeneboronic acid and <Intermediate 11-d> was used instead of <Intermediate 1-b>. (yield 63%)
MS (MALDI-TOF) : m/z 586.19 [M⁺]

### Synthesis Example 12. Synthesis of A-137

### Synthesis Example 12-1 : Synthesis of A-137

[A-137] was obtained in the same manner as in Synthesis Example 2-5, except that 5-bromo-2-phenylbenzofuran was used instead of 2-bromo-3-phenylbenzofuran. (yield 52%)
MS (MALDI-TOF) : m/z 455.22 [M⁺]

### Synthesis Example 13. Synthesis of A-144

### Synthesis Example 13-1 : Synthesis of Intermediate 13-a

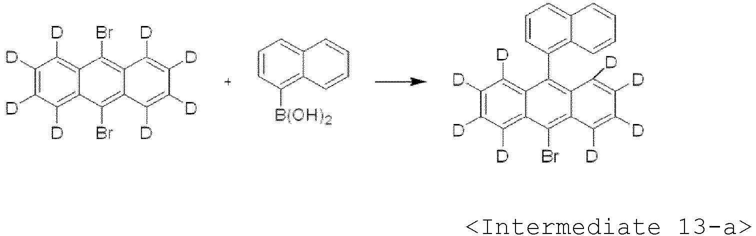

<Intermediate 13-a> was obtained in the same manner as in Synthesis Example 1-3, except that 9,10-dibromo(anthracene-d8) was used instead of <Intermediate 1-b> and 1-naphthaleneboronic acid was used instead of 10-phenylanthracene-9-boronic acid. (yield 64%)

### Synthesis Example 13-2 : Synthesis of Intermediate 13-b

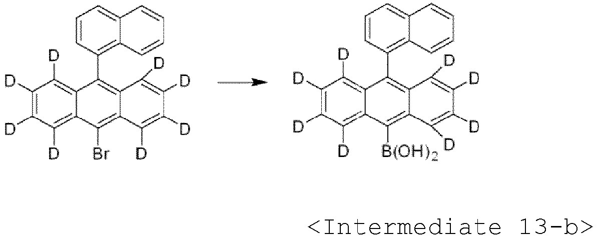

<Intermediate 13-b> was obtained in the same manner as in Synthesis Example 2-4, except that <Intermediate 13-a> was used instead of <Intermediate 2-c>. (yield 75%)

### Synthesis Example 13-3 : Synthesis of Intermediate 13-c

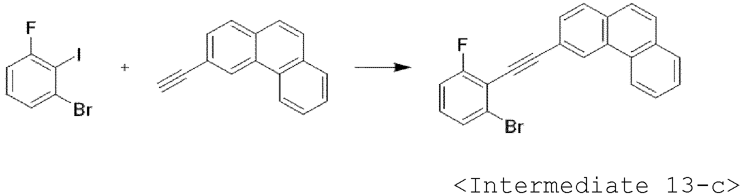

<Intermediate 13-c> was obtained in the same manner as in Synthesis Example 11-3, except that 1-bromo-3-fluoro-2-iodobenzene was used instead of 1-bromo-4-fluoro-3-iodobenzene, and 3-ethynyl phenanthrene was used instead of <Intermediate 11-b>. (yield 84%)

### Synthesis Example 13-4 : Synthesis of Intermediate 13-d

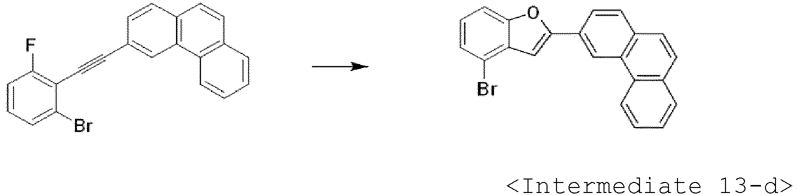

<Intermediate 13-d> was obtained in the same manner as in Synthesis Example 11-4, except that <Intermediate 13-d> was used instead of <Intermediate 11-c>. (yield 79%)

### Synthesis Example 13-5 : Synthesis of A-144

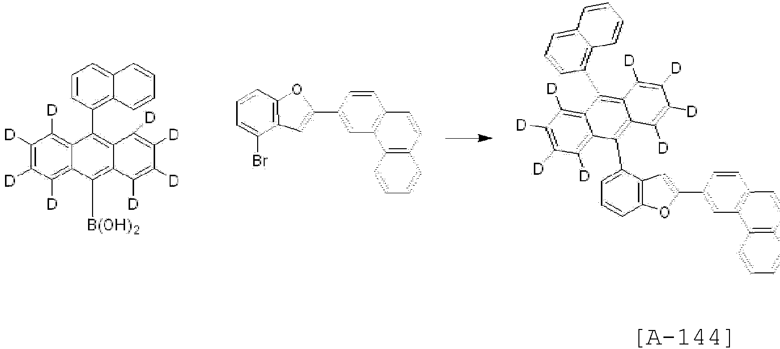

[A-144] was obtained in the same manner as in Synthesis Example 1-3, except that <Intermediate 13-d> was used instead of <Intermediate 1-b>, and <Intermediate 13-b> was used instead of 10-phenylanthracene-9-boronic acid. (yield 60%)
MS (MALDI-TOF) : m/z 604.26 [M⁺]

### Synthesis Example 14. Synthesis of A-161

### Synthesis Example 14-1 : Synthesis of Intermediate 14-a

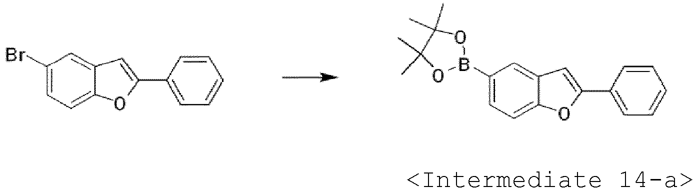

5-bromo-2-phenylbenzofuran (50 g, 0.183 mol), bis(pinacolato)diboron (55.8 g, 0.22 mol), palladium (II) dichloride(diphenylphosphine ferrocene) (4.5 g, 0.005 mol), potassium acetate (53.9 g, 0.55 mol), and 500 mL of toluene were added to a 1L flask and then refluxed. After completion of the reaction, the reaction product was concentrated under reduced pressure and then separated by column chromatography to obtain <Intermediate 14-a>. (47.1 g, 80%)

### Synthesis Example 14-2 : Synthesis of Intermediate 14-b

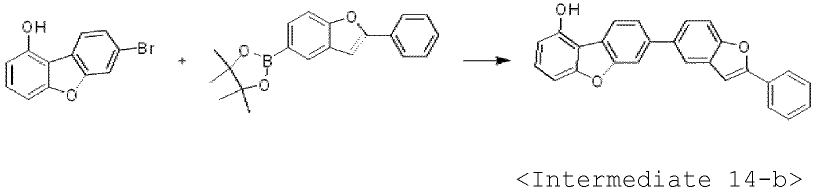

<Intermediate 14-a> (47.1 g, 0.147 mol), 7-bromo-1-hydroxydibenzofuran (35 g, 0.133 mol), palladium (II) dichloride(diphenylphosphine ferrocene) (2.17 g, 0.003 mol), sodium bicarbonate (22.35 g, 0.266 mol), 420 mL of tetrahydrofuran, and 140 mL of water were added to a 1L flask and then refluxed. After completion of the reaction, the reaction product was cooled to room temperature and the resulting solid was filtered with dichloromethane to obtain <Intermediate 14-b>. (41.5 g, 83%)

### Synthesis Example 14-3 : Synthesis of Intermediate 14-c

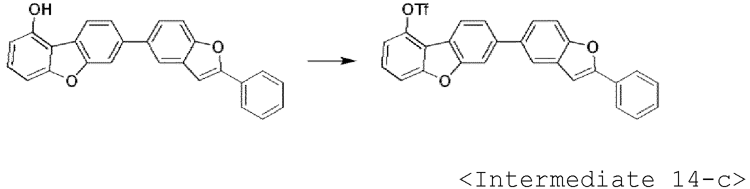

<Intermediate 14-b> (41.5 g, 0.11 mol), pyridine (17.44 g, 0.220 mol) (17.8 mL), and dichloromethane (415 mL) were added to a 1L flask, and the reactor was cooled to 0°C in a nitrogen atmosphere, followed by stirring. Trifluoromethanesulfonic anhydride (46.7 g, 0.165 mol) (28 mL) was added dropwise to the resulting product, followed by stirring at room temperature. The reaction was terminated by addition of water and the organic layer was concentrated under reduced pressure to obtain <Intermediate 14-c>. (48.2 g, 86%)

### Synthesis Example 14-4 : Synthesis of Intermediate 14-d

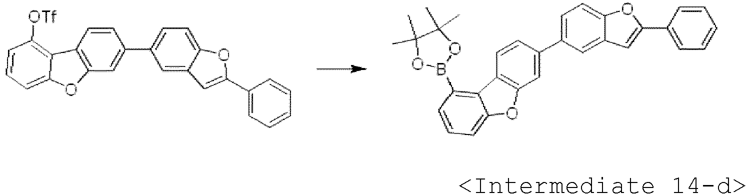

<Intermediate 14-c> (48.2 g, 0.095 mol), bis(pinacolato)diboron(28.9 g, 0.114 mol), palladium (II) dichloride(diphenylphosphine ferrocene) (2.32 g, 0.003 mol), potassium acetate (27.91 g, 0.284 mol), and 480 mL of toluene were added to a 1L flask, followed by refluxing. After completion of the reaction, the resulting product was concentrated under reduced pressure and then separated by column chromatography to obtain <Intermediate 14-d>. (37.2 g, 81%)

### Synthesis Example 14-5 : Synthesis of A-161

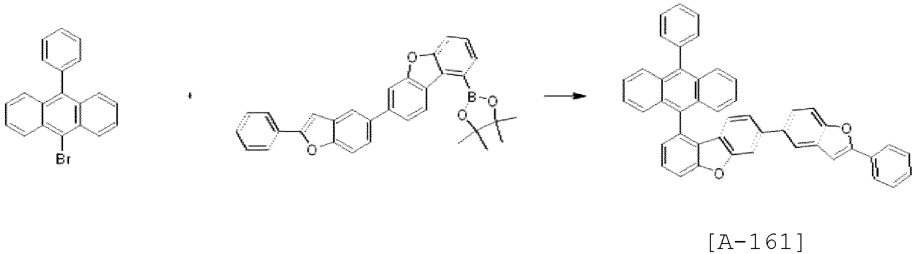

9-bromo-10-phenylanthracene (10.0 g, 0.030 mol), <Intermediate 14-d> (16.1 g, 0.033 mol), palladium (II) dichloride(diphenylphosphine ferrocene) (0.49 g, 0.001 mol), sodium bicarbonate (5.04 g, 0.06 mol), 120 mL of tetrahydrofuran, and 40 mL of distilled water added to a 300 mL flask, followed by stirring. After completion of the reaction, excess methanol was poured at room temperature to form a solid, and the resulting product was filtered and recrystallized with toluene and acetone to obtain [A-161]. (12.7 g, 69%)
MS (MALDI-TOF) : m/z 612.21 [M⁺]

### Synthesis Example 15. Synthesis of B-119

### Synthesis Example 15-1 : Synthesis of B-119

14.0 g of 4,4"-diiodo-p-terphenyl, 18.3 g of [4-(benzooxazol-2-yl)phenyl]phenylamine, 13.2 g of potassium carbonate, 0.3 g of a copper powder, 0.9 g of sodium bisulfite, 0.7 g of 3,5-di-tert-butyl salicylic acid, and 30 mL of dodecylbenzene were added to a nitrogen-purged reaction vessel, followed by heating and stirring at 210°C for 44 hours. The reaction product was cooled to room temperature and 50 mL toluene was added thereto, followed by filtering. 1,2-dichlorobenzene 230 mL was added to the filtrate, followed by heating and hot filtering. The filtrate was concentrated and the resulting crystals were filtered with 1,2-dichlorobenzene to obtain [B-119] as a yellow solid. (10.9 g, 47%)
MS (MALDI-TOF) : m/z 800.32 [M⁺]

### Synthesis Example 16. Synthesis of B-120

### Synthesis Example 16-1 : Synthesis of B-120

[B-120] was obtained in the same manner as in Synthesis Example 15-1, except that 4,4'-diiodobiphenyl was used instead of 4,4"-diiodo-p-terphenyl. (yield 54%)
MS (MALDI-TOF) : m/z 724.28 [M⁺]

### Synthesis Example 17. Synthesis of C-10

### Synthesis Example 17-1 : Synthesis of C-10

5.6 g of ([1,1',2',1"]terphenyl-4'-yl)-amine, 14.4 g of 2-(4-bromophenyl)benzooxazole, 4.4 g of t-butoxy sodium, and 60 mL of toluene were added to a reaction vessel, followed by nitrogen purging while ultrasonicating for 30 minutes. 0.1 g of palladium acetate and 0.4 mL of a 50% (w/v) solution of tri-(t-butyl)phosphine in toluene were further added to the reaction vessel, followed by stirring one night under reflux. The reaction vessel was allowed to cool, methanol was added thereto and the precipitated solid was collected to obtain a product. The product was precipitated by crystallization and purification using toluene/acetone to obtain [C-10] as a yellow sold. (11 g, 76.4%)
MS (MALDI-TOF) : m/z 631.23 [M⁺]

### Synthesis Example 18. Synthesis of C-27

### Synthesis Example 18-1 : Synthesis of C-27

10 g of tri(4-bromophenyl)amine, 11.5 g of benzo[d]oxazole-2-yl boronic acid, 17.2 g of potassium carbonate, and 1.2 g of tetrakis(triphenylphosphine)palladium(0) were added to 150 mL of toluene, 40 mL of ethanol and 20 mL of distilled water in a reaction vessel and allowed to react by stirring at 90°C for 12 hours. After completion of the reaction, the reaction product was subject to column purification to obtain [C-27]. (9.2 g, 74.3%)
MS (MALDI-TOF) : m/z 596.18 [M⁺]

### Synthesis Example 19. Synthesis of C-60

### Synthesis Example 19-1 : Synthesis of C-60

6.2 g of ([1,1',2',1"]terphenyl-4'-yl)-amine, 16.1 g of 2-(4-bromophenyl)benzothiazole, 7.3 g of t-butoxy sodium, and 160 mL of toluene were added to a reaction vessel, followed by nitrogen purging while ultrasonicating for 30 minutes. 0.2 g of palladium acetate and 0.6 mL of a 50% (w/v) solution of tri-(t-butyl)phosphine in toluene were further added to the reaction vessel, followed by stirring one night under reflux. The reaction vessel was allowed to cool to 80°C, the result was filtered through silica gel, and the filtrate was concentrated with methanol to obtain a product. The product was recrystallized with toluene to obtain [C-60] as a yellow sold. (9.7 g, 58%)
MS (MALDI-TOF) : m/z 663.18 [M⁺]

### Examples 1 to 31 : Fabrication of organic light-emitting device

ITO glass was patterned such that a light-emitting area of the ITO glass was adjusted to 2 mm × 2 mm and was then washed. The ITO glass was mounted in a vacuum chamber, a base pressure was set to 1 × 10⁻⁷ torr, and 2-TNATA (4,4',4"-tris[2-naphthyl(phenyl)amino]triphenylamine) (700 Å) and [Formula F] (600 Å) were sequentially deposited on ITO. Then, a mixture of each of compounds according to [Formula A-1] to [Formula A-6] of the present invention and a dopant (D-211) (3 wt%) was deposited thereon to form a to a 200Å-thick light-emitting layer. Then, [Formula E-2] was deposited thereon to form a 300Å-thick electron transport layer, [Formula E-1] was deposited thereon to form a 10A-thick electron injection layer, and MgAg was deposited thereon to a thickness of 120Å. Finally, the compound according to [Formula B] or [Formula C] of the present invention was deposited thereon to form a 600Å-thick capping layer, thereby fabricating an organic light-emitting device. The luminescent properties of the organic light-emitting device were measured at 10 mA/cm².

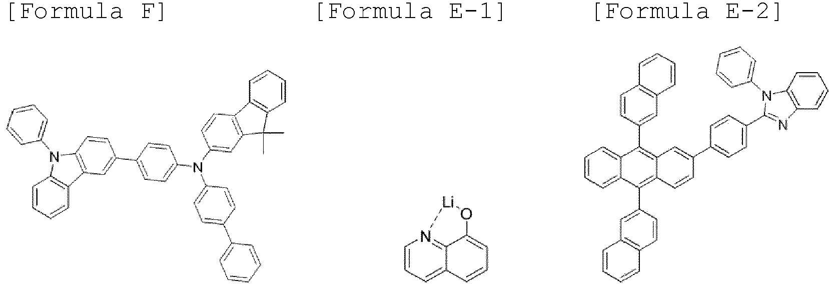

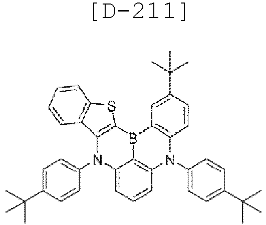

### Comparative Examples 1 to 17

An organic light-emitting device was fabricated in the same manner as in Example above, except that [BH] was used instead of the host compound used in Example above, and Alq₃ or [CPL-1] was used instead of the compound for the capping layer, and the luminescent properties of the organic light-emitting device were measured at 10 mA/cm². The structures of [BH] and [CPL-1] are as follows:

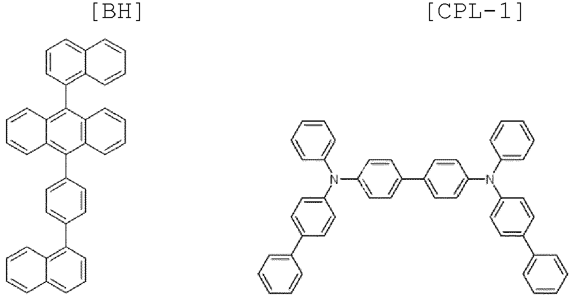

**[Table 1]**

| Item | Host | Capping layer | Current density (mA/ cm²) | External quantum efficiency (EQE, %) |
|---|---|---|---|---|
| Example 1 | A-20 | B-119 | 10 | 17.13 |
| Example 2 | A-30 | B-119 | 10 | 16.08 |
| Example 3 | A-58 | B-119 | 10 | 16.74 |
| Example 4 | A-79 | B-119 | 10 | 16.41 |
| Example 5 | A-89 | B-119 | 10 | 16.93 |
| Example 6 | A-91 | B-119 | 10 | 16.82 |
| Example 7 | A-137 | B-119 | 10 | 16.58 |
| Example 8 | A-144 | B-119 | 10 | 16.45 |
| Example 9 | A-20 | B-120 | 10 | 17.25 |
| Example 10 | A-30 | B-120 | 10 | 16.15 |
| Example 11 | A-58 | B-120 | 10 | 16.65 |
| Example 12 | A-79 | B-120 | 10 | 16.53 |
| Example 13 | A-89 | B-120 | 10 | 17.02 |
| Example 14 | A-91 | B-120 | 10 | 17.21 |
| Example 15 | A-137 | B-120 | 10 | 16.74 |
| Example 16 | A-144 | B-120 | 10 | 16.52 |
| Example 17 | A-20 | C-10 | 10 | 17.17 |
| Example 18 | A-89 | C-10 | 10 | 16.97 |
| Example 19 | A-91 | C-10 | 10 | 17.05 |
| Example 20 | A-137 | C-10 | 10 | 16.67 |
| Example 21 | A-144 | C-10 | 10 | 16.24 |
| Example 22 | A-20 | C-27 | 10 | 17.23 |
| Example 23 | A-89 | C-27 | 10 | 17.02 |
| Example 24 | A-91 | C-27 | 10 | 17.12 |
| Example 25 | A-137 | C-27 | 10 | 16.65 |
| Example 26 | A-144 | C-27 | 10 | 16.54 |
| Example 27 | A-20 | C-60 | 10 | 17.11 |
| Example 28 | A-89 | C-60 | 10 | 16.95 |
| Example 29 | A-91 | C-60 | 10 | 17.04 |
| Example 30 | A-137 | C-60 | 10 | 16.76 |
| Example 31 | A-144 | C-60 | 10 | 16.35 |
| Comparative Example 1 | A-20 | Alq₃ | 10 | 14.12 |
| Comparative Example 2 | A-89 | Alq₃ | 10 | 13.97 |
| Comparative Example 3 | A-91 | Alq₃ | 10 | 14.15 |
| Comparative Example 4 | A-137 | Alq₃ | 10 | 13.86 |
| Comparative Example 5 | A-144 | Alq₃ | 10 | 13.62 |
| Comparative Example 6 | A-20 | CPL-1 | 10 | 14.39 |
| Comparative Example 7 | A-89 | CPL-1 | 10 | 14.12 |
| Comparative Example 8 | A-91 | CPL-1 | 10 | 14.28 |
| Comparative Example 9 | A-137 | CPL-1 | 10 | 13.95 |
| Comparative Example 10 | A-144 | CPL-1 | 10 | 13.78 |
| Comparative Example 11 | BH | B-119 | 10 | 12.94 |
| Comparative Example 12 | BH | B-120 | 10 | 13.07 |
| Comparative Example 13 | BH | C-10 | 10 | 12.97 |
| Comparative Example 14 | BH | C-27 | 10 | 13.15 |
| Comparative Example 15 | BH | C-60 | 10 | 13.04 |
| Comparative Example 16 | BH | Alq₃ | 10 | 12.44 |
| Comparative Example 17 | BH | CPL-1 | 10 | 12.65 |

As can be seen from [Table 1] above, the organic light-emitting device that contains each of the compounds according to [Formula A-1] to [Formula A-6] of the present invention as a host compound for the light-emitting layer in the organic light-emitting device, and the compound according to [Formula B] or [Formula C] of the present invention as a material for a capping layer provided in the organic light-emitting device can exhibit remarkably improved efficiency, compared to an organic light-emitting device containing a conventional compound and the compound ([BH] and [CPL-1]) structurally different from the specific structure of the compound according to the present invention.

According to the present invention, a high-efficiency organic light-emitting device can be realized using an anthracene derivative compound having a characteristic structure as a host for a light-emitting layer, further forming a capping layer and using a polycyclic compound as a dopant for the light-emitting layer, and is thus useful for lighting systems as well as various displays such as flat panel displays, flexible displays and wearable displays.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. An organic light-emitting device comprising:
a first electrode;
a second electrode facing the first electrode;
a light-emitting layer interposed between the first electrode and the second electrode; and
a capping layer disposed on one surface of the first electrode or the second electrode which is opposite to a remaining surface of the first electrode or the second electrode that faces the light-emitting layer,
wherein the light-emitting layer comprises at least one selected from compounds represented by the following [Formula A-1] to [Formula A-6], and
the capping layer comprises at least one of compounds represented by the following [Formula B] or [Formula C]: 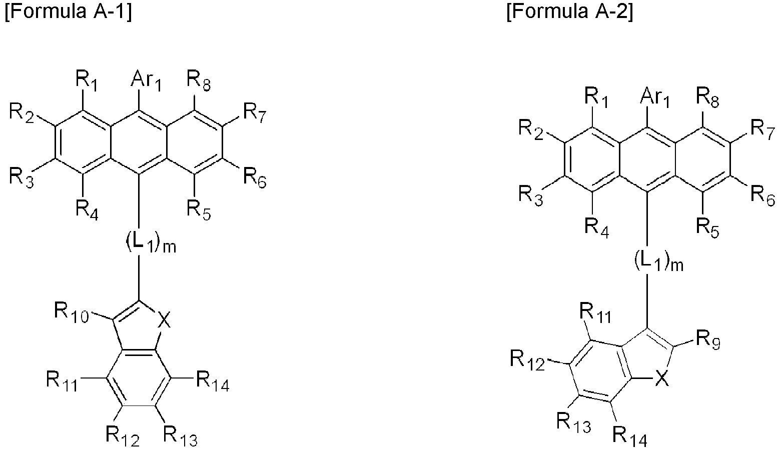 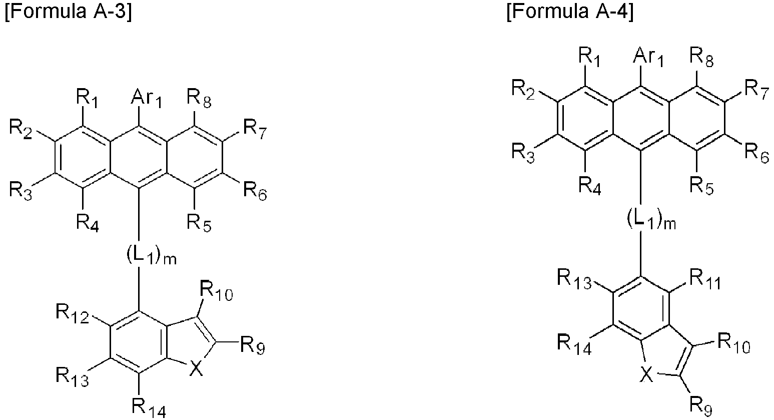 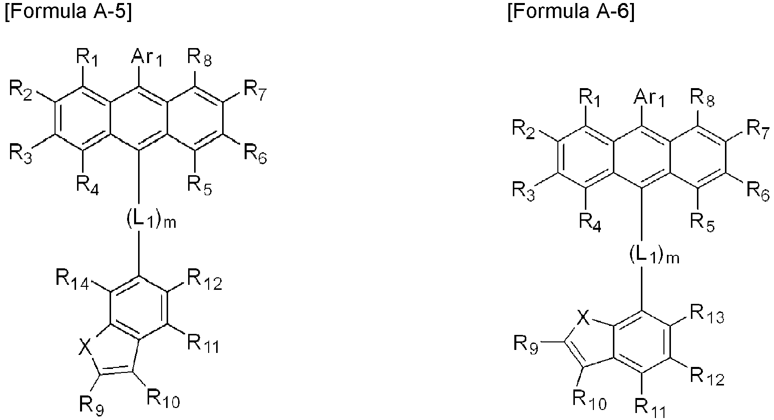
wherein Ar₁ is selected from a substituted or unsubstituted C6-C50 aryl group, a substituted or unsubstituted C2-C50 heteroaryl group, and a substituted or unsubstituted C3-C50 mixed aliphatic-aromatic ring group,
R₁ to R₁₄ are identical to or different from each other, and are each independently hydrogen, deuterium, a substituted or unsubstituted C1-C30 alkyl group, a substituted or unsubstituted C6-C50 aryl group, a substituted or unsubstituted C2-C30 alkynyl group, a substituted or unsubstituted C3-C30 cycloalkyl group, a substituted or unsubstituted C3-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a cyano group, a nitro group and a halogen group,
X is an oxygen atom (O) or a sulfur atom (S),
L₁ is a divalent linker and is a single bond or is selected from a substituted or unsubstituted C6-C50 arylene group, a substituted or unsubstituted C2-C50 heteroarylene group, and a substituted or unsubstituted C3-C50 mixed aliphatic-aromatic ring group, and
m is an integer from 1 to 3, provided that when m is 2 or more, a plurality of L₁ are identical to or different from each other, 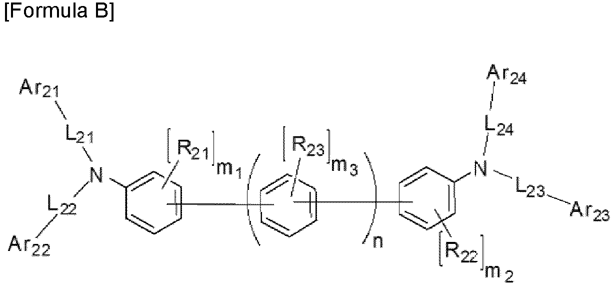
wherein R₂₁ to R₂₃ are identical to or different from each other, and are each independently selected from hydrogen, deuterium, a substituted or unsubstituted C1-C20 alkyl group, a substituted or unsubstituted C6-C50 aryl group, a substituted or unsubstituted C2-C30 heteroaryl group, a substituted or unsubstituted C7-C50 arylalkyl group, a substituted or unsubstituted C3-C30 cycloalkyl group, a substituted or unsubstituted silyl group, and a halogen group,
L₂₁ to L₂₄ are identical to or different from each other, and are each independently a single bond or are selected from are selected from a substituted or unsubstituted C6-C50 arylene group and a substituted or unsubstituted C2-C50 heteroarylene group,
Ar₂₁ to Ar₂₄ are identical to or different from each other, and are each independently selected from a substituted or unsubstituted C6-C50 aryl group, and a substituted or unsubstituted C2-C50 heteroaryl group,
n is an integer from 0 to 4, provided that when n is 2 or more, a plurality of aromatic ring structures in () including R₂₃ are identical to or different from each other,
m₁ to m₃ are integers from 0 to 4, provided that when each of m₁ to m₃ is 2 or more, a plurality of each of R₂₁, R₂₂, and R₂₃ are identical to or different from each other, and
a carbon atom of the aromatic ring, to which R₂₁ to R₂₃ are not bonded, is bonded to hydrogen or deuterium, 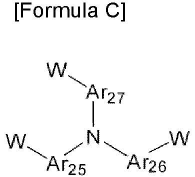
wherein Ar₂₅ to Ar₂₇ are divalent linkers, are identical to or different from each other, and are each independently single bonds or are selected from a substituted or unsubstituted C6-C50 arylene group, a substituted or unsubstituted C2-C50 heteroarylene group, a substituted or unsubstituted C3-C30 cycloalkylene group, and a substituted or unsubstituted C3-C50 mixed aliphatic-aromatic ring group, and
W's are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C30 alkynyl group, a substituted or unsubstituted C3-C30 cycloalkyl group, a substituted or unsubstituted C3-C30 cycloalkenyl group, or a substituted or unsubstituted C2-C50 heteroaryl group, a substituted or unsubstituted C2-30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a nitro group and a halogen group, wherein W's are identical to or different from each other, with the proviso that at least one of W's is represented by the following [Formula C-1]: 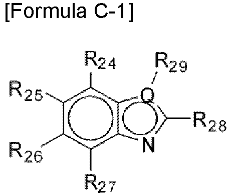
wherein R₂₄ to R₂₉ are identical to or different from each other, and are each independently linkers as binding sites to Ar₂₅ to Ar₂₇, or are selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C30 alkynyl group, a substituted or unsubstituted C3-C30 cycloalkyl group, a substituted or unsubstituted C3-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C50 aryloxy group, a substituted or unsubstituted C1-C30 alkylthioxy group, a substituted or unsubstituted C6-C50 arylthioxy group, a substituted or unsubstituted amine group, a substituted or unsubstituted silyl group, a substituted or unsubstituted C3-C50 mixed aliphatic-aromatic ring group, a cyano group, a nitro group and a halogen group, with the proviso that R₂₄ to R₂₇ are bonded to each other or each of R₂₄ to R₂₇ is bonded to an adjacent substituent to further form an alicyclic or aromatic monocyclic or polycyclic ring, at least one carbon atom of which is substituted with at least one heteroatom selected from nitrogen, oxygen, and sulfur, and
Q is N, O or S, provided that when Q is 0 or S, Q does not include R₂₉.

2. The organic light-emitting device according to claim 1, wherein each of the compounds represented by [Formula A-1] to [Formula A-6] comprises at least one deuterium atom (D) as a substituent.

3. The organic light-emitting device according to claim 1, wherein each of the compounds represented by [Formula A-1] to [Formula A-6] has a degree of deuteration of 10% or more.

4. The organic light-emitting device according to claim 1, wherein at least one of R₁₁ to R₁₄ in each of the compounds represented by [Formula A-1] to [Formula A-6] is selected from a substituted or unsubstituted C6-C20 aryl group, a substituted or unsubstituted C3-C20 cycloalkyl group, and a substituted or unsubstituted C3-C20 heteroaryl group.

5. The organic light-emitting device according to claim 4, wherein at least one of R₁₁ to R₁₄ in each of the compounds represented by [Formula A-1] to [Formula A-6] is a deuterium-substituted or unsubstituted C6-C20 aryl group.

6. The organic light-emitting device according to claim 1, wherein at least one of Ar₂₁ to Ar₂₄ is represented by the following [Formula E]: 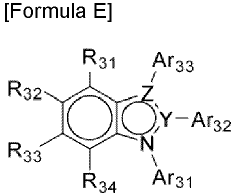
wherein R₃₁ to R₃₄ are identical to or different from each other, and are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C20 alkynyl group, a substituted or unsubstituted C3-C30 cycloalkyl group, a substituted or unsubstituted C5-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted amine group, a substituted or unsubstituted silyl group, a nitro group, a cyano group, and a halogen group, with the proviso that R₃₁ to R₃₄ are bonded to each other to form a ring,
Y is a carbon atom (C) or a nitrogen atom (N), and Z is a carbon atom (C), an oxygen atom (O), a sulfur atom (S), or a nitrogen atom (N), and
Ar₃₁ to Ar₃₃ are identical to or different from each other, and are each independently selected from a substituted or unsubstituted C5-C50 aryl group and a substituted or unsubstituted C3-C50 heteroaryl group, provided that when Z is an oxygen atom (O) or a sulfur atom (S), Ar₃₃ is nothing, provided that when Y and Z are nitrogen atoms (N), only one of Ar₃₁, Ar₃₂, and Ar₃₃ is present, provided that when Y is a nitrogen atom (N) and Z is a carbon atom (C), Ar₃₂ is nothing, with the proviso that one of R₃₁ to R₃₄ and Ar₃₁ to Ar₃₃ is a single bond linked to one of the linkers L₂₁ to L₂₄ in [Formula B].

7. The organic light-emitting device according to claim 1, wherein each of the compounds represented by [Formula A-1] to [Formula A-6] is selected from compounds represented by the following [A-1] to [A-218]:

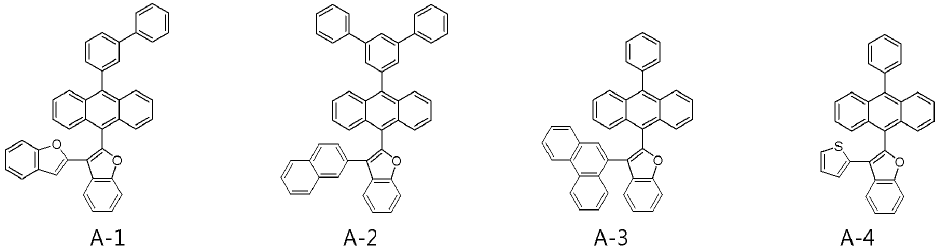

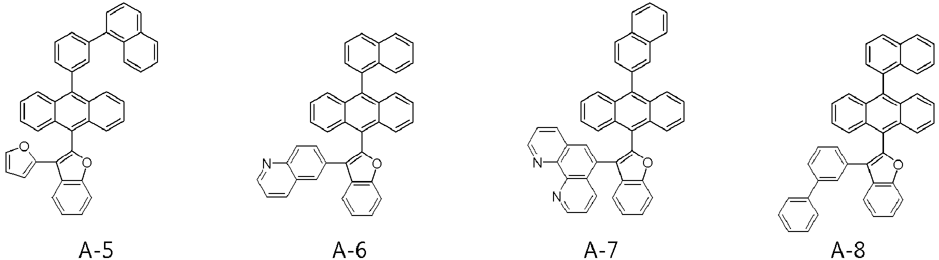

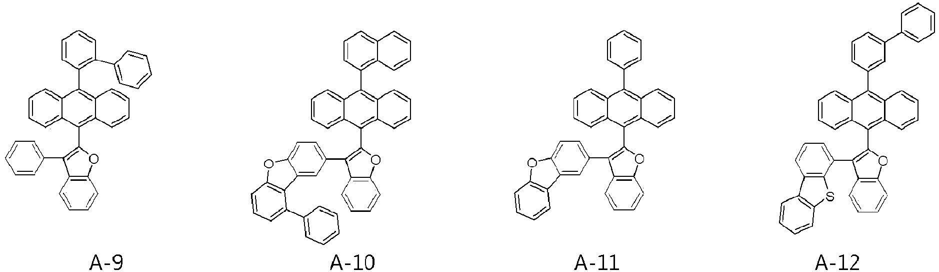

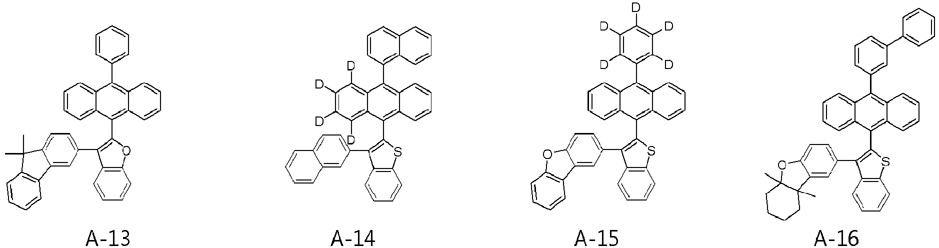

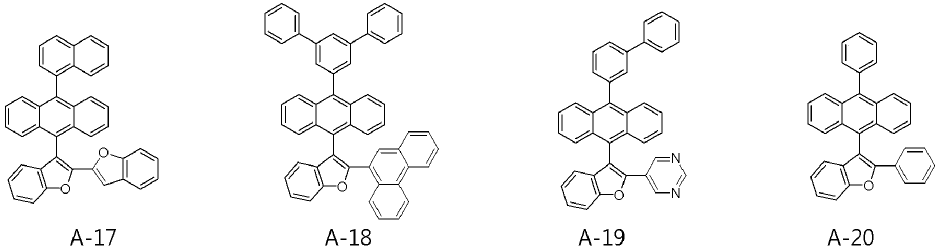

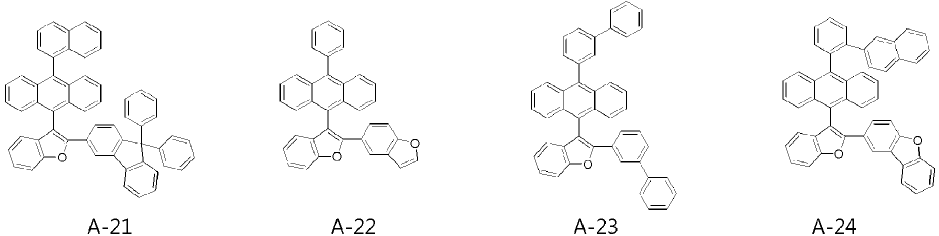

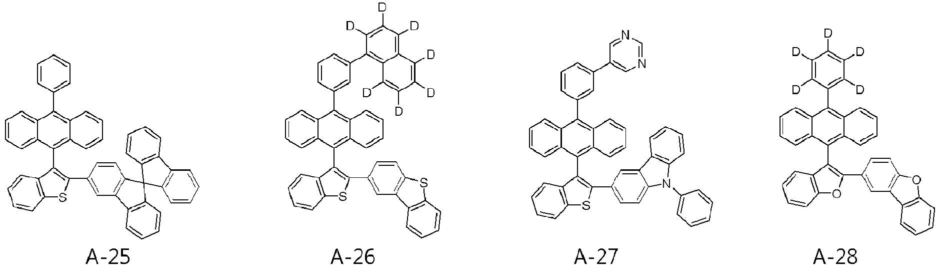

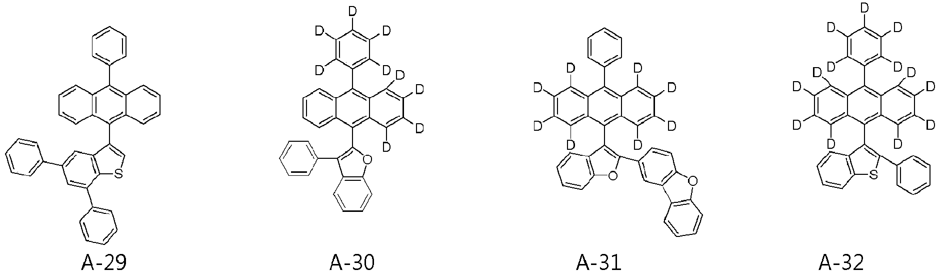

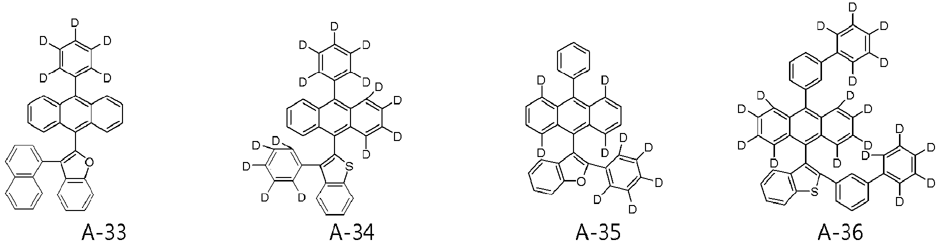

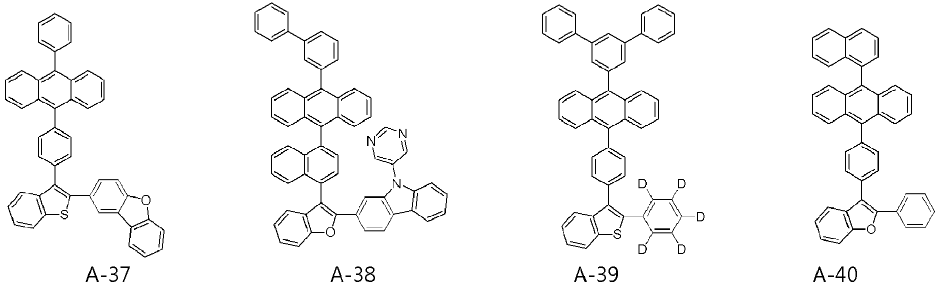

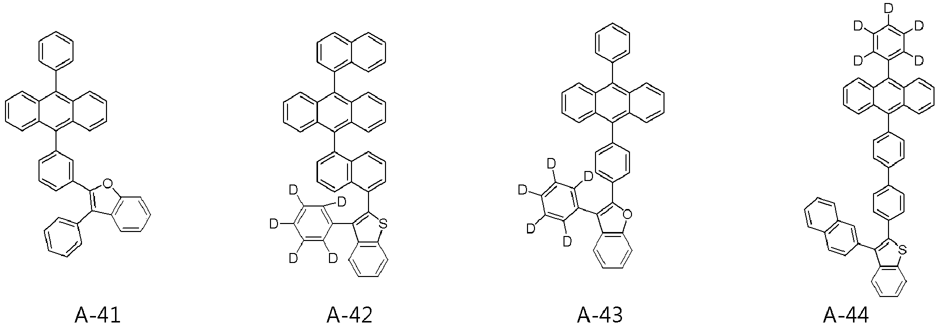

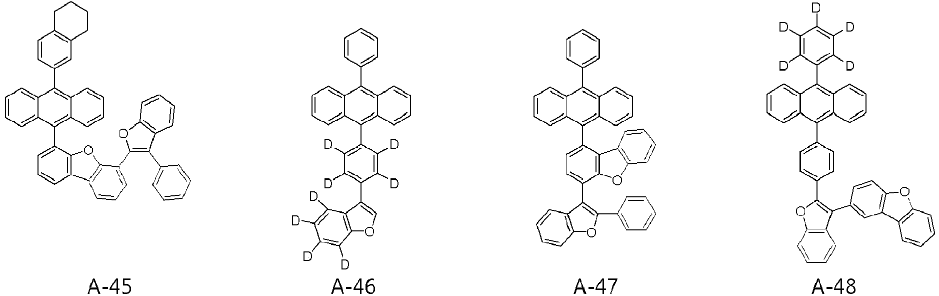

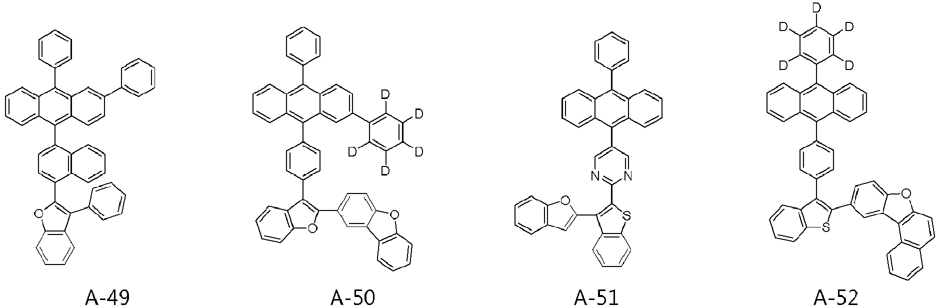

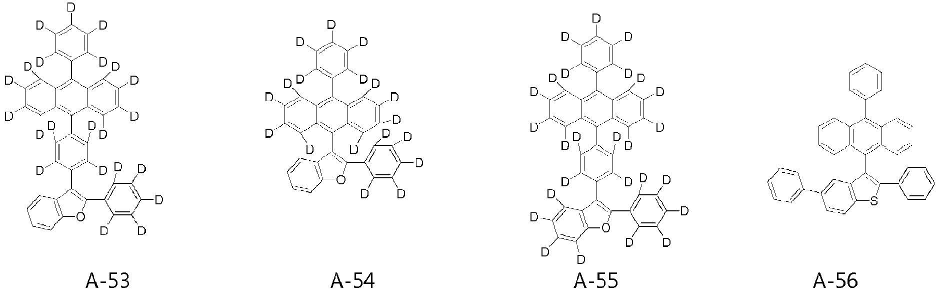

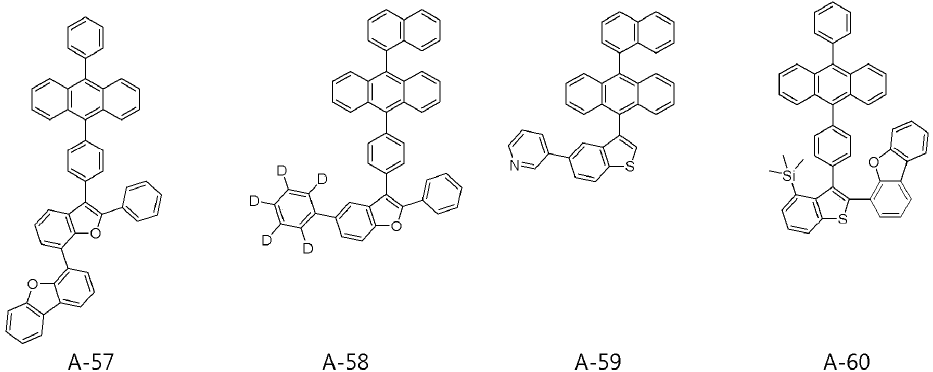

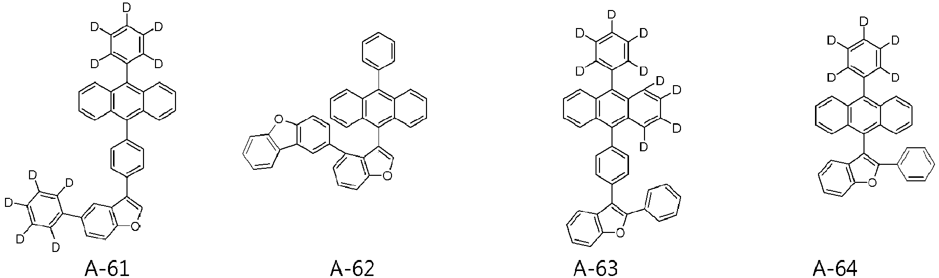

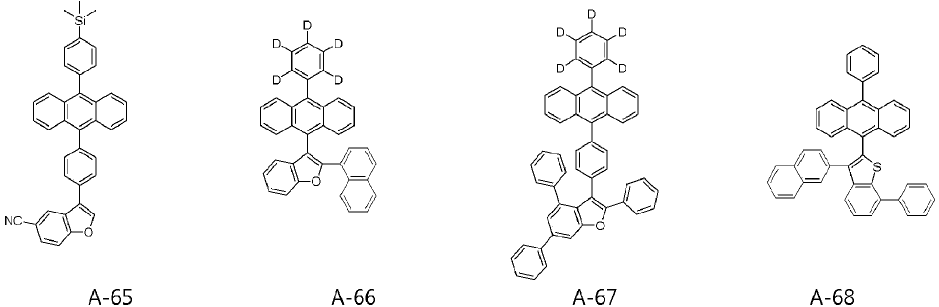

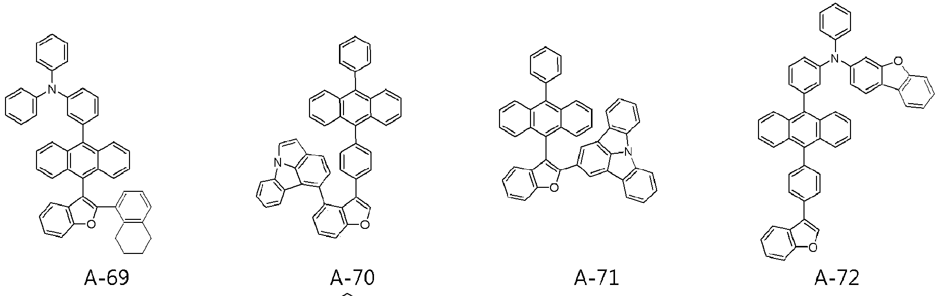

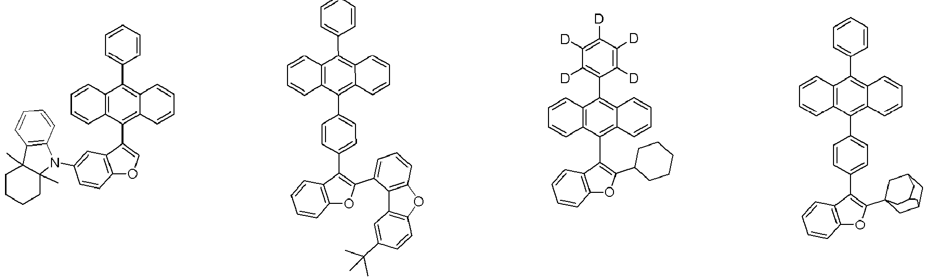

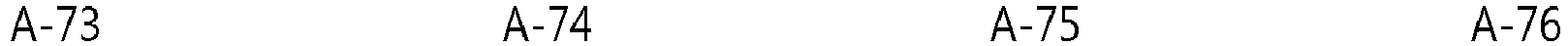

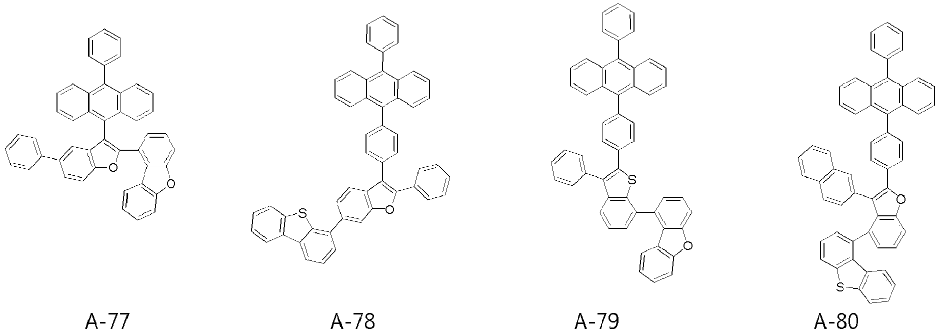

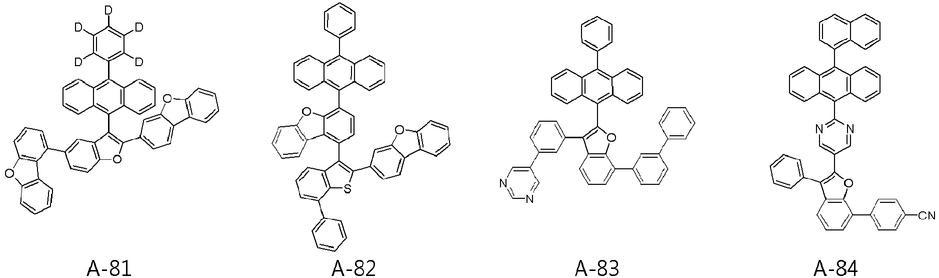

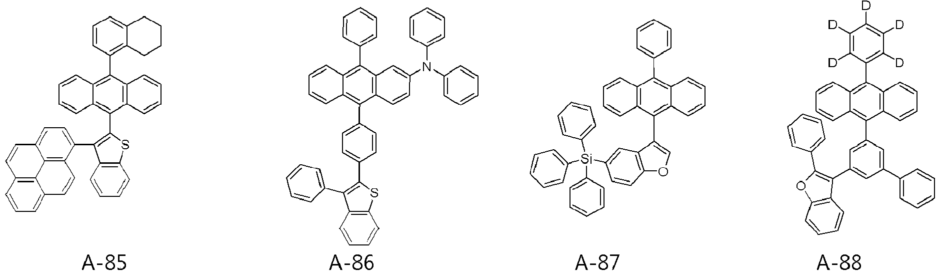

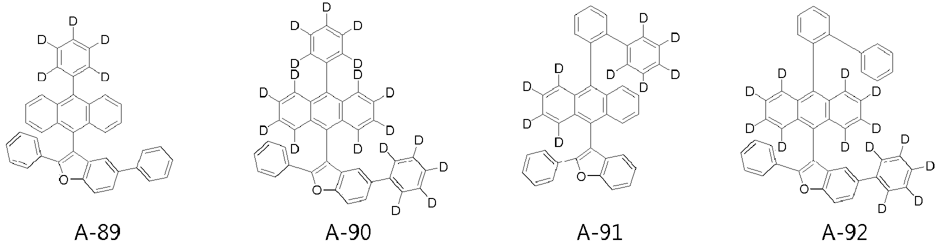

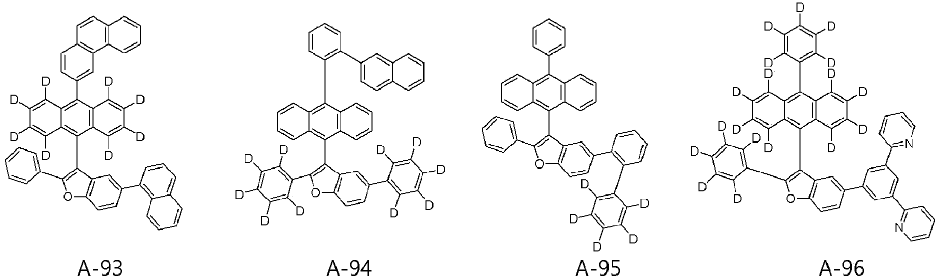

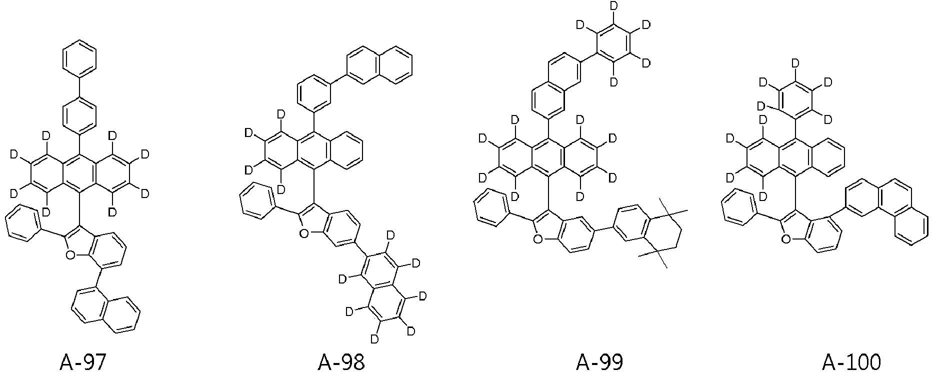

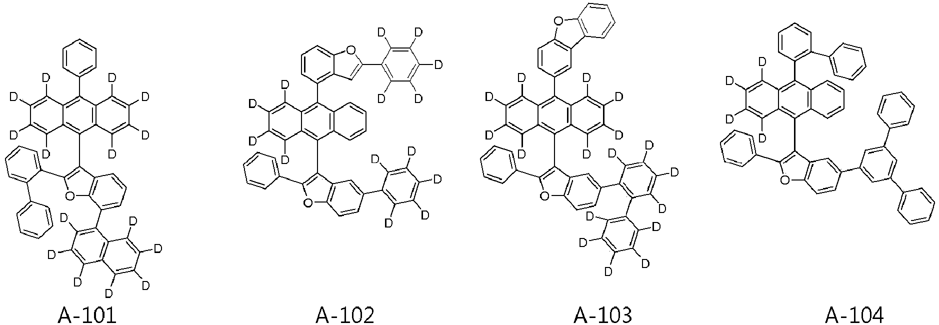

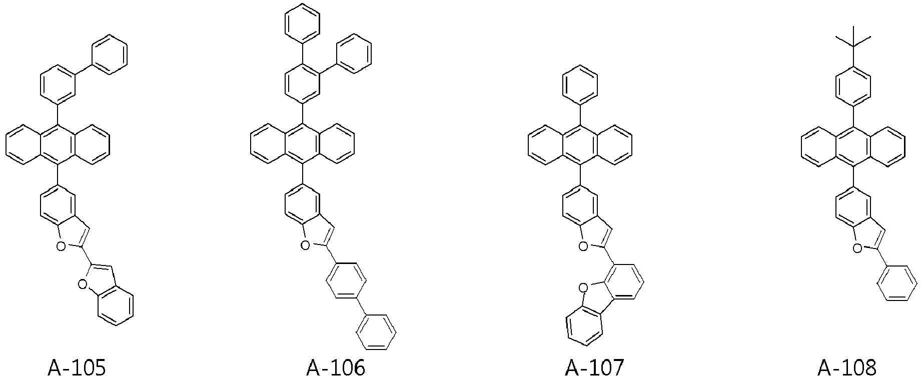

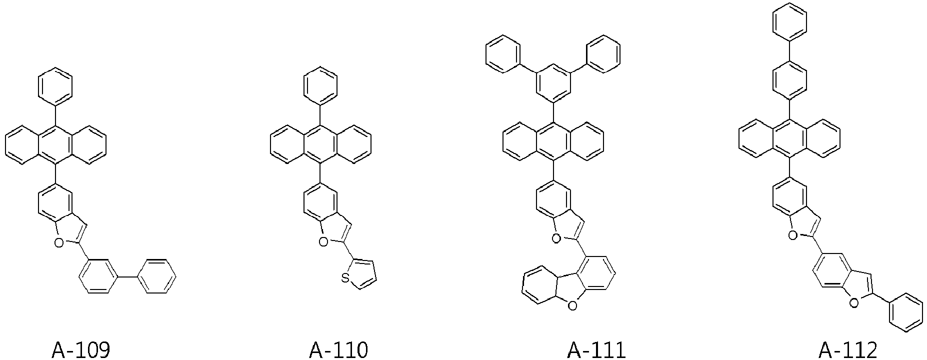

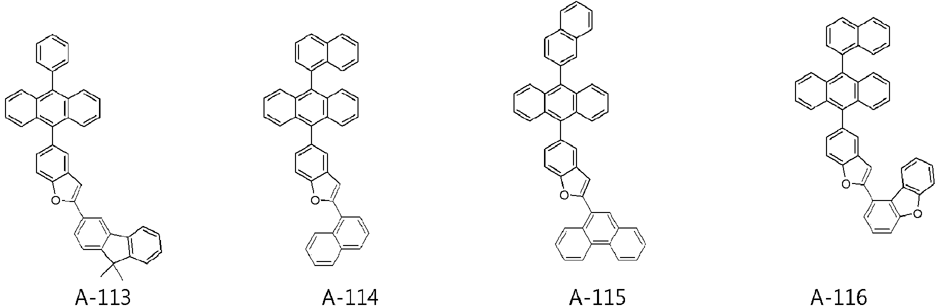

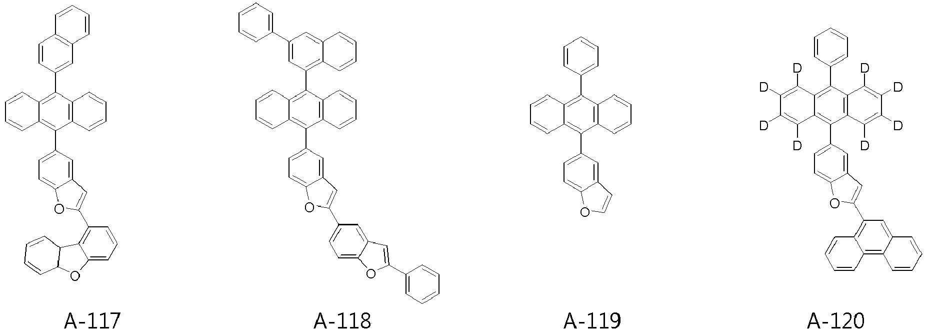

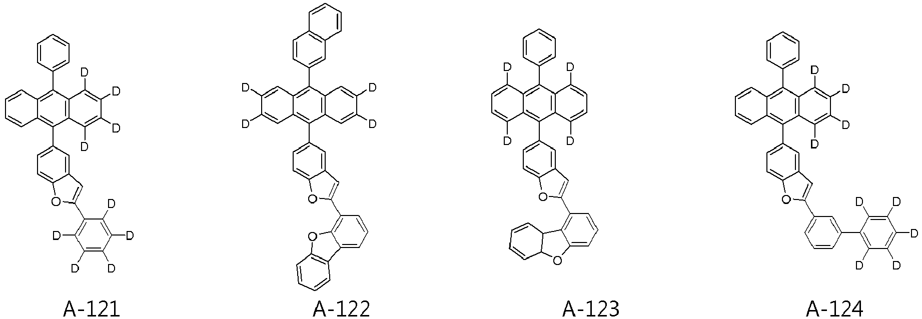

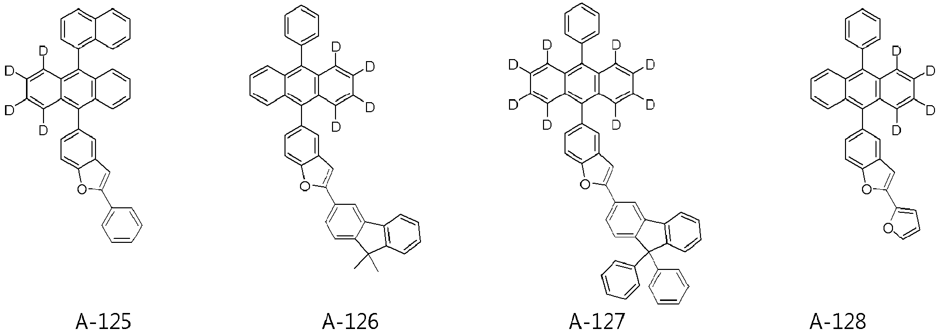

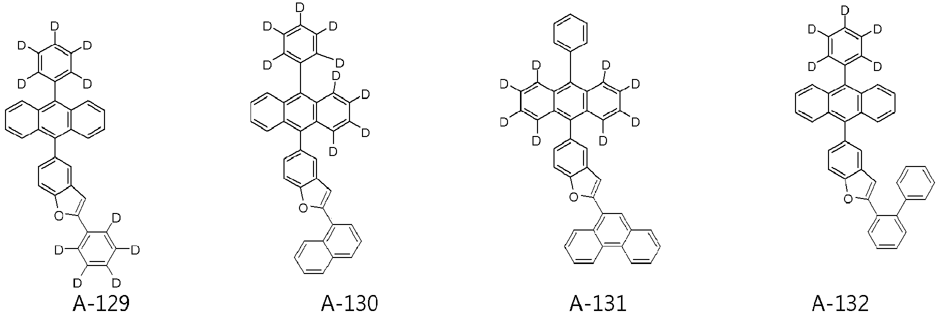

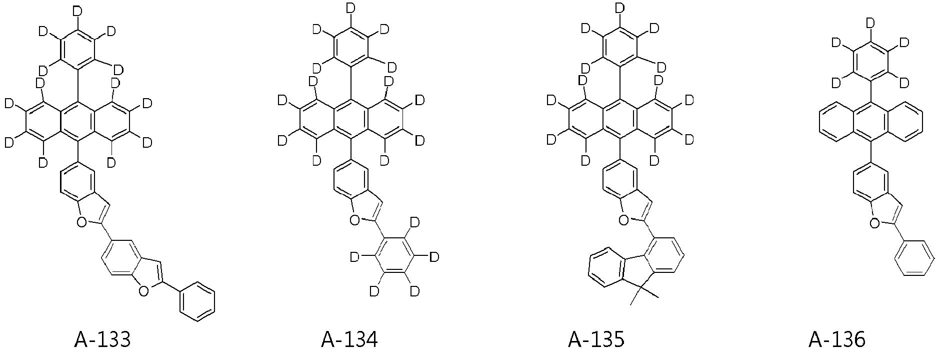

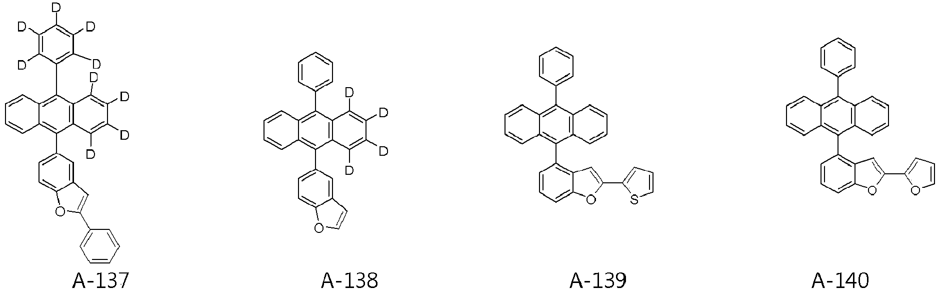

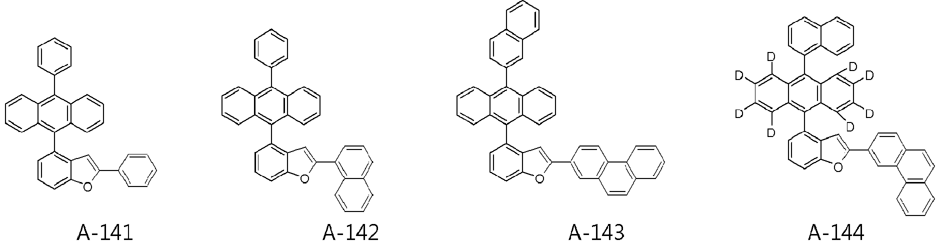

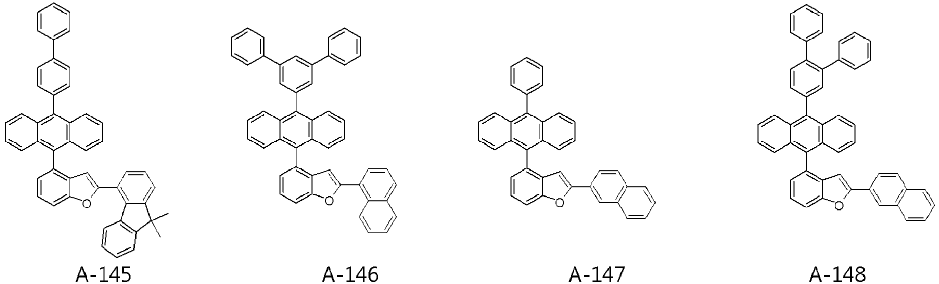

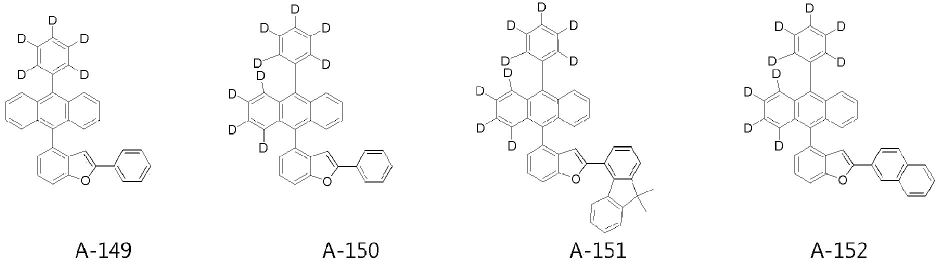

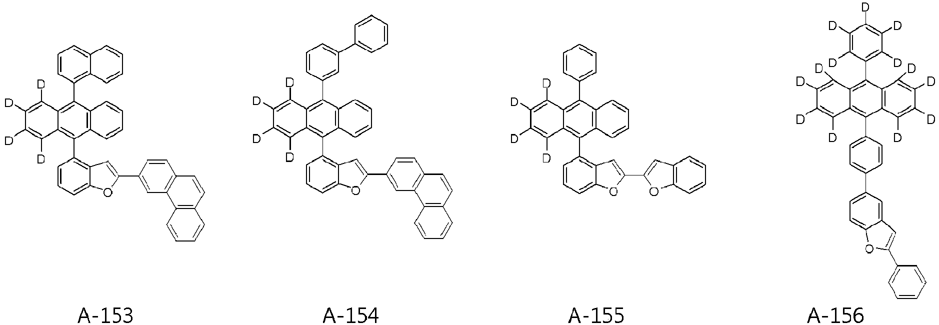

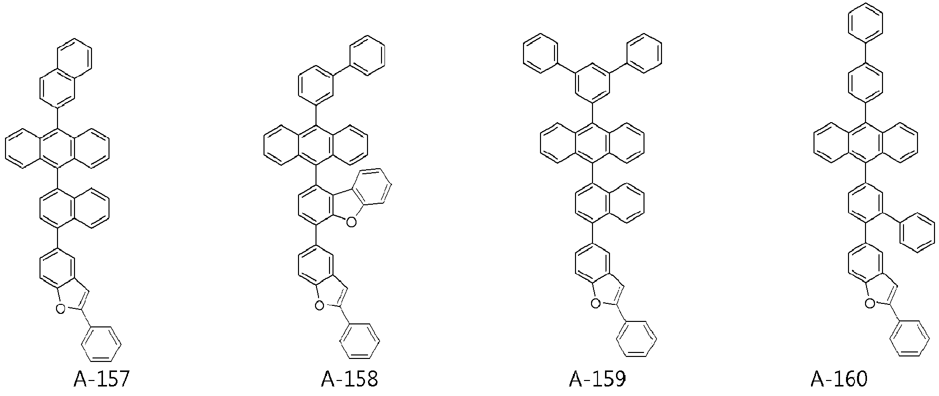

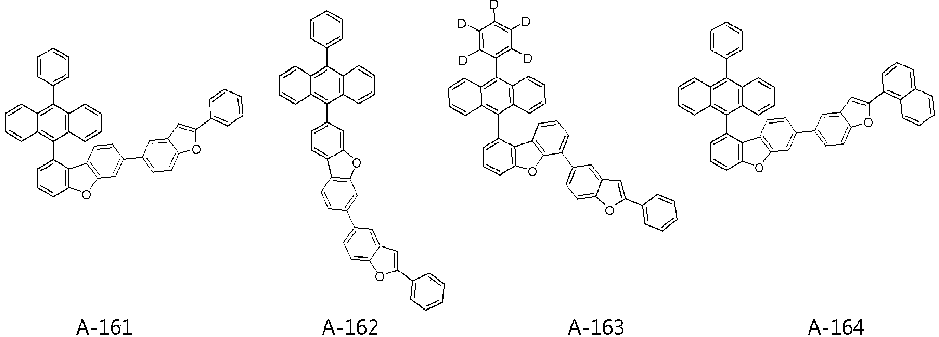

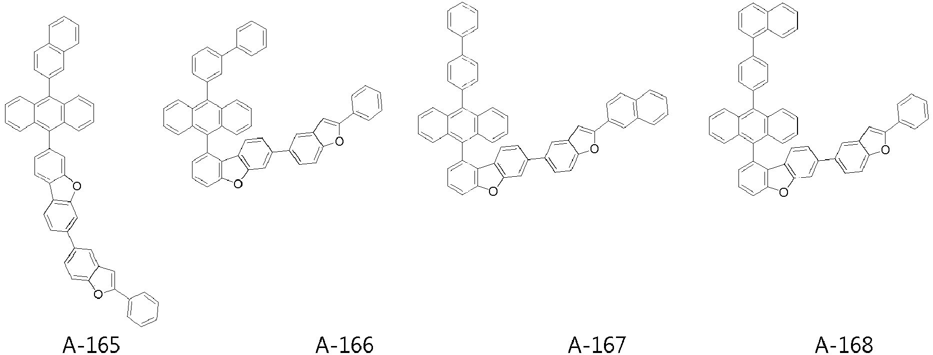

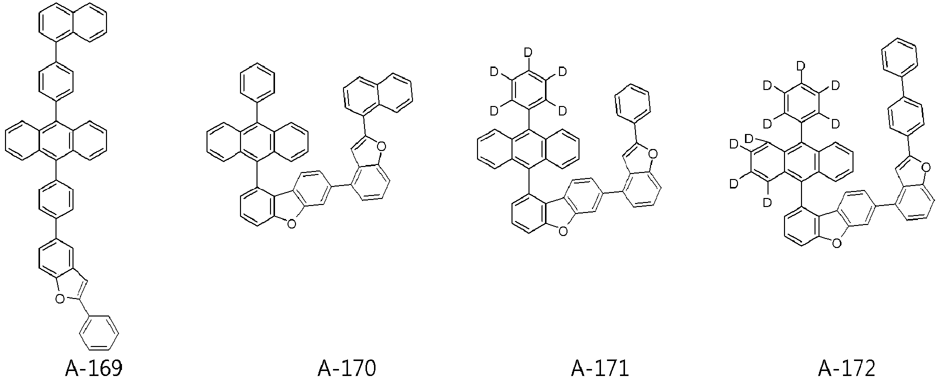

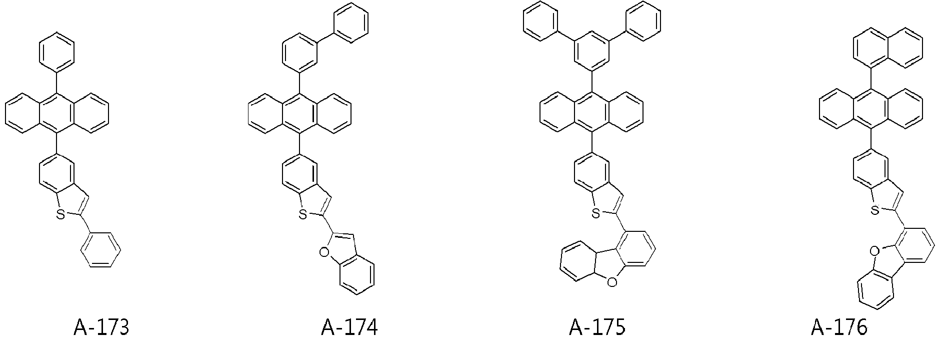

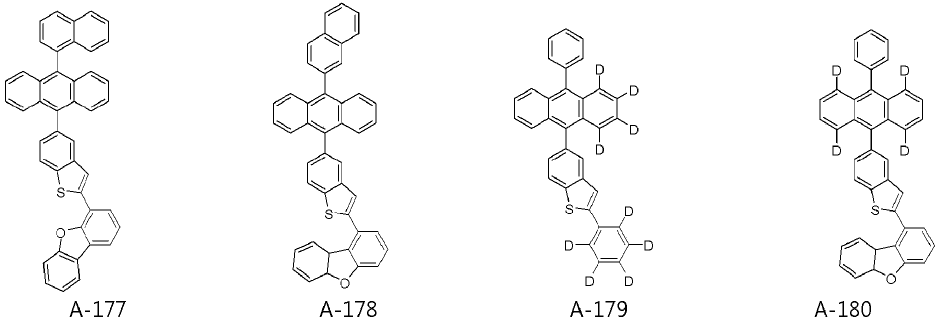

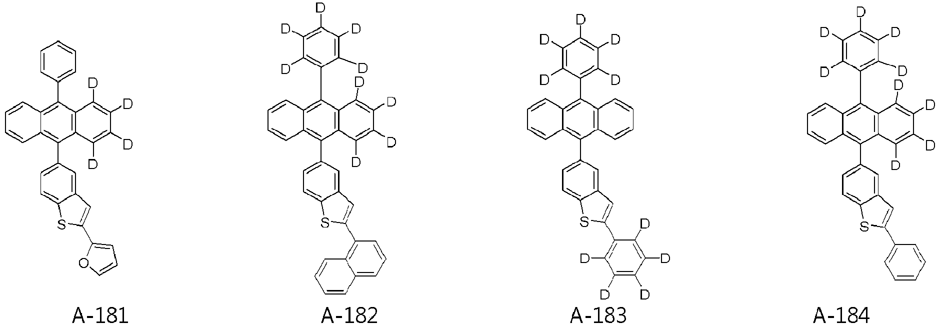

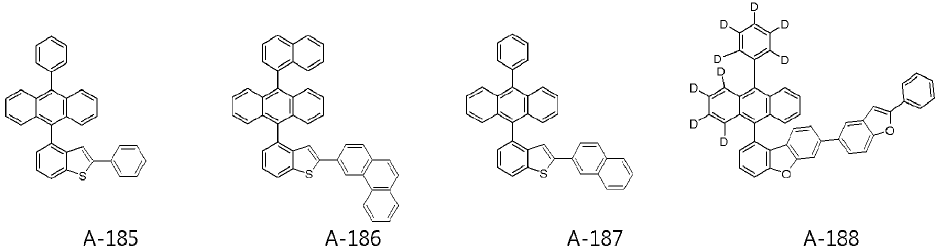

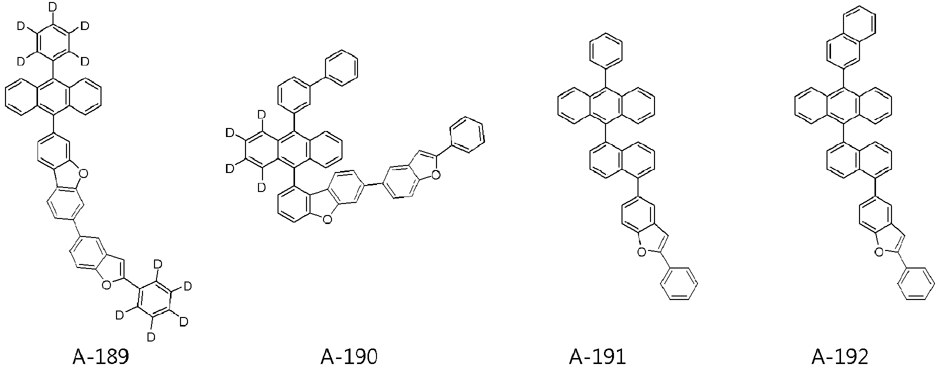

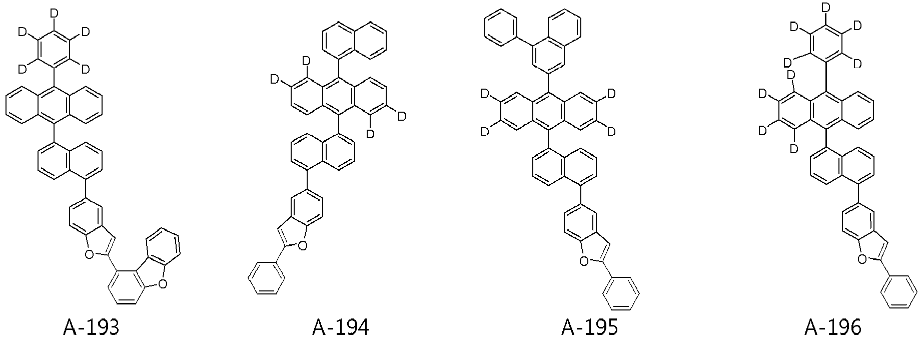

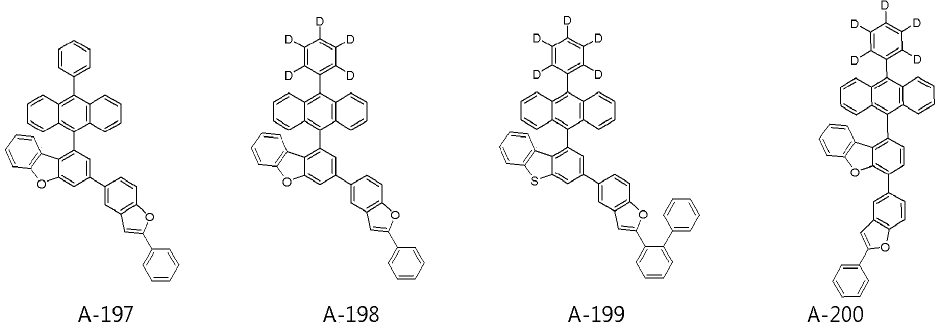

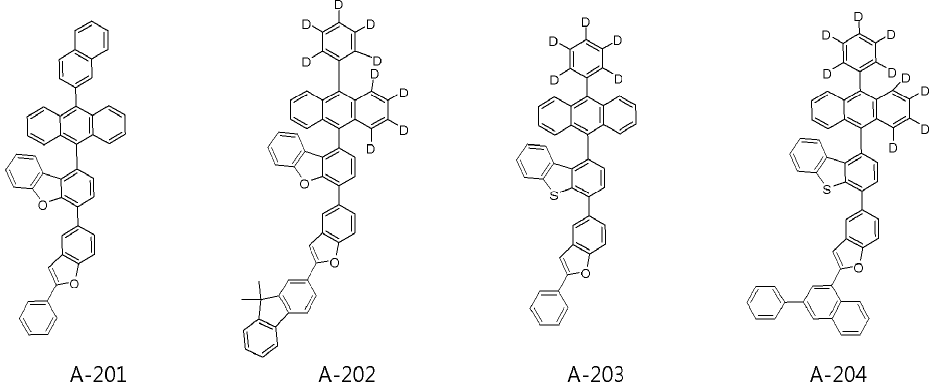

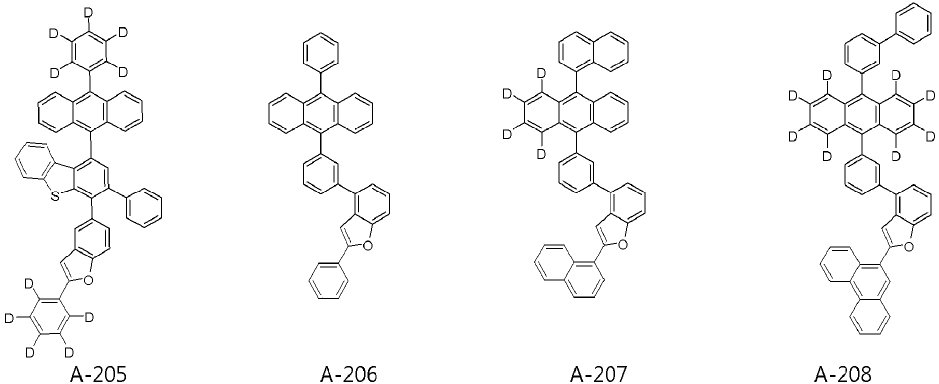

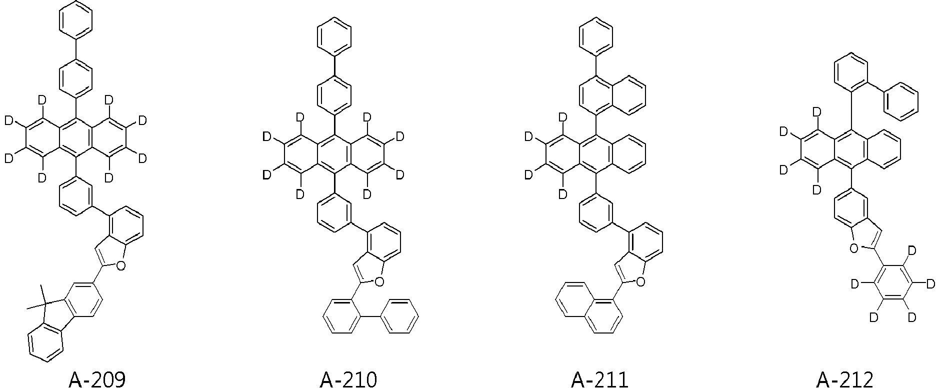

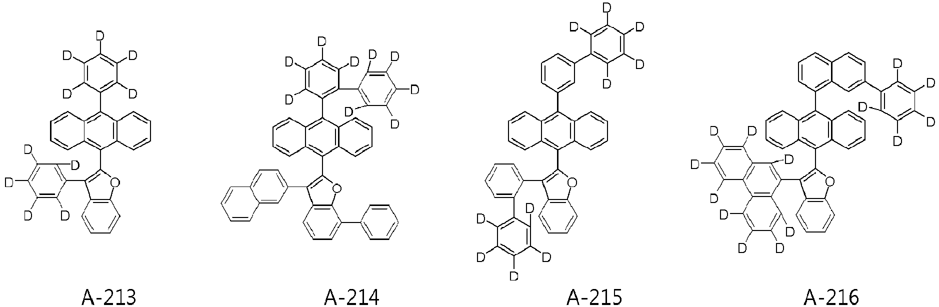

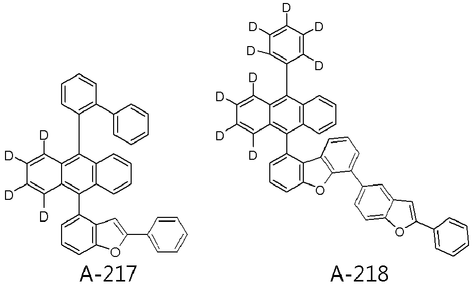

8. The organic light-emitting device according to claim 1, wherein the compound of [Formula B] is selected from compounds represented by the following [B-1] to [B-79]:

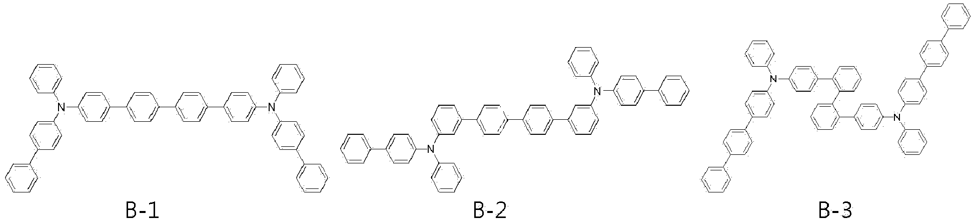

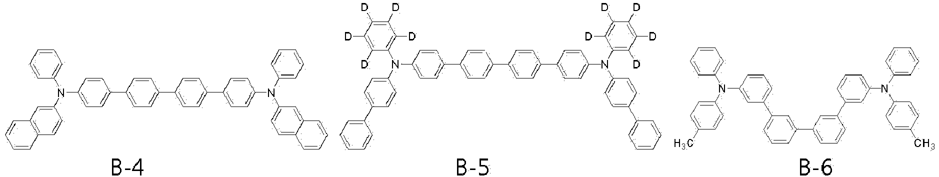

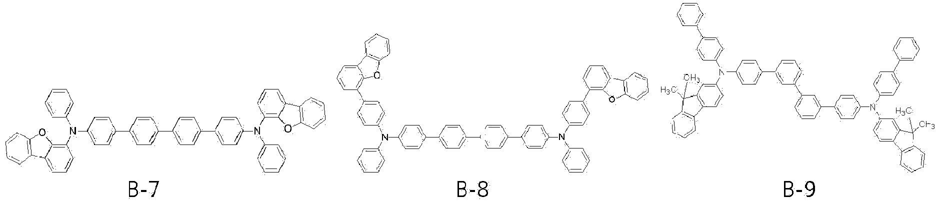

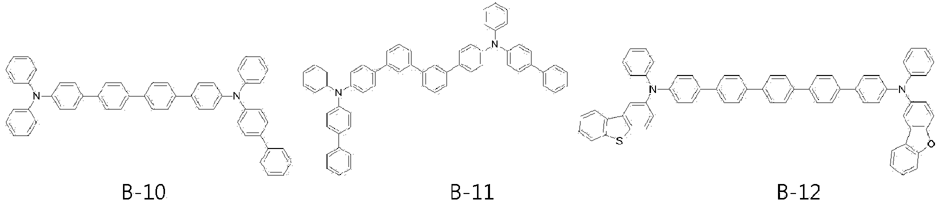

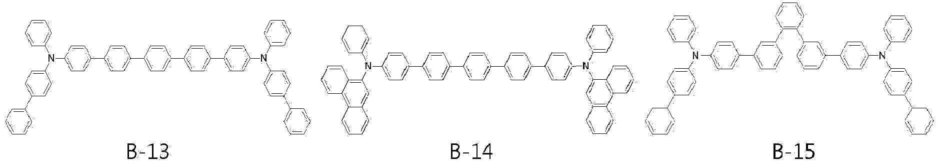

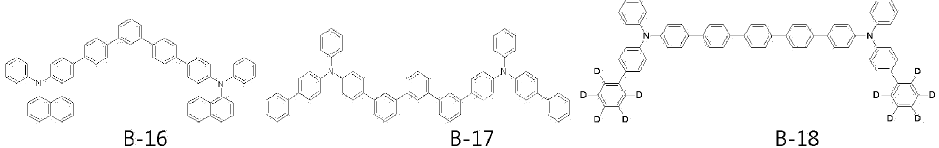

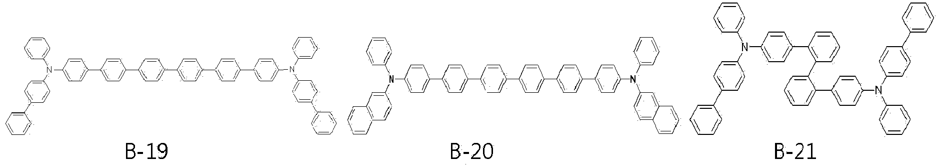

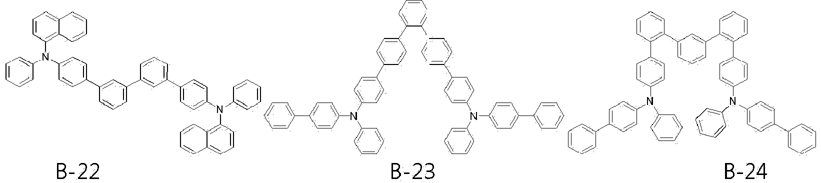

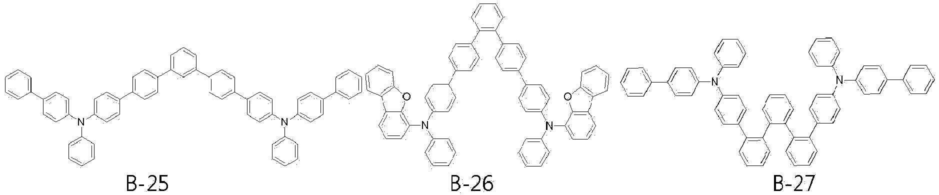

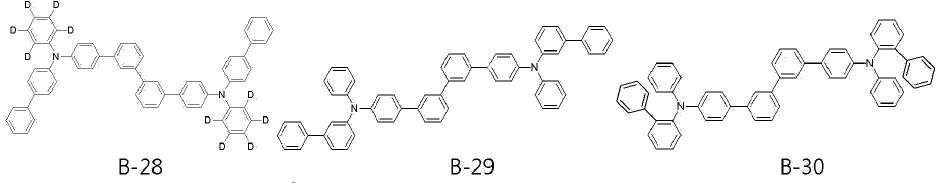

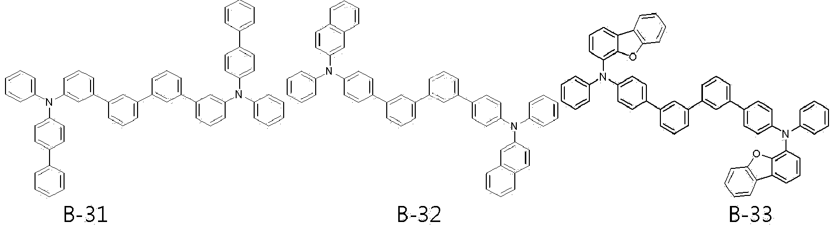

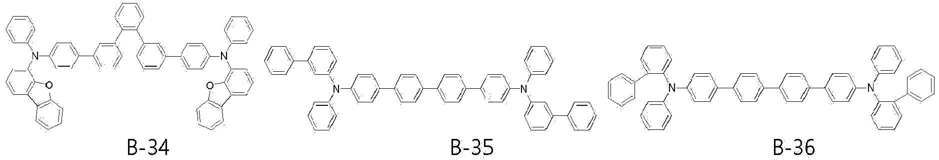

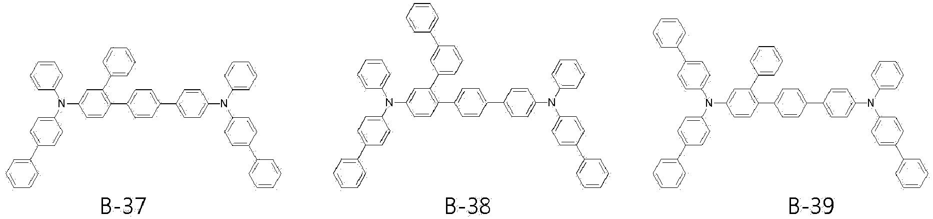

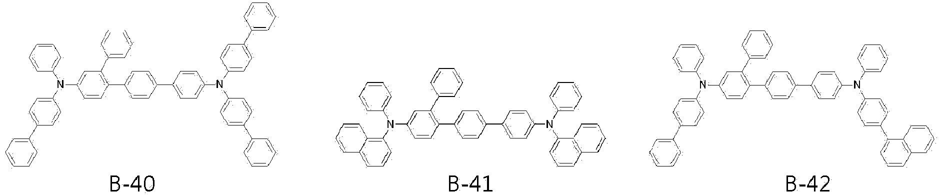

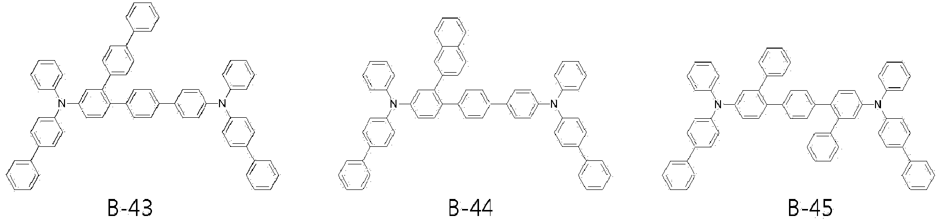

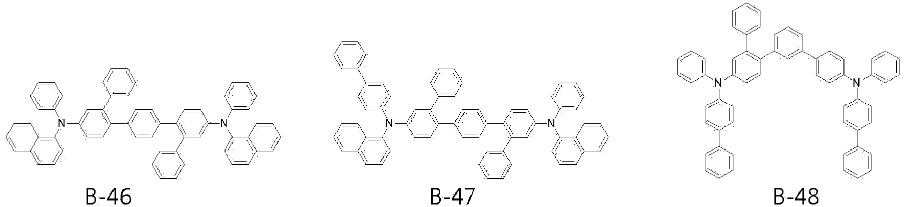

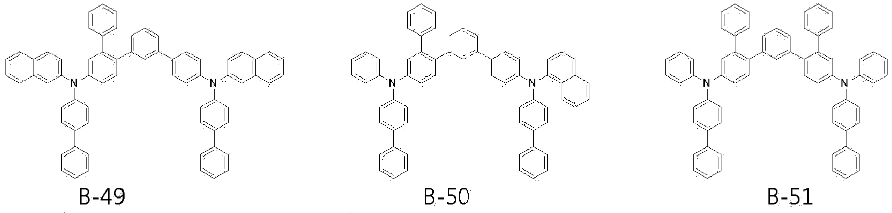

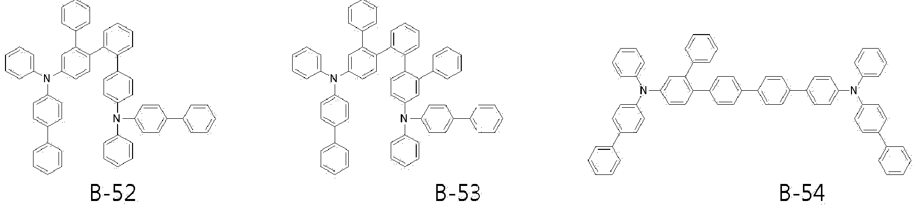

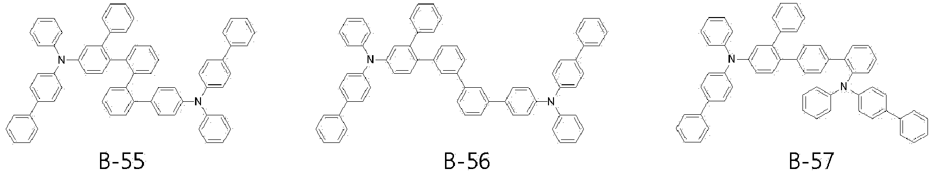

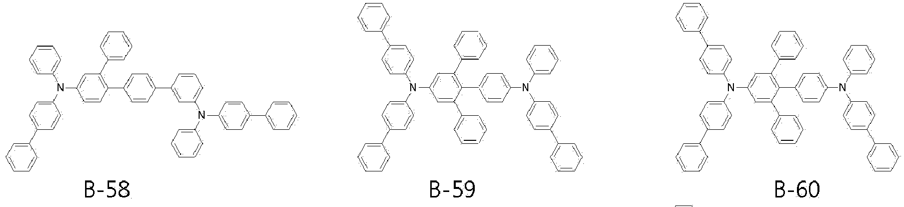

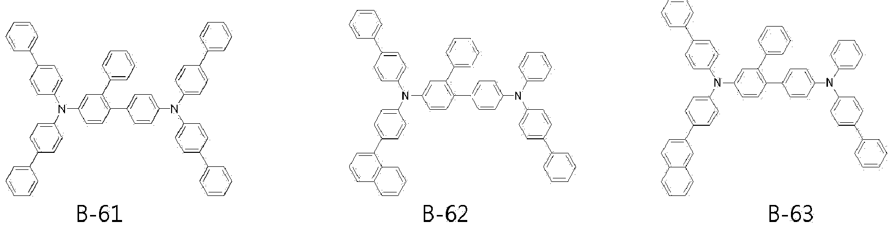

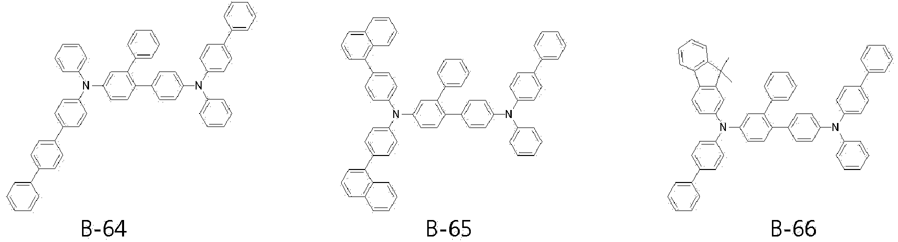

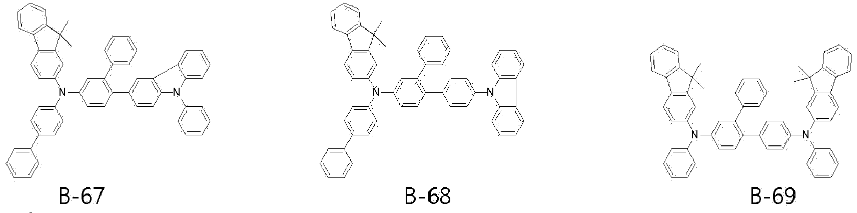

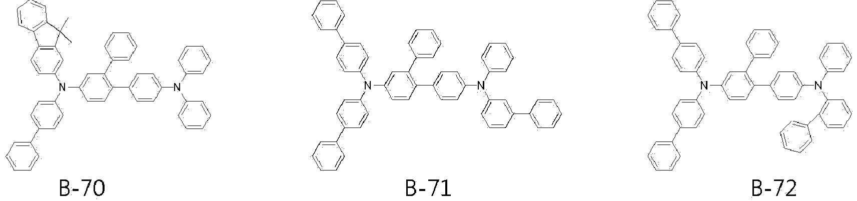

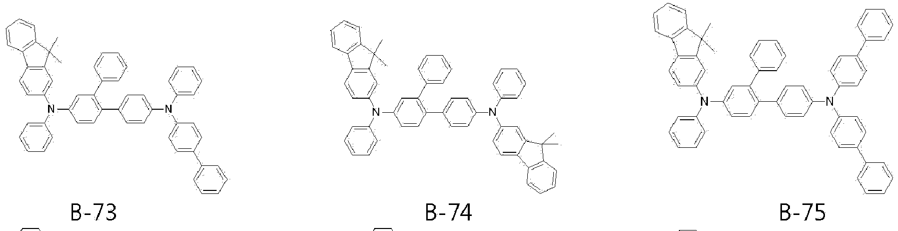

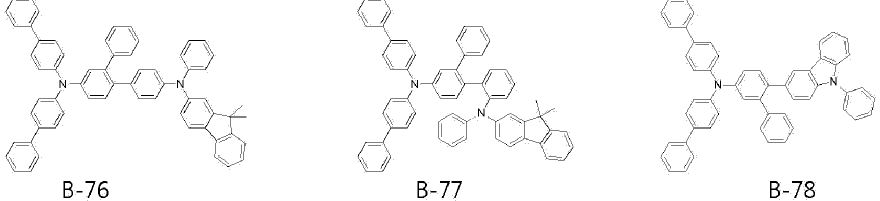

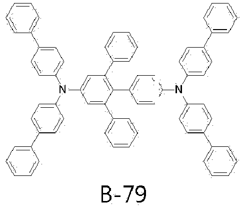

9. The organic light-emitting device according to claim 1, wherein the compound represented by [Formula B] is selected from compounds represented by the following [B-101] to [B-148]:

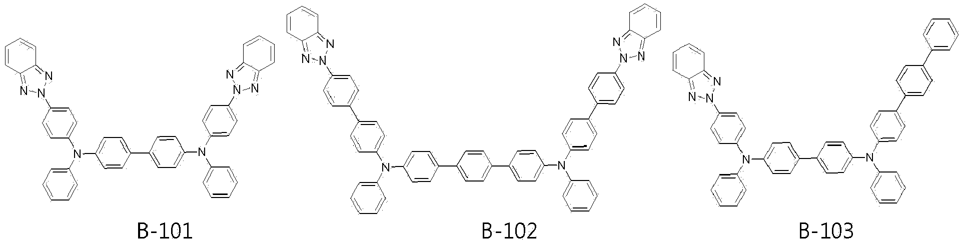

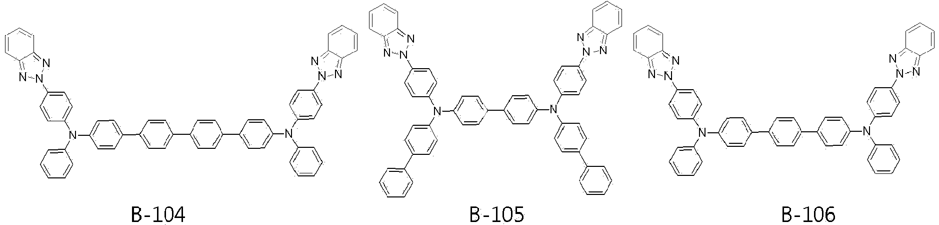

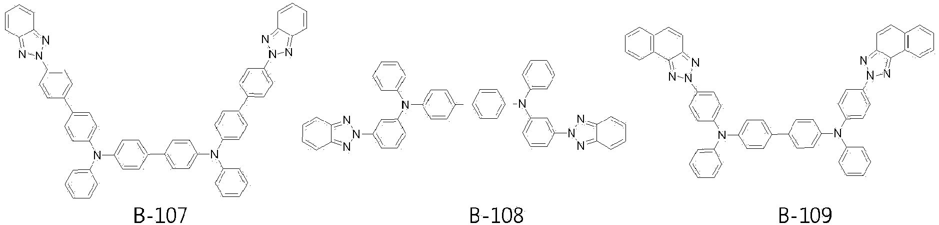

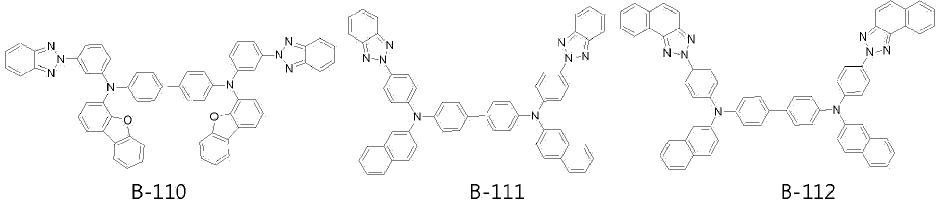

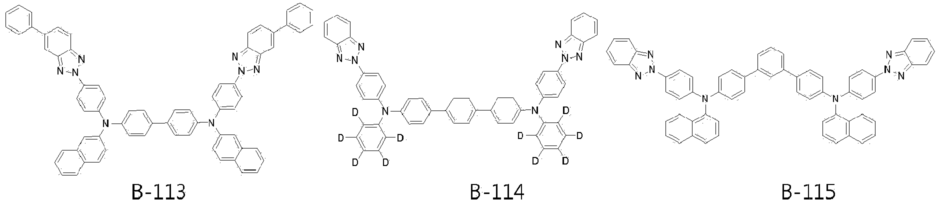

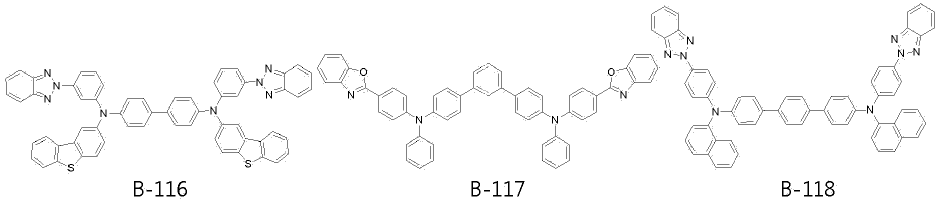

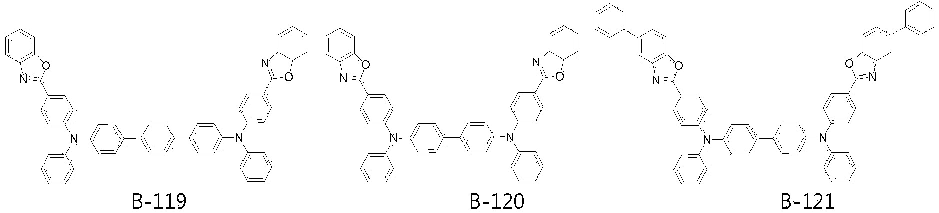

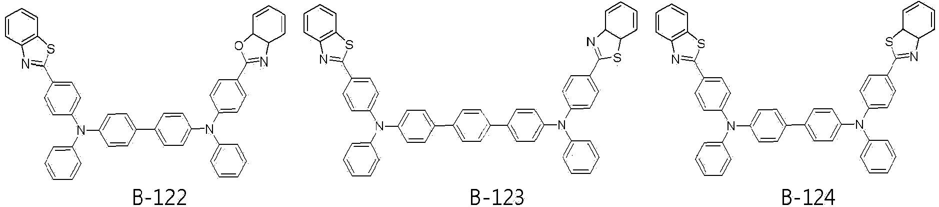

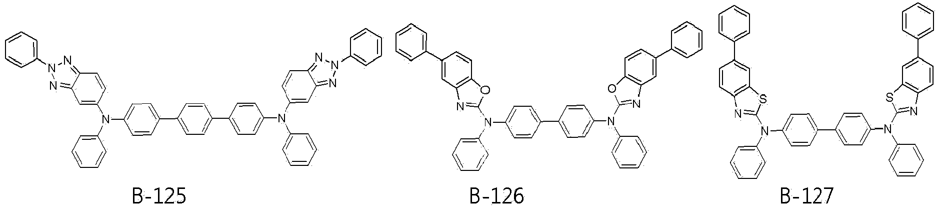

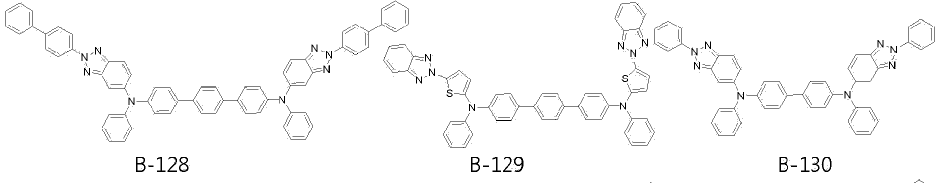

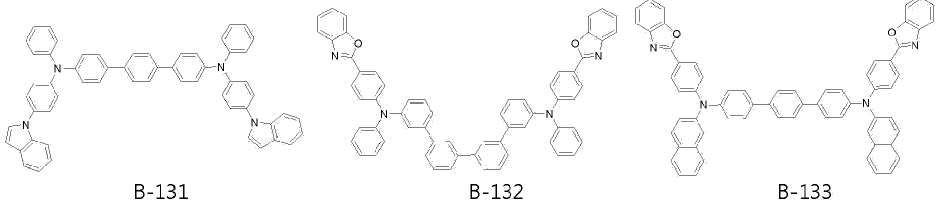

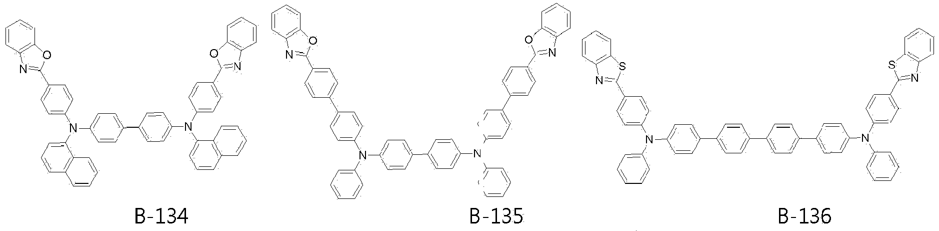

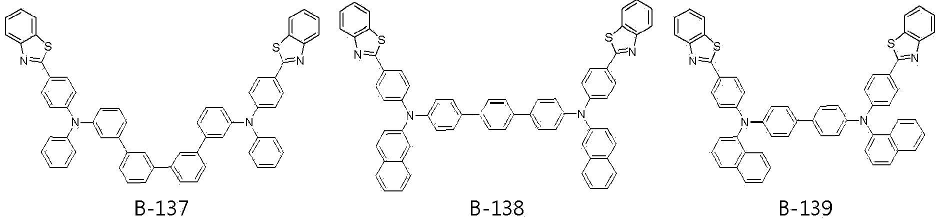

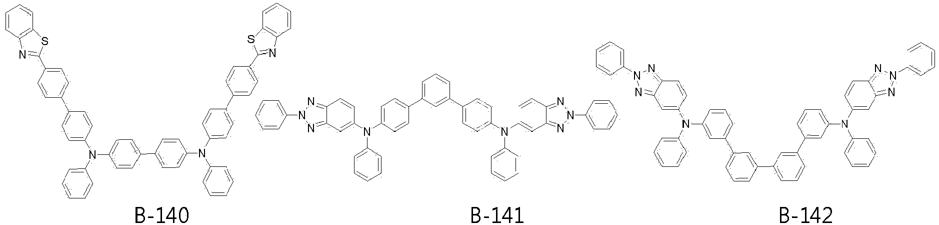

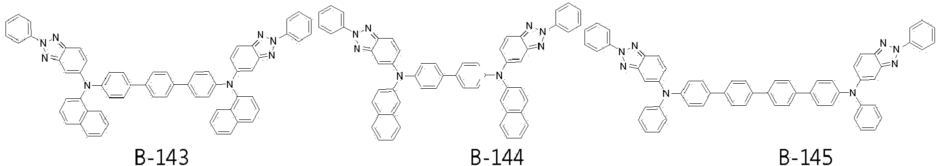

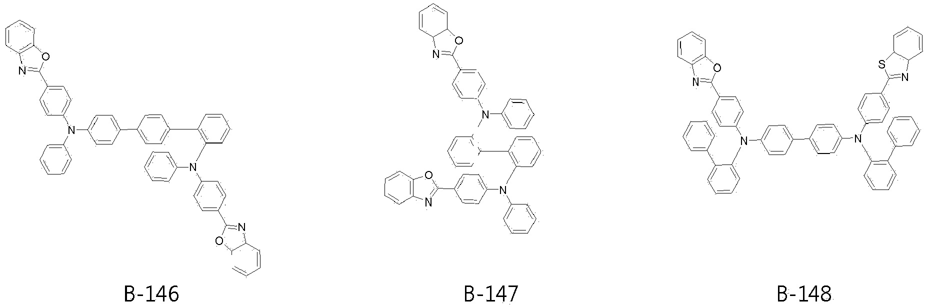

10. The organic light-emitting device according to claim 1, wherein the compound represented by [Formula C] is selected from compounds represented by the following [C-1] to [C-99]:

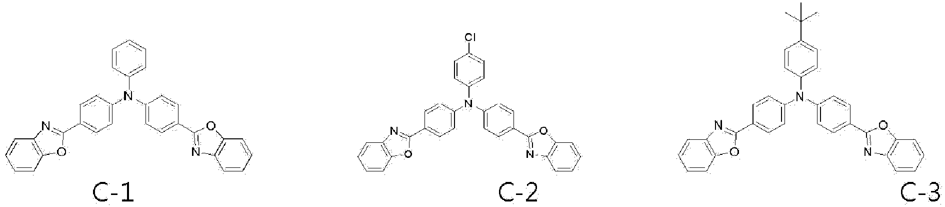

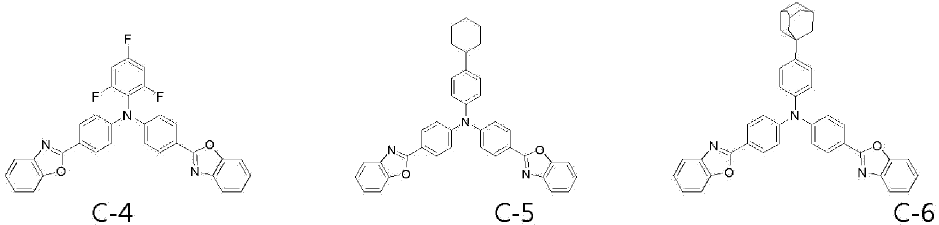

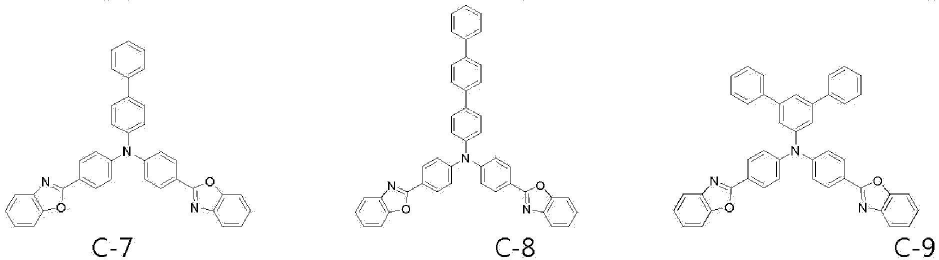

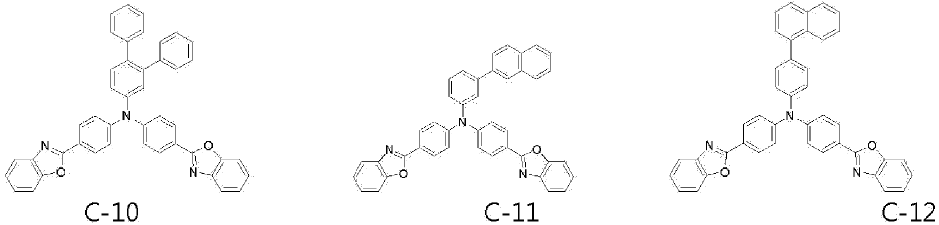

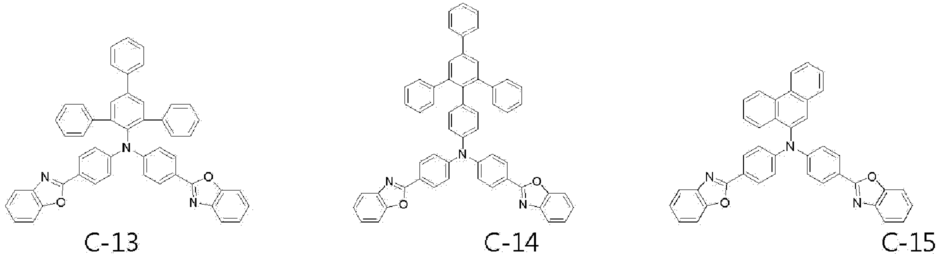

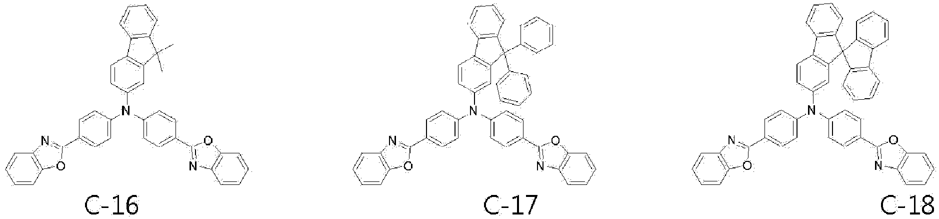

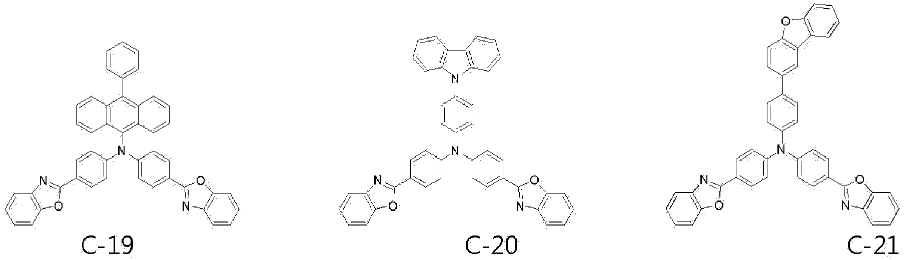

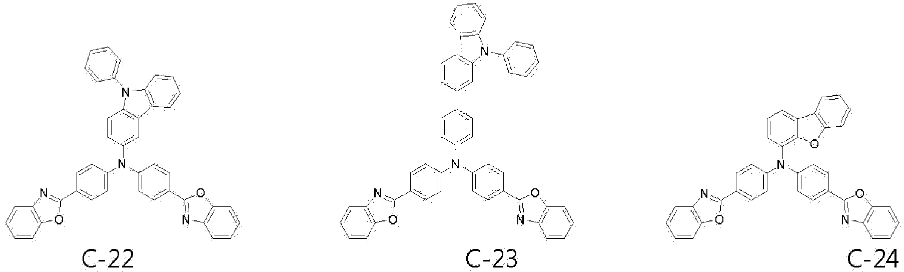

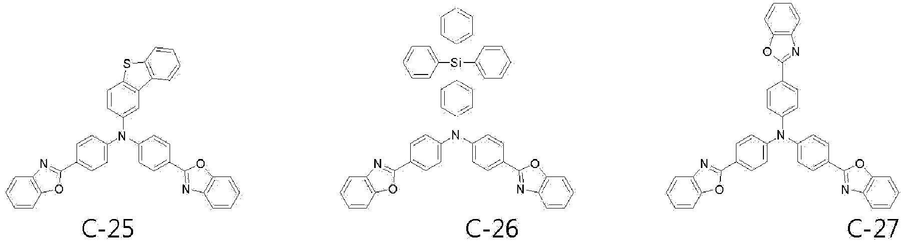

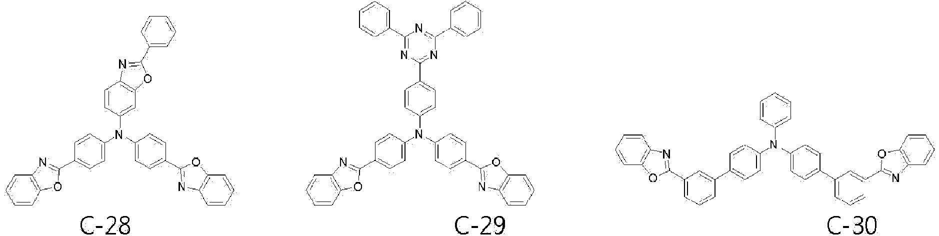

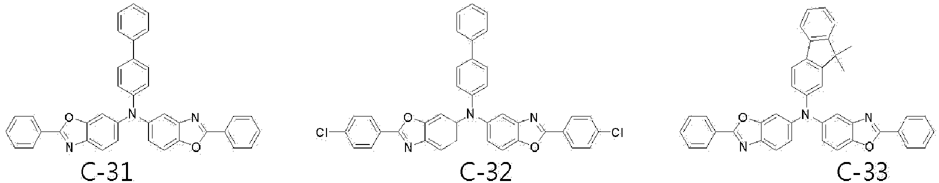

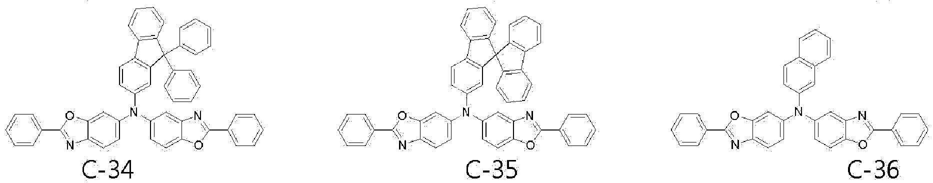

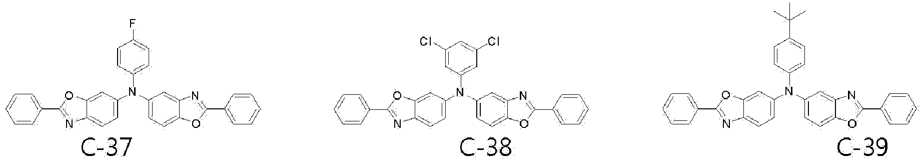

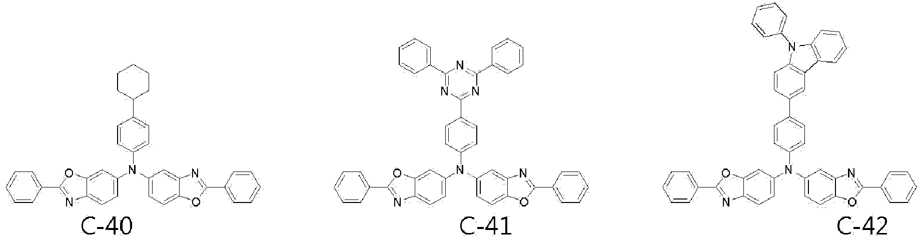

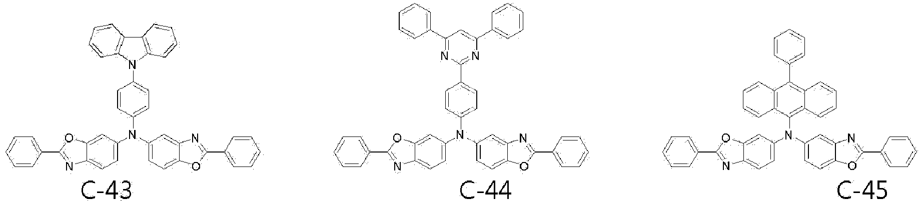

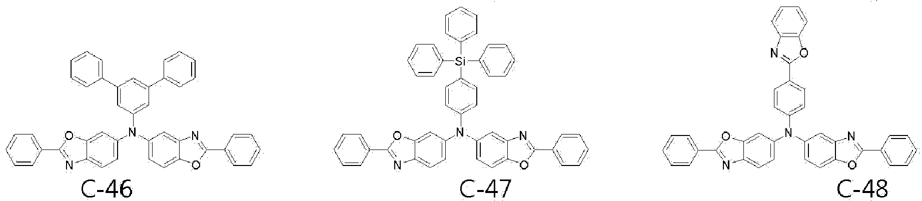

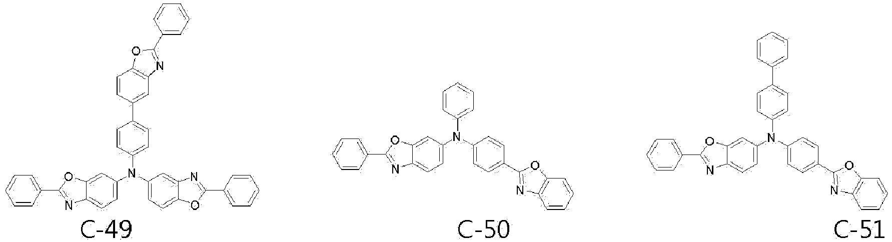

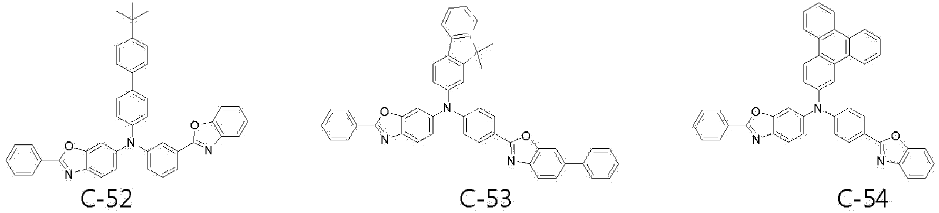

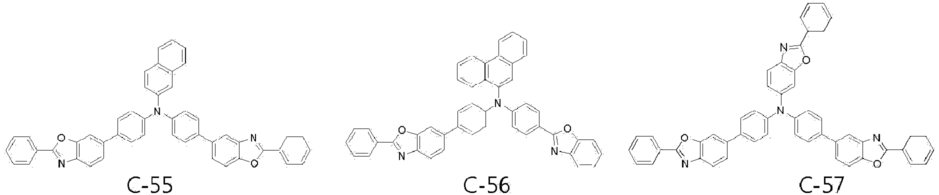

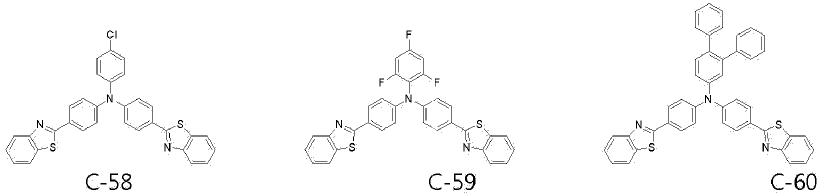

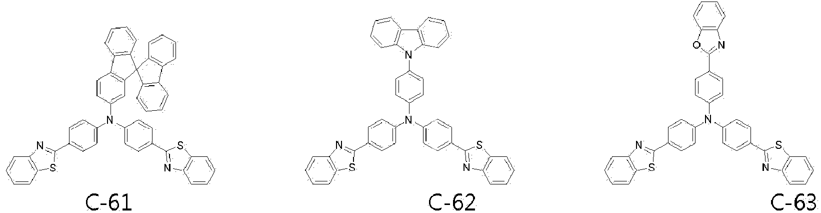

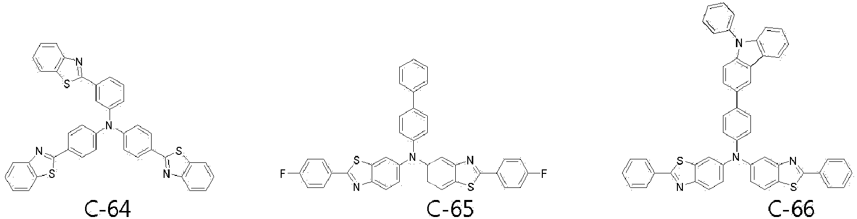

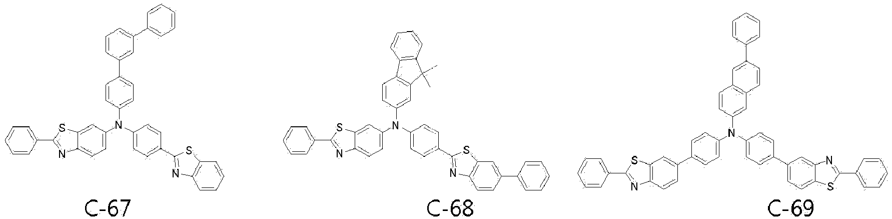

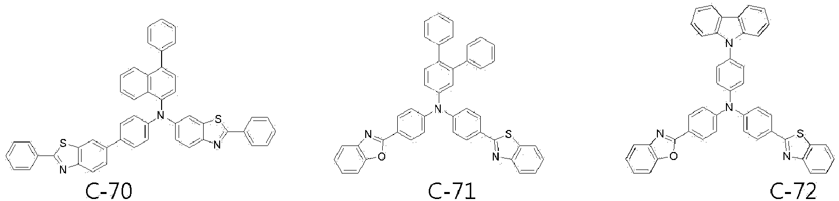

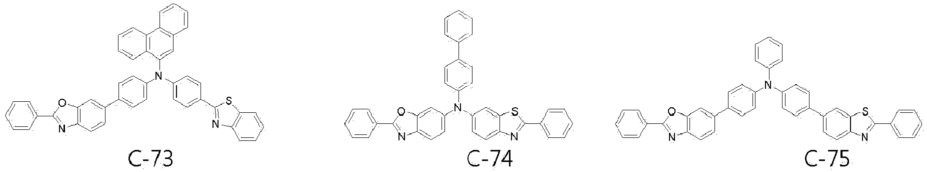

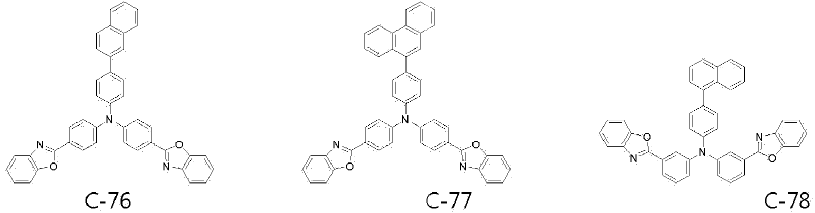

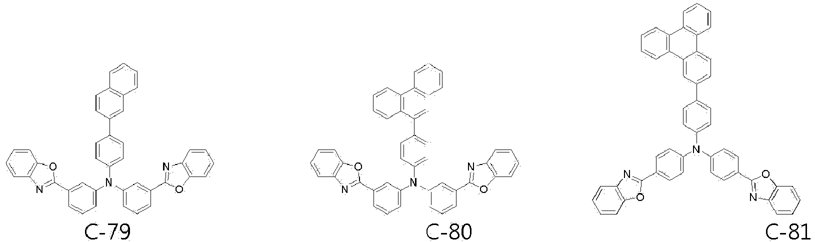

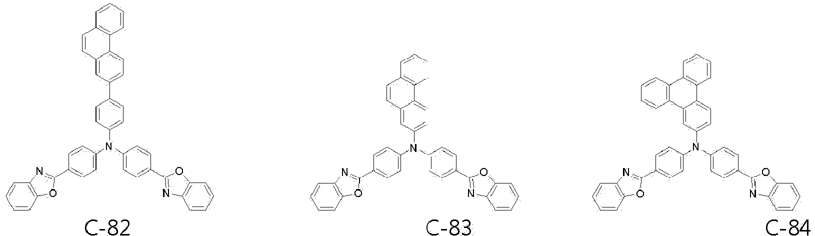

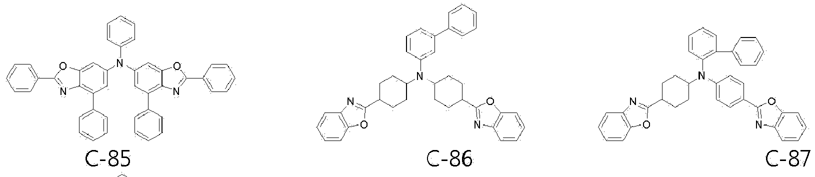

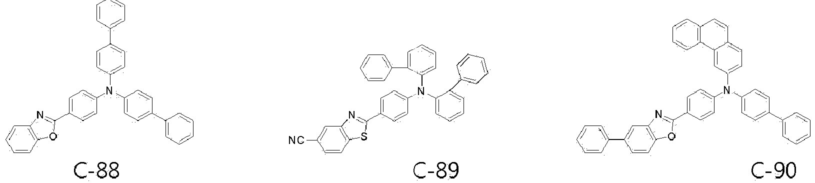

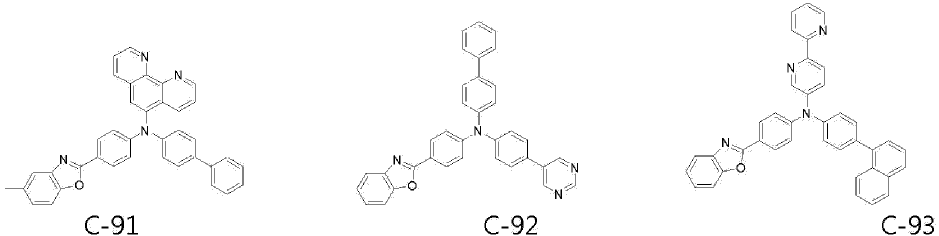

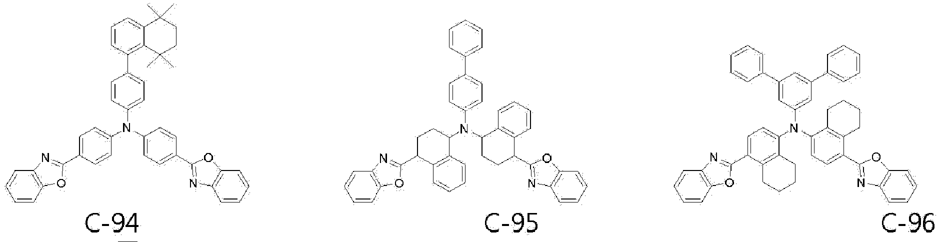

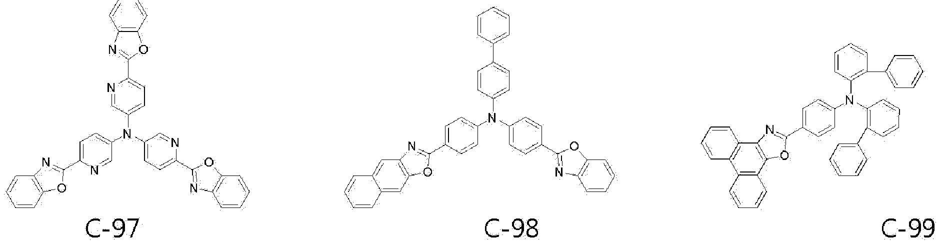

11. The organic light-emitting device according to claim 1, wherein the light-emitting layer comprises a host and a dopant and the host comprises one of compounds represented by [A-1] to [A-66] above.

12. The organic light-emitting device according to claim 11, wherein the dopant compound comprises a polycyclic compound represented by the following [Formula D]: 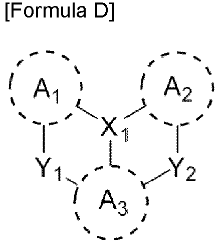 wherein
X₁ is selected from B, P=O and P=S,
Y₁ and Y₂ are each independently selected from NR₄₁, CR₄₂R₄₃, O, S, Se and SiR₄₄R₄₅,
A₁ to A₃ are each independently selected from a substituted or unsubstituted C6-C50 aromatic hydrocarbon ring, a substituted or unsubstituted C2-C50 heteroaromatic ring, a substituted or unsubstituted C3-C30 aliphatic ring, and a substituted or unsubstituted C3-C30 mixed aliphatic-aromatic ring, and
R₄₁ to R₄₅ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that each of R₄₁ to R₄₅ is bonded to each of the rings A₁ to A₃ to form an alicyclic or aromatic monocyclic or polycyclic ring, the substituents of the rings A₁ to A₃ are bonded to each other to form an alicyclic or aromatic monocyclic or polycyclic ring, and R₄₂ and R₄₃, and R₄₄ and R₄₅ are bonded to each other to further form an alicyclic or aromatic monocyclic or polycyclic ring, at least one carbon atom of which is substituted with at least one heteroatom selected from nitrogen, oxygen, and sulfur.

13. The organic light-emitting device according to claim 12, wherein the polycyclic compound represented by [Formula D] comprises any one of compounds represented by the following [Formula D-1] to [Formula D-8]: 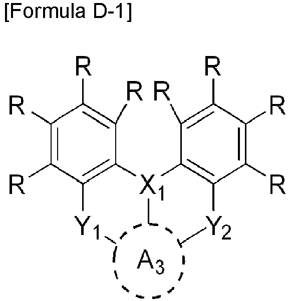 wherein
R's are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted a C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that R's are bonded to each other to further form an alicyclic or aromatic monocyclic or polycyclic ring, at least one carbon atom of which is substituted with at least one heteroatom selected from nitrogen, oxygen, and sulfur, and
X₁, Y₁, Y₂ and A₃ are as defined in [Formula D] in claim 12, 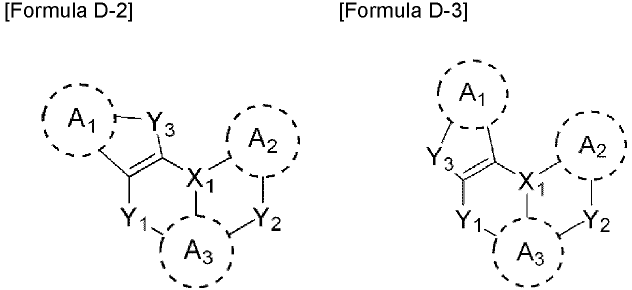
wherein
Y₃ is each independently selected from NR₄₁, CR₄₂R₄₃, O, S, Se, and SiR₄₄R₄₅, and
X₁, Y₁, Y₂, A₁ to A₃ and R₄₁ to R₄₅ are as defined in [Formula D] in claim 12, 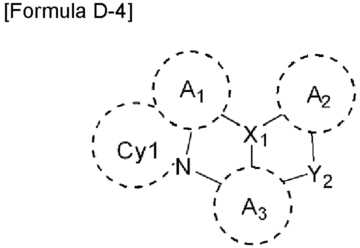
wherein
X₁, Y₂ and A₁ to A₃ are as defined in [Formula D] in claim 12, and
Cy1 is bonded to an adjacent nitrogen atom (N) and the aromatic carbon atom in the ring A₁ to be bonded to Cy1, to form a condensed ring including the nitrogen atom (N), the aromatic carbon atom in the ring A₁ to which the nitrogen atom (N) is bonded, and the aromatic carbon atom in the A₁ ring to be bonded to Cy1,
wherein a moiety of the ring formed by Cy1, excluding the nitrogen atom (N), the aromatic carbon atom in the ring A₁ to which the nitrogen atom (N) is bonded, and the aromatic carbon atom in the A₁ ring to be bonded to Cy1, is a substituted or unsubstituted C2-C5 alkylene group, 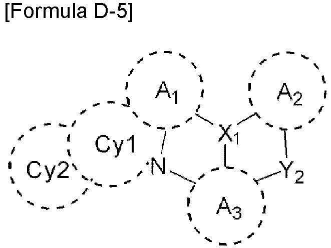
wherein
X₁, Y₂ and A₁ to A₃ are as defined in [Formula D] in claim 12,
Cy2 is added to Cy1 to form a saturated hydrocarbon ring and a moiety of the ring formed by Cy2, excluding the carbon atom included in Cy1, is a substituted or unsubstituted C2-C5 alkylene group, 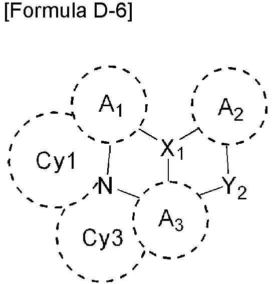
wherein
X₁, Y₂ and A₁ to A₃ are as defined in [Formula D] in claim 12, and
Cy3 is bonded to the carbon atom bonded to the nitrogen atom (N) in Cy1 and to the aromatic carbon atom in the ring A₃ to be bonded to Cy3, to form a condensed ring including the aromatic carbon atom in the A₃ ring to be bonded to Cy3, the nitrogen atom (N), and the carbon atom in Cy1 to which the nitrogen atom (N) is bonded,
wherein a moiety of the ring formed by Cy3, excluding the aromatic carbon atom in the A₃ ring to be bonded to Cy3, the nitrogen atom (N), and the carbon atom in Cy1 to which the nitrogen atom (N) is bonded, is a substituted or unsubstituted C1-C4 alkylene group, 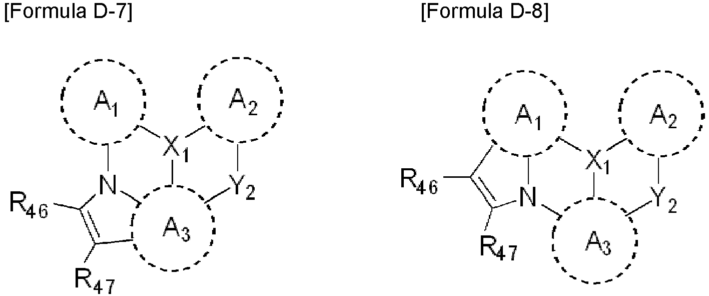
wherein
R₄₆ and R₄₇ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C3-C30 heterocycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted amine group, a substituted or unsubstituted silyl group, a substituted or unsubstituted C3-C20 mixed aliphatic-aromatic ring group, a nitro group, a cyano group, and a halogen group, with the proviso that R₄₅ and R₄₇ are bonded to each other to further form an alicyclic or aromatic monocyclic or polycyclic ring and a mixed aliphatic-aromatic ring, and
X₁, Y₂ and A₁ to A₃ are as defined in [Formula D] in claim 12.

14. The organic light-emitting device according to claim 1, further comprising at least one selected from a hole injection layer, a hole transport layer, a functional layer capable of injecting and transporting holes, an electron transport layer, an electron transport layer and a functional layer capable of injecting and transporting electrons, in addition to the light-emitting layer.

15. The organic light-emitting device according to claim 1, wherein the first electrode is an anode and the second electrode is a cathode, and
the capping layer is formed on one surface of the cathode.

16. The organic light-emitting device according to claim 14, wherein the organic light-emitting device is used for a display or lighting system selected from flat panel displays, flexible displays, monochromatic or white flat panel lighting systems, monochromatic or white flexible lighting systems, vehicle displays, and displays for virtual or augmented reality.

## Patentansprüche

1. Eine organische lichtemittierende Vorrichtung, umfassend:
eine erste Elektrode;
eine zweite Elektrode, die der ersten Elektrode gegenüberliegt;
eine lichtemittierende Schicht, die zwischen der ersten Elektrode und der zweiten Elektrode angeordnet ist; und
eine Deckschicht, die auf einer Oberfläche der ersten Elektrode oder der zweiten Elektrode angeordnet ist, die der übrigen Oberfläche der ersten Elektrode oder der zweiten Elektrode, die der lichtemittierenden Schicht zugewandt ist, gegenüberliegt,
wobei die lichtemittierende Schicht mindestens eine Verbindung umfasst, die ausgewählt ist aus den durch eine von [Formel A-1] bis [Formel A-6] repräsentierten Verbindungen, und
die Deckschicht mindestens eine Verbindung umfasst, die von [Formel B] oder [Formel C] repräsentierten sind: 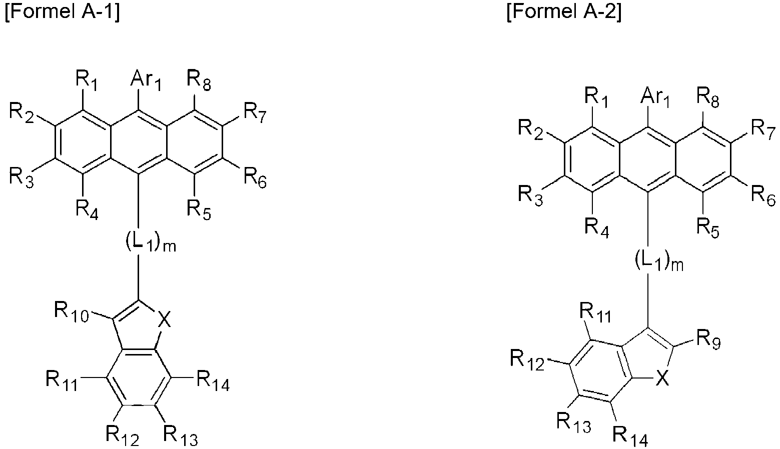 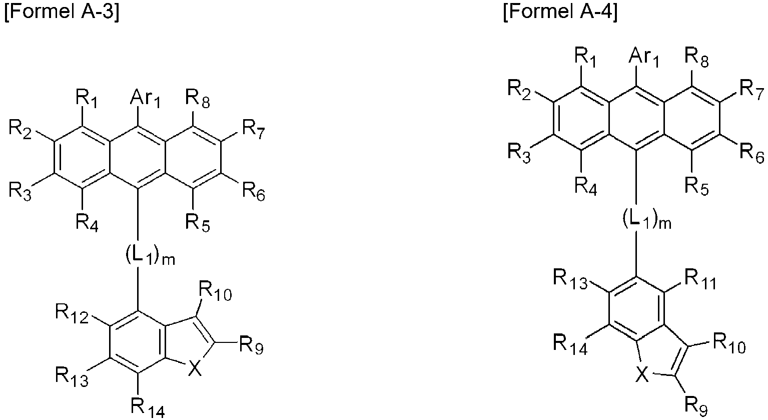 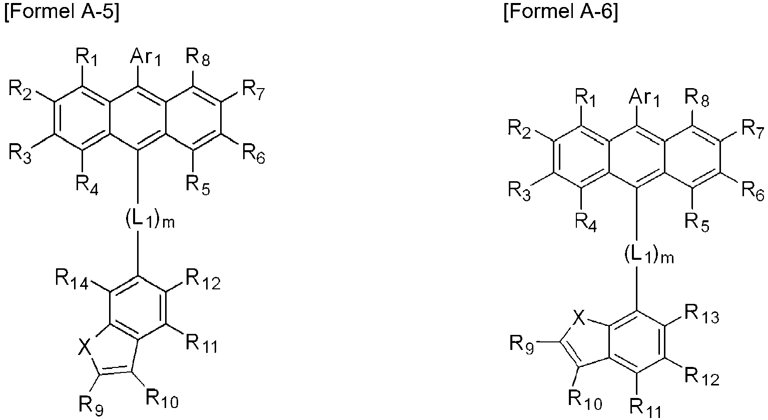
wobei Ar₁ ausgewählt ist aus einer substituierten oder unsubstituierten C6-C50-Arylgruppe, einer substituierten oder unsubstituierten C2-C50-Heteroarylgruppe und einer substituierten oder unsubstituierten C3-C50-gemischten aliphatisch-aromatischen Ringgruppe,
R₁ bis R₁₄ identisch oder voneinander verschieden sind und jeweils unabhängig voneinander Wasserstoff, Deuterium, eine substituierte oder unsubstituierte C1-C30-Alkylgruppe, eine substituierte oder unsubstituierte C6-C50-Arylgruppe, eine substituierte oder unsubstituierte C2-C30-Alkinylgruppe, eine substituierte oder unsubstituierte C3-C30-Cycloalkylgruppe, eine substituierte oder unsubstituierte C3-C30-Cycloalkenylgruppe, eine substituierte oder unsubstituierte C2 -C50-Heteroarylgruppe, eine substituierte oder unsubstituierte C2-C30-Heterocycloalkylgruppe, eine substituierte oder unsubstituierte C1-C30-Alkoxygruppe, eine substituierte oder unsubstituierte C6-C50-Aryloxygruppe, eine substituierte oder unsubstituierte C1 -C30-Alkylthioxygruppe, eine substituierte oder unsubstituierte C6-C50-Arylthioxygruppe, eine substituierte oder unsubstituierte Amingruppe, eine substituierte oder unsubstituierte Silylgruppe, eine substituierte oder unsubstituierte C3-C50-gemischt aliphatisch-aromatische Ringgruppe, eine Cyanogruppe, eine Nitrogruppe oder eine Halogengruppe sind,
X ein Sauerstoffatom (O) oder ein Schwefelatom (S) ist,
L₁ ein zweiwertiger Linker ist und entweder eine Einfachbindung ist oder aus einer substituierten oder unsubstituierten C6-C50-Arylen-Gruppe, einer substituierten oder unsubstituierten C2-C50-Heteroarylen-Gruppe und einer substituierten oder unsubstituierten C3-C50-gemischt aliphatisch-aromatischen Ringgruppe ausgewählt ist, und
m eine ganze Zahl zwischen 1 und 3 ist, vorausgesetzt, dass, wenn m 2 oder mehr ist, mehrere L1 identisch oder voneinander verschieden sind, 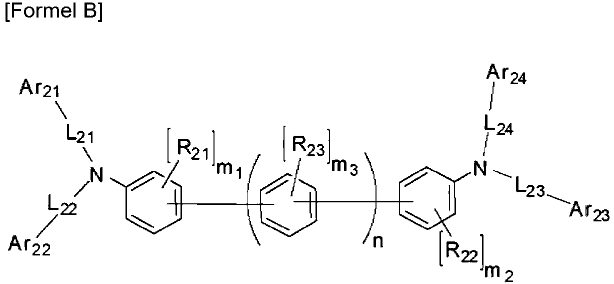
wobei R₂₁ bis R₂₃ identisch oder voneinander verschieden sind und jeweils unabhängig voneinander ausgewählt sind aus Wasserstoff, Deuterium, einer substituierten oder unsubstituierten C1-C20-Alkylgruppe, einer substituierten oder unsubstituierten C6-C50-Arylgruppe, einer substituierten oder unsubstituierten C2-C30-Heteroarylgruppe, einer substituierten oder unsubstituierten C7-C50-Arylalkylgruppe, einer substituierten oder unsubstituierten C3-C30-Cycloalkylgruppe, einer substituierten oder unsubstituierten Silylgruppe und einer Halogengruppe,
L₂₁ bis L₂₄ identisch oder voneinander verschieden sind und jeweils unabhängig voneinander eine Einfachbindung sind oder aus einer substituierten oder unsubstituierten C6-C50-Arylengruppe und einer substituierten oder unsubstituierten C2-C50-Heteroarylengruppe ausgewählt sind,
Ar₂, bis Ar₂₄ identisch oder voneinander verschieden sind und jeweils unabhängig voneinander ausgewählt sind aus einer substituierten oder unsubstituierten C6-C50-Arylgruppe und einer substituierten oder unsubstituierten C2-C50-Heteroarylgruppe,
n eine ganze Zahl von 0 bis 4 ist, vorausgesetzt, dass, wenn n 2 oder mehr ist, mehrere aromatische Ringstrukturen in ( ), einschließlich R₂₃, identisch oder voneinander verschieden sind,
m₁ bis m₃ ganze Zahlen von 0 bis 4 sind, vorausgesetzt, dass, wenn m₁ bis m₃ jeweils 2 oder mehr sind, mehrere von R₂₁, R₂₂, und R₂₃ identisch oder voneinander verschieden sind, und
ein Kohlenstoffatom des aromatischen Rings, an das R₂, bis R₂₃ nicht gebunden sind, an Wasserstoff oder Deuterium gebunden ist, 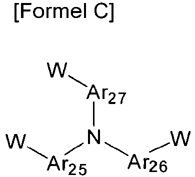
wobei Ar₂₅ bis Ar₂₇ zweiwertige Linker sind, identisch oder voneinander verschieden sind und jeweils unabhängig voneinander Einfachbindungen sind oder ausgewählt sind aus einer substituierten oder unsubstituierten C6-C50-Arylengruppe, einer substituierten oder unsubstituierten C2-C50-Heteroarylengruppe, einer substituierten oder unsubstituierten C3-C30-Cycloalkylengruppe und einer substituierten oder unsubstituierten C3-C50-gemischt aliphatisch-aromatischen Ringgruppe, und
die W-Gruppen jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C2-C30-Alkenylgruppe, einer substituierten oder unsubstituierten C2-C30-Alkinylgruppe, einer substituierten oder unsubstituierten C3-C30-Cycloalkylgruppe, einer substituierten oder unsubstituierten C3-C30-Cycloalkenylgruppe oder einer substituierten oder unsubstituierten C2-C50-Heteroarylgruppe, einer substituierten oder unsubstituierten C2-30-Heterocycloalkylgruppe, einer substituierten oder unsubstituierten C1-C30-Alkoxygruppe, einer substituierten oder unsubstituierten C6-C50-Aryloxygruppe, einer substituierten oder unsubstituierten C1-C30-Alkylthioxygruppe, einer substituierten oder unsubstituierten C6-C50-Arylthioxygruppe, einer substituierten oder unsubstituierten Amingruppe, einer substituierten oder unsubstituierten Silylgruppe, einer substituierten oder unsubstituierten C3-C50-gemischt aliphatisch-aromatischen Ringgruppe, einer Nitrogruppe und einer Halogengruppe, wobei die W-Gruppen identisch oder voneinander verschieden sind, mit der Maßgabe, dass mindestens eine der W-Gruppen durch die folgende [Formel C-1] repräsentiert ist: 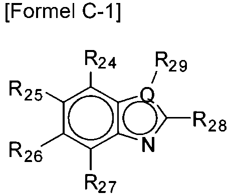
wobei R₂₄ bis R₂₉ identisch oder voneinander verschieden sind und jeweils unabhängig voneinander Linker als Bindungsstellen zu Ar₂₅ bis Ar₂₇ sind oder ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C2-C30-Alkenylgruppe, einer substituierten oder unsubstituierten C2-C30-Alkinylgruppe, einer substituierten oder unsubstituierten C3-C30-Cycloalkylgruppe, einer substituierten oder unsubstituierten C3-C30-Cycloalkenylgruppe, einer substituierten oder unsubstituierten C2-C50-Heteroarylgruppe, einer substituierten oder unsubstituierten C2 -C30-Hetero-Cycloalkylgruppe, einer substituierten oder unsubstituierten C1-C30-Alkoxygruppe, einer substituierten oder unsubstituierten C6-C50-Aryloxygruppe, einer substituierten oder unsubstituierten C1-C30-Alkylthioxygruppe, einer substituierten oder unsubstituierten C6-C50-Arylthioxygruppe, einer substituierten oder unsubstituierten Amingruppe, einer substituierten oder unsubstituierten Silylgruppe, einer substituierten oder unsubstituierten C3-C50-gemischt aliphatisch-aromatischen Ringgruppe, einer Cyanogruppe, einer Nitrogruppe und einer Halogengruppe, mit der Maßgabe, dass R₂₄ bis R₂₇ miteinander verbunden sind oder jedes von R₂₄ bis R₂₇ mit einem benachbarten Substituenten verbunden ist, um ferner einen alicyclischen oder aromatischen monocyclischen oder polycyclischen Ring zu bilden, von dem mindestens ein Kohlenstoffatom mit mindestens einem Heteroatom substituiert ist, das aus Stickstoff, Sauerstoff und Schwefel ausgewählt ist, und
Q entweder N, O oder S ist, mit der Maßgabe, dass, wenn Q O oder S ist, Q kein R₂₉ enthält.

2. Die organische lichtemittierende Vorrichtung gemäß Anspruch 1, wobei jede der durch [Formel A-1] bis [Formel A-6] repräsentierten Verbindungen mindestens ein Deuteriumatom (D) als Substituenten umfasst.

3. Die organische lichtemittierende Vorrichtung gemäß Anspruch 1, wobei jede der durch [Formel A-1] bis [Formel A-6] repräsentierten Verbindungen einen Deuterierungsgrad von 10 % oder mehr aufweist.

4. Die organische lichtemittierende Vorrichtung gemäß Anspruch 1, wobei mindestens einer der Reste R₁₁ bis R₁₄ in jeder der von [Formel A-1] bis [Formel A-6] repräsentierten Verbindungen ausgewählt ist aus einer substituierten oder unsubstituierten C6-C20-Arylgruppe, einer substituierten oder unsubstituierten C3-C20-Cycloalkylgruppe und einer substituierten oder unsubstituierten C3-C20-Heteroarylgruppe.

5. Die organische lichtemittierende Vorrichtung gemäß Anspruch 4, wobei mindestens einer der Reste R₁₁ bis R₁₄ in jeder der von [Formel A-1] bis [Formel A-6] repräsentierten Verbindungen eine mit Deuterium substituierte oder unsubstituierte C6-C20-Arylgruppe ist.

6. Die organische lichtemittierende Vorrichtung gemäß Anspruch 1, wobei mindestens eine der Ar₂₁ bis Ar₂₄-Gruppen durch die folgende [Formel E] dargestellt ist: 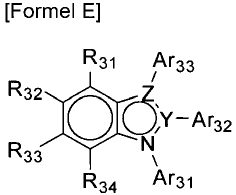
wobei R₃₁ bis R₃₄ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C2 -C30-Alkenylgruppe, einer substituierten oder unsubstituierten C2-C20-Alkinylgruppe, einer substituierten oder unsubstituierten C3-C30-Cycloalkylgruppe, einer substituierten oder unsubstituierten C5-C30-Cycloalkenylgruppe, einer substituierten oder unsubstituierten C2-C50-Heteroarylgruppe, einer substituierten oder unsubstituierten C2-C30-Hetero-Cycloalkylgruppe, einer substituierten oder unsubstituierten C1-C30-Alkoxygruppe, einer substituierten oder unsubstituierten C6-C30-Aryloxygruppe, einer substituierten oder unsubstituierten C1 -C30-Alkylthioxygruppe, einer substituierten oder unsubstituierten C5-C30-Arylthioxygruppe, einer substituierten oder unsubstituierten Amingruppe, einer substituierten oder unsubstituierten Silylgruppe, einer Nitrogruppe, einer Cyanogruppe und einer Halogengruppe, mit der Maßgabe, dass R₃₁ bis R₃₄ miteinander verbunden sind, um einen Ring zu bilden,
Y ein Kohlenstoffatom (C) oder ein Stickstoffatom (N) ist und Z ein Kohlenstoffatom (C), ein Sauerstoffatom (O), ein Schwefelatom (S) oder ein Stickstoffatom (N) ist und
Ar₃₁ bis Ar₃₃ sind identisch oder voneinander verschieden und jeweils unabhängig voneinander ausgewählt sind aus einer substituierten oder unsubstituierten C5-C50-Arylgruppe und einer substituierten oder unsubstituierten C3-C50-Heteroarylgruppe, mit der Maßgabe, dass, wenn Z ein Sauerstoffatom (O) oder ein Schwefelatom (S) ist, Ar₃₃ nichts ist, mit der Maßgabe, dass, wenn Y und Z Stickstoffatome (N) sind, nur eines von Ar₃₁, Ar₃₂ und Ar₃₃ vorhanden ist, mit der Maßgabe, dass, wenn Y ein Stickstoffatom (N) und Z ein Kohlenstoffatom (C) ist, Ar₃₂ nichts ist, mit der Maßgabe, dass eines von R₃₁ bis R₃₄ und Ar₃₁ bis Ar₃₃ eine Einfachbindung ist, die an einen der Linker L₂₁ bis L₂₄ in [Formel B] gebunden ist.

7. Die organische lichtemittierende Vorrichtung gemäß Anspruch 1, wobei jede der durch [Formel A-1] bis [Formel A-6] repräsentierten Verbindungen aus Verbindungen ausgewählt ist, die durch die folgenden [A-1] bis [A-218] repräsentiert sind:

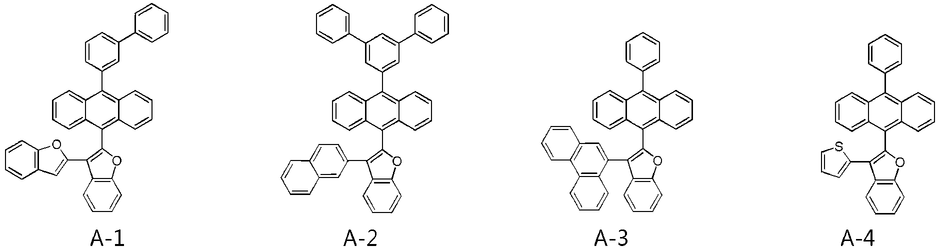

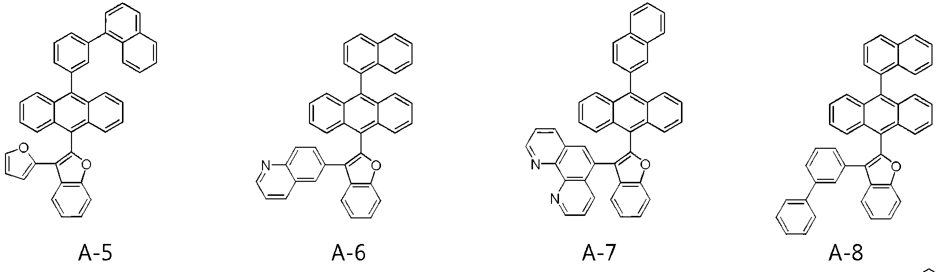

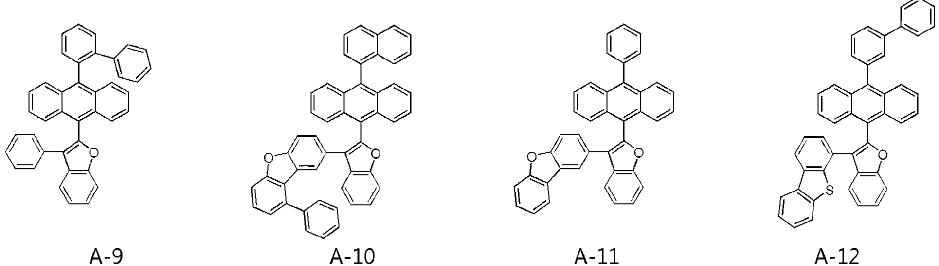

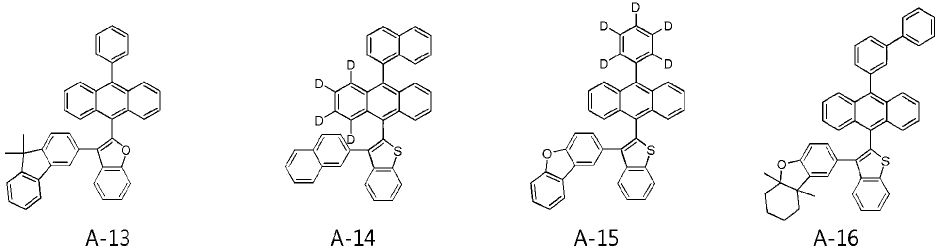

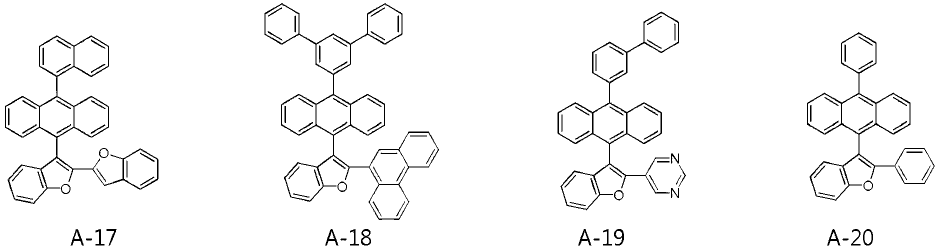

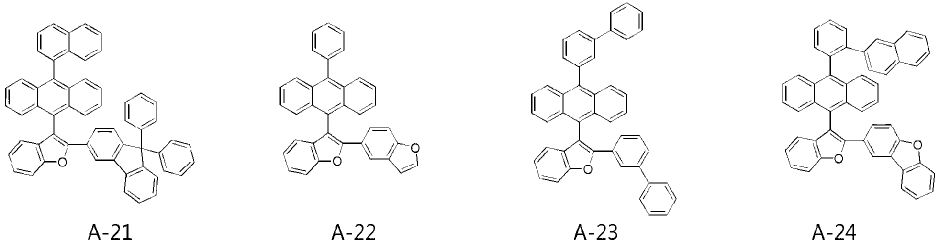

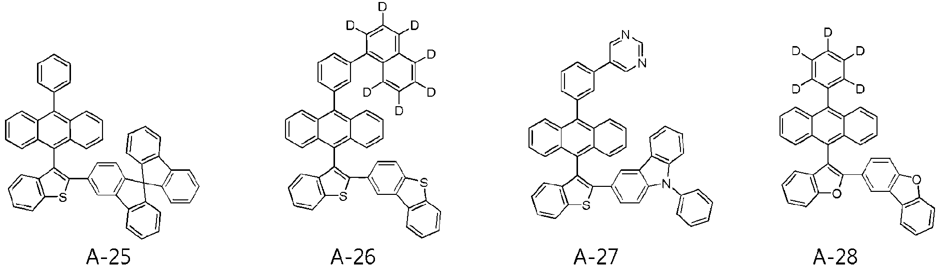

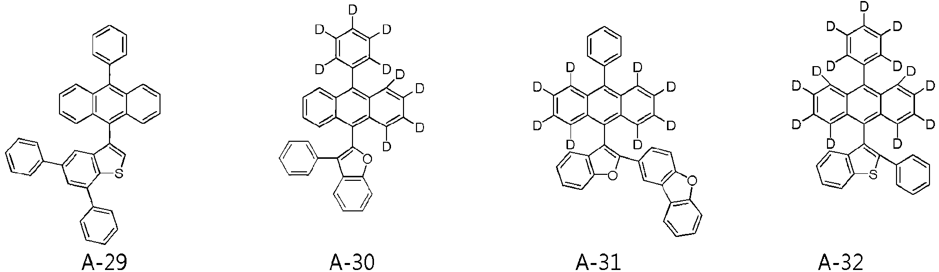

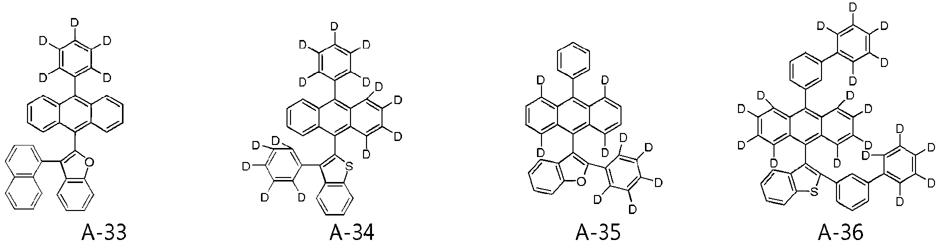

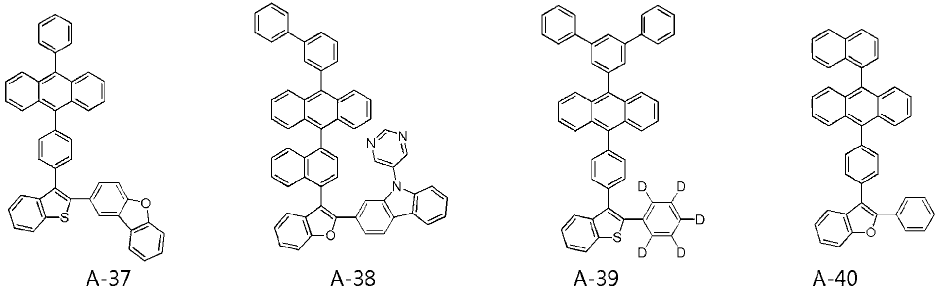

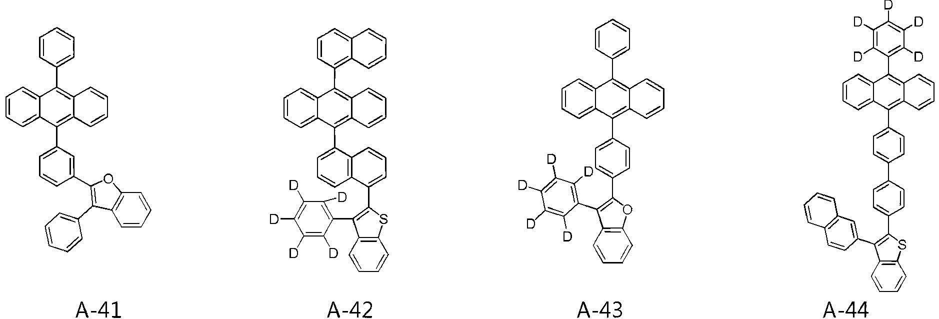

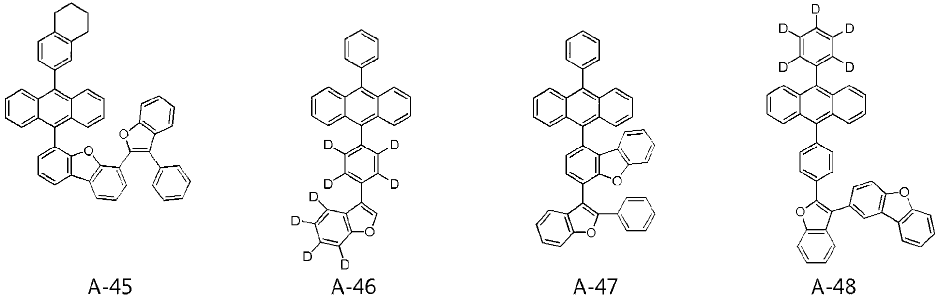

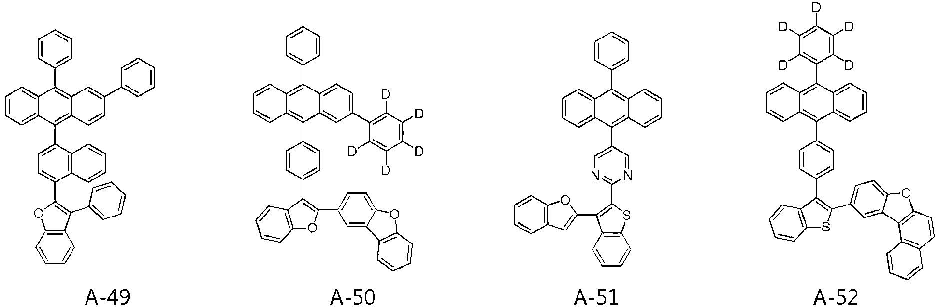

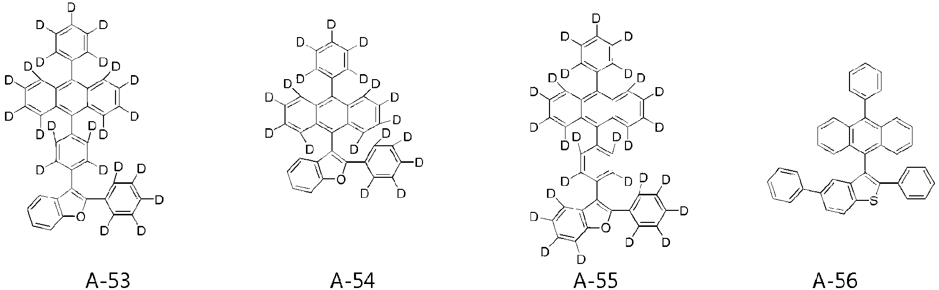

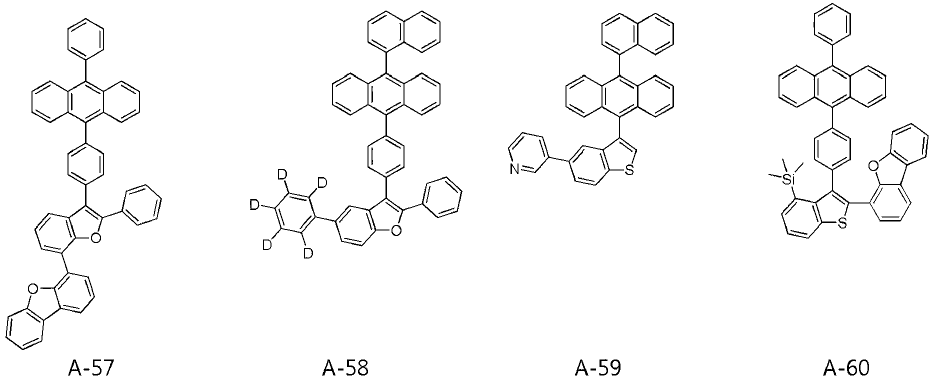

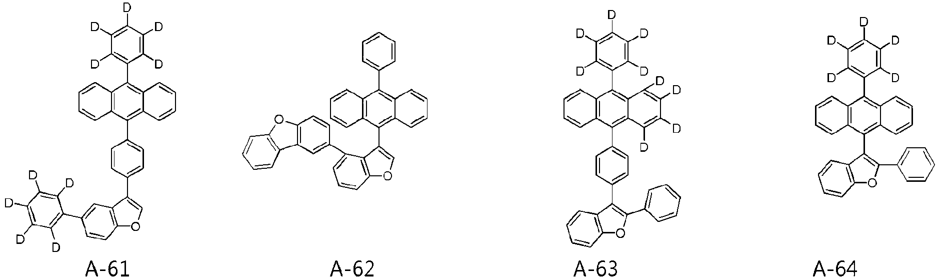

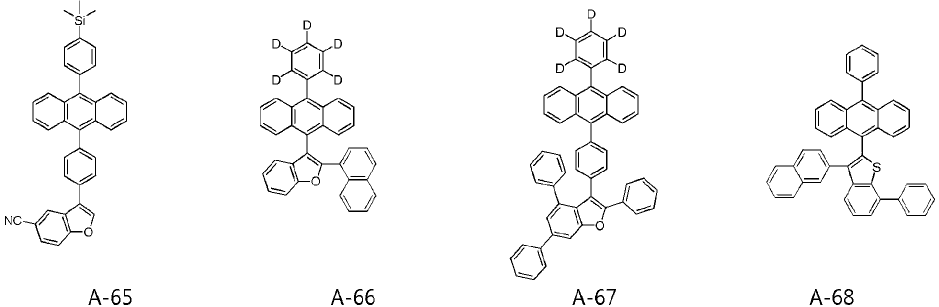

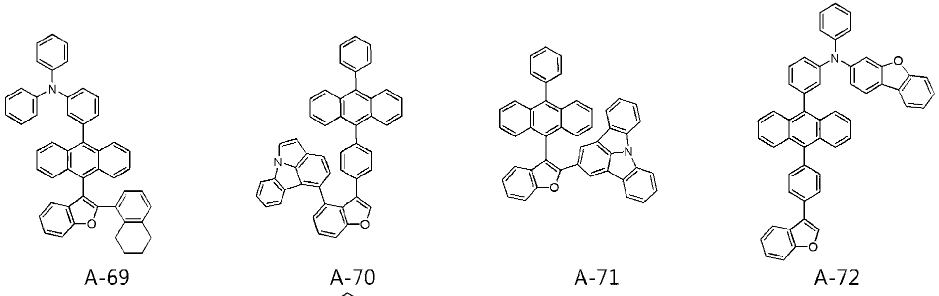

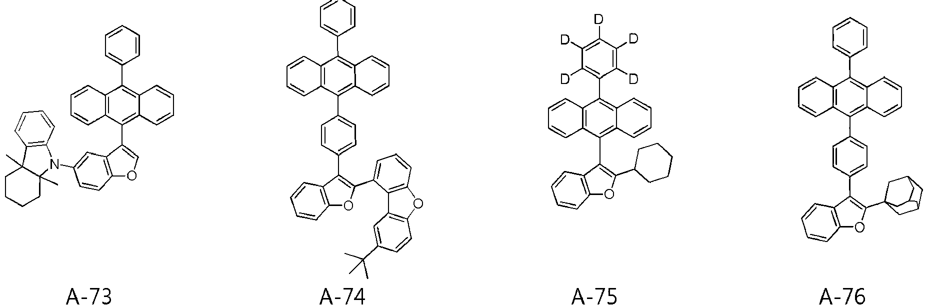

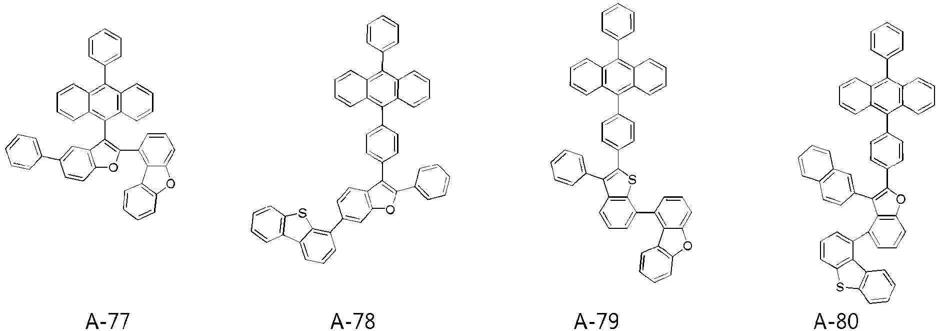

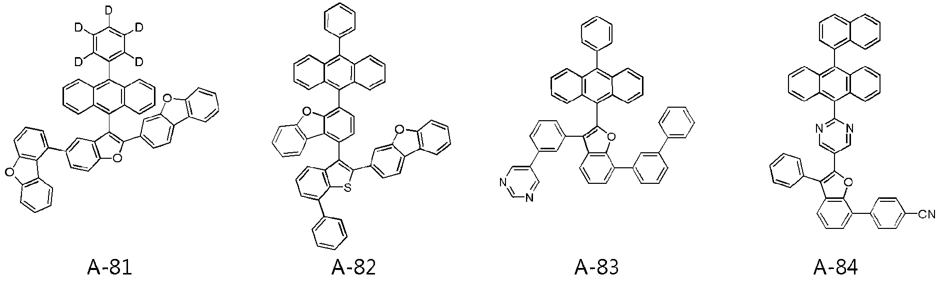

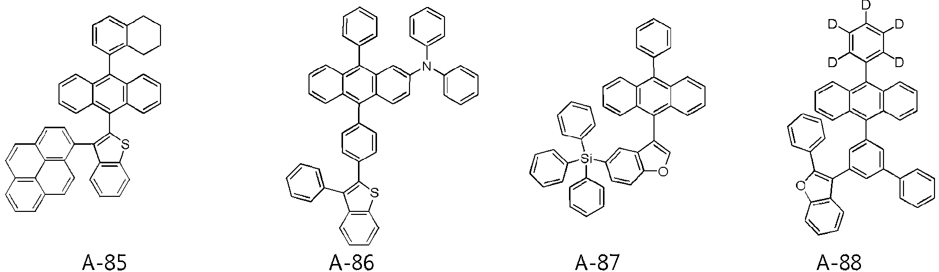

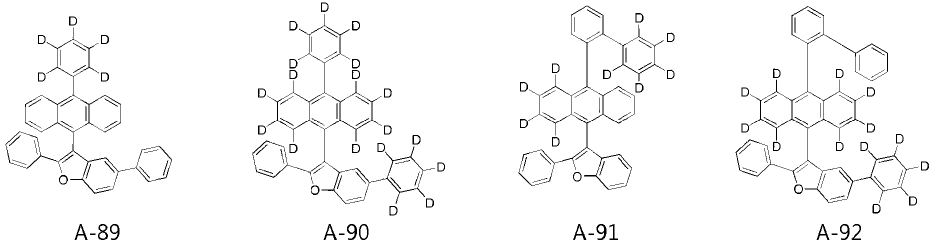

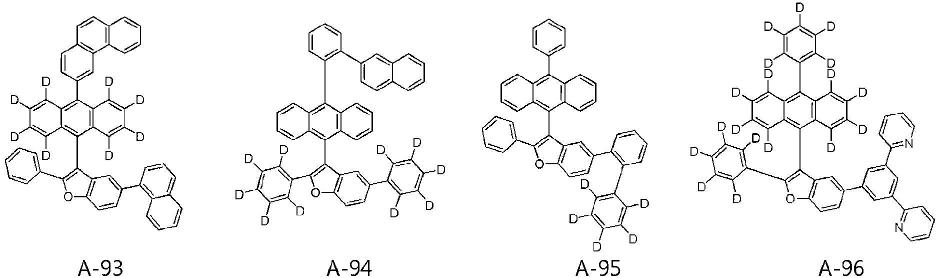

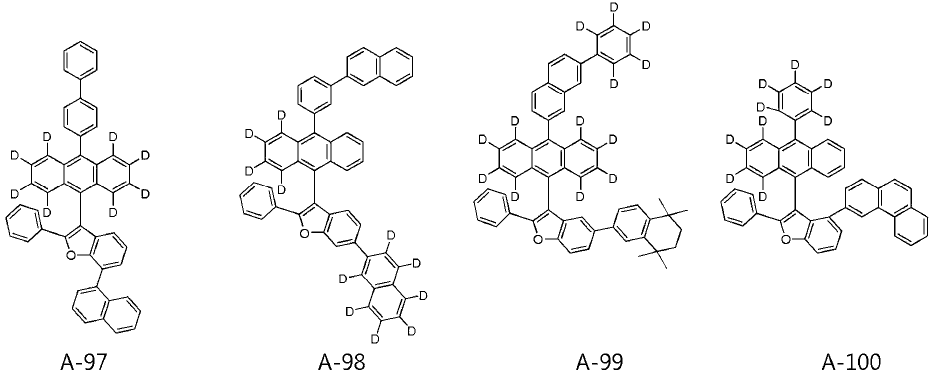

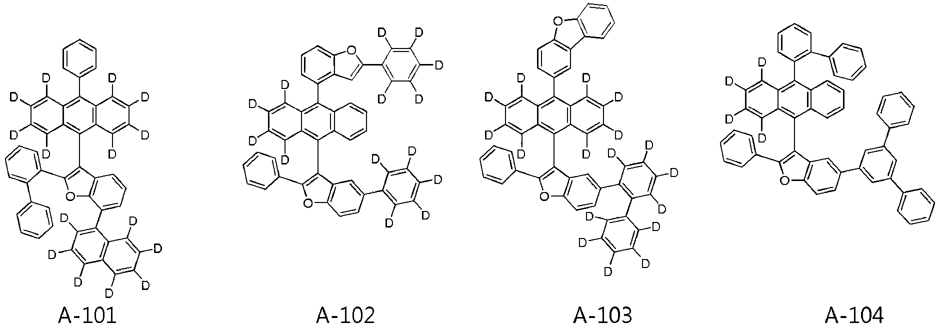

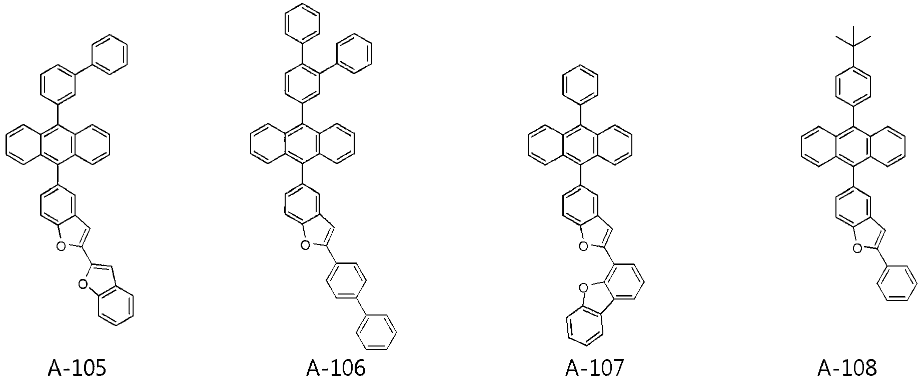

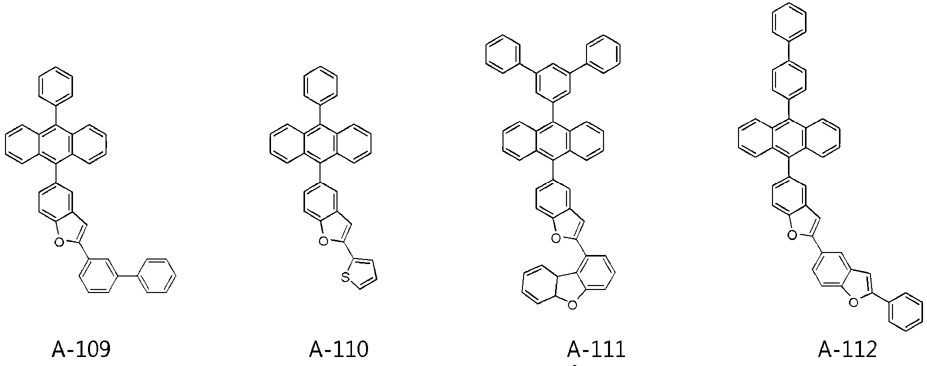

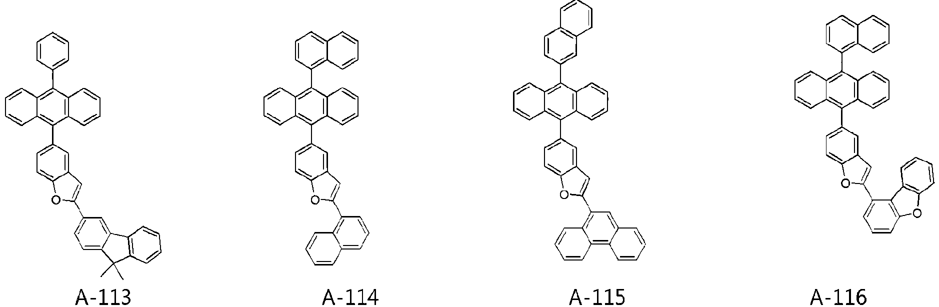

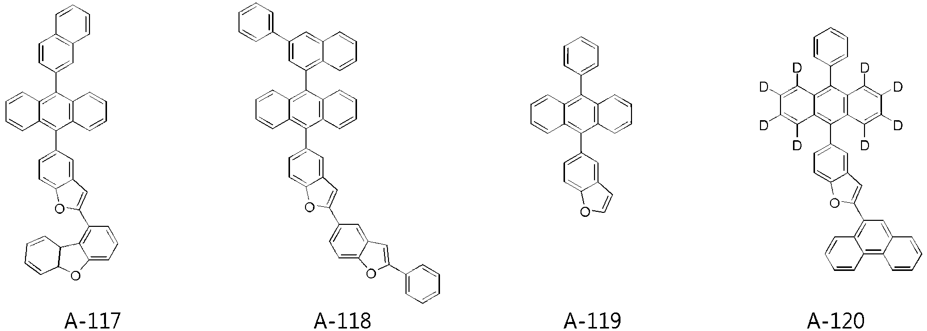

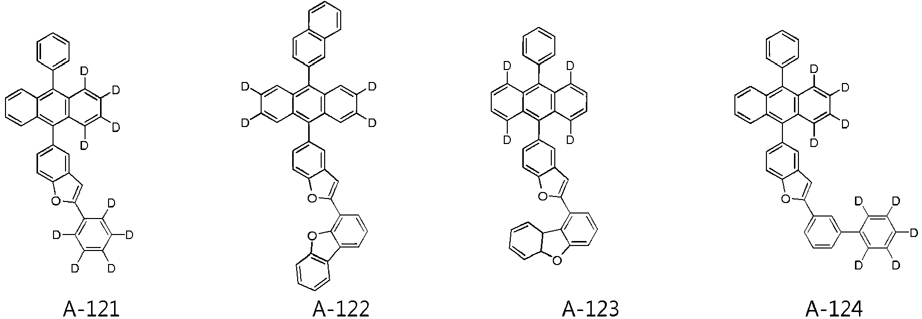

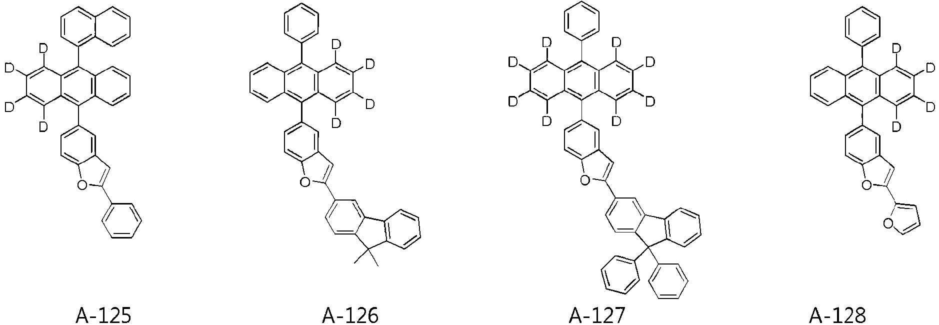

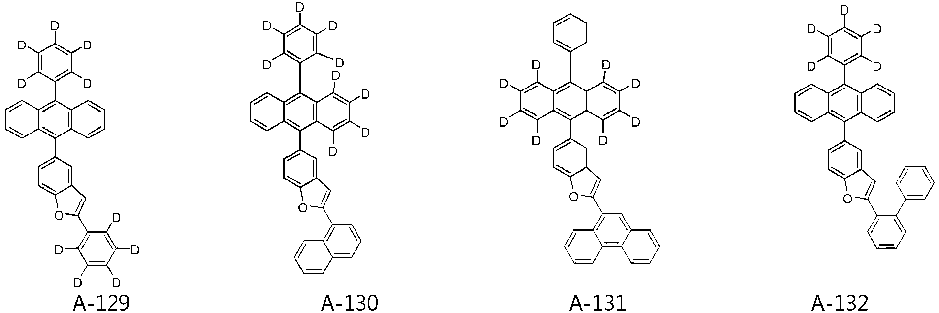

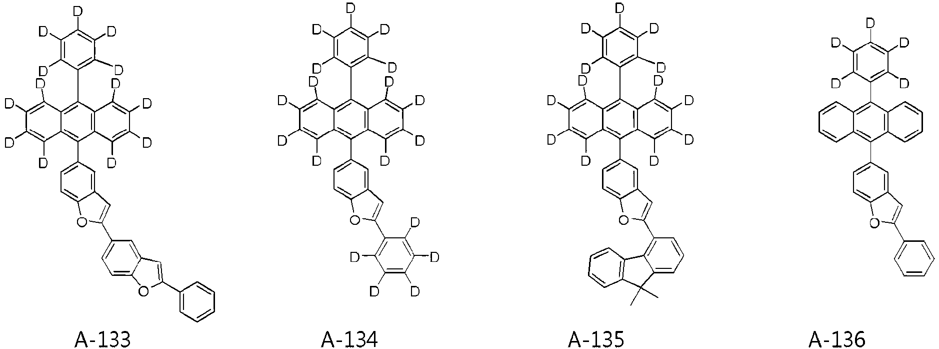

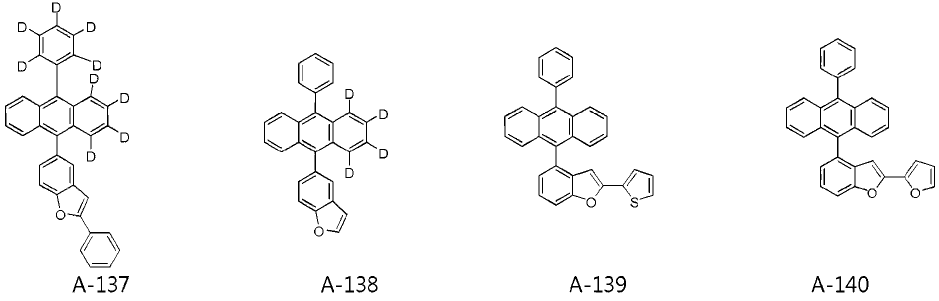

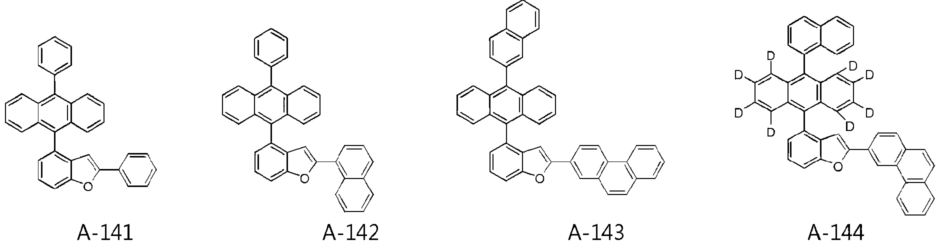

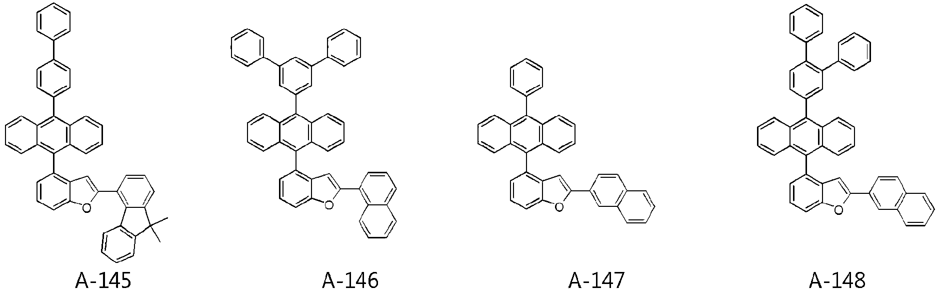

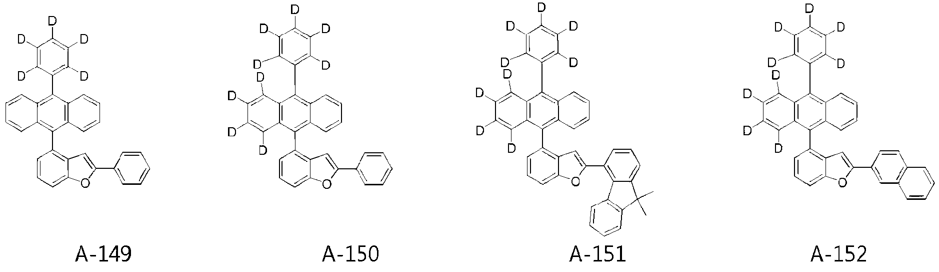

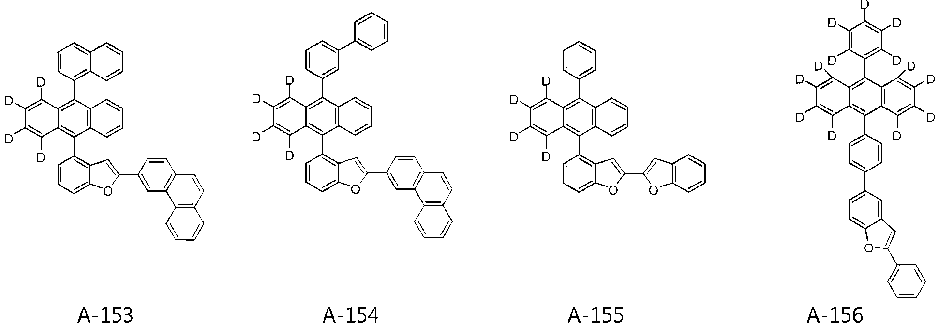

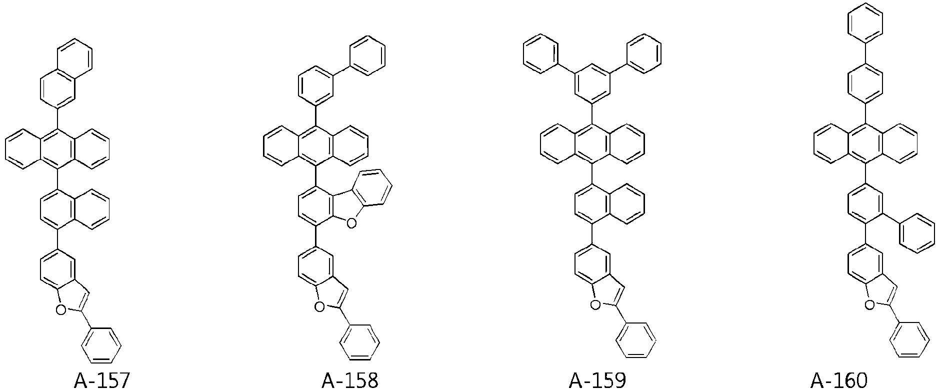

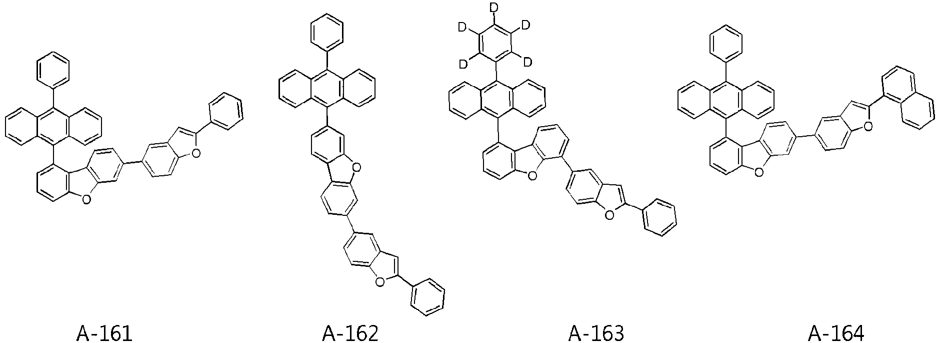

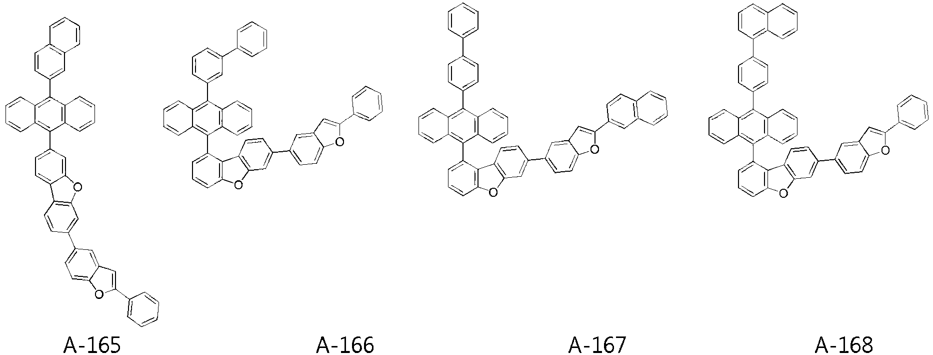

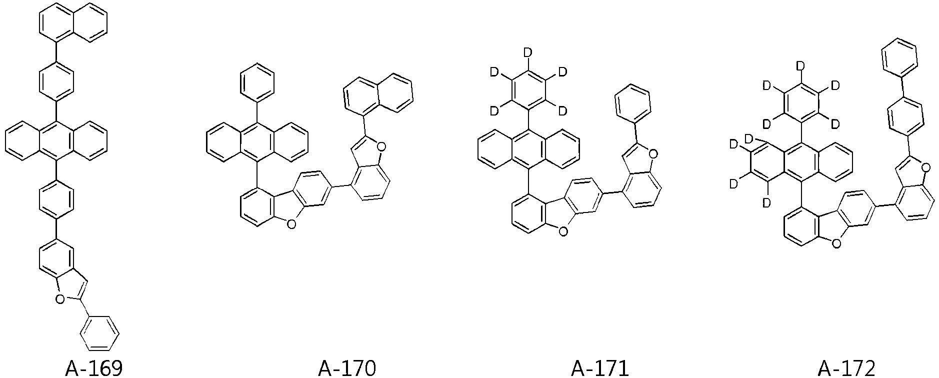

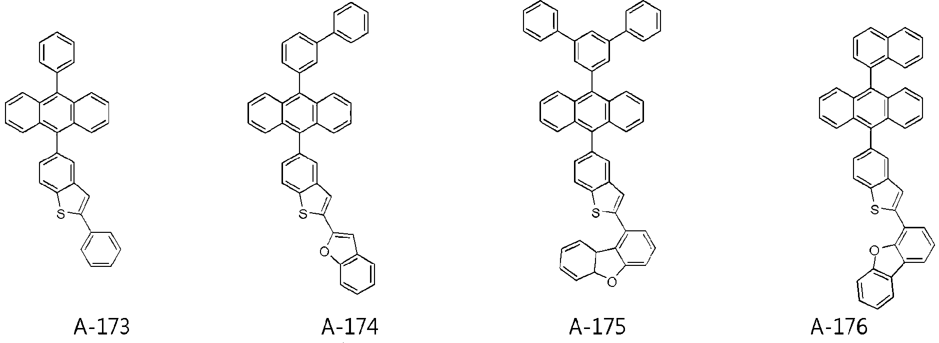

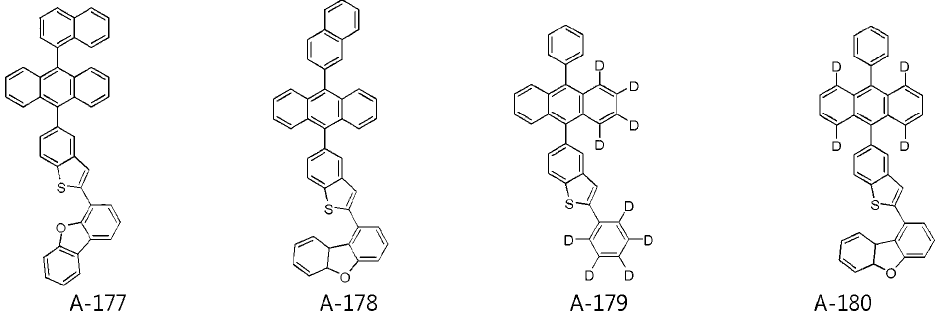

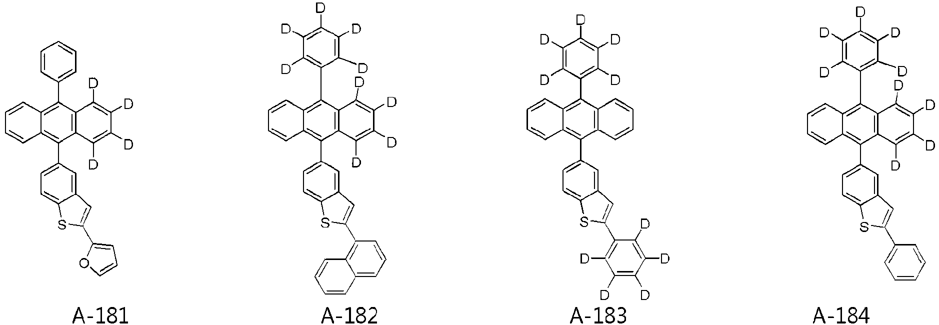

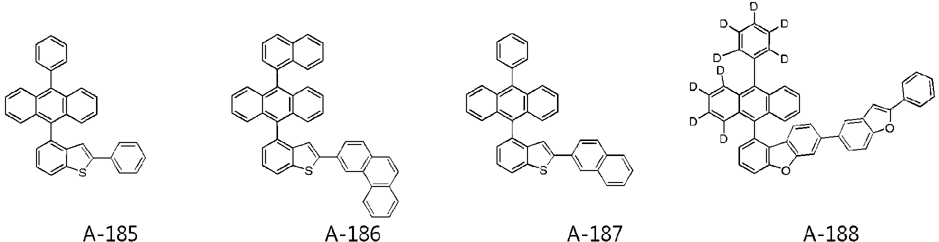

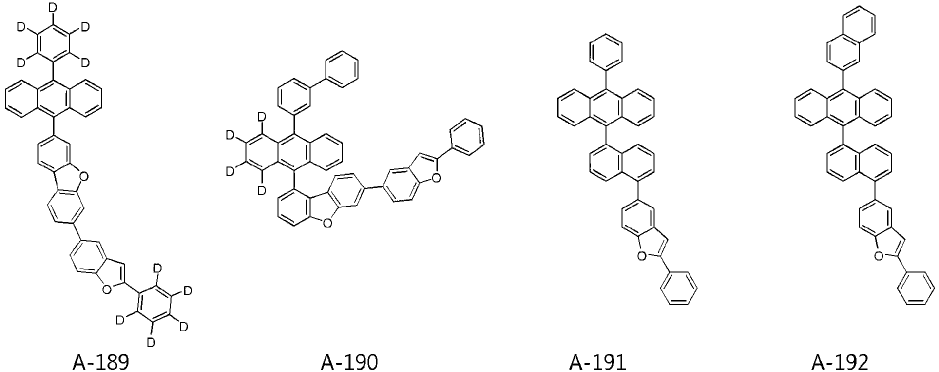

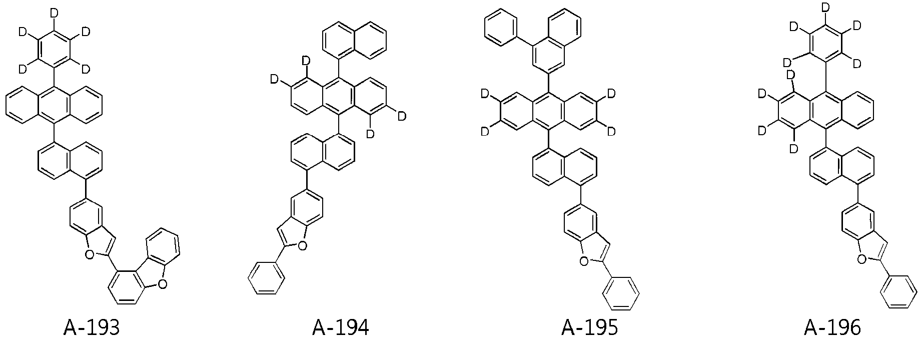

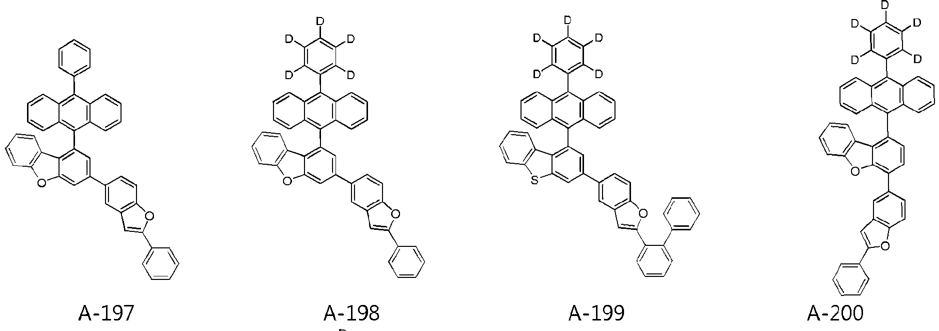

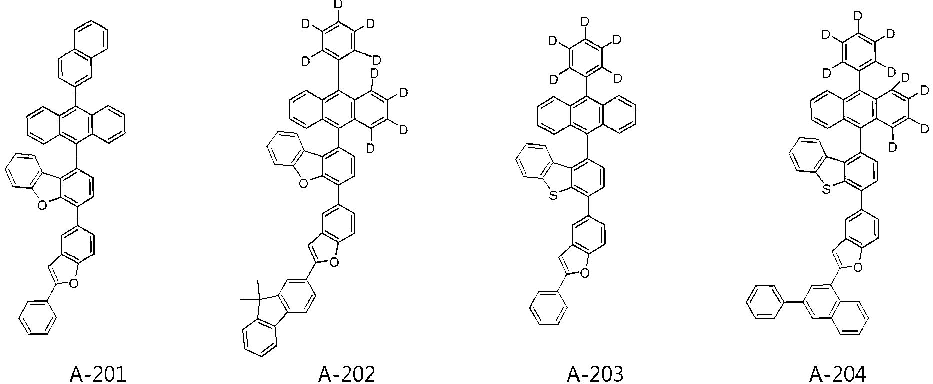

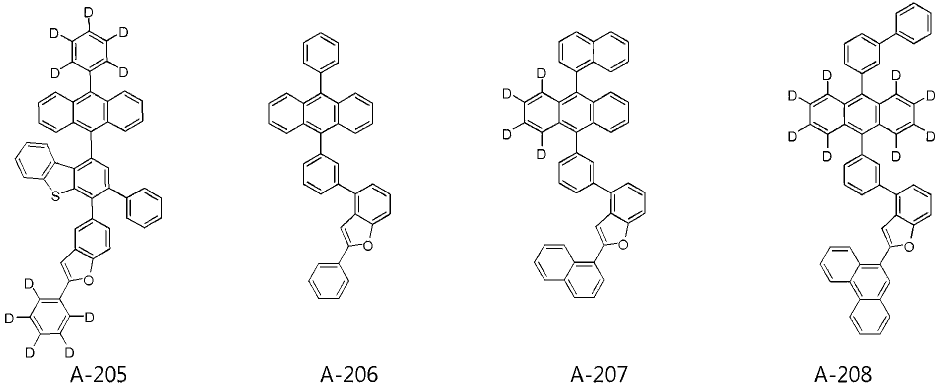

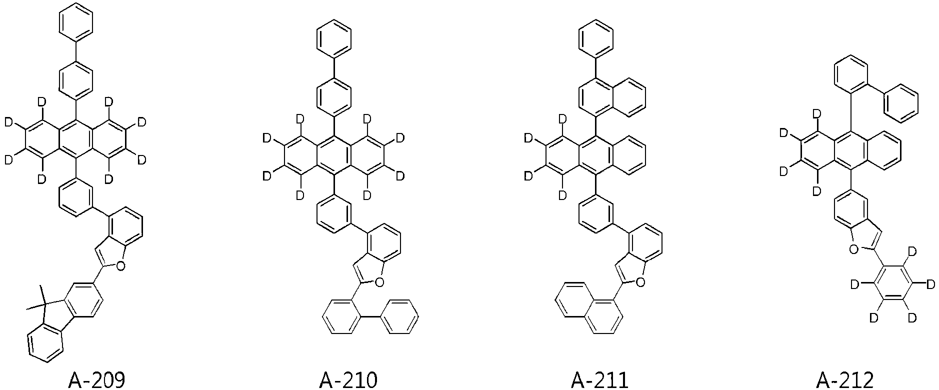

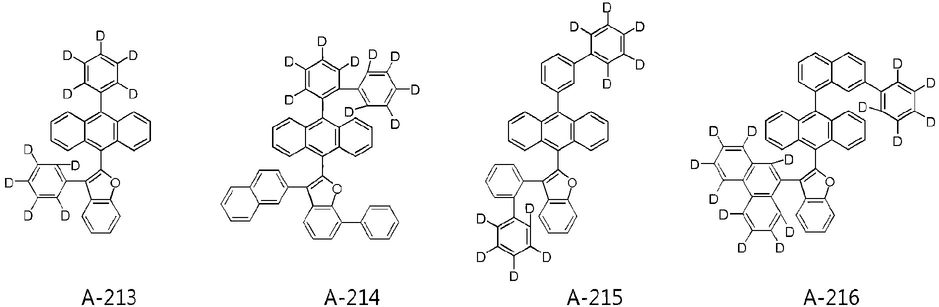

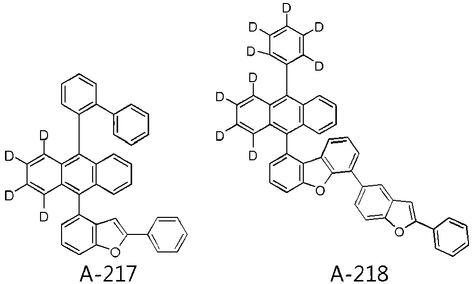

8. Die organische lichtemittierende Vorrichtung gemäß Anspruch 1, wobei die Verbindung nach [Formel B] aus Verbindungen ausgewählt ist, die durch die folgenden [B-1] bis [B-79] repräsentiert sind:

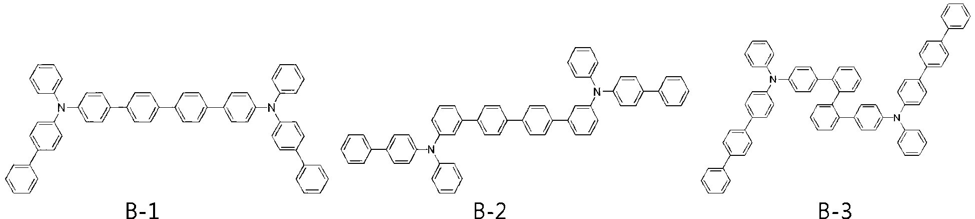

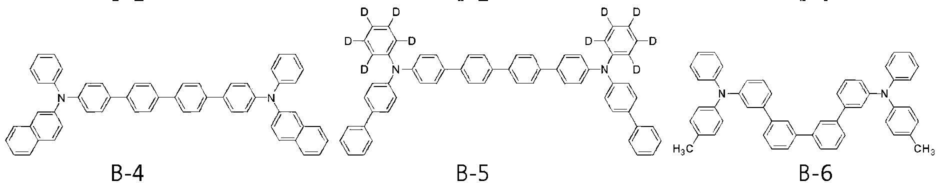

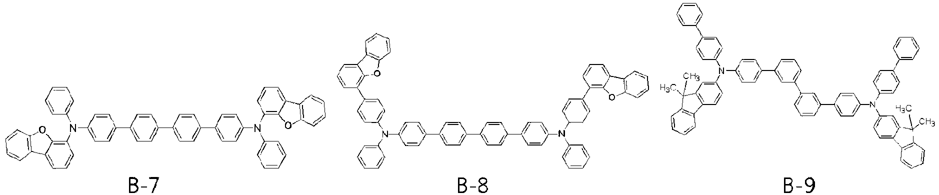

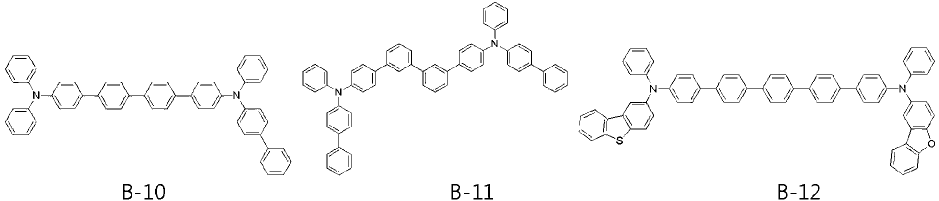

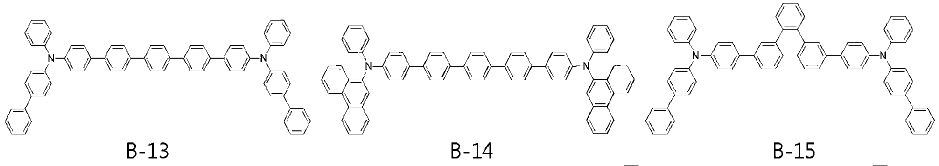

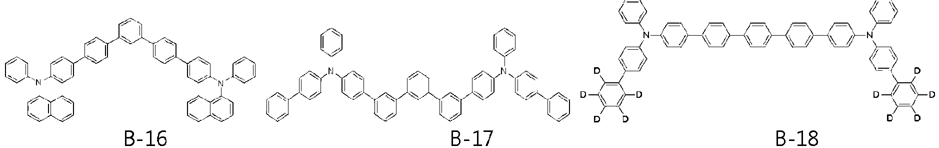

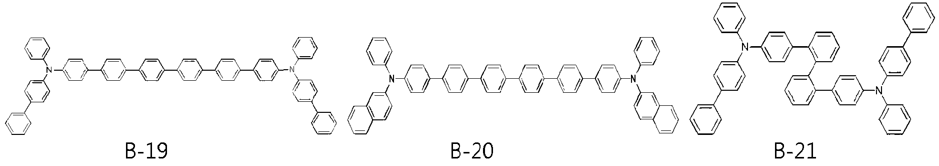

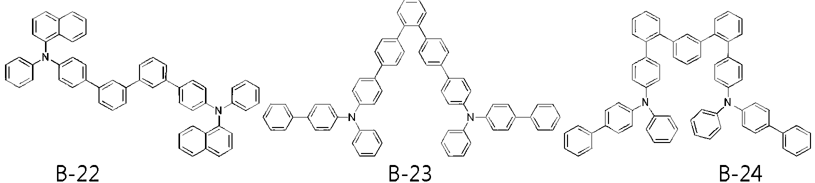

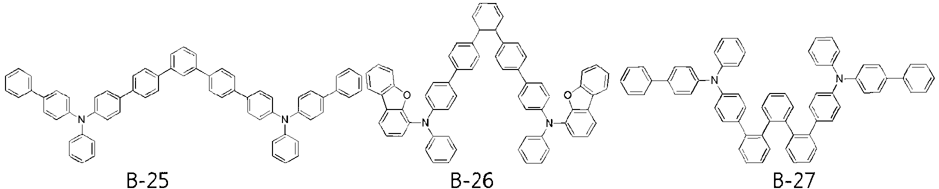

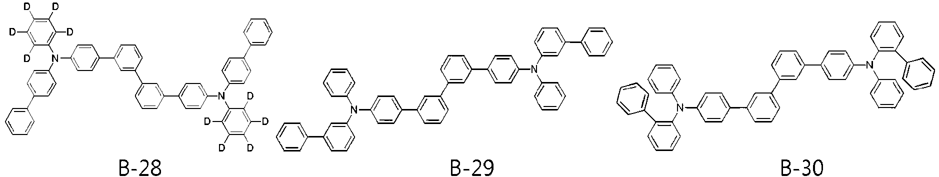

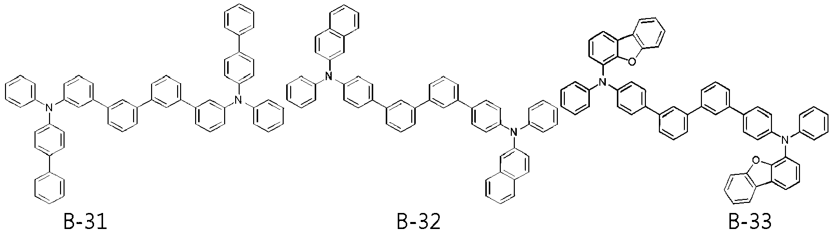

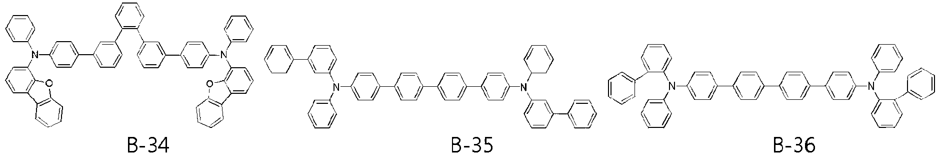

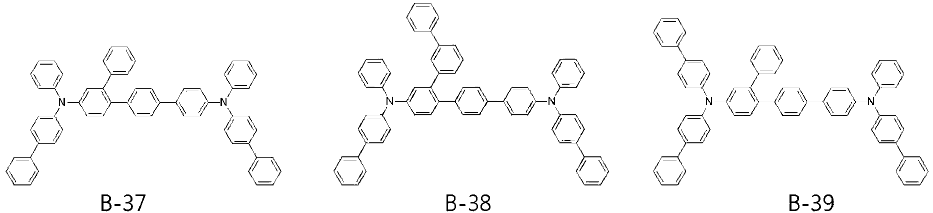

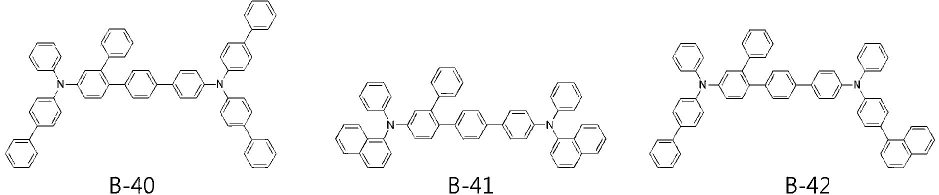

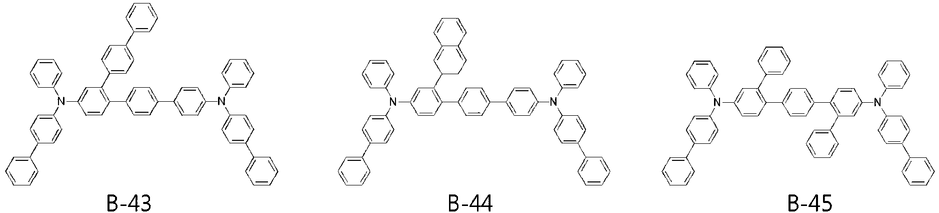

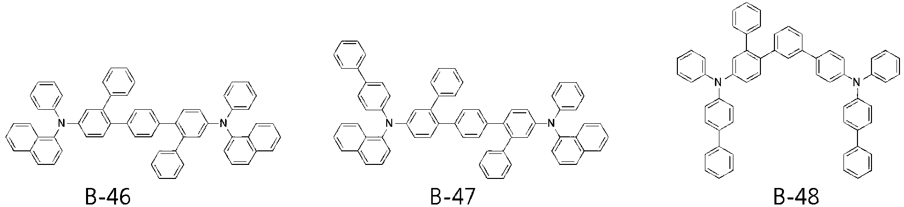

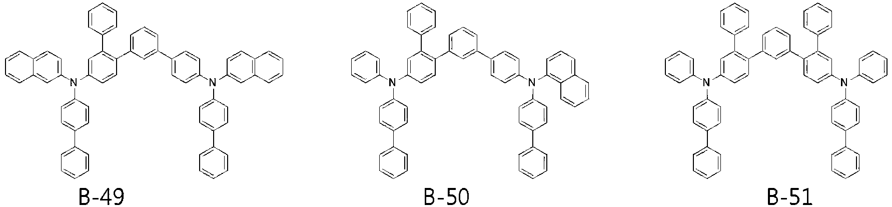

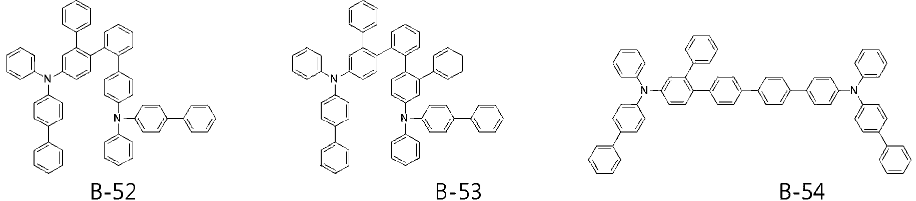

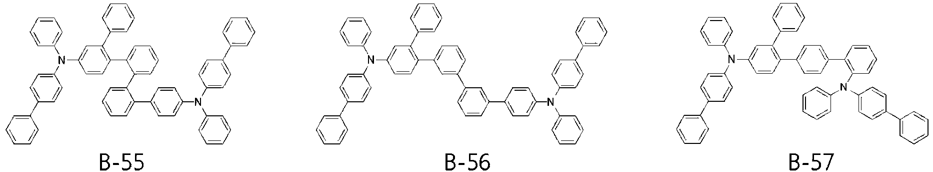

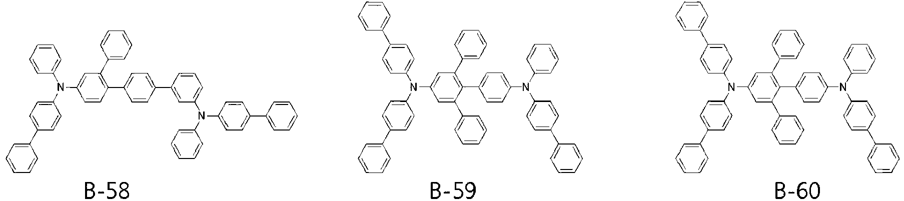

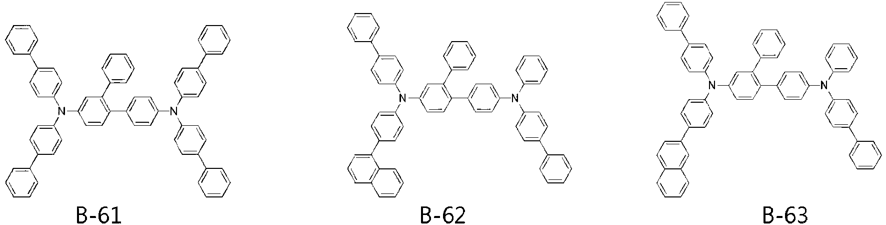

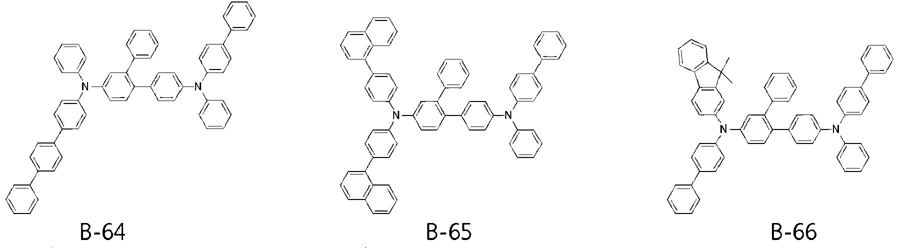

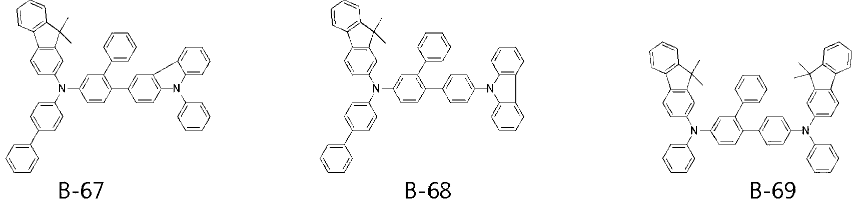

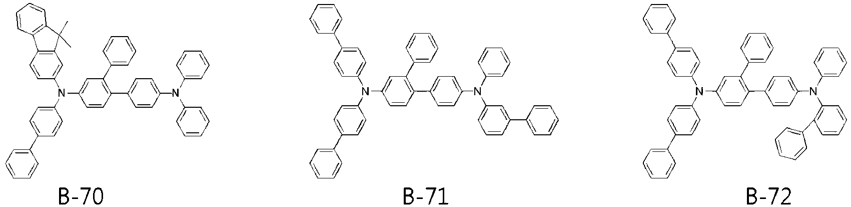

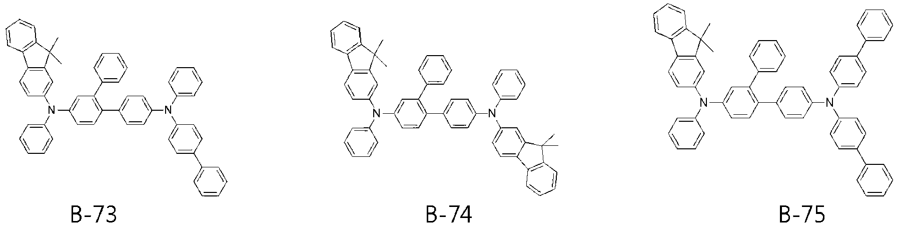

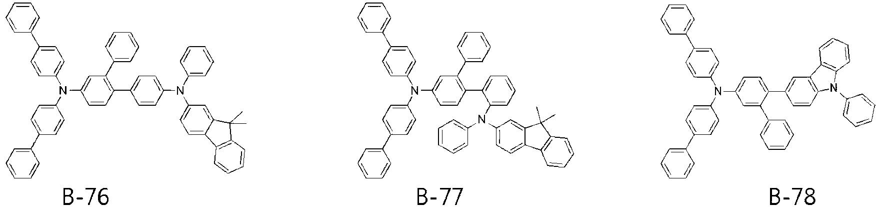

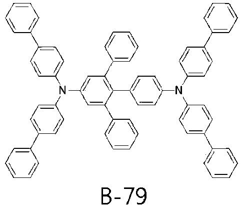

9. Die organische lichtemittierende Vorrichtung gemäß Anspruch 1, wobei die von [Formel B] repräsentierte Verbindung ausgewählt ist aus den folgenden Verbindungen [B-101] bis [B-148]:

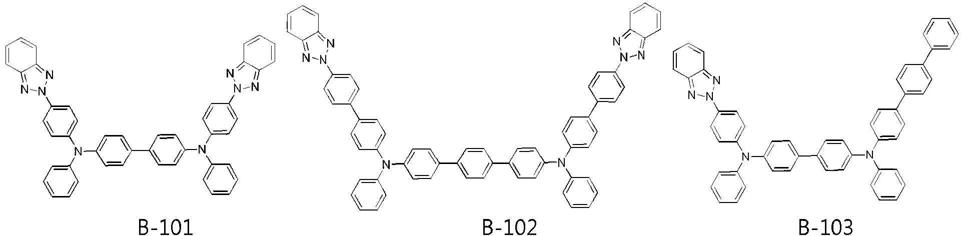

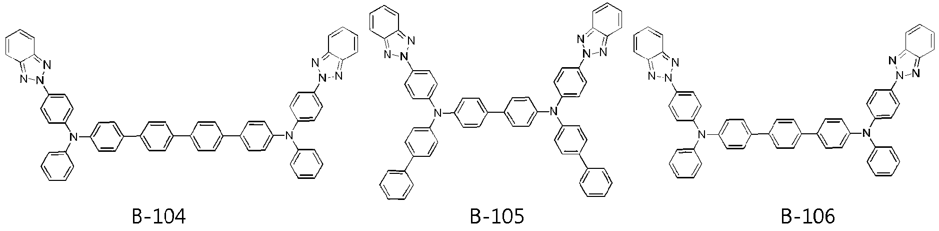

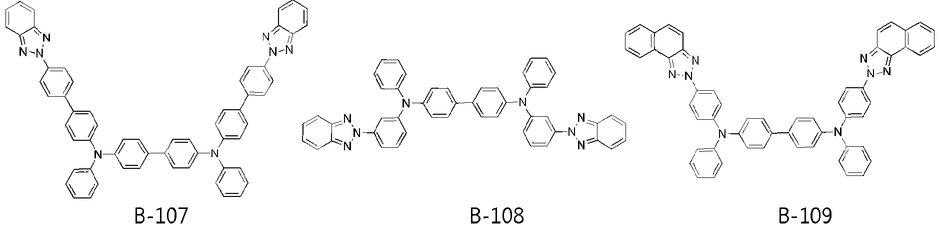

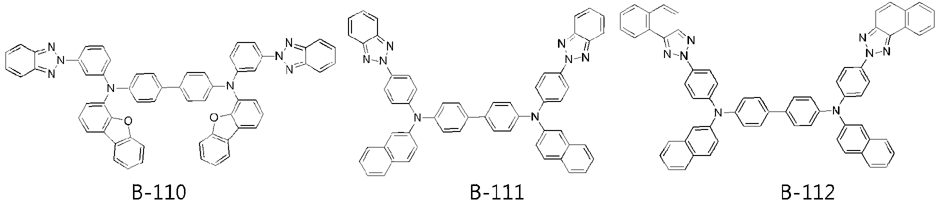

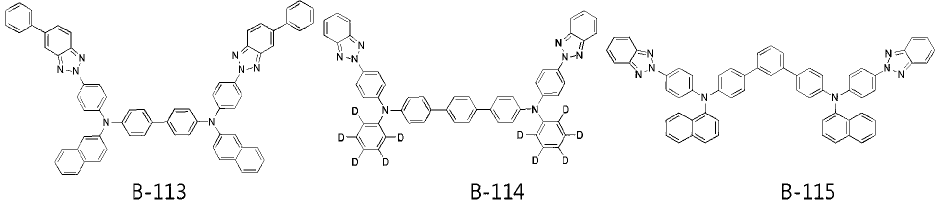

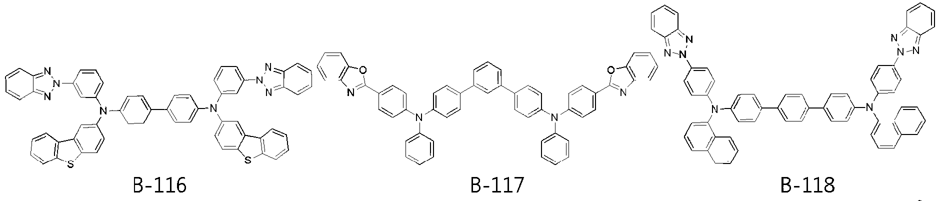

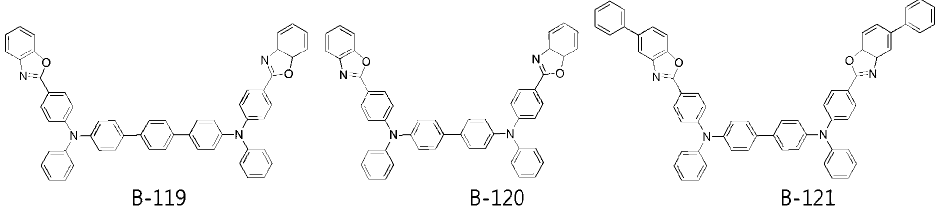

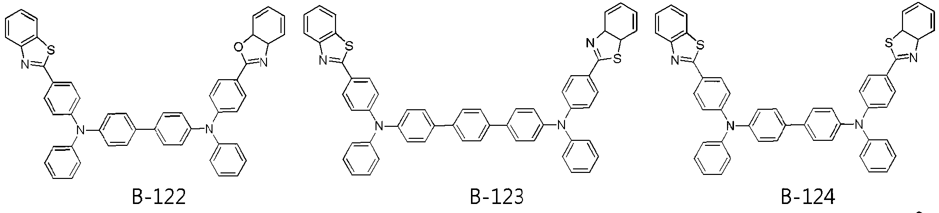

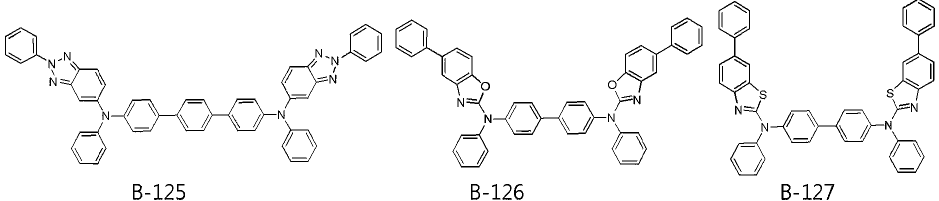

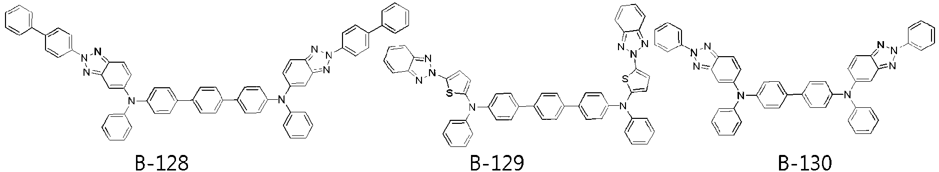

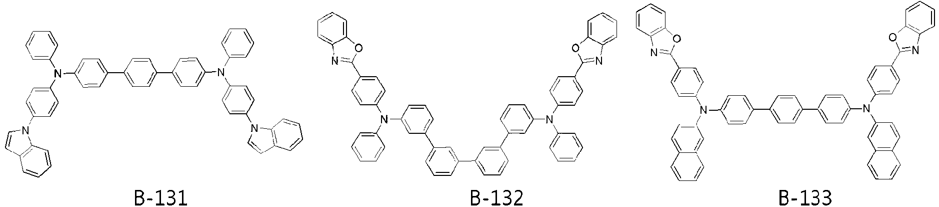

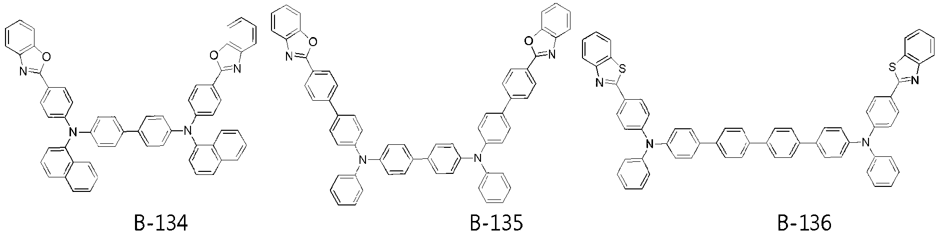

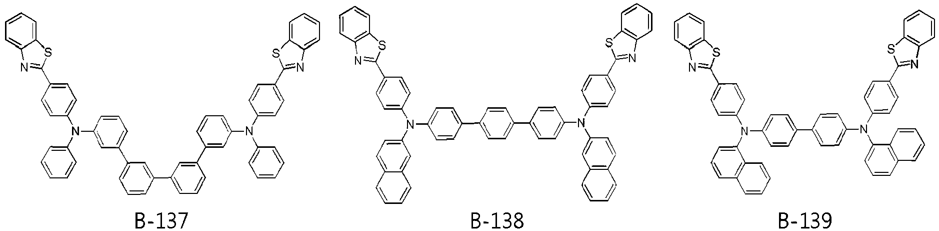

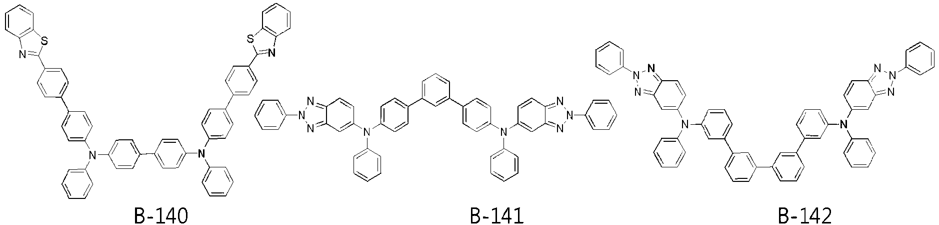

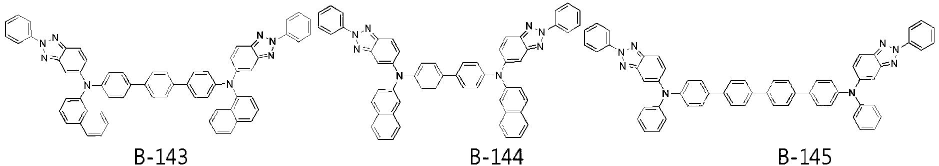

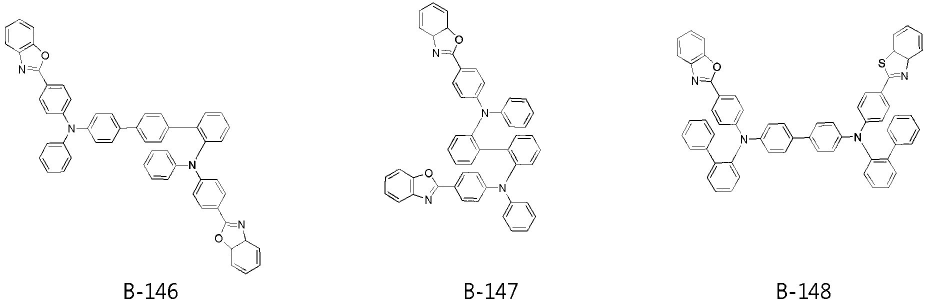

10. Die organische lichtemittierende Vorrichtung gemäß Anspruch 1, wobei die von [Formel C] repräsentierte Verbindung ausgewählt ist aus den folgenden Verbindungen [C-1] bis [C-99]:

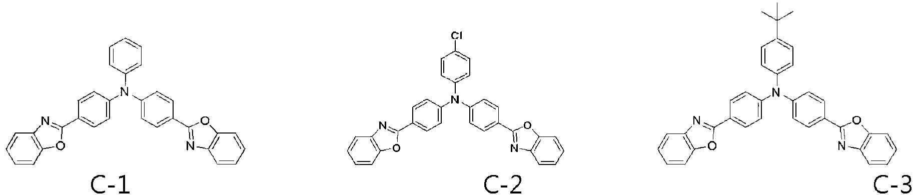

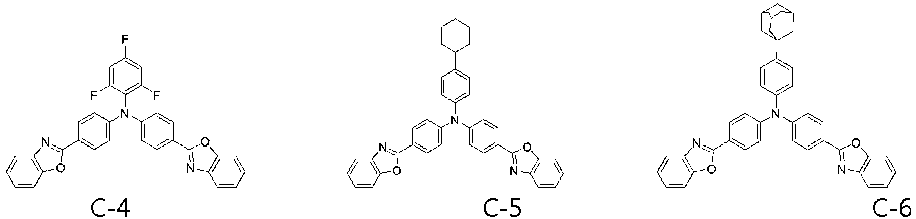

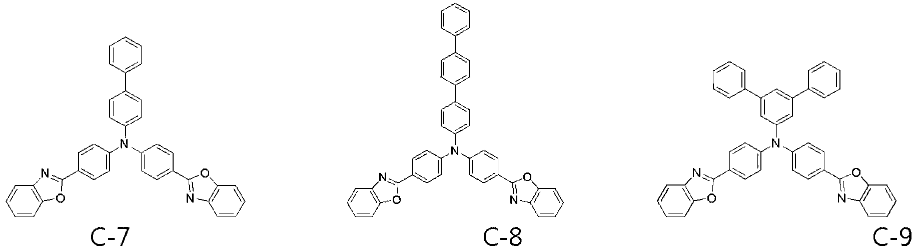

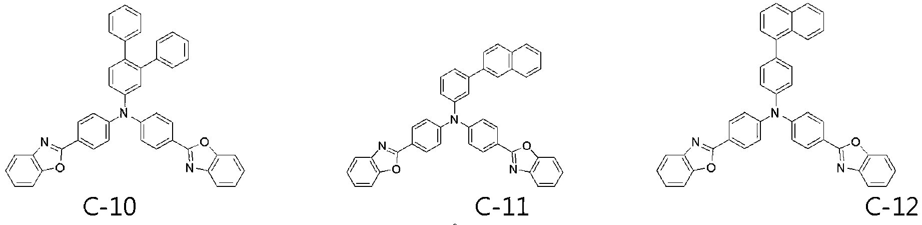

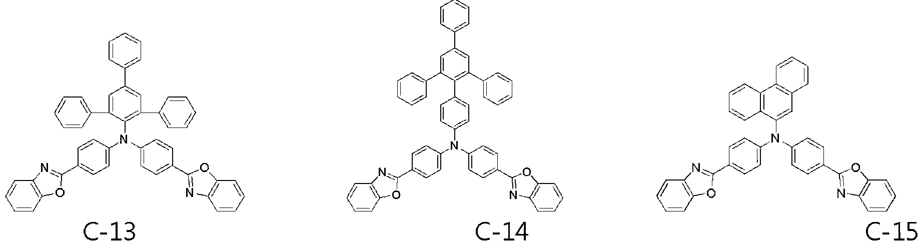

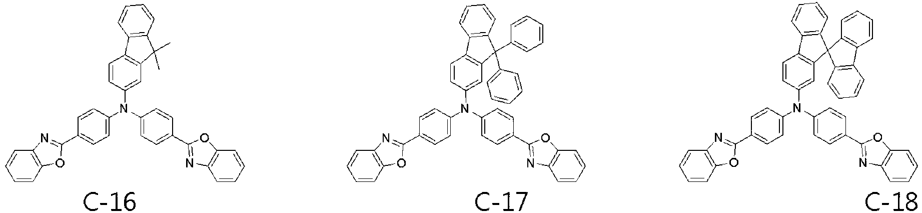

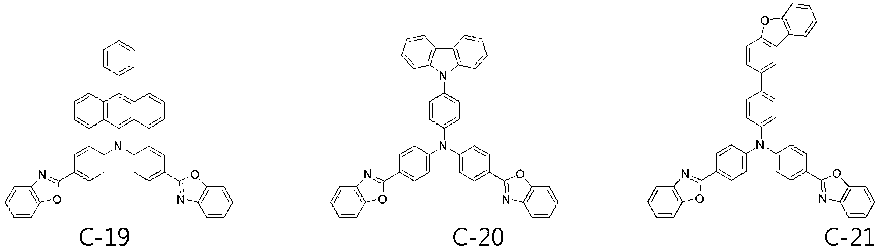

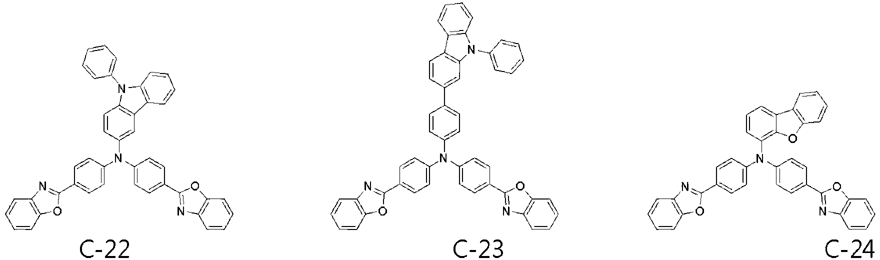

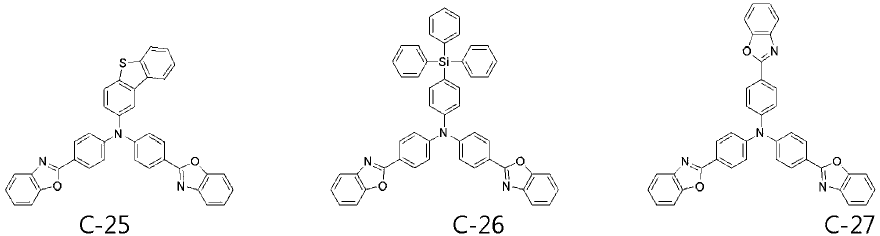

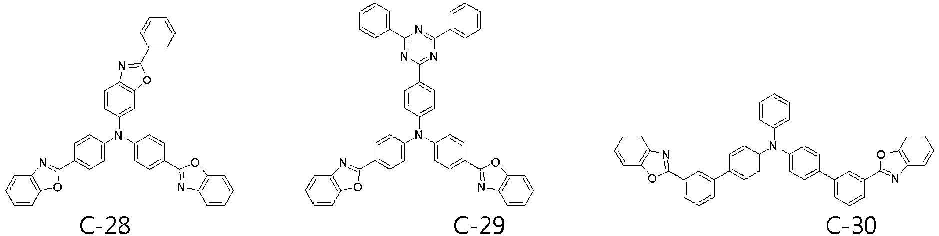

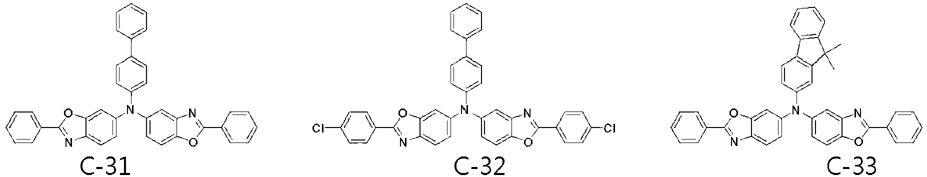

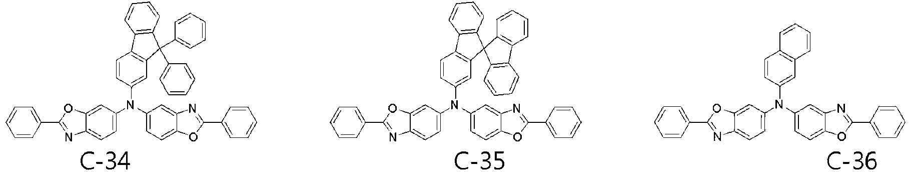

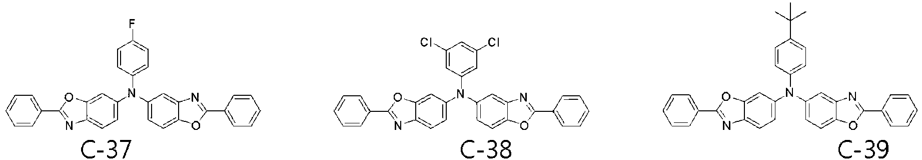

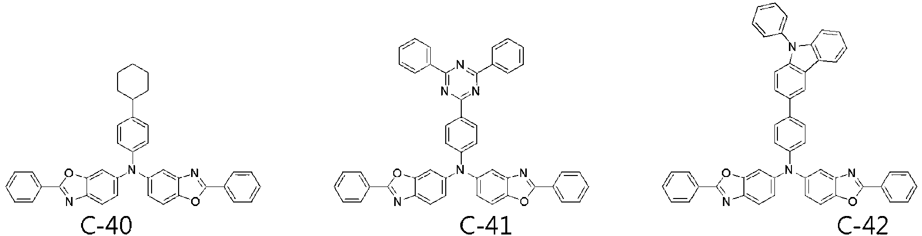

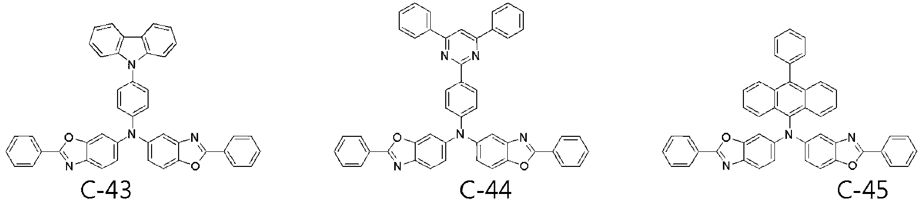

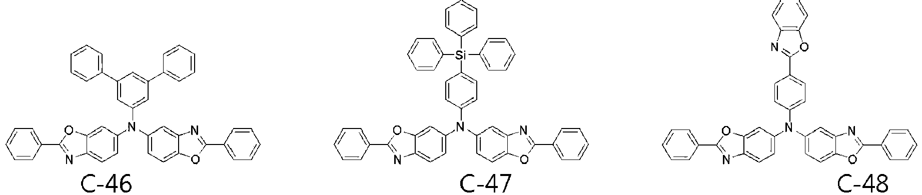

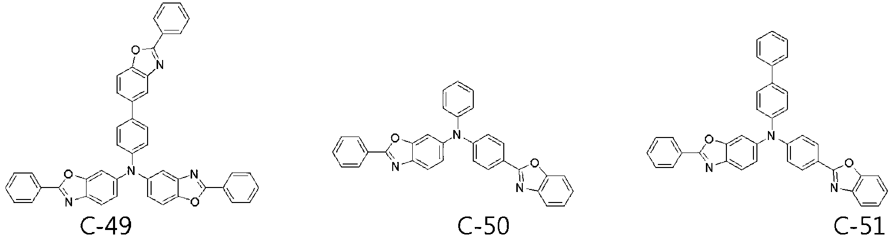

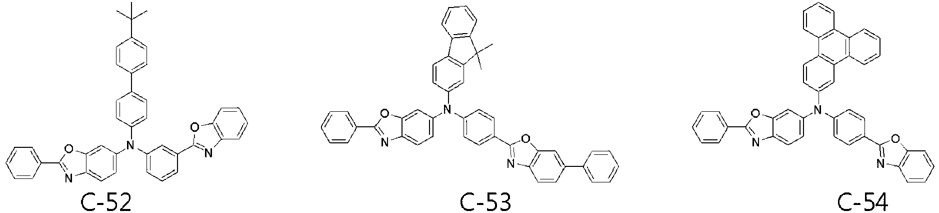

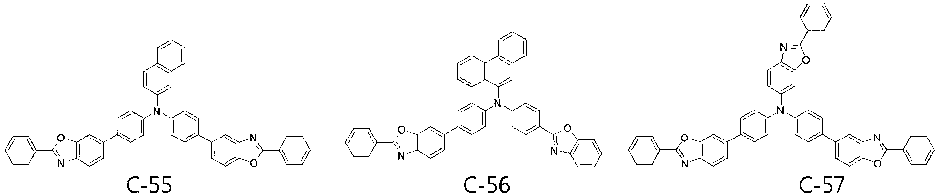

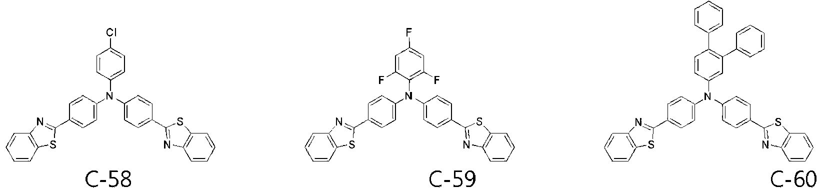

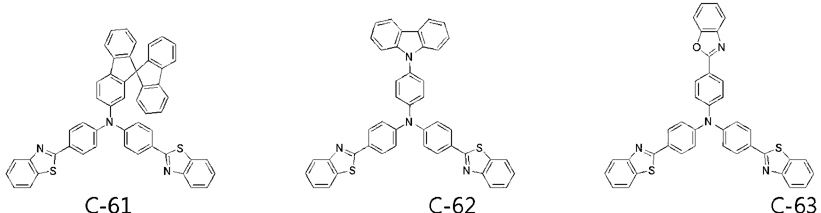

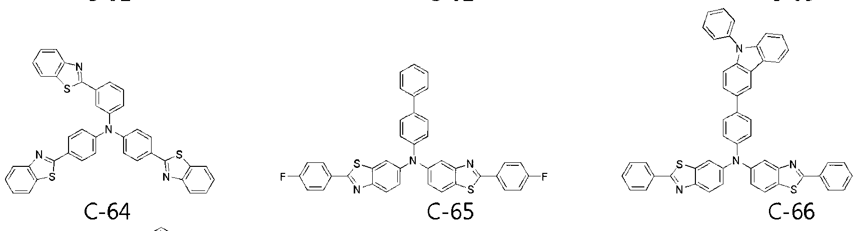

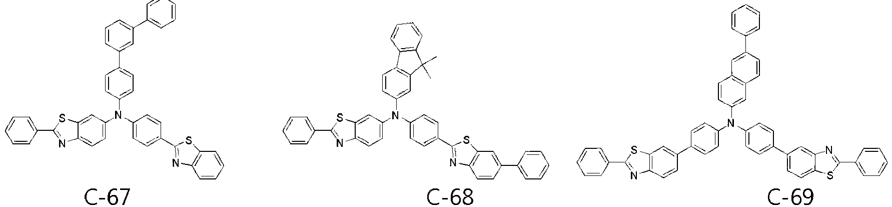

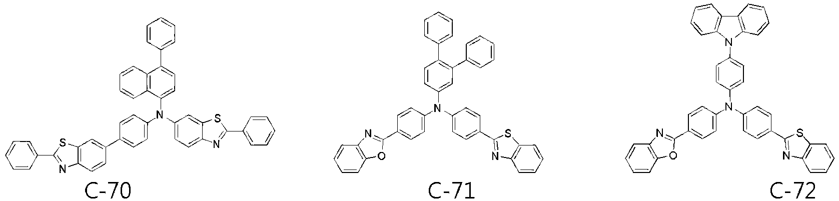

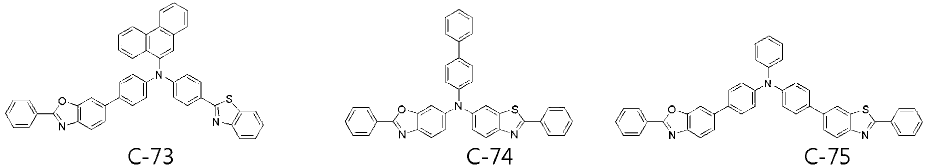

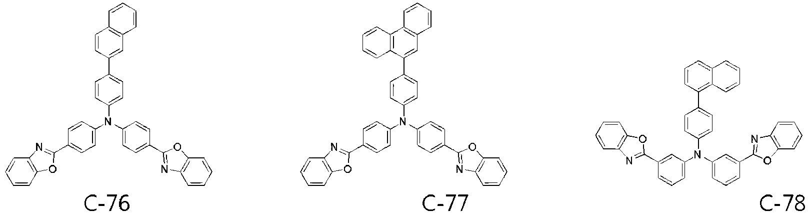

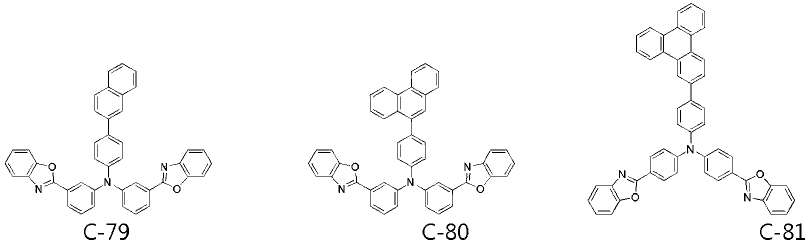

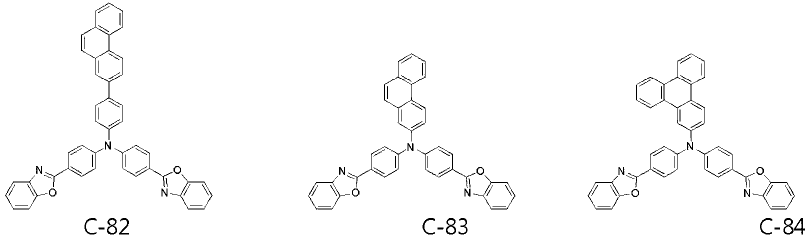

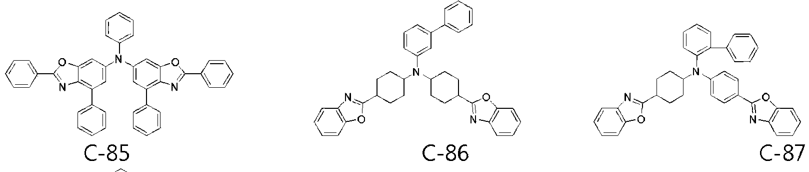

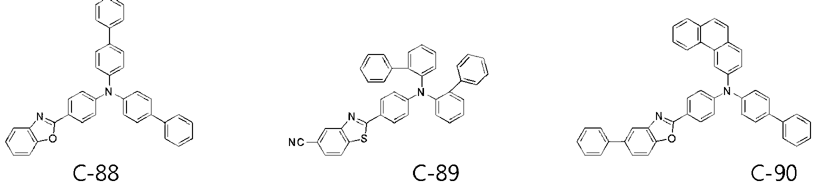

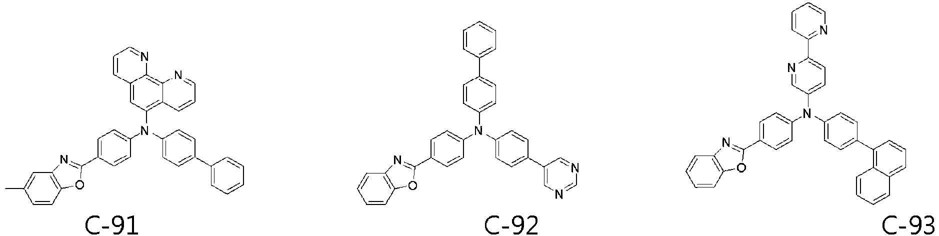

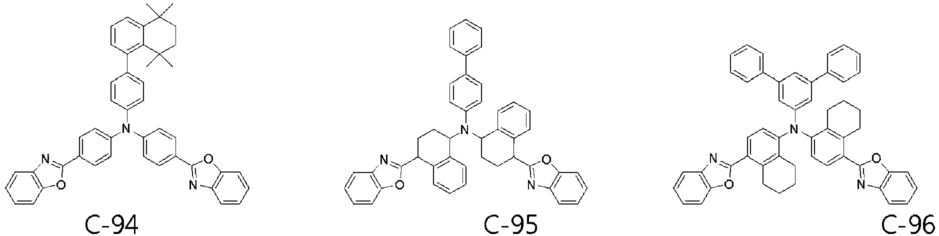

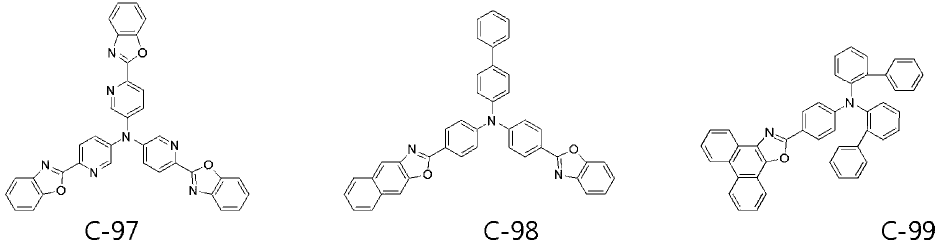

11. Die organische lichtemittierende Vorrichtung gemäß Anspruch 1, wobei die lichtemittierende Schicht eine Wirtssubstanz und einen Dotierungsstoff umfasst und die Wirtssubstanz eine der Verbindungen gemäß [A-1] bis [A-66] oben umfasst.

12. Die organische lichtemittierende Vorrichtung gemäß Anspruch 11, wobei der Dotierstoff eine polyzyklische Verbindung umfasst, die durch die folgende [Formel D] repräsentiert ist: 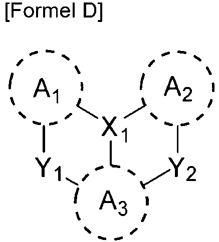 wobei
X1 aus B, P=O und P=S ausgewählt ist,
Y₁ und Y₂ jeweils unabhängig voneinander aus NR₄₁, CR₄₂R₄₃, O, S, Se und SiR₄₄R₄₅ ausgewählt sind,
A₁ bis A₃ jeweils unabhängig voneinander ausgewählt sind aus einem substituierten oder unsubstituierten aromatischen C6-C50-Kohlenwasserstoffring, einem substituierten oder unsubstituierten heteroaromatischen C2-C50-Ring, einem substituierten oder unsubstituierten aliphatischen C3-C30-Ring und einem substituierten oder unsubstituierten gemischt aliphatisch-aromatischen C3-C30-Ring, und
R₄₁ bis R₄₅ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C3-C30-Hetero-Cycloalkylgruppe, einer substituierten oder unsubstituierten C2-C50-Heteroarylgruppe, einer substituierten oder unsubstituierten C1-C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C6-C30-Arylthioxygruppe, einer substituierten oder unsubstituierten Amingruppe, einer substituierten oder unsubstituierten Silylgruppe, einer substituierten oder unsubstituierten C3-C20-gemischt aliphatisch-aromatischen Ringgruppe, einer Nitrogruppe, einer Cyanogruppe und einer Halogengruppe, mit der Maßgabe, dass jedes von R₄₁ bis R₄₅ an jeden der Ringe A₁ bis A₃ gebunden ist, um einen alicyclischen oder aromatischen monocyclischen oder polycyclischen Ring zu bilden, die Substituenten der Ringe A₁ bis A₃ aneinander gebunden sind, um einen alicyclischen oder aromatischen monocyclischen oder polycyclischen Ring zu bilden, und R₄₂ und R₄₃, und R₄₄ und R₄₅ miteinander verbunden sind, um weiterhin einen alicyclischen oder aromatischen monocyclischen oder polycyclischen Ring zu bilden, von dem mindestens ein Kohlenstoffatom mit mindestens einem Heteroatom substituiert ist, das aus Stickstoff, Sauerstoff und Schwefel ausgewählt ist.

13. Die organische lichtemittierende Vorrichtung gemäß Anspruch 12, wobei die von [Formel D] repräsentierte polyzyklische Verbindung eine der von den folgenden [Formel D-1] bis [Formel D-8] repräsentierten Verbindungen umfasst: 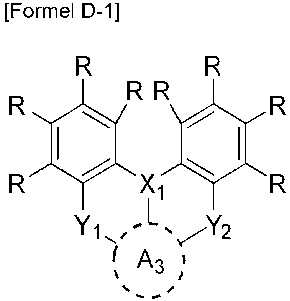 wobei
die R-Gruppen jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C3-C30-Heterocycloalkylgruppe, einer substituierten oder unsubstituierten C2-C50-Heteroarylgruppe, einer substituierten oder unsubstituierten C1-C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C6-C30-Arylthioxygruppe, einer substituierten oder unsubstituierten Amingruppe, einer substituierten oder unsubstituierten Silylgruppe, einer substituierten oder unsubstituierten C3-C20-gemischten aliphatisch-aromatischen Ringgruppe, einer Nitrogruppe, einer Cyanogruppe und einer Halogengruppe, mit der Maßgabe, dass die R-Gruppen miteinander verbunden sind, um einen alicyclischen oder aromatischen monocyclischen oder polycyclischen Ring zu bilden, von dem mindestens ein Kohlenstoffatom mit mindestens einem Heteroatom substituiert ist, das aus Stickstoff, Sauerstoff und Schwefel ausgewählt ist, und
X₁, Y₁, Y₂ und A₃ wie in [Formel D] in Anspruch 12 definiert sind, 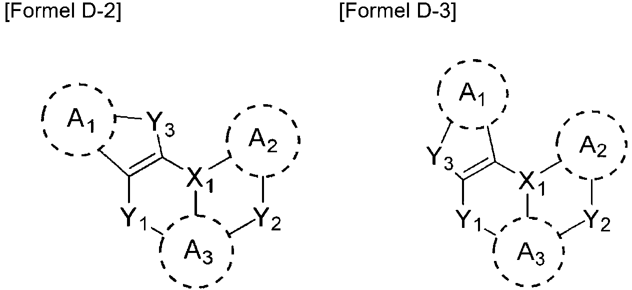
wobei
Y3 jeweils unabhängig voneinander ausgewählt ist aus NR41, CR42R43, O, S, Se und SiR44R45, und
X1, Y1, Y2, A1 bis A3 und R41 bis R45 wie in [Formel D] in Anspruch 12 definiert sind, [Formel D-4] 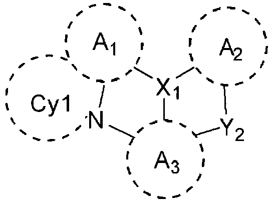
wobei
X₁, Y₂ und A₁ bis A₃ wie in [Formel D] in Anspruch 12 definiert sind und
Cy1 an ein benachbartes Stickstoffatom (N) und das aromatische Kohlenstoffatom im Ring A₁ gebunden ist, das an Cy1 gebunden sein soll, um einen kondensierten Ring zu bilden, der das Stickstoffatom (N), das aromatische Kohlenstoffatom im Ring A_{1,} an das das Stickstoffatom (N) gebunden ist, und das aromatische Kohlenstoffatom im Ring A₁, das an Cy1 gebunden sein soll, umfasst,
wobei ein Teil des durch Cy1 gebildeten Rings, mit Ausnahme des Stickstoffatoms (N), des aromatischen Kohlenstoffatoms im Ring A₁, an das das Stickstoffatom (N) gebunden ist, und des aromatischen Kohlenstoffatoms im A₁-Ring, das an Cy1 gebunden sein soll, eine substituierte oder unsubstituierte C2-C5-Alkylengruppe ist, 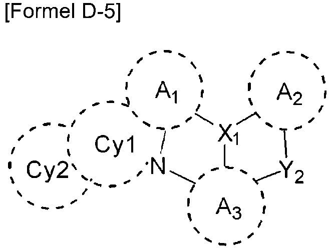
wobei
X₁, Y₂ und A₁ bis A₃ wie in [Formel D] in Anspruch 12 definiert sind,
Cy2 an Cy1 addiert ist, um einen gesättigten Kohlenwasserstoffring zu bilden, und ein Teil des durch Cy2 gebildeten Rings, mit Ausnahme des in Cy1 enthaltenen Kohlenstoffatoms, eine substituierte oder unsubstituierte C2-C5-Alkylengruppe ist, 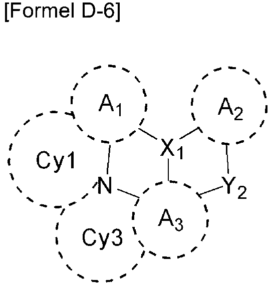
wobei
X₁, Y₂ und A₁ bis A₃ wie in [Formel D] in Anspruch 12 definiert sind, und
Cy3 an das Kohlenstoffatom gebunden ist, das an das Stickstoffatom (N) in Cy1 und an das aromatische Kohlenstoffatom im Ring A₃ gebunden ist, der an Cy3 gebunden sein soll, um einen kondensierten Ring zu bilden, der das aromatische Kohlenstoffatom im Ring A₃, der an Cy3 gebunden sein soll, das Stickstoffatom (N) und das Kohlenstoffatom in Cy1, an das das Stickstoffatom (N) gebunden ist, enthält
wobei ein Teil des durch Cy3 gebildeten Rings, mit Ausnahme des aromatischen Kohlenstoffatoms im A₃-Ring, der an Cy3 gebunden sein soll, des Stickstoffatoms (N) und des Kohlenstoffatoms in Cy1, an das das Stickstoffatom (N) gebunden ist, eine substituierte oder unsubstituierte C1-C4-Alkylengruppe ist, 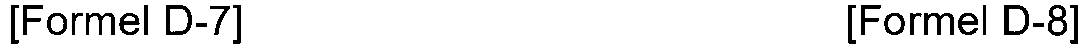 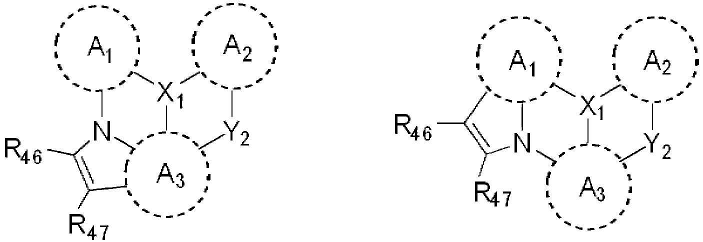
wobei
R₄₆ und R₄₇ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C3-C30-Hetero-Cycloalkylgruppe, einer substituierten oder unsubstituierten C2-C50-Heteroarylgruppe, einer substituierten oder unsubstituierten C1-C30-Alkoxygruppe, einer substituierten oder unsubstituierten C6-C30-Aryloxygruppe, einer substituierten oder unsubstituierten C1 -C30-Alkylthioxygruppe, einer substituierten oder unsubstituierten C6-C30-Arylthioxygruppe, einer substituierten oder unsubstituierten Amingruppe, einer substituierten oder unsubstituierten Silylgruppe, einer substituierten oder unsubstituierten C3-C20-gemischt aliphatisch-aromatischen Ringgruppe, einer Nitrogruppe, einer Cyanogruppe und einer Halogengruppe, mit der Maßgabe, dass R₄₆ und R₄₇ miteinander verbunden sind, um einen alicyclischen oder aromatischen monocyclischen oder polycyclischen Ring und einen gemischten aliphatisch-aromatischen Ring zu bilden, und X₁, Y₂ und A₁ bis A₃ wie in [Formel D] in Anspruch 12 definiert sind.

14. Die organische lichtemittierende Vorrichtung gemäß Anspruch 1, ferner umfassend zumindest eine Lochinjektionsschicht, eine Lochtransportschicht, eine Funktionsschicht, die in der Lage ist, Löcher zu injizieren und zu transportieren, eine Elektronentransportschicht, eine Elektronentransportschicht und eine Funktionsschicht, die in der Lage ist, Elektronen zu injizieren und zu transportieren, zusätzlich zu der lichtemittierenden Schicht..

15. Die organische lichtemittierende Vorrichtung gemäß Anspruch 1, wobei die erste Elektrode eine Anode und die zweite Elektrode eine Kathode ist und
die Deckschicht auf einer Oberfläche der Kathode ausgebildet ist.

16. Die organische lichtemittierende Vorrichtung gemäß Anspruch 14, wobei die organische lichtemittierende Vorrichtung für ein Anzeige- oder Beleuchtungssystem verwendet wird, das aus Flachbildschirmen, flexiblen Displays, monochromatischen oder weißen Flachbildschirm-Beleuchtungssystemen, monochromatischen oder weißen flexiblen Beleuchtungssystemen, Fahrzeuganzeigen und Anzeigen für virtuelle oder erweiterte Realität ausgewählt ist.

## Revendications

1. Dispositif électroluminescent organique comprenant :
une première électrode ;
une deuxième électrode faisant face à la première électrode ;
une couche d'émission de lumière interposée entre la première électrode et la deuxième électrode ; et
une couche de revêtement disposée sur une des surfaces de la première électrode ou la deuxième électrode qui est opposée à une surface restante de la première électrode ou la deuxième électrode qui fait face à la couche d'émission de lumière,
la couche d'émission de lumière comprenant au moins un composé choisi parmi des composés représentés par les [Formule A-1] à [Formule A-6] suivantes, et
la couche de revêtement comprenant au moins un composé des composés représentés par les [Formule B] ou [Formule C] suivantes : 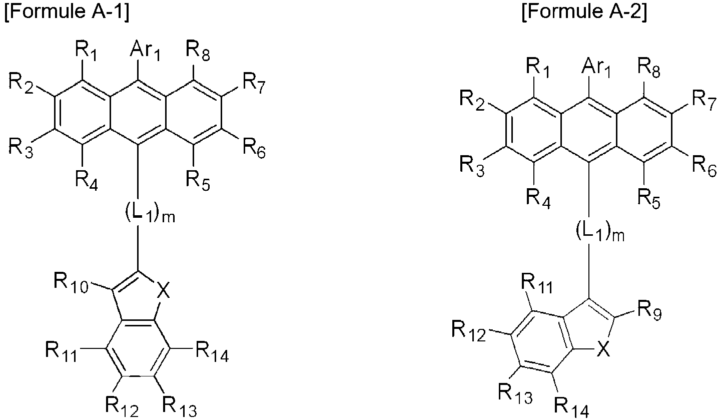 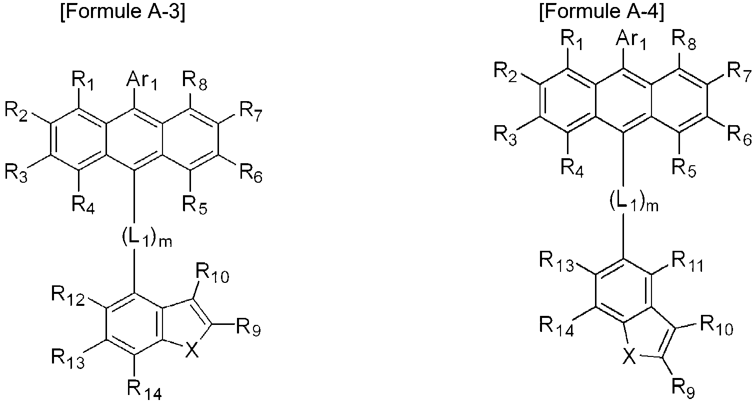 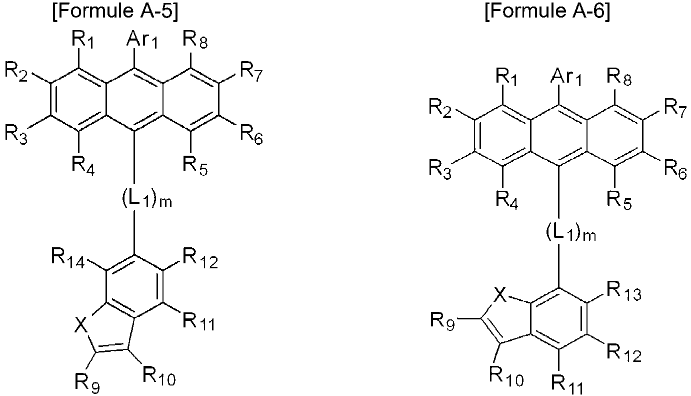
Ar1 étant choisi parmi un groupe aryle en C6-C50 substitué ou non substitué, un groupe hétéroaryle en C2-C50 substitué ou non substitué, et un groupe à cycles mixtes aliphatiques-aromatiques en C3-C50 substitué ou non substitué,
R₁ à R₁₄ étant identiques ou différents les uns des autres, et étant chacun indépendamment hydrogène, deutérium, un groupe alkyle en C1-C30 substitué ou non substitué, un groupe aryle en C6-C50 substitué ou non substitué, un groupe alcynyle en C2-C30 substitué ou non substitué, un groupe cycloalkyle en C3-C30 substitué ou non substitué, un groupe cycloalcényle en C3-C30 substitué ou non substitué, un groupe hétéroaryle en C2-C50 substitué ou non substitué, un groupe hétérocycloalkyle en C2-C30 substitué ou non substitué, un groupe alkoxy en C1-C30 substitué ou non substitué, un groupe aryloxy en C6-C50 substitué ou non substitué, un groupe alkylthioxy en C1-C30 substitué ou non substitué, un groupe arylthioxy en C6-C50 substitué ou non substitué, un groupe amine substitué ou non substitué, un groupe silyle substitué ou non substitué, un groupe à cycles mixtes aliphatiques-aromatiques en C3-C50 substitué ou non substitué, un groupe cyano, un groupe nitro et un groupe halogène,
X étant un atome d'oxygène (O) ou un atome de soufre (S),
L₁ étant un lieur divalent et étant une liaison simple ou étant choisi parmi un groupe arylène en C6-C50 substitué ou non substitué, un groupe hétéroarylène en C2-C50 substitué ou non substitué, et un groupe à cycles mixtes aliphatiques-aromatiques en C3-C50 substitué ou non substitué,
m étant un entier de 1 à 3, pourvu que, lorsque m est égal ou supérieur à 2, une pluralité des L₁ sont identiques ou différents les uns des autres, 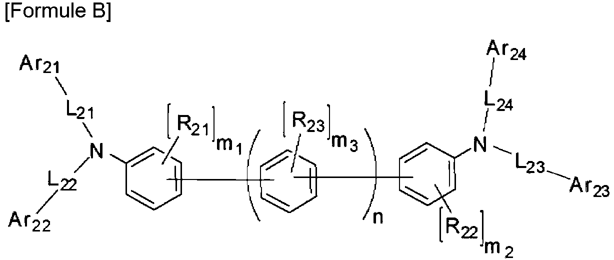
R₂₁ à R₂₃ étant identiques ou différents les uns des autres, et étant chacun indépendamment choisi parmi hydrogène, deutérium, un groupe alkyle en C1-C20 substitué ou non substitué, un groupe aryle en C6-C50 substitué ou non substitué, un groupe hétéroaryle en C2-C30 substitué ou non substitué, un groupe arylalkyle en C7-C50 substitué ou non substitué, un groupe cycloalkyle en C3-C30 substitué ou non substitué, un groupe silyle substitué ou non substitué, et un groupe halogène,
L₂₁ à L₂₄ étant identiques ou différents les uns des autres, et étant chacun indépendamment une liaison simple ou étant choisi parmi un groupe arylène en C6-C50 substitué ou non substitué et un groupe hétéroarylène en C2-C50 substitué ou non substitué,
Ar₂₁ à Ar₂₄ étant identiques ou différents les uns des autres, et étant chacun indépendamment choisi parmi un groupe aryle en C6-C50 substitué ou non substitué, et un groupe hétéroaryle en C2-C50 substitué ou non substitué,
n étant un entier de 0 à 4, pourvu que, lorsque n est égal ou supérieur à 2, une pluralité de structures cycliques aromatiques dans ( ) comprenant R₂₃ sont identiques ou différentes les unes des autres
m₁ à m₃ étant des entiers de 0 à 4, pourvu que, lorsque chacun des m₁ à m₃ est égal ou supérieur à 2, une pluralité de chacun des R₂₁, R₂₂, et R₂₃ sont identiques ou différents les uns des autres, et
un atome de carbone du cycle aromatique auquel les R₂₁ à R₂₃ ne sont pas liés étant lié à hydrogène ou deutérium, 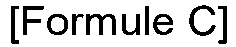 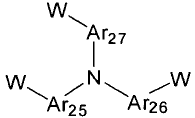
Ar₂₅ à Ar₂₇ étant des lieurs divalents, étant identiques ou différents les uns des autres, et étant chacun indépendamment des liaisons simples ou étant choisis parmi un groupe arylène en C6-C50 substitué ou non substitué, un groupe hétéroarylène en C2-C50 substitué ou non substitué, un groupe cycloalkylène en C3-C30 substitué ou non substitué, et un groupe à cycles mixtes aliphatiques-aromatiques en C3-C50 substitué ou non substitué, et
les W's étant chacun indépendamment choisis parmi hydrogène, deutérium, un groupe alkyle en C1-C30 substitué ou non substitué, un groupe aryle en C6-C50 substitué ou non substitué, un groupe alcényle en C2-C30 substitué ou non substitué, un groupe alcynyle en C2-C30 substitué ou non substitué, un groupe cycloalkyle en C3-C30 substitué ou non substitué, un groupe cycloalcényle en C3-C30 substitué ou non substitué, ou un groupe hétéroaryle en C2-C50 substitué ou non substitué, un groupe hétérocycloalkyle en C2-30 substitué ou non substitué, un groupe alkoxy en C1-C30 substitué ou non substitué, un groupe aryloxy en C6-C50 substitué ou non substitué, un groupe alkylthioxy C1-C30 substitué ou non substitué, un groupe arylthioxy en C6-C50 substitué ou non substitué, un groupe amine substitué ou non substitué, un groupe silyle substitué ou non substitué, un groupe à cycles mixtes aliphatiques-aromatiques en C3-C50 substitué ou non substitué, un groupe nitro et un groupe halogène, les W's étant identiques ou différents les uns des autres, sous réserve qu'au moins un des W's étant représenté par la [Formule C-1] suivante : 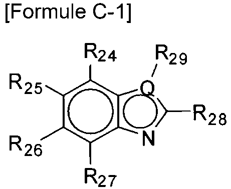
les R₂₄ à R₂₉ étant identiques ou différents les uns des autres, et étant chacun indépendamment des lieurs en tant que sites de liaison à Ar₂₅ à Ar₂₇, ou étant choisis parmi hydrogène, deutérium, un groupe alkyle en C1-C30 substitué ou non substitué, un groupe aryle en C6-C50 substitué ou non substitué, un groupe alcényle en C2-C30 substitué ou non substitué, un groupe alcynyle en C2-C30 substitué ou non substitué, un groupe cycloalkyle en C3-C30 substitué ou non substitué, un groupe cycloalcényle en C3-C30 substitué ou non substitué, un groupe hétéroaryle en C2-C50 substitué ou non substitué, un groupe hétérocycloalkyle en C2-C30 substitué ou non substitué, un groupe alkoxy en C1-C30 substitué ou non substitué, un groupe aryloxy en C6-C50 substitué ou non substitué, un groupe alkylthioxy en C1-C30 substitué ou non substitué, un groupe arylthioxy en C6-C50 substitué ou non substitué, un groupe amine substitué ou non substitué, un groupe silyle substitué ou non substitué, un groupe à cycles mixtes aliphatiques-aromatiques en C3-C50 substitué ou non substitué, un groupe cyano, un groupe nitro et un groupe halogène,
sous réserve que les R₂₄ à R₂₇ sont liés les uns aux autres ou chacun des R₂₄ à R₂₇ est lié à un substituant adjacent pour former en outre un monocycle ou polycycle alicyclique ou aromatique dont au moins un atome de carbone est substitué par au moins un hétéroatome choisi parmi azote, oxygène et soufre, et
Q étant N, O ou S, pourvu que, lorsque Q est O ou S, Q ne comprend pas R₂₉.

2. Dispositif électroluminescent organique selon la revendication 1, dans lequel chacun des composés représentés par les [Formule A-1] à [Formule A-6] comprend au moins un atome de deutérium (D) comme substituant.

3. Dispositif électroluminescent organique selon la revendication 1, dans lequel chacun des composés représentés par les [Formule A-1] à [Formule A-6] a un degré de deutération égal ou supérieur à 10 %.

4. Dispositif électroluminescent organique selon la revendication 1, dans lequel au moins un des R₁₁ à R₁₄ dans chacun des composés représentés par les [Formule A-1] à [Formule A-6] est choisi parmi un groupe aryle en C6-C20 substitué ou non substitué, un groupe cycloalkyle en C3-C20 substitué ou non substitué, et un groupe hétéroaryle en C3-C20 substitué ou non substitué.

5. Dispositif électroluminescent organique selon la revendication 4, dans lequel au moins un des R₁₁ à R₁₄ dans chacun des composés représentés par les [Formule A-1] à [Formule A-6] est un groupe aryle en C6-C20 substitué ou non substitué par deuterium.

6. Dispositif électroluminescent organique selon la revendication 1, dans lequel au moins un des Ar₂₁ à Ar₂₄ est représenté par la [Formule E] suivante : 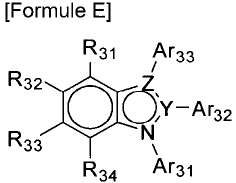
R₃₁ à R₃₄ étant identiques ou différents les uns des autres, et étant chacun indépendamment choisi parmi hydrogène, deutérium, un groupe alkyle en C1-C30 substitué ou non substitué, un groupe aryle en C6-C50 substitué ou non substitué, un groupe alcényle en C2-C30 substitué ou non substitué, un groupe alcynyle en C2-C20 substitué ou non substitué, un groupe cycloalkyle en C3-C30 substitué ou non substitué, un groupe cycloalcényle en C5-C30 substitué ou non substitué, un groupe hétéroaryle en C2-C50 substitué ou non substitué, un groupe hétérocycloalkyle en C2-C30 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe amine substitué ou non substitué, un groupe silyle substitué ou non substitué, un groupe nitro, un groupe cyano, et un groupe halogène, sous réserve que les R₃₁ à R₃₄ sont liés les uns aux autres pour former un cycle,
Y étant un atome de carbone (C) ou un atome d'azote (N), et Z est un atome de carbone (C), un atome d'oxygène (O), un atome de soufre (S) ou un atome d'azote (N), et
Ar₃₁ à Ar₃₃ étant identiques ou différents les uns des autres, et étant chacun indépendamment choisi parmi un groupe aryle en C5-C50 substitué ou non substitué et un groupe hétéroaryle en C3-C50 substitué ou non substitué, pourvu que, lorsque Z est un atome d'oxygène (O) ou un atome de soufre (S), Ar₃₃ n'est rien, pourvu que, lorsque Y et Z sont des atomes d'azote (N), seulement un des Ar₃₁, Ar₃₂, et Ar₃₃ est présent, pourvu que, lorsque Y est un atome d'azote (N) et Z est un atome de carbone (C), Ar₃₂ n'est rien, sous réserve qu'un des R₃₁ à R₃₄ et Ar₃₁ à Ar₃₃ est une liaison simple qui est liée à un des lieurs L₂₁ à L₂₄ dans la [Formule B].

7. Dispositif électroluminescent organique selon la revendication 1, dans lequel chacun des composés représentés par les [Formule A-1] à [Formule A-6] est choisi parmi les composés représentés par les [A-1] à [A-218] suivantes :

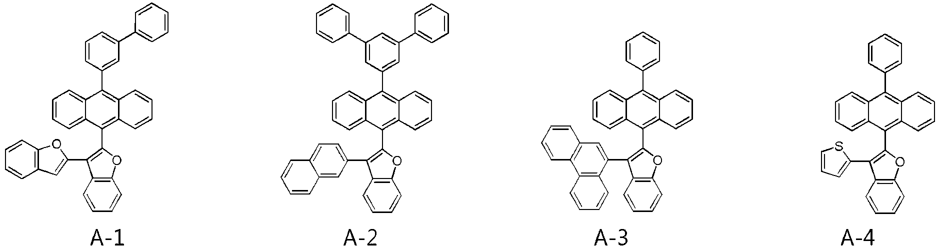

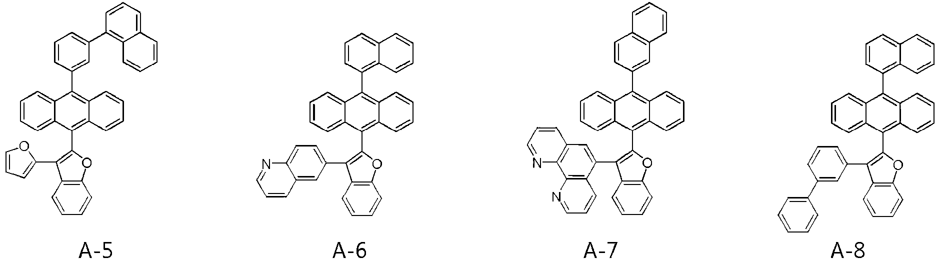

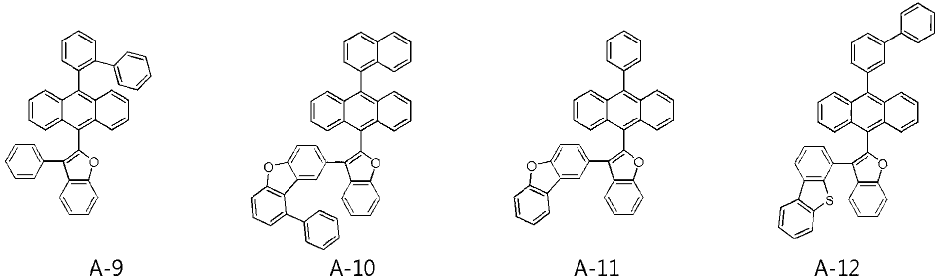

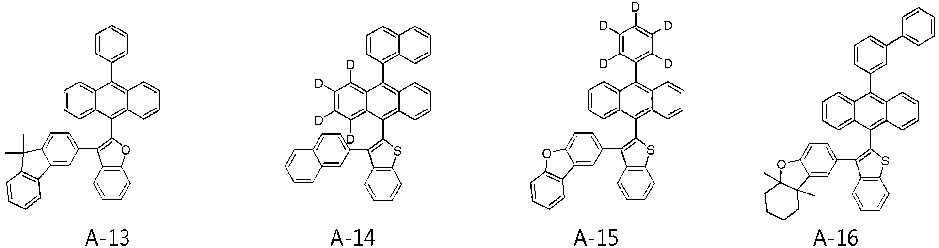

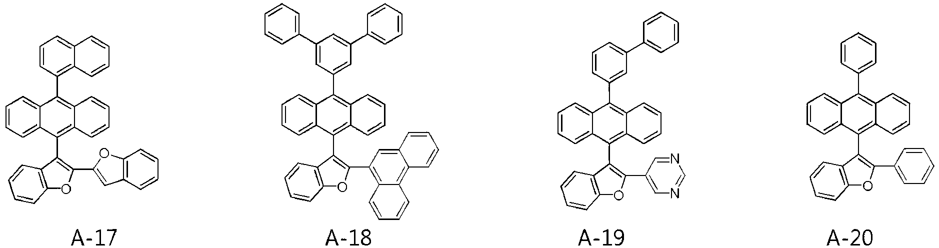

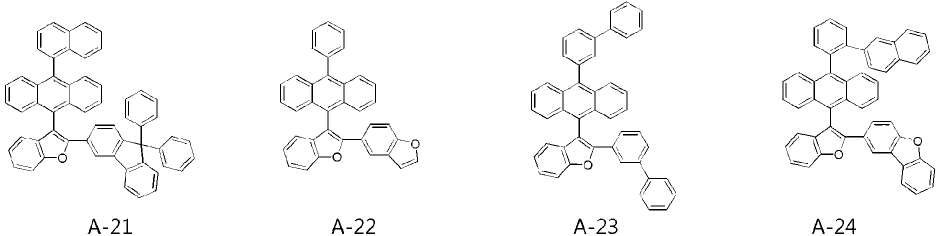

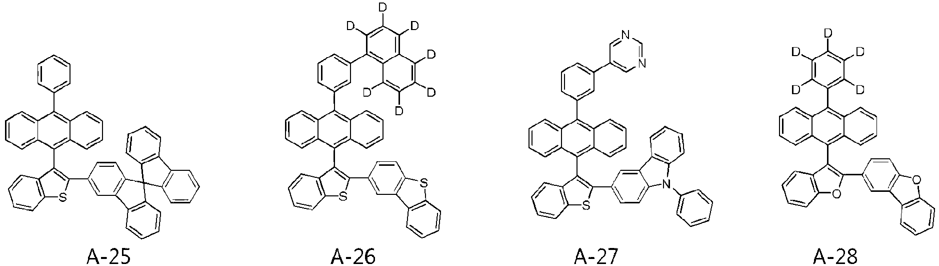

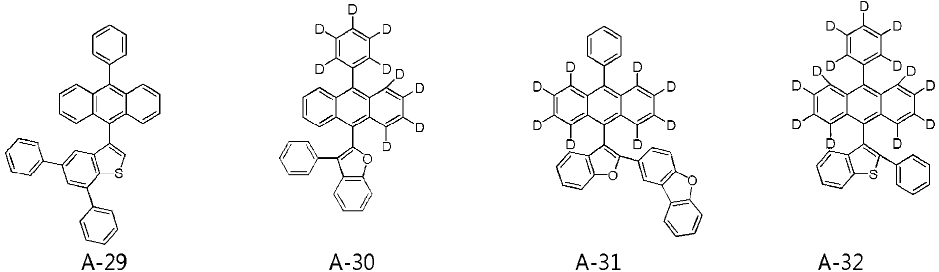

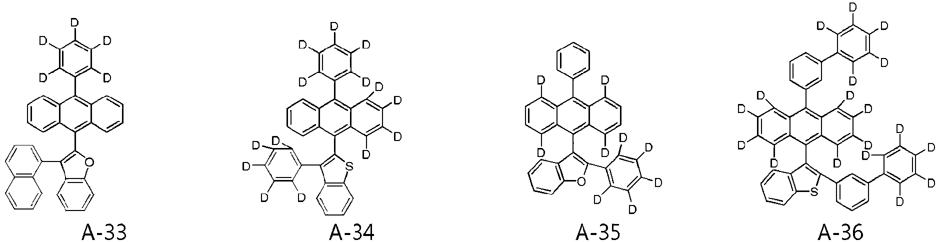

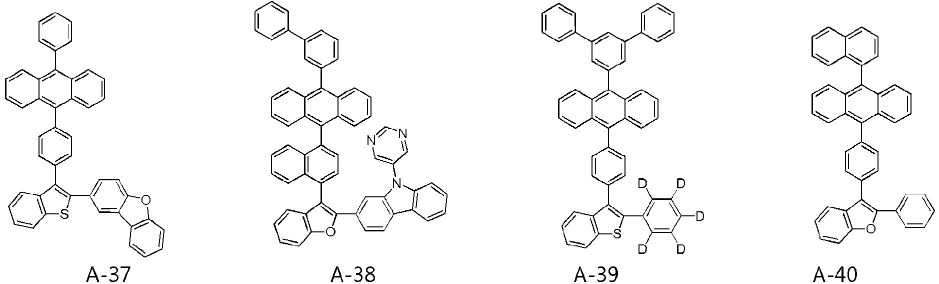

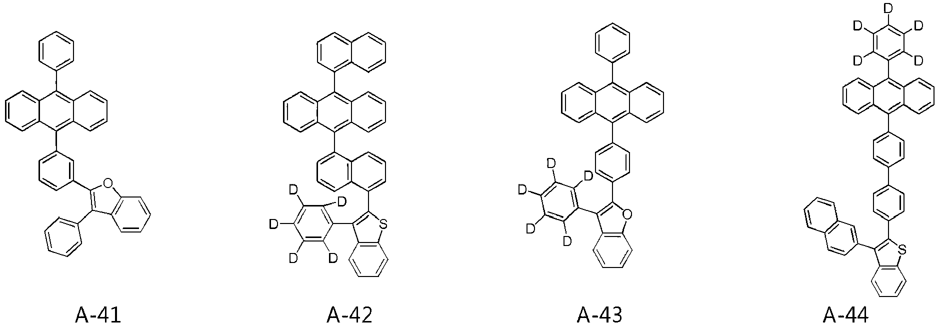

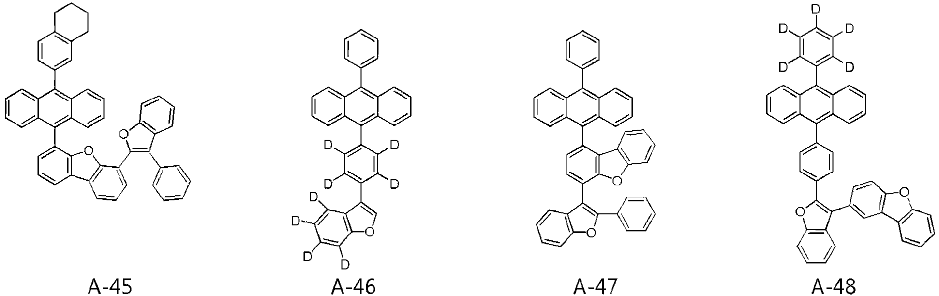

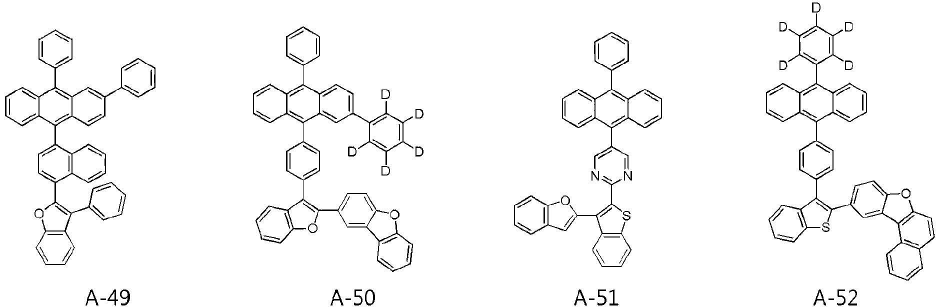

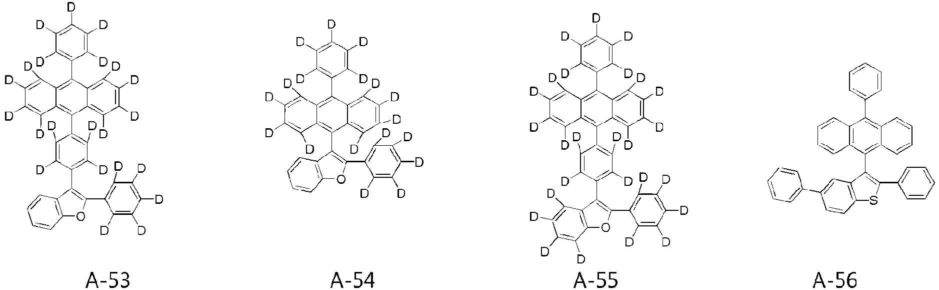

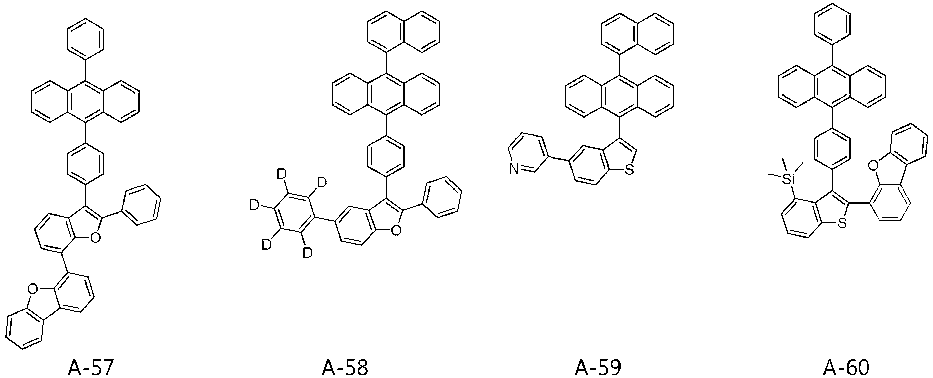

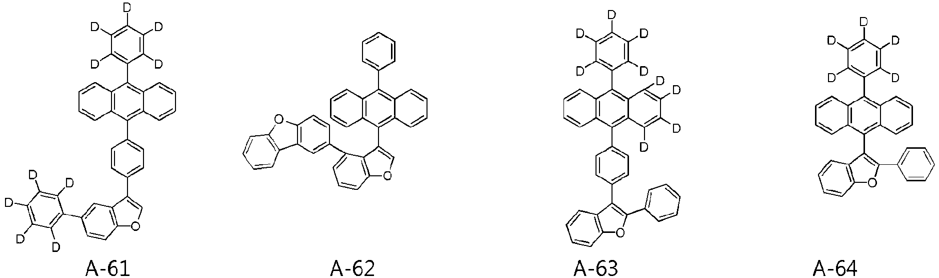

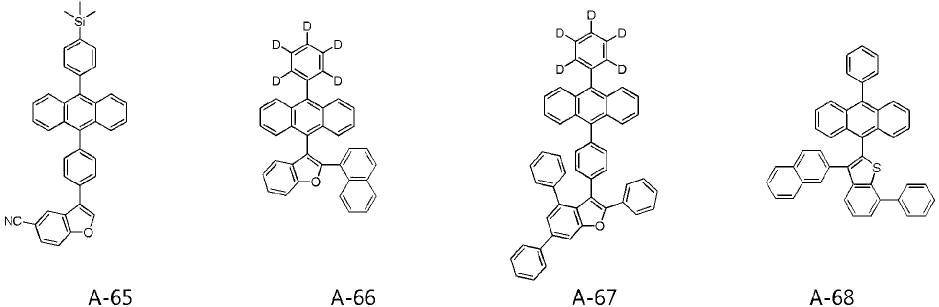

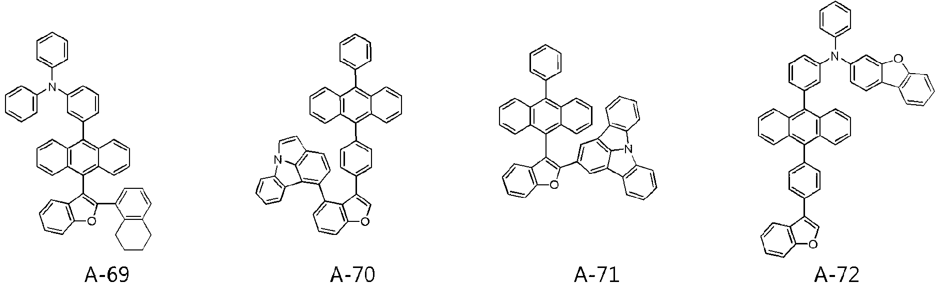

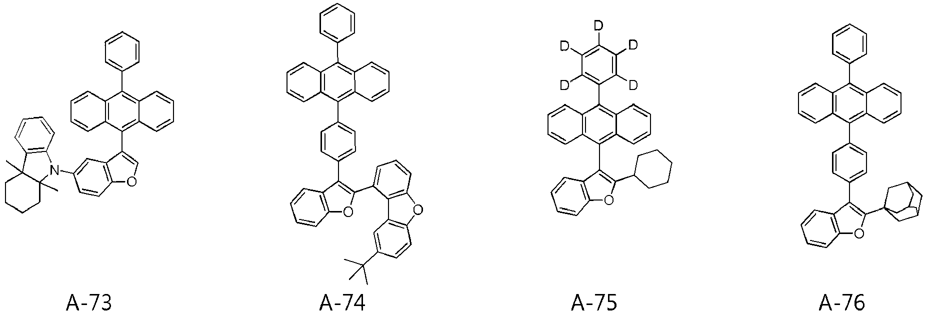

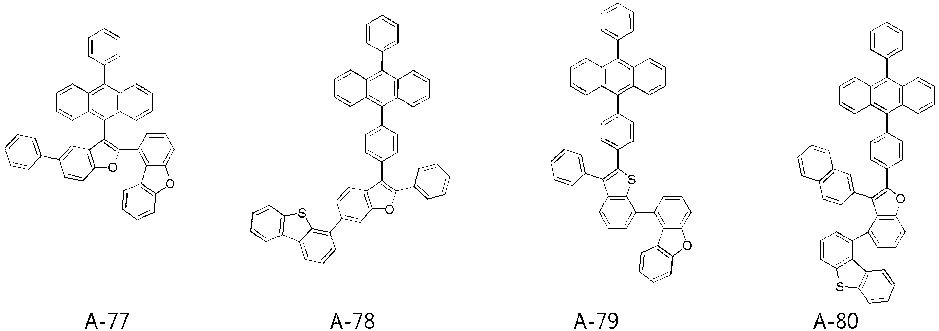

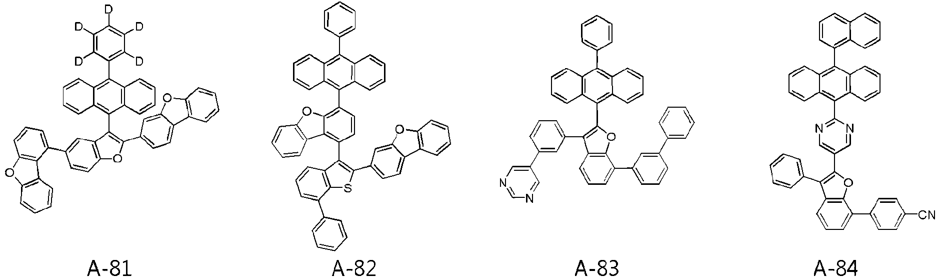

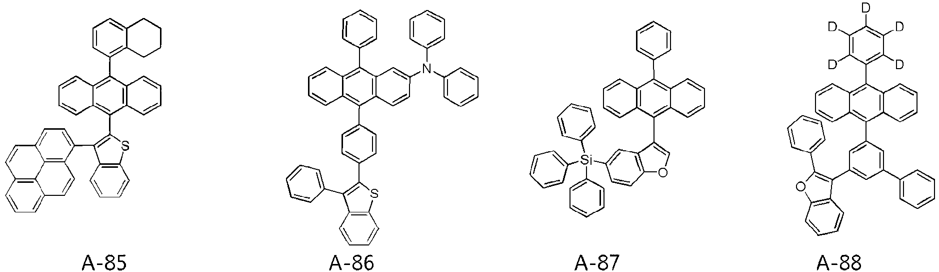

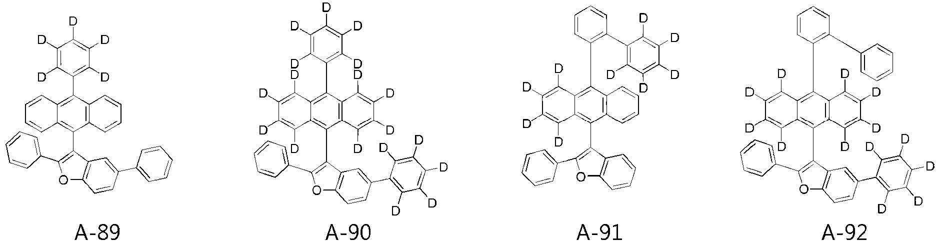

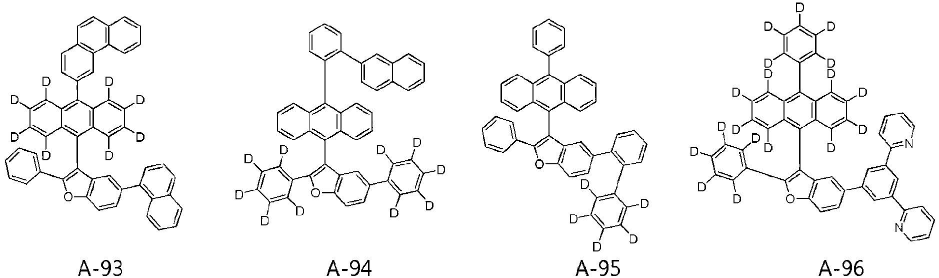

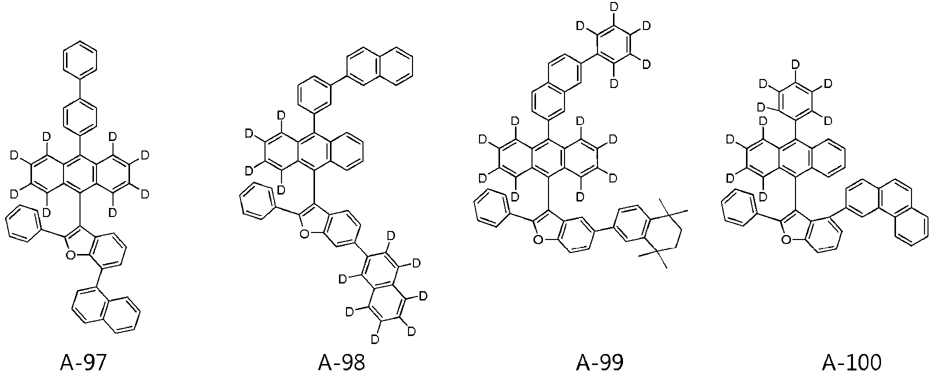

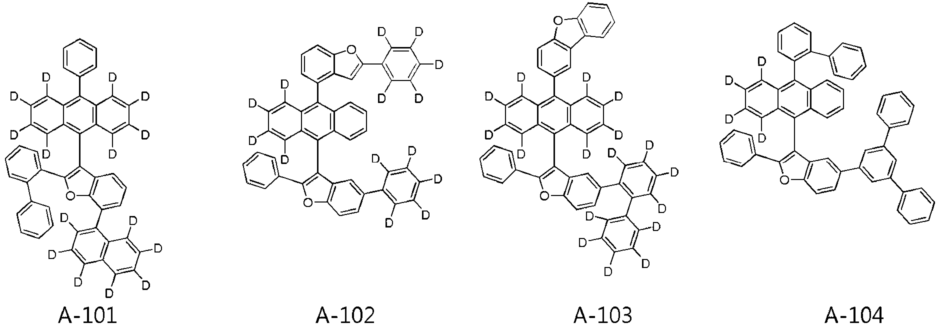

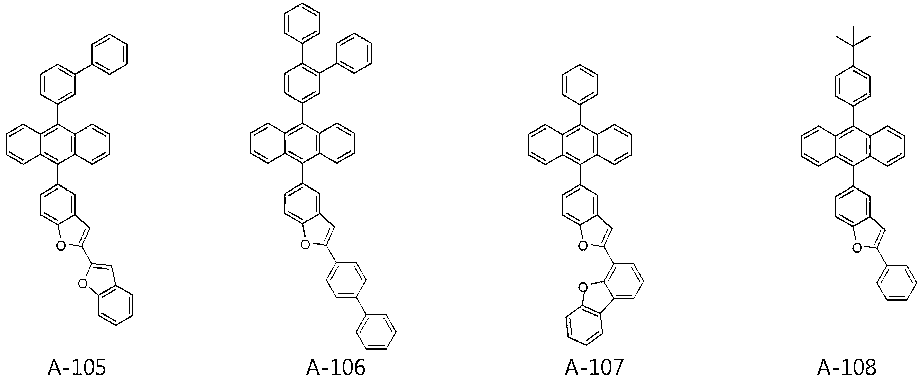

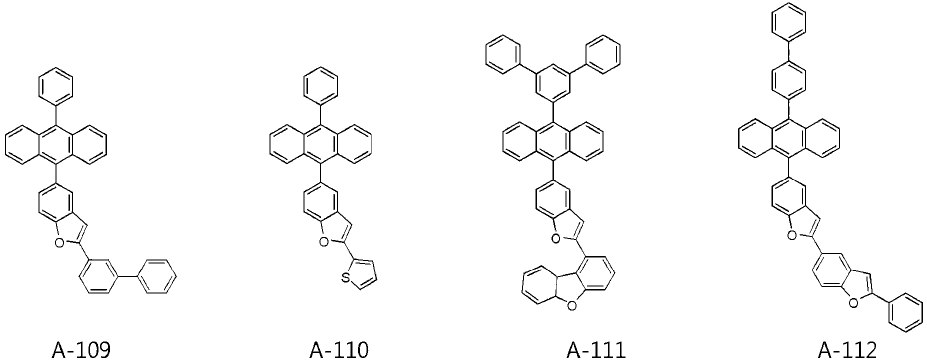

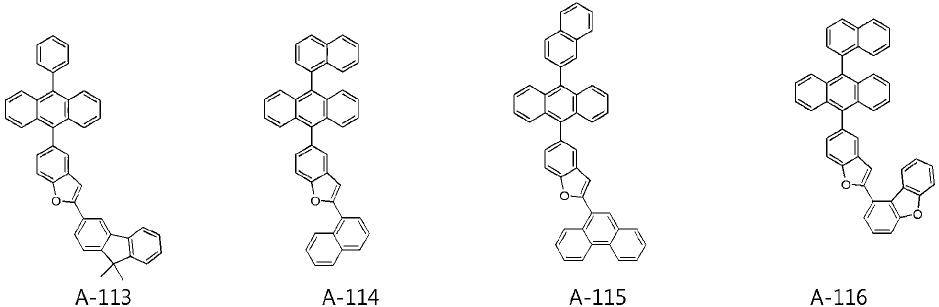

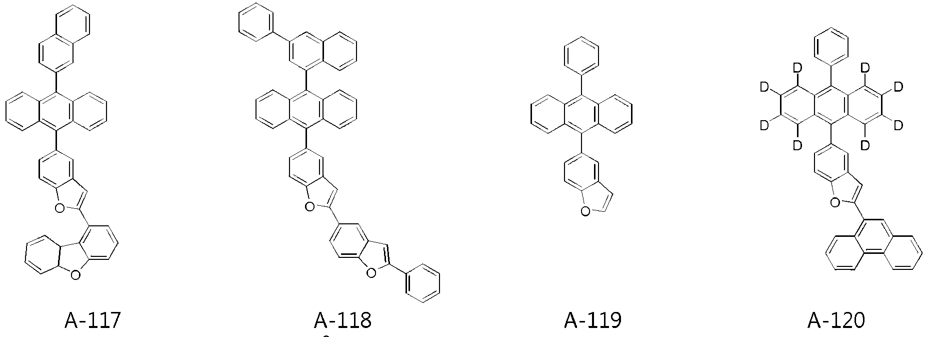

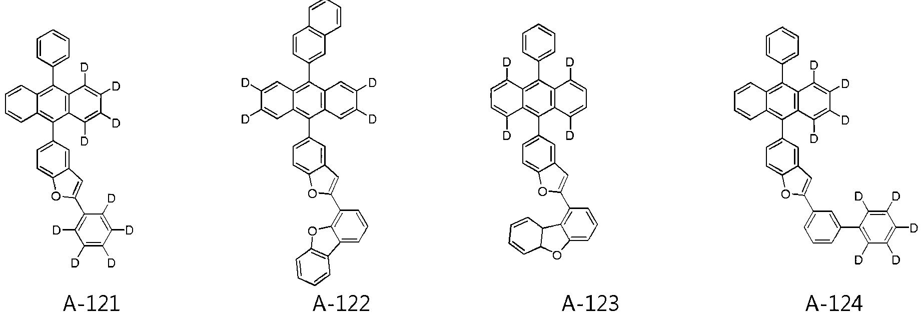

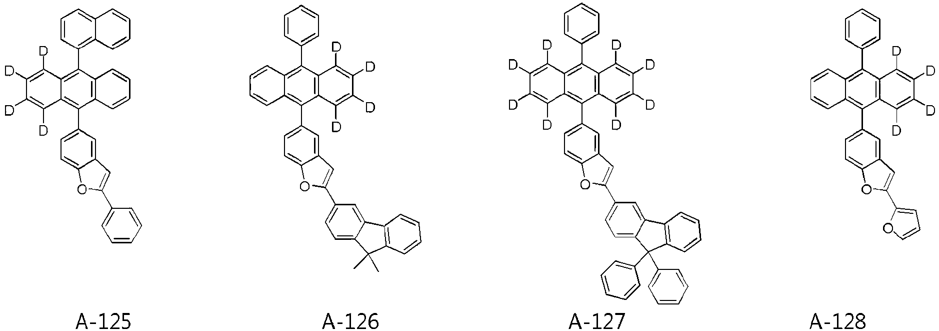

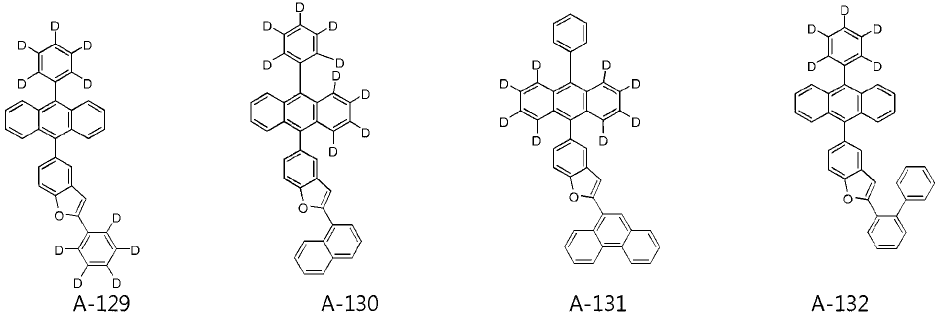

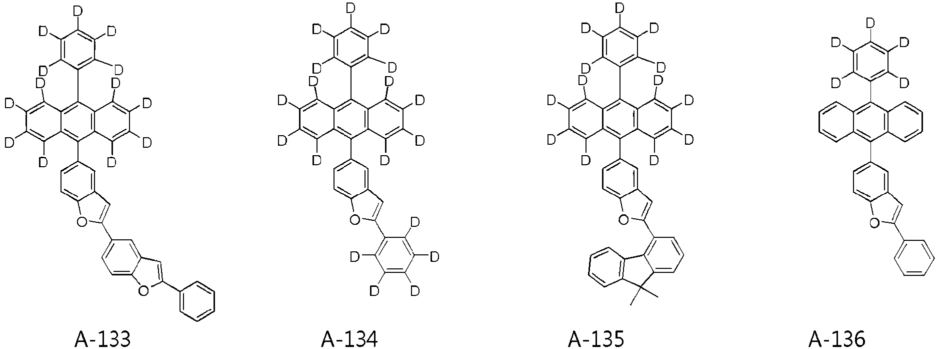

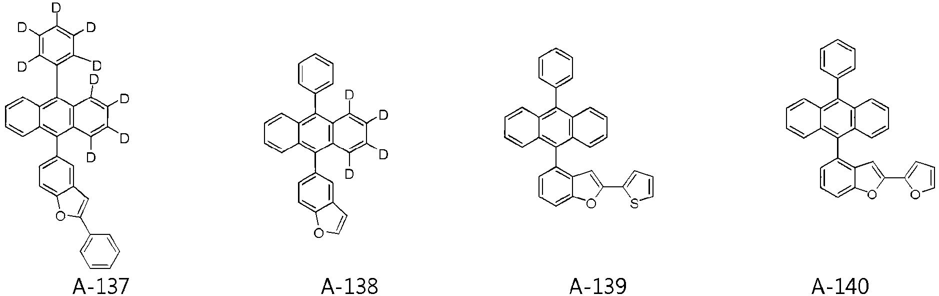

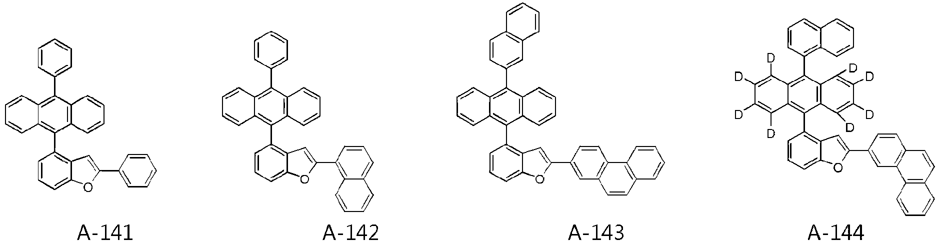

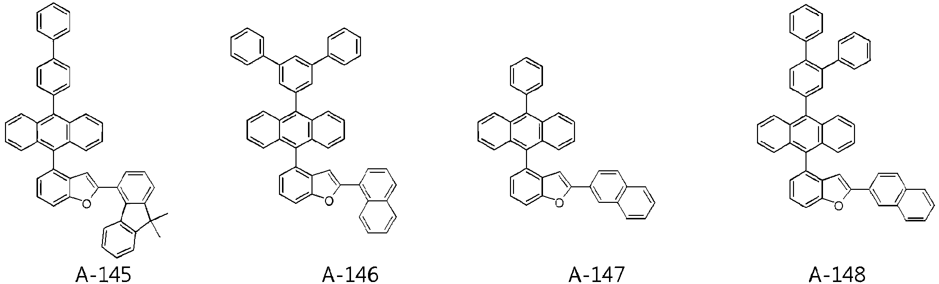

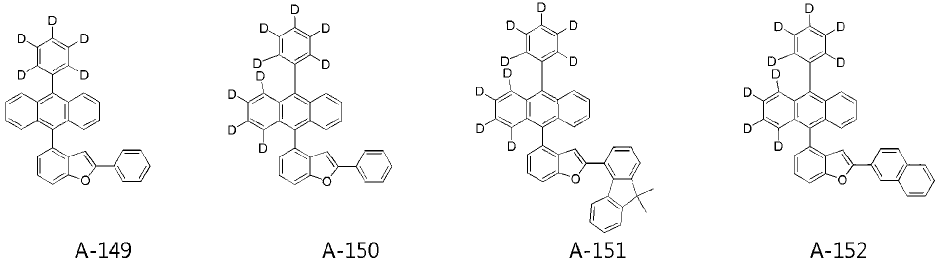

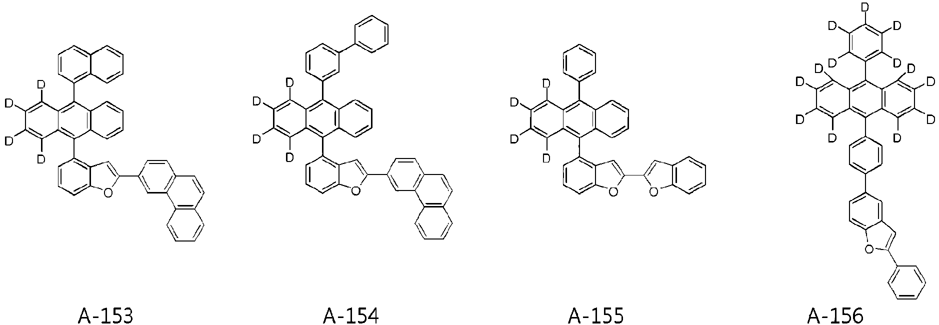

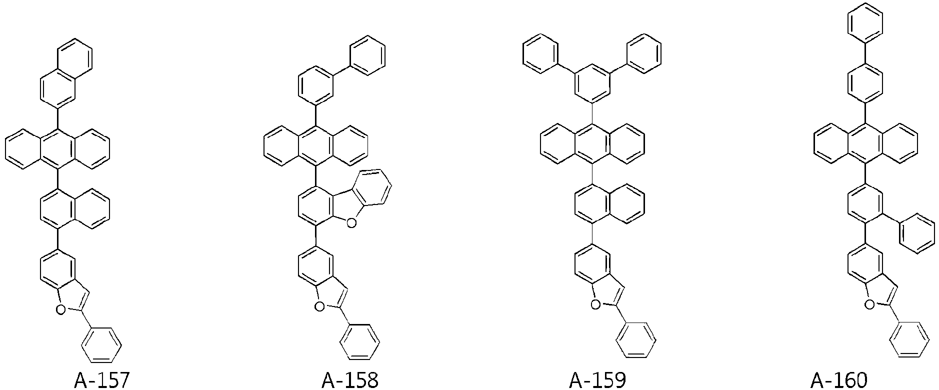

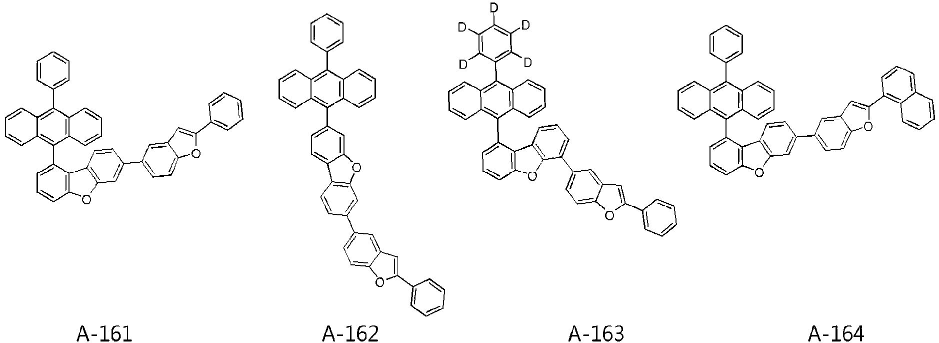

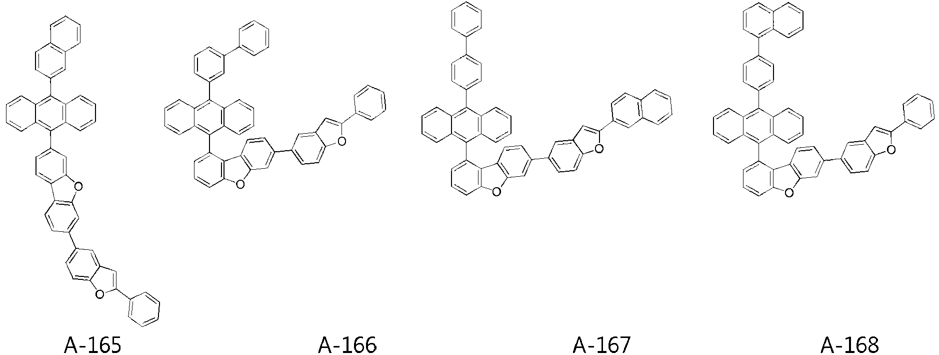

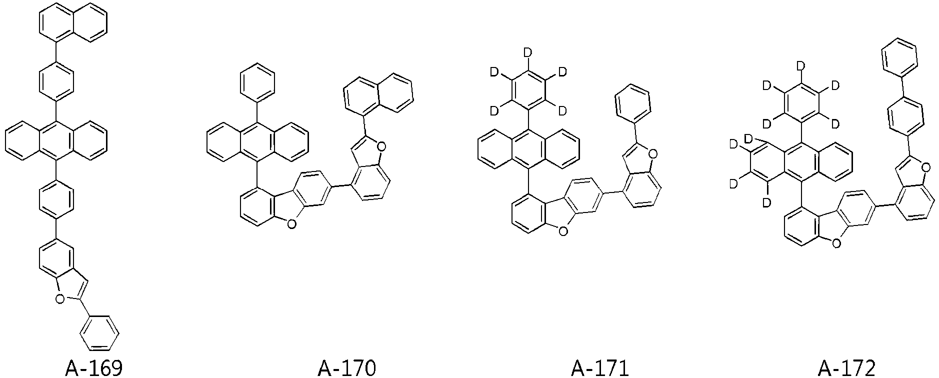

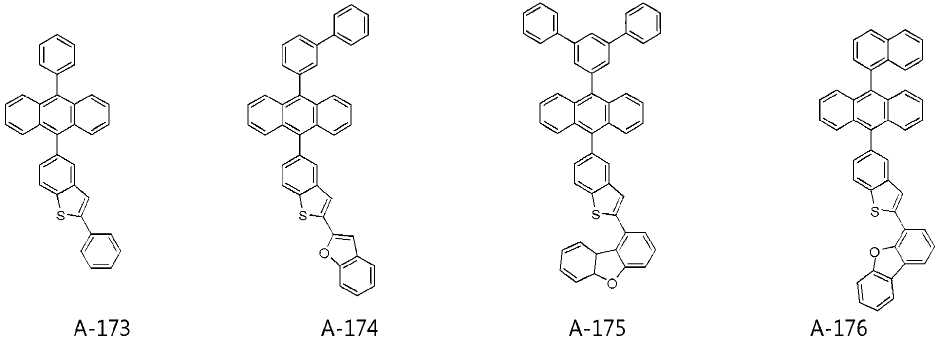

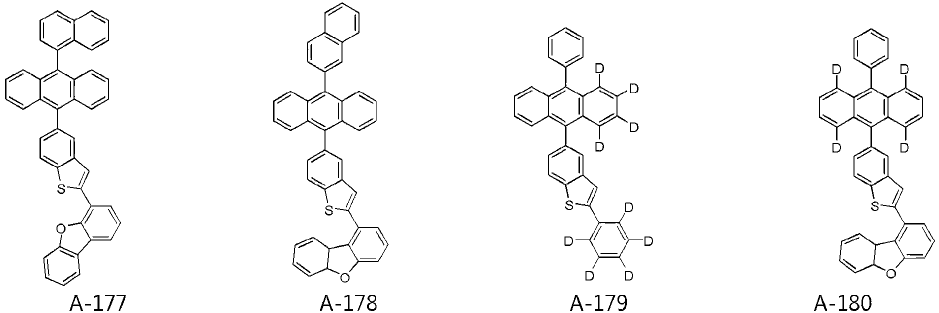

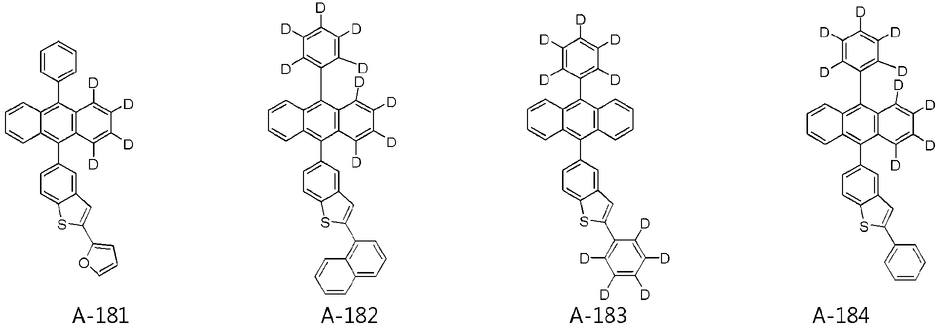

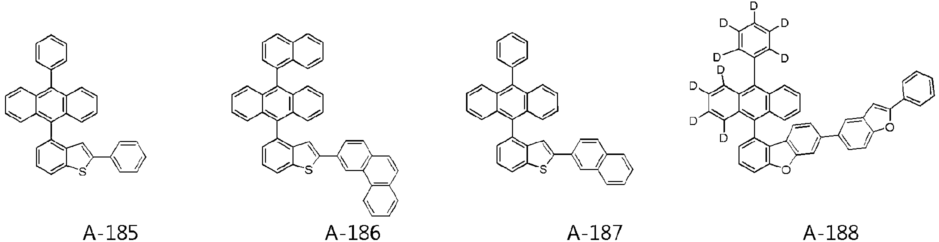

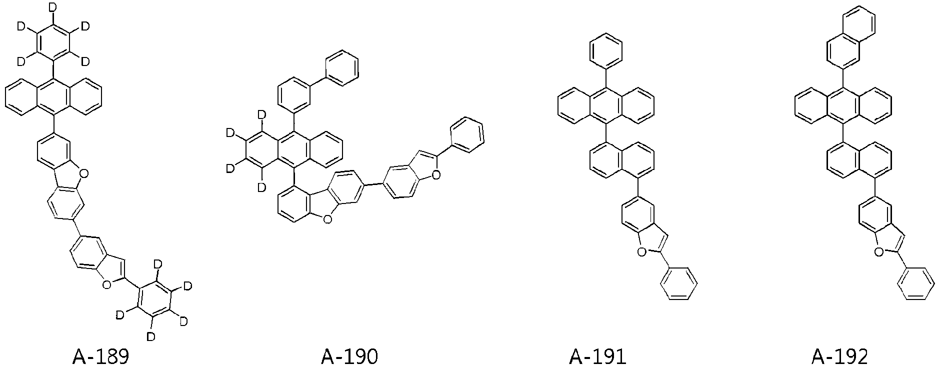

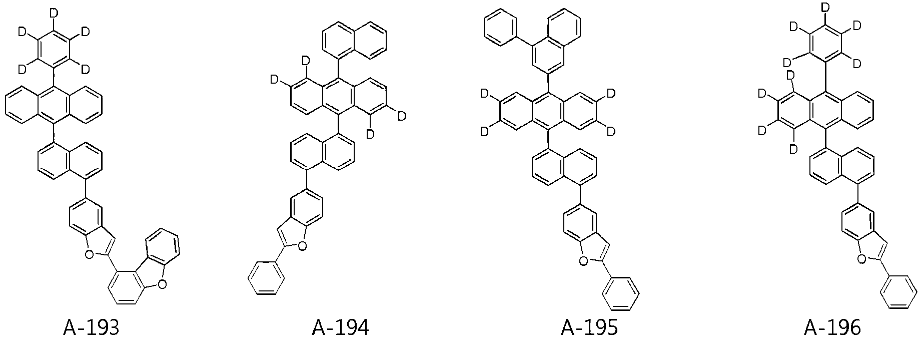

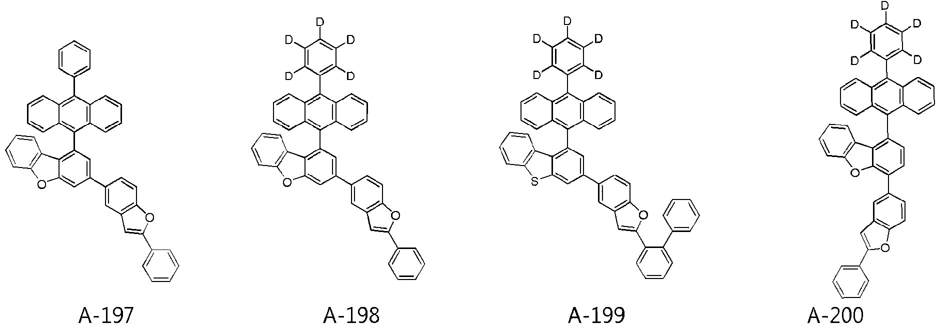

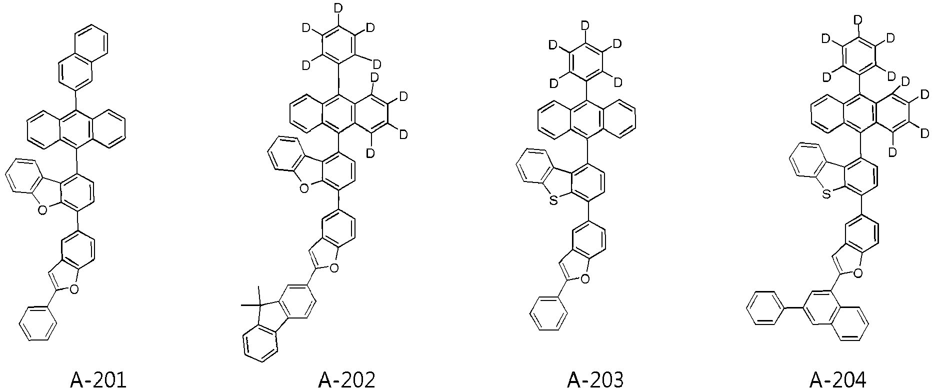

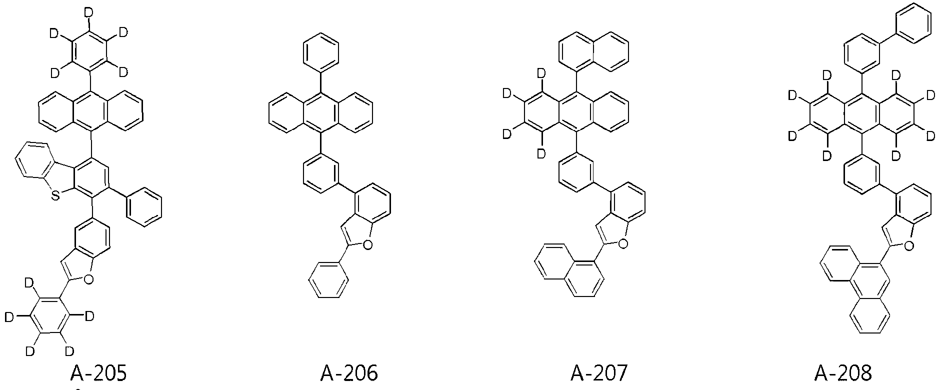

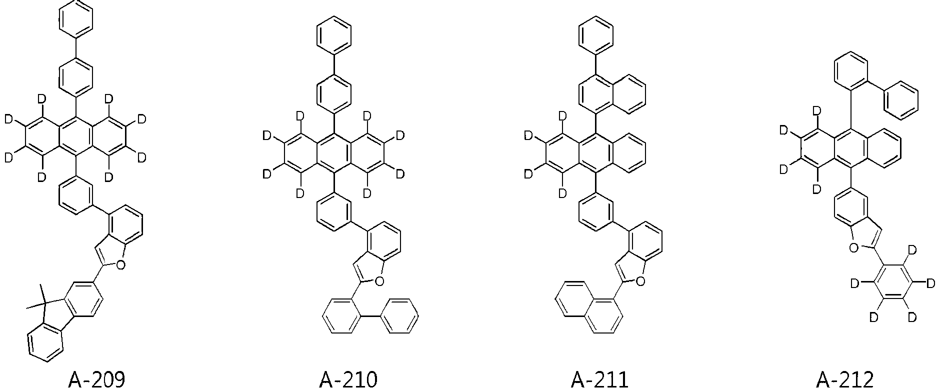

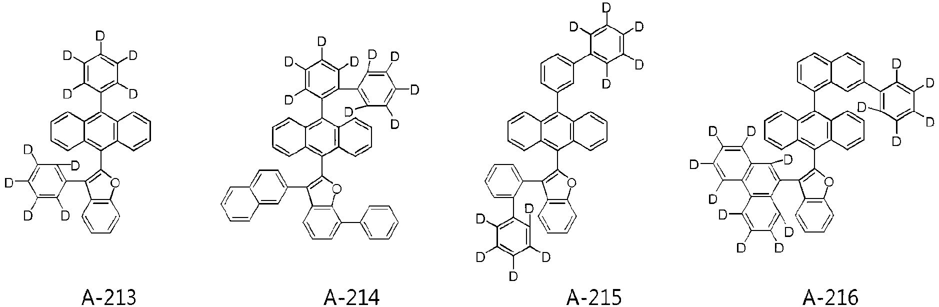

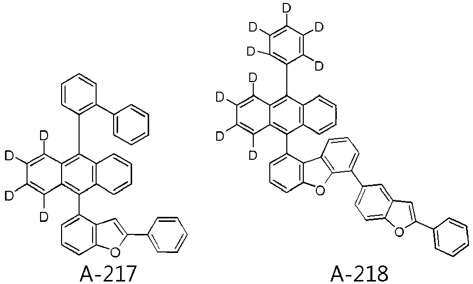

8. Dispositif électroluminescent organique selon la revendication 1, dans lequel le composé de la [Formule B] est choisi parmi les composés représentés par les [B-1] à [B-79] suivantes :

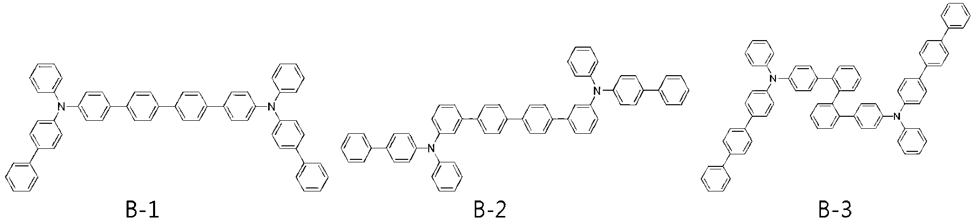

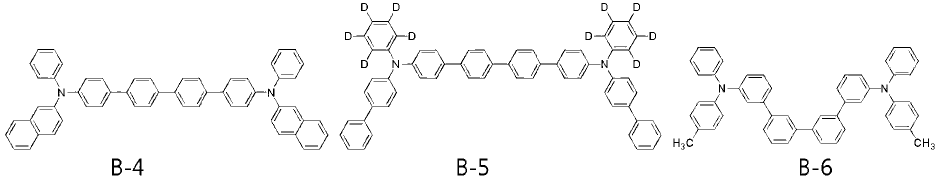

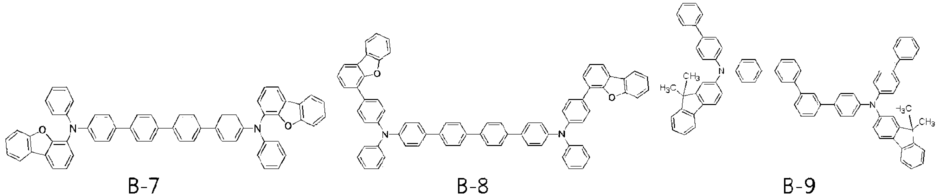

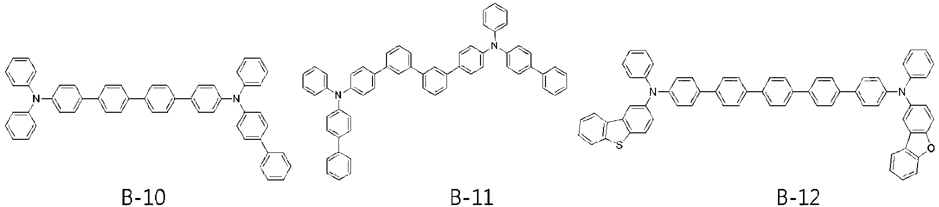

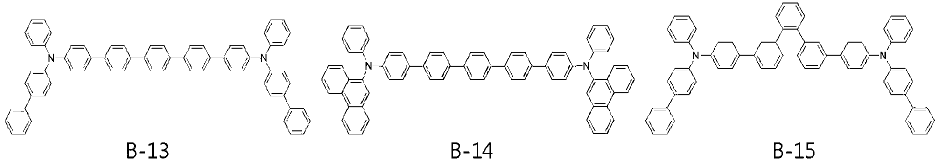

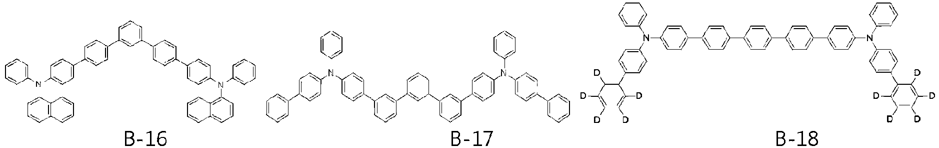

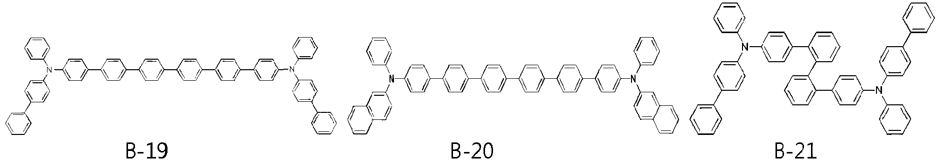

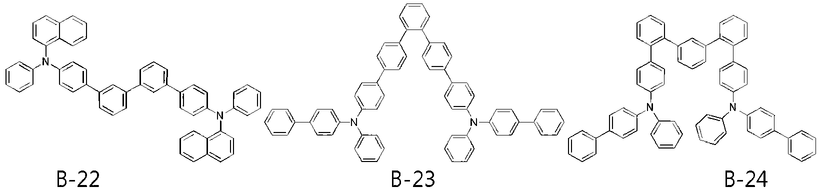

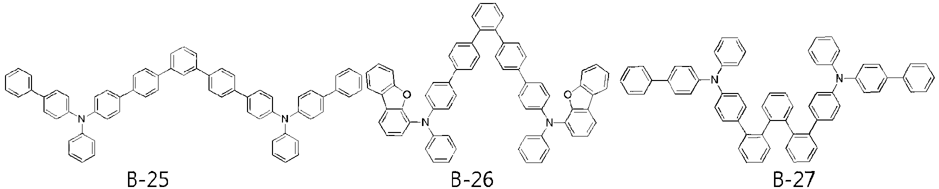

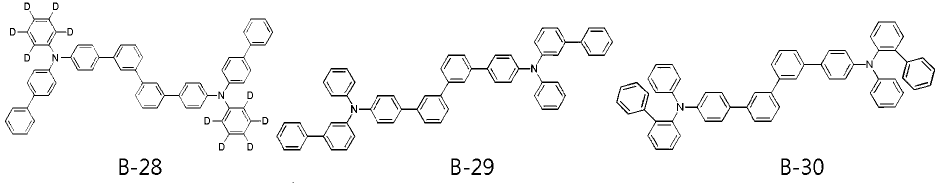

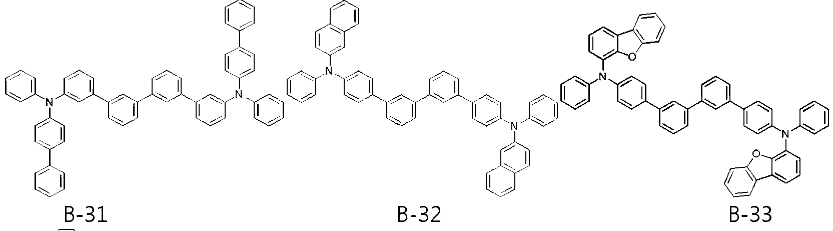

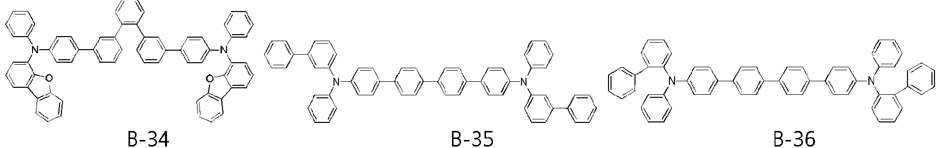

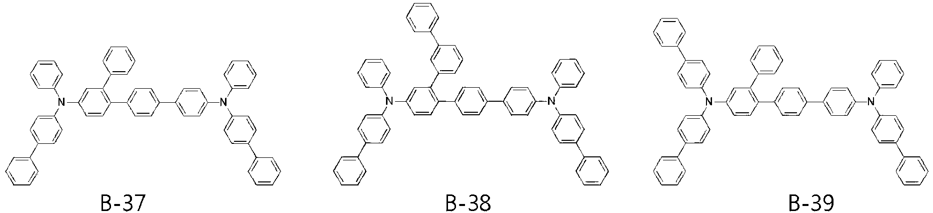

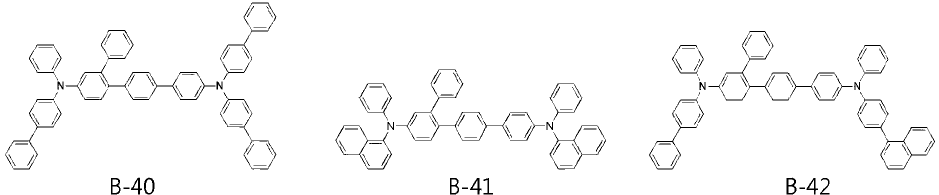

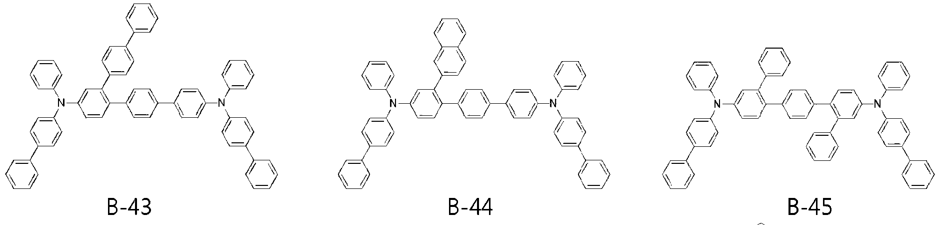

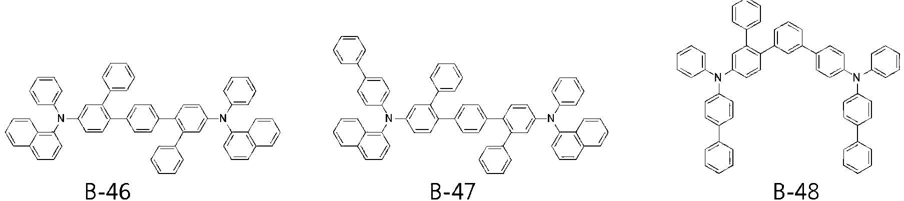

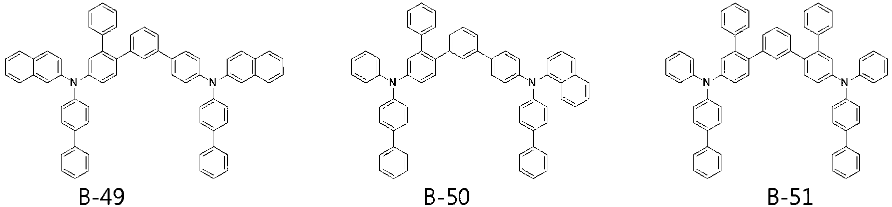

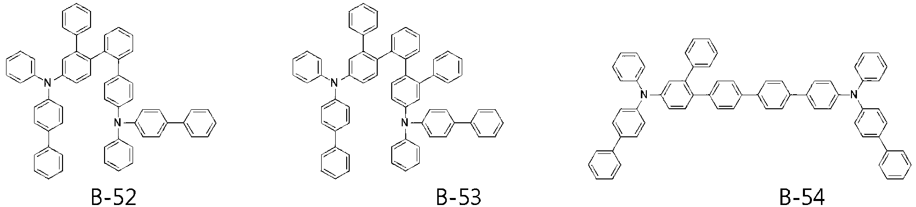

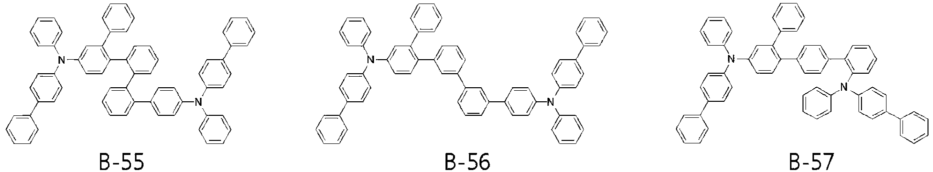

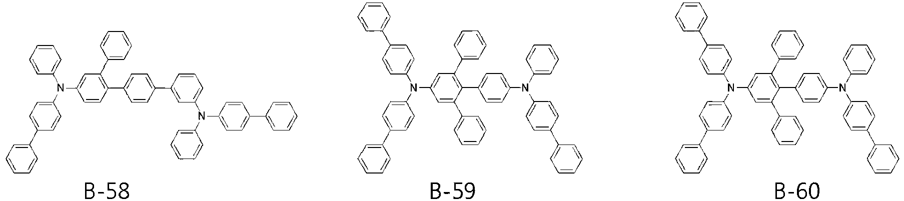

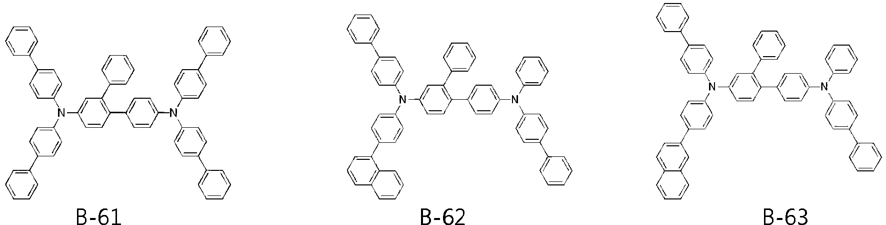

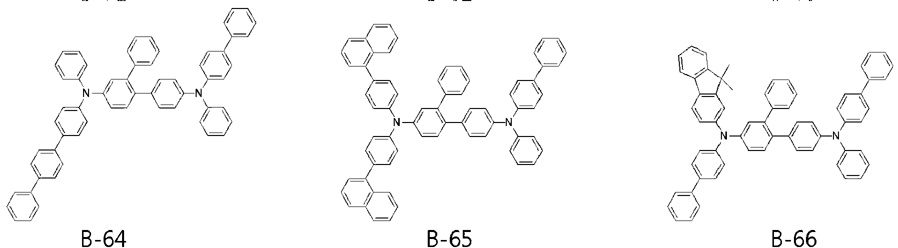

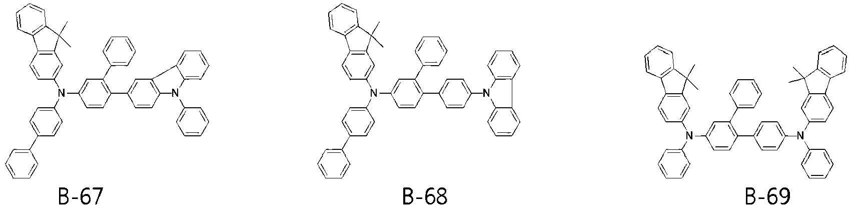

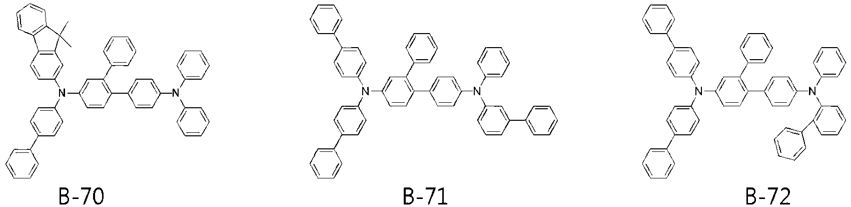

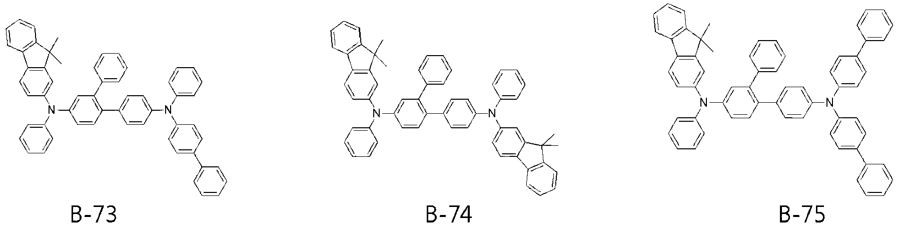

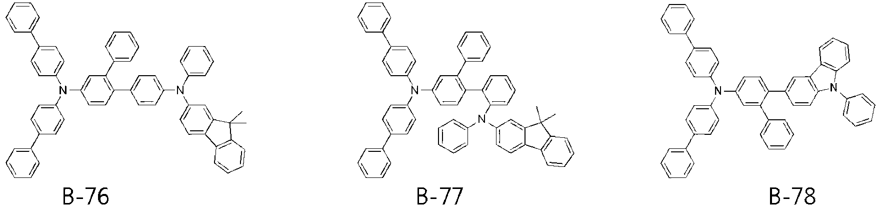

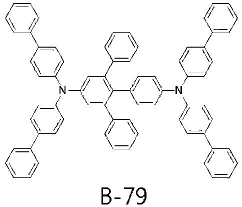

9. Dispositif électroluminescent organique selon la revendication 1, dans lequel le composé représenté par la [Formule B] est choisi parmi les composés représentés par les [B-101] à [B-148] suivantes :

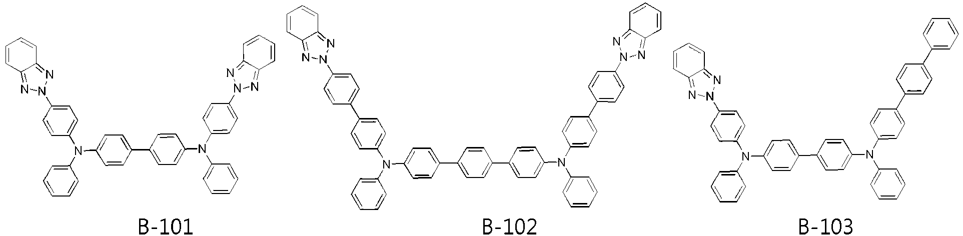

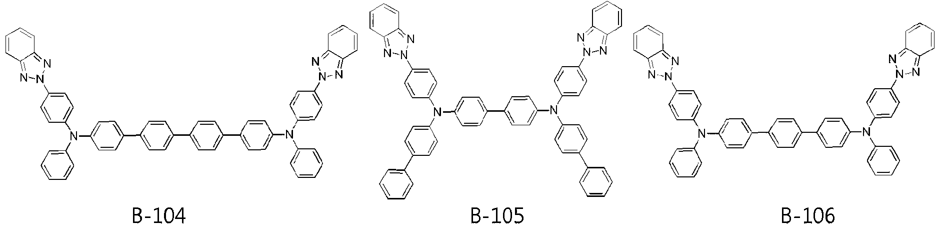

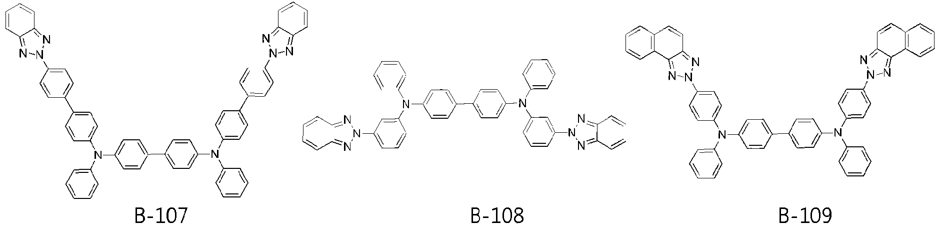

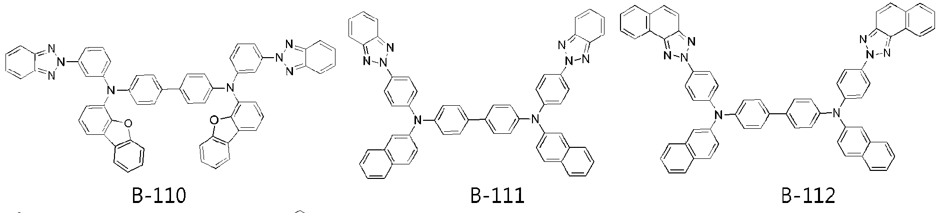

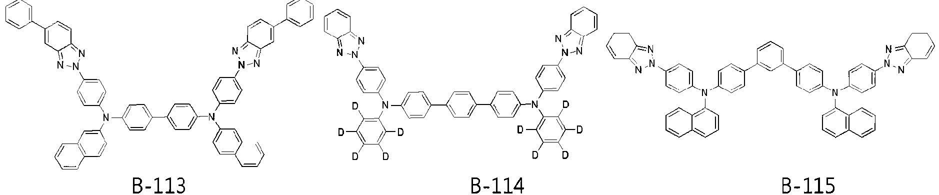

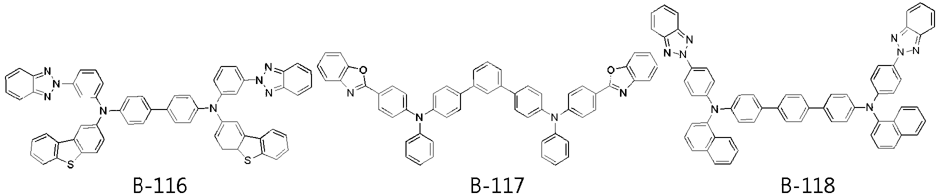

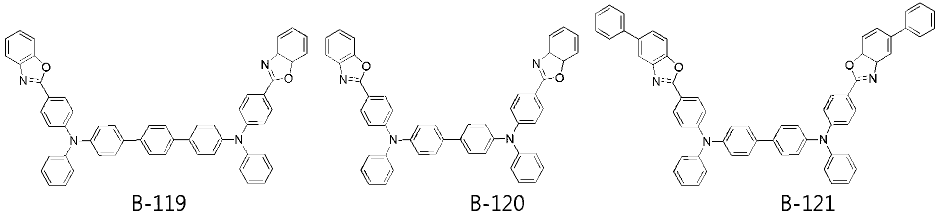

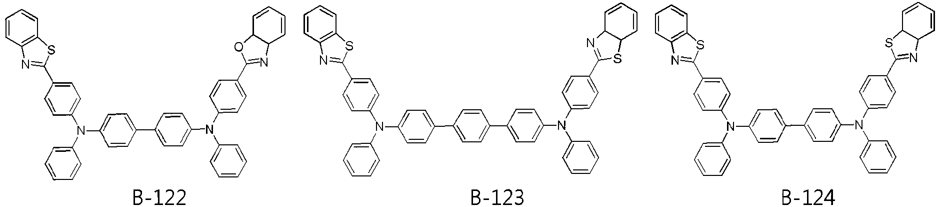

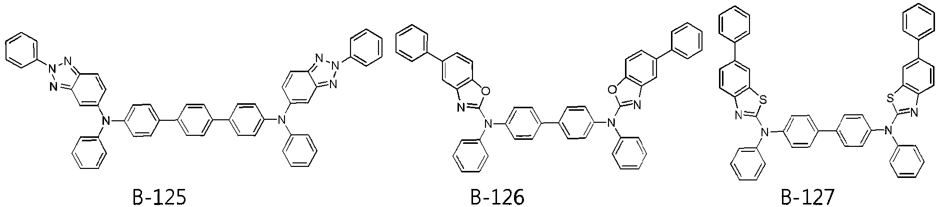

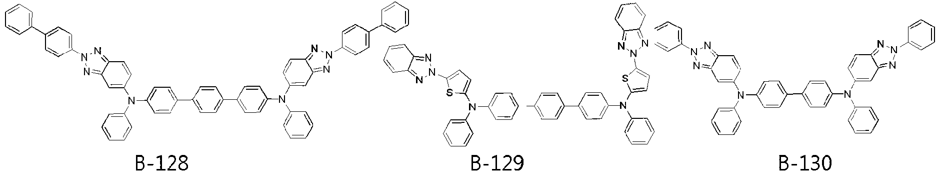

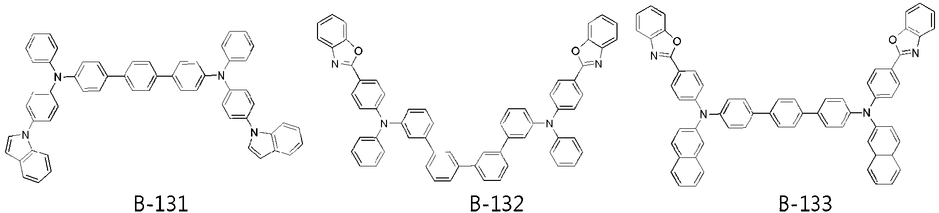

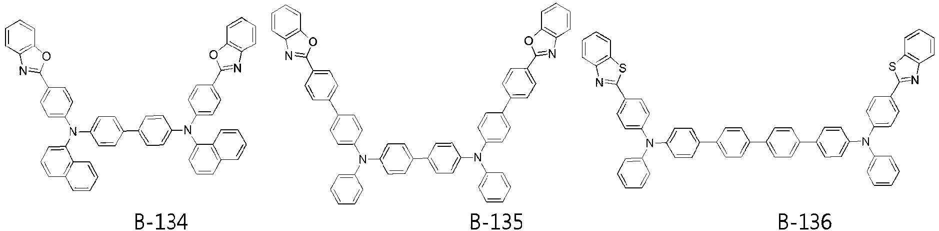

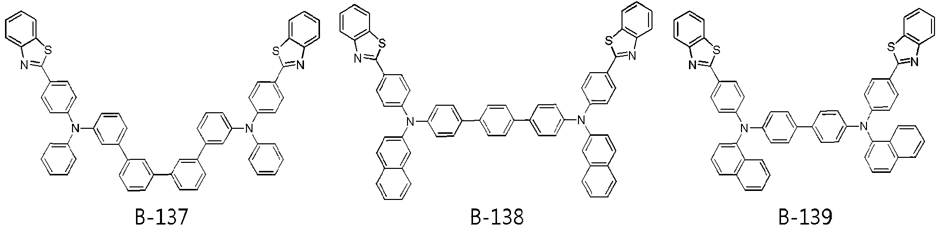

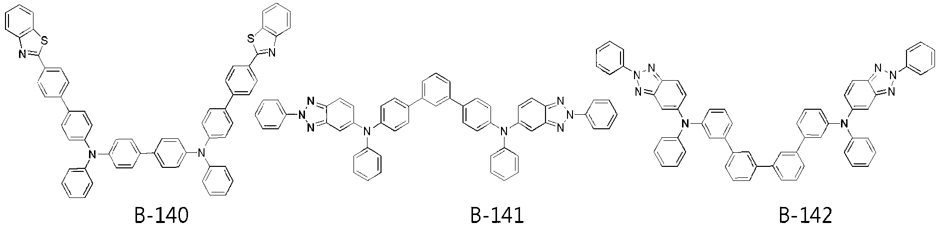

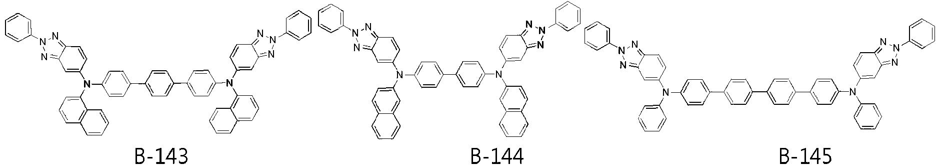

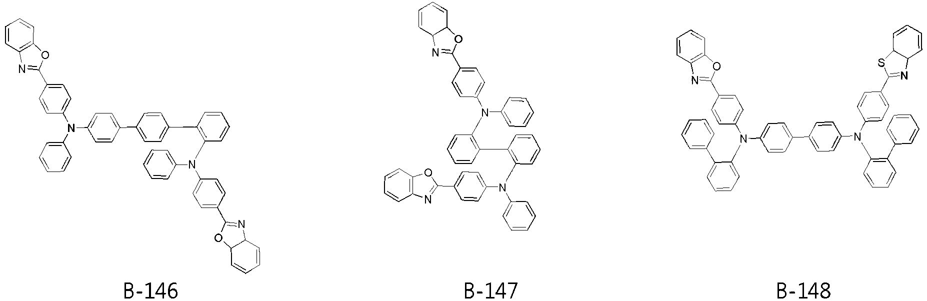

10. Dispositif électroluminescent organique selon la revendication 1, dans lequel le composé représenté par la [Formule C] est choisi parmi les composés représentés par les [C-1] à [C-99] suivantes :

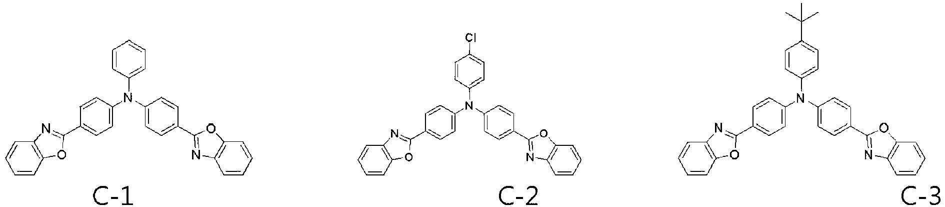

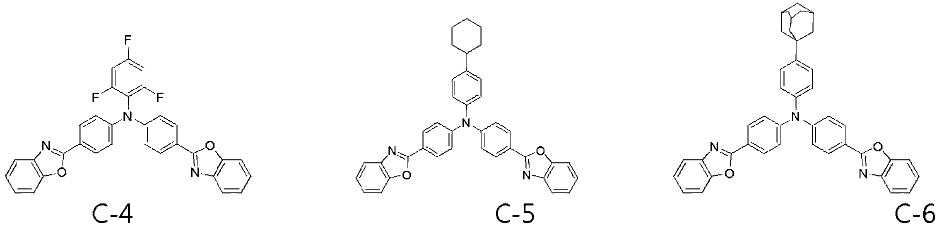

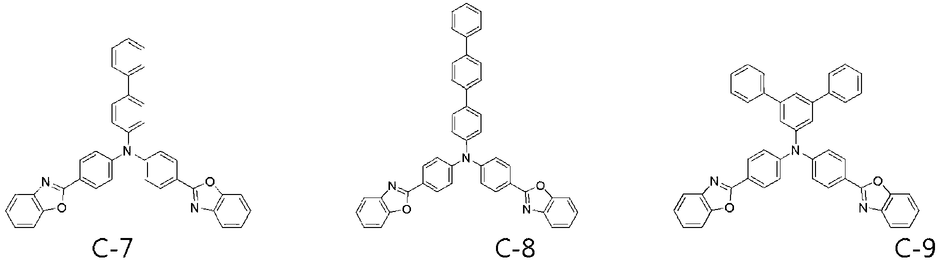

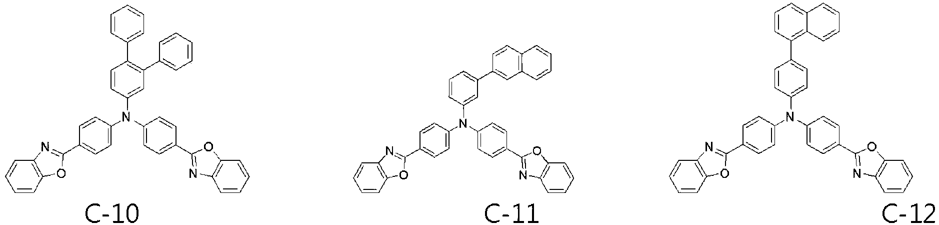

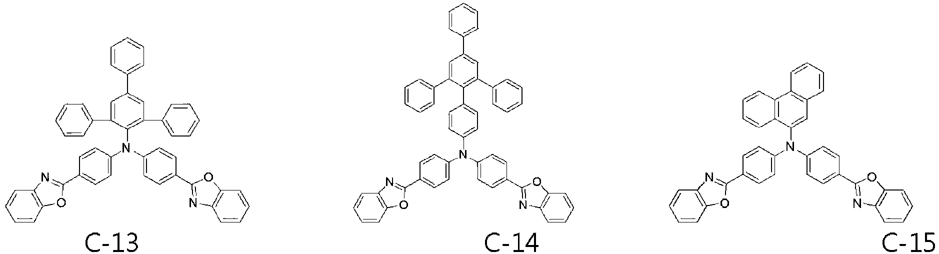

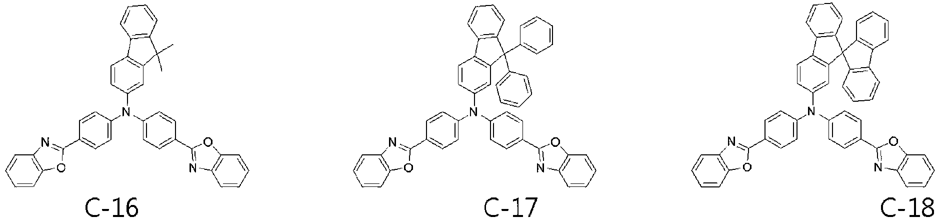

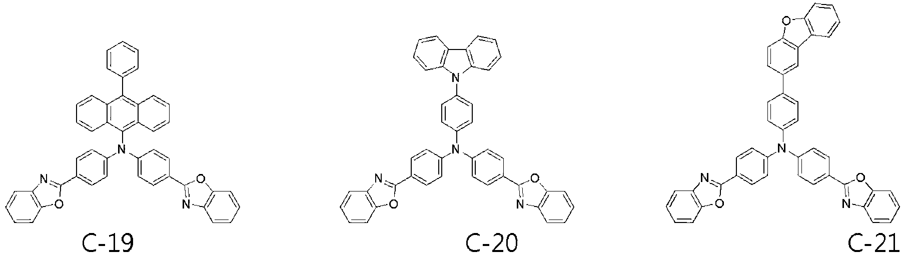

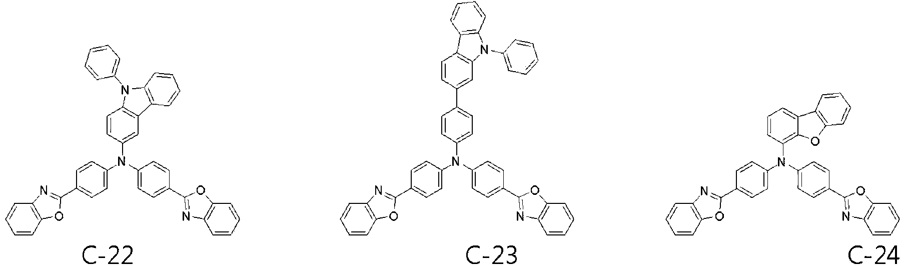

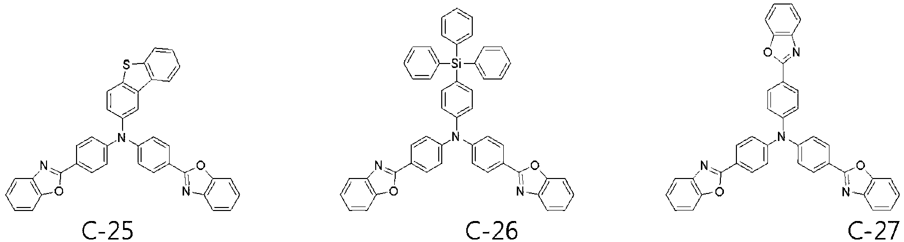

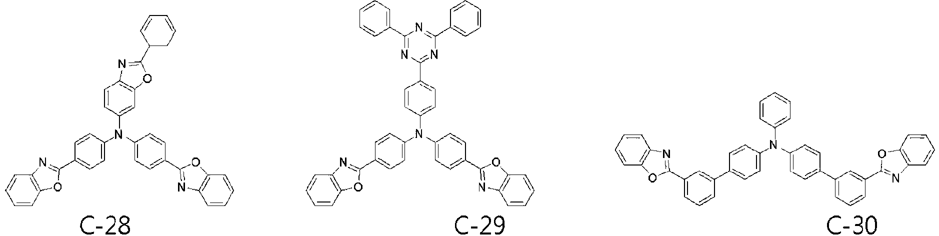

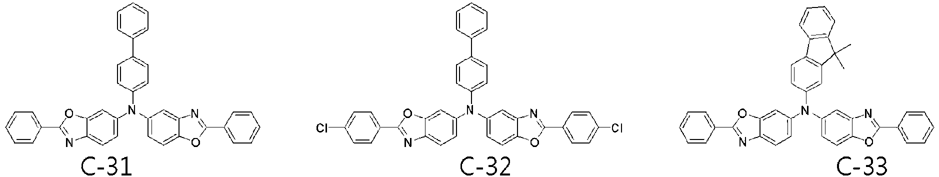

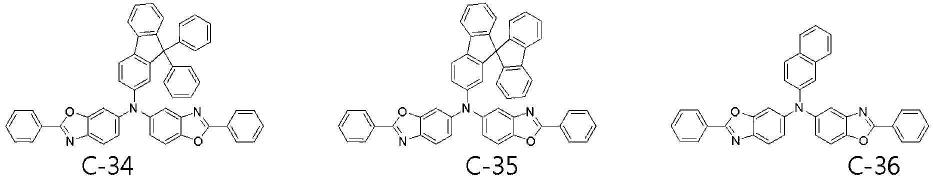

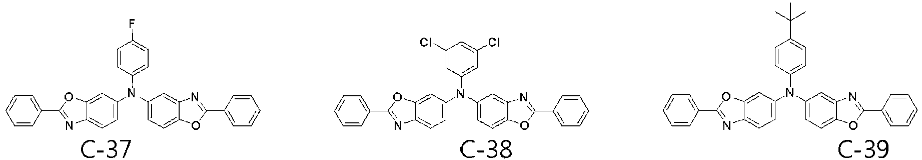

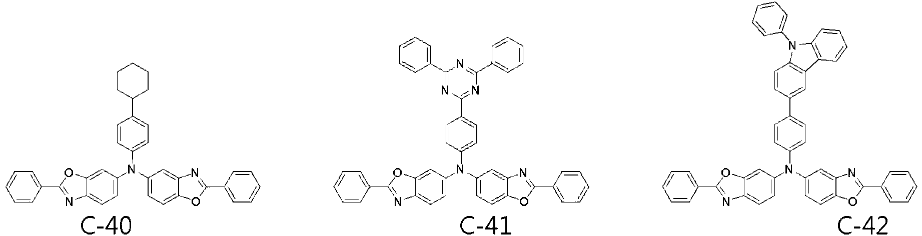

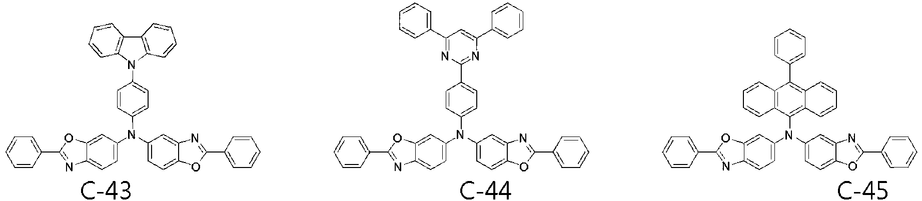

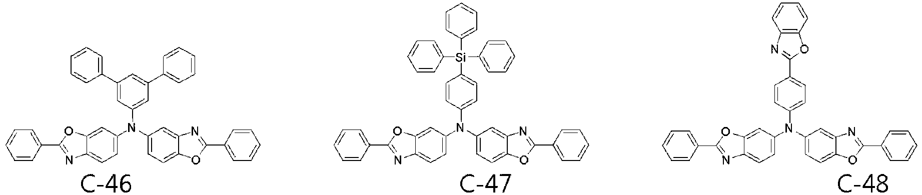

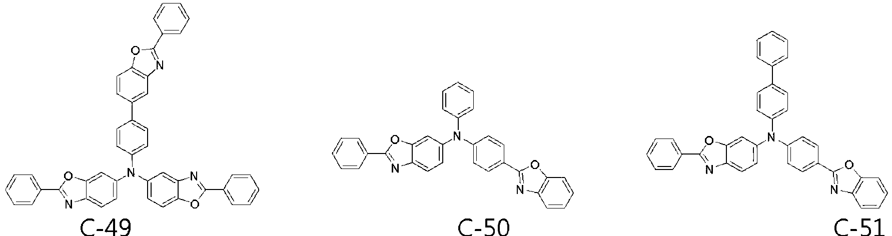

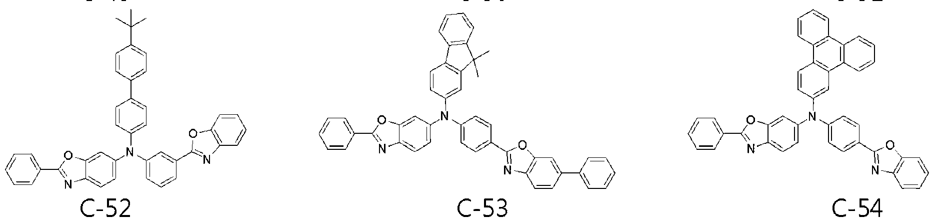

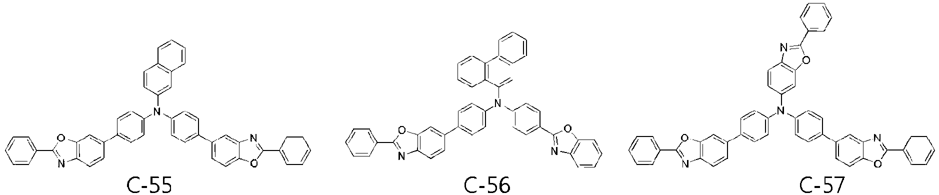

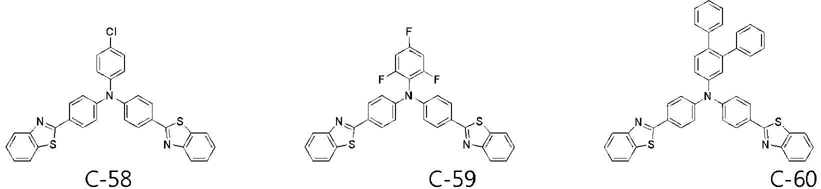

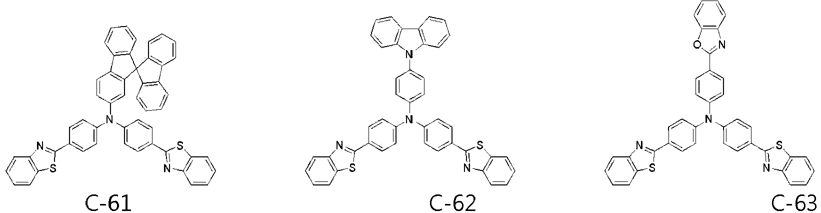

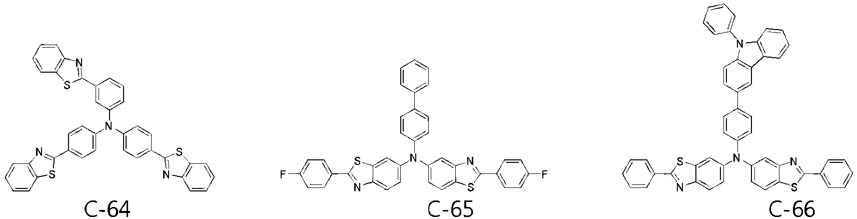

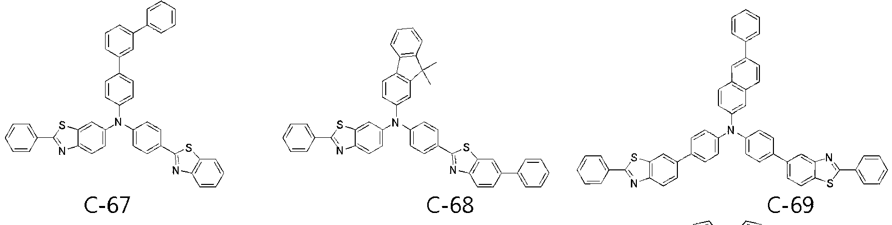

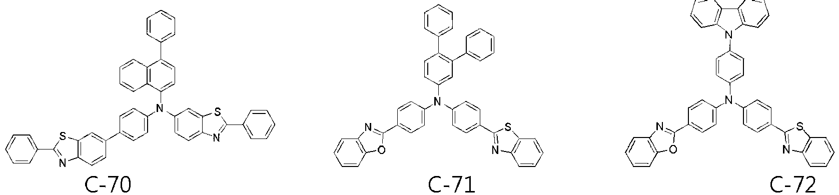

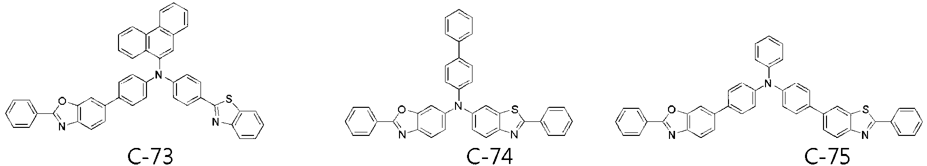

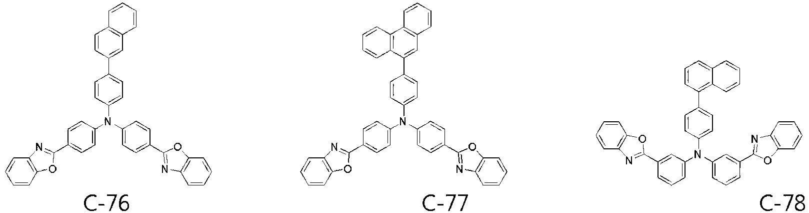

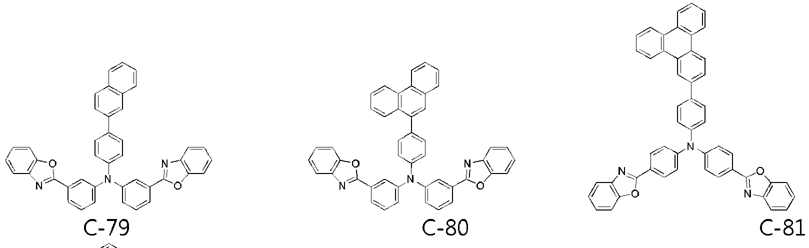

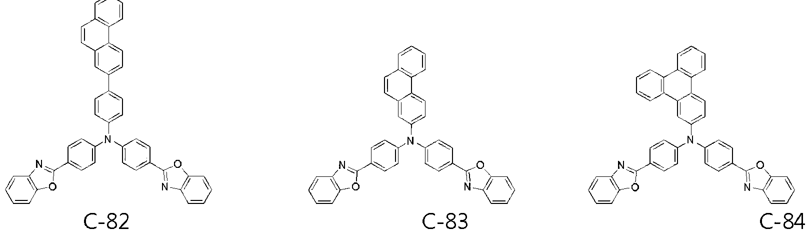

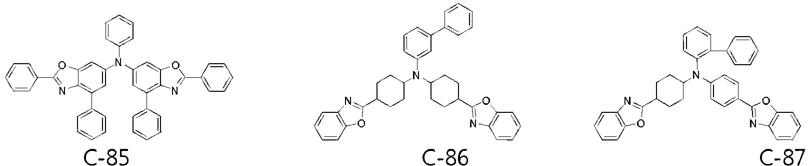

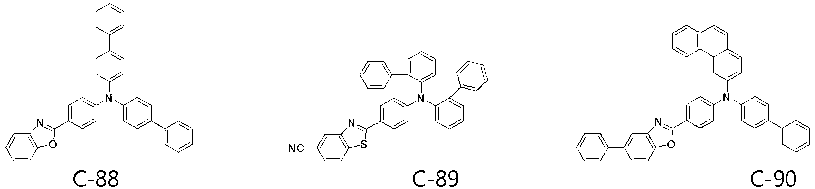

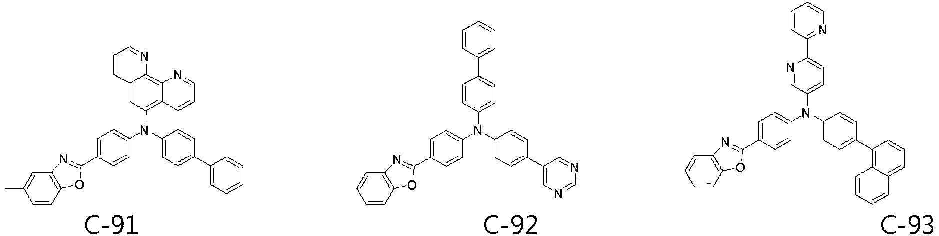

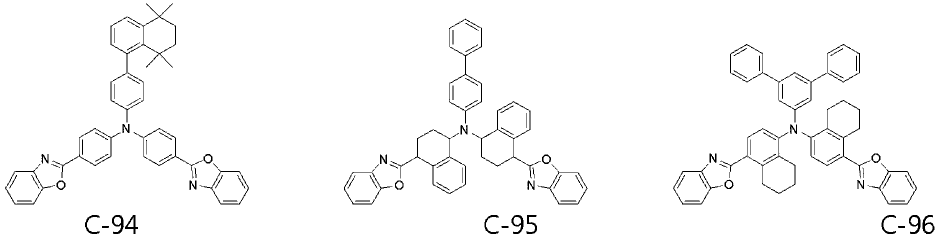

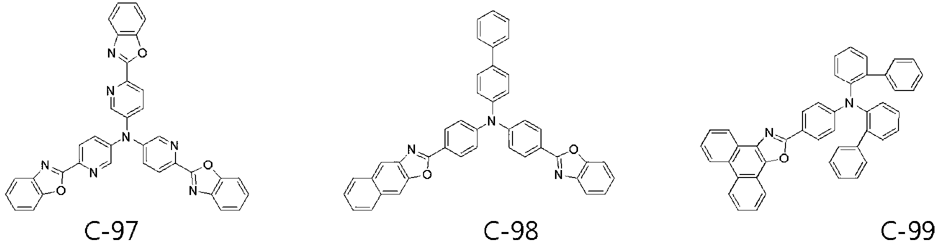

11. Dispositif électroluminescent organique selon la revendication 1, dans lequel la couche d'émission de lumière comprend un hôte et un dopant et l'hôte comprend un composé des composés représentés par les [A-1] à [A-66] ci-dessus.

12. Dispositif électroluminescent organique selon la revendication 11, dans lequel le composé dopant comprend un composé polycyclique représenté par la [Formule D] suivante : 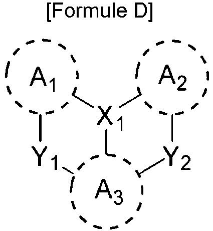
X₁ étant choisi parmi B, P=O et P=S,
Y₁ et Y₂ étant chacun indépendamment choisi parmi NR₄₁, CR₄₂R₄₃, O, S, Se et SiR₄₄R₄₅,
A₁ à A₃ étant chacun indépendamment choisi parmi un cycle hydrocarboné aromatique en C6-C50 substitué ou non substitué, un cycle hétéroaromatique en C2-C50 substitué ou non substitué, un cycle aliphatique en C3-C30 substitué ou non substitué, et un cycle mixte aliphatique-aromatique en C3-C30 substitué ou non substitué, et
R₄₁ à R₄₅ étant identiques ou différents les uns des autres, et étant chacun indépendamment choisis parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétérocycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C6-C30 substitué ou non substitué, un groupe amine substitué ou non substitué, un groupe silyle substitué ou non substitué, un groupe à cycles mixtes aliphatiques-aromatiques en C3-C20 substitué ou non substitué, un groupe nitro, un groupe cyano, et un groupe halogène, sous réserve que chacun des R₄₁ à R₄₅ est lié à chacun des cycles A₁ à A₃ pour former un monocycle ou polycycle alicyclique ou aromatique, les substituants des cycles A₁ à A₃ sont liés les uns aux autres pour former un monocycle ou polycycle alicyclique ou aromatique, et R₄₂ et R₄₃, et R₄₄ et R₄₅ sont liés les uns aux autres pour former en outre un monocycle ou polycycle alicyclique ou aromatique dont au moins un atome de carbone est substitué par au moins un hétéroatome choisi parmi azote, oxygène et soufre.

13. Dispositif électroluminescent organique selon la revendication 12, dans lequel le compose polycyclique représenté par la [Formule D] comprend l'un quelconque des composés représentés par les [Formule D-1] à [Formule D-8] suivantes : 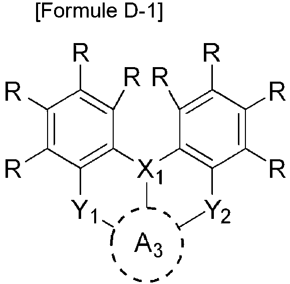
les R's étant chacun indépendamment choisi parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétérocycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C6-C30 substitué ou non substitué, un groupe amine substitué ou non substitué, un groupe silyle substitué ou non substitué, un groupe à cycles mixtes aliphatiques-aromatiques en C3-C20 substitué ou non substitué, un groupe nitro, un groupe cyano, et un groupe halogène, sous réserve que les R's sont liés les uns aux autres pour former en outre un monocycle ou polycycle alicyclique ou aromatique dont au moins un atome de carbone est substitué par au moins un hétéroatome choisi parmi azote, oxygène et soufre, et
X₁, Y₁, Y₂ et A₃ étant tels que définis dans la [Formule D] dans la revendication 12, 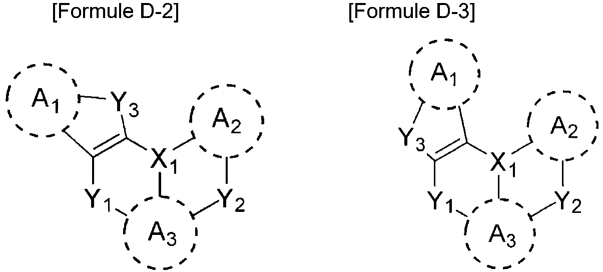
Y₃ étant chacun indépendamment choisi parmi NR₄₁, CR₄₂R₄₃, O, S, Se, et SiR₄₄R₄₅, et X₁, Y₁, Y₂, A₁ à A₃ et R₄₁ à R₄₅ étant tels que définis dans la [Formule D] dans la revendication 12, 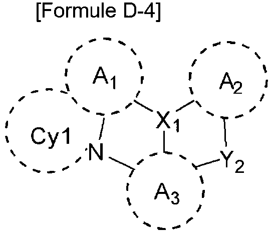
X₁, Y₂ et A₁ à A₃ étant tels que définis dans la [Formule D] dans la revendication 12, et
Cy1 étant lié à un atome d'azote adjacent (N) et l'atome de carbone aromatique dans le cycle A₁ à lier à Cy1, pour former un cycle condensé comprenant l'atome d'azote (N), l'atome de carbone aromatique dans le cycle A₁ auquel l'atome d'azote (N) est lié, et l'atome de carbone aromatique dans le cycle A₁ à lier à Cy1,
une partie du cycle formé par Cy1, à l'exclusion de l'atome d'azote (N), l'atome de carbone aromatique dans le cycle A₁ auquel l'atome d'azote (N) est lié, et l'atome de carbone aromatique dans le cycle A₁ à lier à Cy1, étant un groupe alkylène en C2-C5 substitué ou non substitué, 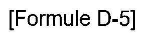 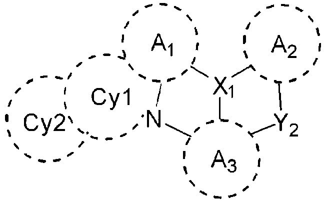
X₁, Y₂ et A₁ à A₃ étant tels que définis dans la [Formule D] dans la revendication 12,
Cy2 étant ajouté à Cy1 pour former un cycle hydrocarboné saturé et une partie du cycle formé par Cy2, à l'exclusion de l'atome de carbone compris dans Cy1, étant un groupe alkylène en C2-C5 substitué ou non substitué, 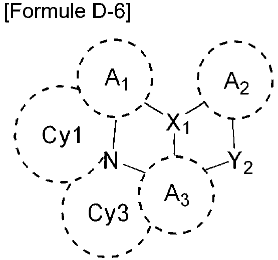
X₁, Y₂ et A₁ à A₃ étant tels que définis dans la [Formule D] dans la revendication 12, et
Cy3 étant lié à l'atome de carbone lié à l'atome d'azote (N) dans Cy1 et à l'atome de carbone aromatique dans le cycle A₃ à lier à Cy3, pour former un cycle condensé comprenant l'atome de carbone aromatique dans le cycle A₃ à lier à Cy3, l'atome d'azote (N), et l'atome de carbone dans Cy1 auquel l'atome d'azote (N) est lié,
une partie du cycle formé par Cy3, à l'exclusion de l'atome de carbone aromatique dans le cycle A₃ à lier à Cy3, l'atome d'azote (N), et l'atome de carbone dans Cy1 auquel l'atome d'azote (N) est lié, étant un groupe alkylène en C1-C4 substitué ou non substitué, 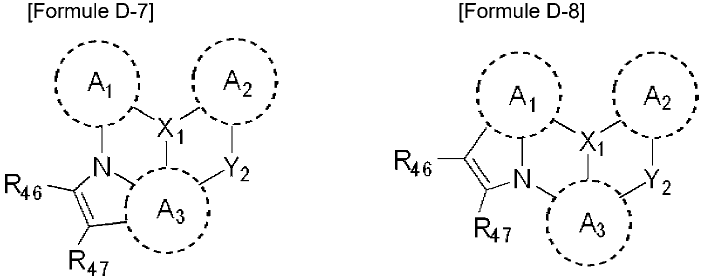
R₄₆ et R₄₇ étant identiques ou différents les uns des autres, et étant chacun indépendamment choisis parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétérocycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C6-C30 substitué ou non substitué, un groupe amine substitué ou non substitué, un groupe silyle substitué ou non substitué, un groupe à cycles mixtes aliphatiques-aromatiques en C3-C20 substitué ou non substitué, un groupe nitro, un groupe cyano, et un groupe halogène, sous réserve que les R₄₅ et R₄₇ sont liés les uns aux autres pour former en outre un monocycle ou polycycle alicyclique ou aromatique et un cycle mixte aliphatique-aromatique, et
X₁, Y₂ et A₁ à A₃ étant tels que définis dans la [Formule D] dans la revendication 12.

14. Dispositif électroluminescent organique selon la revendication 1, comprenant en outre au moins une couche choisie parmi une couche d'injection de trous, une couche de transport de trous, une couche fonctionnelle capable d'injecter et de transporter des trous, une couche de transport d'électrons, une couche de transport d'électrons et une couche fonctionnelle capable d'injecter et de transporter des électrons, outre la couche d'émission de lumière.

15. Dispositif électroluminescent organique selon la revendication 1, dans lequel la première électrode est une anode la deuxième électrode est une cathode, et
la couche de revêtement est disposée sur une des surfaces de la cathode.

16. Dispositif électroluminescent organique selon la revendication 14, le dispositif électroluminescent organique étant utilisé pour un système d'affichage ou d'éclairage choisi parmi des écrans à panneau plat, des écrans flexibles, des systèmes d'éclairage monochromatique ou blanc à panneau plat, des systèmes flexibles d'éclairage monochromatique ou blanc, des écrans pour véhicules, et des écrans pour la réalité virtuelle ou augmentée.
